# EUROPÄISCHE PATENTSCHRIFT

(11) **EP 2 067 191 B1**
(45) Veröffentlichungstag und Bekanntmachung des Hinweises auf die Patenterteilung: **17.06.2020**
(21) Anmeldenummer: 07817586.6
(22) Anmeldetag: 26.09.2007
(51) Int. Cl.: H01L 25/16, F21S 2/00, H01L 51/52, H01L 25/075, F21V 33/00

(54) **BELEUCHTUNGSEINRICHTUNG**
LIGHTING EQUIPMENT
DISPOSITIF D'ÉCLAIRAGE

(30) Priorität: 29.09.2006 DE 102006046293; 29.09.2006 DE 102006046198; 20.11.2006 DE 102006054584; 21.12.2006 DE 102006060781
(43) Veröffentlichungstag der Anmeldung: 10.06.2009
(73) Patentinhaber: OSRAM OLED GMBH, 93049 Regensburg (DE); OSRAM SYLVANIA INC., Danvers, MA 01923 (US)
(72) Erfinder: DIEKMANN, Karsten, 94371 Rattenberg (DE); HEUSER, Karsten, 91056 Erlangen (DE); KLEIN, Markus, 93105 Tegernheim (DE); LANG, Dieter, 83052 Bruckmühl (DE); LECHERMANN, Georg, 82377 Penzberg (DE); REITHMEIER, Michael, 82223 Eichenau (DE); PLUMEYER, Carsten, 82152 Martinsried (DE); CHIPALKATTI, Makarand, Lexington, Massachusetts 02420 (US); CUSTODIS, Udo, Happy Valley, Hong Kong (CN); SEYMOUR, Diane, Towanda, Pennsylvania 18848 (US); POPLAVSKYY, Dmytro, San Jose, California 95129 (US); WEITZEL, Reinhard, 82216 Gernlinden (DE)
(74) Vertreter: Epping - Hermann - Fischer
(86) Internationale Anmeldenummer: PCT/DE2007/001744
(87) Internationale Veröffentlichungsnummer: WO 2008/040323

(56) Entgegenhaltungen:
- EP-A- 1 367 677
- WO-A1-2005/086257
- JP-A- 2003 288 995
- JP-A- 2006 155 940
- US-A1- 2001 045 921

## Beschreibung

Die vorliegende Anmeldung betrifft eine Beleuchtungseinrichtung mit einem organischen Leuchtmittel.

Die Druckschriften US 6,554,443 und US 6,626,554 beschreiben ein Leuchtmittel, das als Lichtquellen Leuchtdioden auf Halbleiterbasis aufweist. Die Druckschrift EP 1 367 677 A beschreibt eine Beleuchtungsvorrichtung mit einer flexiblen OLED, die Druckschrift JP 2006 155940 A eine organische elektrolumineszente Lichtquelle, die Druckschrift JP 2003 288995 A ein Badezimmerbeleuchtungssystem, die Druckschrift US 2001/045921 A1 eine organische Elektrolumineszenzvorrichtung und die Druckschrift WO 2005/086257 A1 eine OLED-Hinterleuchtung.

Leuchtdioden auf Halbleiterbasis sind jedoch in der Regel relativ teuer. Insbesondere steigen die Kosten für eine Leuchtdiode auf Halbleiterbasis mit deren Leuchtfläche an. Großflächige Leuchtdioden auf Halbleiterbasis sind daher besonders teuer und werden aufgrund ihrer geringen Rentabilität nur selten hergestellt. Weiterhin sind Leuchtdioden auf Halbleiterbasis in der Regel weder flexibel noch durchlässig für sichtbares Licht ausgebildet.

Eine Aufgabe der vorliegenden Erfindung ist es unter anderem, eine Beleuchtungseinrichtung mit einem Leuchtmittel anzugeben.

Eine weitere Aufgabe der vorliegenden Erfindung ist es unter anderem, eine Beleuchtungseinrichtung mit einem Leuchtmittel anzugeben, deren Licht einen veränderlichen Farbeindruck verursachen kann.

Diese Aufgaben werden durch einen Gegenstand mit den Merkmalen des unabhängigen Patentanspruchs 1 gelöst. Vorteilhafte Ausführungsformen und Weiterbildungen des Gegenstands sind in den abhängigen Ansprüchen gekennzeichnet.

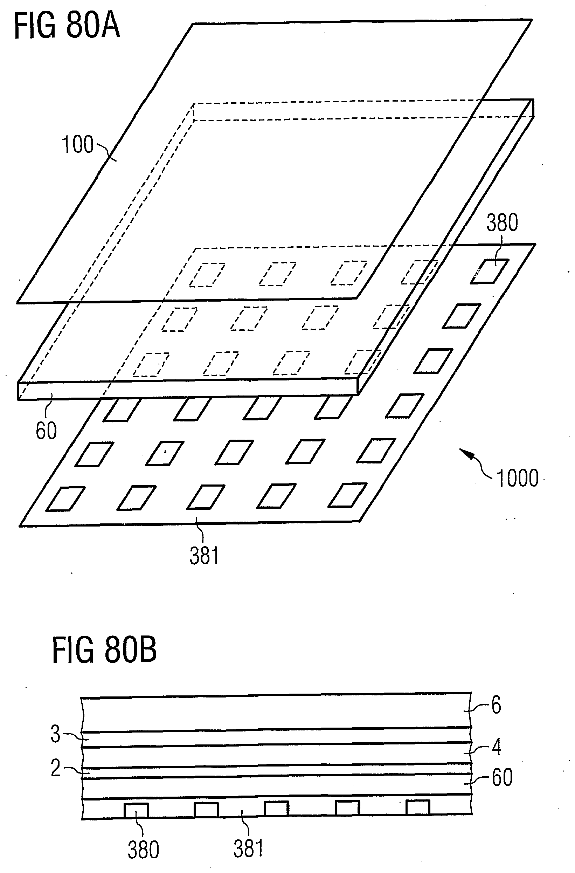

Eine Beleuchtungseinrichtung gemäß der beanspruchten Erfindung ist in den Figuren 80A und 80B und auf den Seiten 190-191 beschrieben.

Die anderen beschriebenen und dargestellten Beispiele sind nicht Teil der Erfindung.

Das Leuchtmittel in der erfindungsgemäßen Beleuchtungseinrichtung umfasst:
- ein Substrat mit einer ersten Hauptfläche, auf die eine erste Elektrode aufgebracht ist,
- eine zweite Elektrode, und
- einen organischen Schichtstapel innerhalb eines aktiven Bereiches des Substrates zwischen der ersten und der zweiten Elektrode, wobei der organische Schichtstapel mindestens eine organische Schicht umfasst, die geeignet ist, Licht zu erzeugen.

Das Substrat des Leuchtmittels ist eine milchige Glasscheibe das durchlässig für sichtbares Licht ausgebildet ist.

Das Leuchtmittel ist für das Licht der zweiten Lichtquelle durchlässig ausgebildet.

Die organischen Schichten des organischen Schichtstapels können niedermolekulare Materialen (small molecules) aufweisen oder polymere Materialien. Niedermolekulare Materialien werden in der Regel durch Vakuumprozesse, wie beispielsweise Verdampfen aufgebracht, während polymere Materialien durch lösungsmittelbasierte Prozesse, wie Rakeln, Drehschleudern (spin-coating) oder Druckverfahren aufgetragen werden können.

Eine der Elektroden dient in der Regel als Anode, die Löcher in den organischen Schichtstapel injiziert, während die andere Elektrode als Kathode dient, die Elektronen in den organischen Schichtstapel einprägt. Die Anode weist bevorzugt ein Material auf, das eine hohe Austrittsarbeit für Elektronen aufweist, wie beispielsweise Indium-Zinn-Oxid (ITO).

Die Kathode hingegen weist bevorzugt ein Material auf, das eine geringe Austrittsarbeit für Elektronen hat, wie beispielsweise Alkali- oder Erdalkalimetalle. Da solche Materialien in der Regel sehr empfindlich gegenüber atmosphärischen Gasen - wie beispielsweise Sauerstoff und Feuchtigkeit - sind, kann die Kathode neben einer Schicht eines solchen Materials mit niedriger Austrittsarbeit eine oder mehrere weitere Schichten umfassen, die deutlich unempfindlicher gegen Umwelteinflüsse sind, wie beispielsweise Silber-, Aluminium- oder Platinschichten. Die weiteren Schichten kapseln die Schicht mit der niedrigen Austrittsarbeit für Elektronen.

Der organische Schichtstapel kann neben der mindestens einen Schicht, die geeignet ist, Licht zu erzeugen, weitere organische Schichten umfassen, wie beispielsweise eine Loch injizierende Schicht, eine Loch leitende Schicht, eine Elektronen injizierende Schicht und eine Elektronen leitende Schicht.

Die Loch leitende Schicht und die Loch injizierende Schicht befinden sich dabei bevorzugt auf der Seite des organischen Schichtstapels, der zur Anode weist, während sich die Elektronen leitende und die Elektronen injizierende Schicht bevorzugt auf der zur Kathode weisenden Seite des organischen Schichtstapels befinden. Die organische Schicht, die geeignet ist, Licht zu erzeugen, ist hierbei bevorzugt zwischen der Loch leitenden Schicht und der Loch injizierenden Schicht auf der einen Seite und der Elektronen leitenden Schicht und der Elektronen injizierenden Schicht auf der anderen Seite angeordnet. In der Regel sind die organischen Materialien lichtdurchlässig, insbesondere für ein von dem organischen Schichtstapel ausgesandtes Licht ausgebildet.

Beispielsweise enthält oder besteht die Loch injizierende Schicht aus mindestens einem der folgenden Materialien:
- Pedot:PSS
- F4TCNQ (Tetrafluorotetracyano-chinodimethan), p-dotiert
- NHT-5 mit NDP-2.

Beispielsweise enthält oder besteht die Loch leitende Schicht aus mindestens einem der folgenden Materialien:
- aNPD=aNPB= 4,4'-bis[N-(1-naphtyl)-N-phenyl-amino] biphenyl
- 1-TNATA = 4,4',4''-Tris(N-(naphth-1-yl)-N-phenyl-amino)triphenylamin
- MTDATA = 4,4',4''-Tris(N-3methylphenyl-N-phenyl-amino)triphenylamin
- TPD = N,N'-diphenyl-N,N'-(3-methylphenyl)-1,1'-biphenyl-4,4'-diamin
- spTAD = 2,2',7,7'-diphenylamino-spiro-9,9'-biflouren.

Beispielsweise enthält oder besteht die Elektronen leitende Schicht aus mindestens einem der folgenden Materialien:
- Alq3 = Tris(8-hydroxychinolin)aluminium
- BAlq = Bis-(2-methyl-8-chinolinolate)-4-(phenylphenolato) aluminium
- TPBi = 1,3,5-Tris-(1-phenyl-1H-benzimidazol-2-yl)-benzol.

Beispielsweise enthält oder besteht die Elektronen injizierende Schicht aus mindestens einem der folgenden Materialien:
- LiF, NaF
- Cs2CO3
- Ba
- NET-5 mit NDN-1.

Das Leuchtmittel weist in der Regel zwei Hauptflächen auf, die einander gegenüberliegen. Die dem Substrat abgewandte Hauptfläche des Leuchtmittels wird im Folgenden als "Oberseite" des Leuchtmittels bezeichnet, während die der Oberseite des Leuchtmittels gegenüberliegende Hauptfläche "Unterseite" des Leuchtmittels genannt wird.

Das Leuchtmittel sendet ein in dem organischen Schichtstapel erzeugtes Licht entweder durch seine Unterseite oder durch seine Oberseite oder durch Unterseite und Oberseite aus. In jedem Fall müssen die Elemente des Leuchtmittels, die von dem im organischen Schichtstapel erzeugten Licht auf dem Weg zur jeweiligen Licht emittierenden Seite - Oberseite oder Unterseite - des Leuchtmittels durchlaufen werden, durchlässig für das von dem organischen Schichtstapel erzeugte Licht sein. Ist es vorgesehen, dass das im organischen Schichtstapel erzeugte Licht von Unter- und Oberseite des Leuchtmittels ausgesendet wird, so müssen in der Regel alle Elemente des Leuchtmittels, insbesondere die Elektroden, sowie eine Verkapselung und das Substrat durchlässig für das von dem organischen Schichtstapel erzeugte Licht sein. Ein Element wird vorliegend auch als "lichtdurchlässig" bezeichnet, wenn es zumindest für das von dem organischen Schichtstapel erzeugte Licht durchlässig ausgebildet ist.

Gemäß zumindest einer Ausführungsform des Leuchtmittels ist die erste Elektrode für ein vom organischen Schichtstapel im Betrieb ausgesandtes Licht durchlässig.

Ist nur die erste Elektrode für ein vom organischen Schichtstapel im Betrieb erzeugtes Licht durchlässig, die zweite Elektrode hingegen nicht, so ist es in der Regel vorgesehen, dass das Licht durch die Unterseite des Leuchtmittels ausgesandt wird. Bevorzugt ist daher in diesem Fall zumindest das Substrat ebenfalls durchlässig für das von dem organischen Schichtstapel erzeugte Licht ausgebildet.

Als Material für ein Substrat, das für das von dem organischen Schichtstapel ausgesandte Licht durchlässig ausgebildet ist, eignet sich beispielsweise Glas oder Kunststoffe, wie zum Beispiel Polyethyleneterephthalat (PET), Polybutylenterephthalat (PBT), Polyethylennaphthalat (PEN), Polycarbonat (PC), Polyimid (PI), Polysulfon (PSO), Polyphenylenethersulfon (PES), Polyethylen (PE), Polypropylen (PP), Polyvinylchlorid (PVC), Polystyrol (PS) and Polymethylmethacrylat (PMMA), Polyamid (PA), Polyurethan (PUR), sowie Kautschuke.

Ferner eignen sich ein Laminat aus einem Glas und zumindest einem der oben aufgeführten Kunststoffe als Substrat, das für das von dem organischen Schichtstapel ausgesandte Licht durchlässig ausgebildet ist.

Gemäß zumindest einer weiteren Ausführungsform des Leuchtmittels ist die zweite Elektrode für ein vom organischen Schichtstapel im Betrieb ausgesandtes Licht durchlässig. Ist nur die zweite Elektrode für ein vom organischen Schichtstapel im Betrieb erzeugtes Licht durchlässig, die erste Elektrode hingegen nicht, so ist es in der Regel vorgesehen, dass das Licht durch die Oberseite des Leuchtmittels ausgesendet wird. Bevorzugt sind daher in diesem Fall die Elemente zwischen zweiter Elektrode und Oberseite - beispielsweise eine Verkapselung - ebenfalls durchlässig für das von dem organischen Schichtstapel erzeugte Licht ausgebildet.

Gemäß zumindest einer besonders bevorzugten Ausführungsform des Leuchtmittels sind beide Elektroden durchlässig für das von dem Schichtstapel erzeugte Licht ausgebildet. Bei dieser Ausführungsform ist das Leuchtmittel in der Regel dafür vorgesehen, durchlässig für das von dem organischen Schichtstapel ausgesandte Licht ausgebildet zu sein. Wie oben bereits erwähnt, sind in diesem Fall ebenfalls die weiteren Elemente des Leuchtmittels, die das Licht auf dem Weg zur Oberseite beziehungsweise Unterseite des Leuchtmittels durchläuft, insbesondere das Substrat und eine Verkapselung, durchlässig für das von dem organischen Schichtstapel ausgesandte Licht ausgebildet.

Gemäß zumindest einer Ausführungsform weist mindestens eine der Elektroden ein transparentes leitendes Oxid, ein Metall oder ein leitendes organisches Material auf oder besteht aus einem solchen.

Transparente leitende Oxide (transparent conductive oxides, kurz "TCO") sind leitende Materialien, in der Regel Metalloxide, wie beispielsweise Zinkoxid, Zinnoxid, Cadmiumoxid, Titanoxid, Indiumoxid oder Indiumzinnoxid (ITO), die durchlässig sind für sichtbares Licht. Sie sind daher insbesondere geeignet, für Elektroden verwendet zu werden, die durchlässig für das von dem organischen Schichtstapel ausgesandte Licht ausgebildet sind. Als Anodenmaterial ist beispielsweise ITO geeignet. Neben binären Metallsauerstoffverbindungen, wie beispielsweise ZnO, SnO₂ oder In₂O₃ gehören auch ternäre Metallsauerstoffverbindungen, wie beispielsweise ZnO:Al (ZAO), Zn₂SnO₄, CdSnO₃, ZnSnO₃, MgIn₂O₄, GaInO₃, Zn₂In₂O₅ oder In₄Sn₃O₁₂ oder Mischungen unterschiedlicher transparenter leitender Oxide zu der Gruppe der TCOs. Weiterhin entsprechen die TCOs nicht zwingend einer stöchiometrischen Zusammensetzung und können auch p- oder n-dotiert sein.

Als Metall für die Kathode können beispielsweise Alkali- oder Erdalkalimetalle verwendet werden. Weiter eigenen sich auch die oben angegebenen TCO-Materialien zur Bildung der Kathode.

Die Elektrode kann beispielsweise eine metallische Schicht aufweisen oder aus einer solchen bestehen. Soll die Elektrode, die die metallische Schicht aufweist oder aus einer solchen besteht, durchlässig für das von dem organischen Schichtstapel ausgesandte Licht ausgebildet sein, so muss die metallische Schicht hinreichend dünn ausgebildet sein. Bevorzugt liegt die Dicke einer solchen semitransparenten metallischen Schicht zwischen 1 nm und 100 nm, wobei die Grenzen eingeschlossen sind.

Als organisches leitendes Material für eine Elektrode ist beispielsweise PEDOT:PSS geeignet, das sich besonders gut für die Anode eignet. Weiter geeignete organische leitende Materialien sind unter anderem Polythiophene oder Pentacen.

Organische Materialien sind in der Regel durchlässig für sichtbares Licht. Daher ist auch eine Elektrode, die organisches leitendes Material umfasst oder aus einem solchen besteht, in der Regel durchlässig für das von dem organischen Schichtstapel ausgesandte Licht.

Gemäß zumindest einer Ausführungsform des Leuchtmittels weist mindestens eine der Elektroden elektrisch leitende Bahnen auf. Die elektrisch leitenden Bahnen weisen bevorzugt ein Metall auf oder bestehen aus einem solchen. Besonders bevorzugt sind die elektrischen Bahnen relativ dick, beispielsweise im Vergleich mit einer oben beschriebenen semitransparenten metallischen Schicht, ausgebildet. Bevorzugt beträgt die Dicke der metallischen Bahnen höchstens 1,5 µm. Derart dicke elektrisch leitende Bahnen weisen in der Regel eine gute elektrische Leitfähigkeit auf, so dass sie besonders gut geeignet sind, Ladungsträger in den organischen Schichtstapel einzuprägen. Weiterhin sind die metallischen Bahnen bevorzugt so ausgebildet, dass sie von der Fläche der sie umfassenden Elektrode nur einen kleinen Teil ausfüllen. Beispielsweise sind die elektrisch leitenden Bahnen als Gitter ausgebildet, das für das von dem organischen Schichtstapel ausgesandte Licht durchlässig ist. Auf diese Art und Weise kann mit Hilfe der elektrisch leitenden Bahnen eine für das vom organischen Schichtstapel ausgesandte Licht durchlässige Elektrode geschaffen werden, die weiterhin vorteilhafterweise eine gute Ladungsträgereinprägung in den organischen Schichtstapel erlaubt.

Bevorzugt beträgt der Anteil der metallischen Bahnen an der gesamten Elektrodenfläche maximal 25 %, bevorzugt höchstens 10 %, besonders bevorzugt höchsten 5 %. Die metallischen Bahnen sind dann für einen Betrachter nicht mehr oder nur kaum wahrnehmbar.

Besonders bevorzugt weisen die elektrisch leitenden Bahnen einen Mehrschichtaufbau auf. Ein solcher Mehrschichtaufbau kann beispielsweise mehrere metallische Schichten aufweisen. Bevorzugt umfasst der Mehrschichtaufbau drei metallische Schichten oder besteht aus diesen, von denen die beiden äußeren Schichten als Schutzschichten für die mittlere Schicht dienen, beispielsweise gegen Korrosion. Die mittlere Schicht des Mehrschichtaufbaus kann beispielsweise Aluminium aufweisen oder aus Aluminium bestehen, während die beiden äußeren Schichten Chrom, Molybdän, Kupfer oder Silber aufweisen können oder aus einem dieser Materialien bestehen können.

Der Mehrschichtaufbau weist dabei eine Dicke von vorzugsweise wenigstens 50 nm und höchstens 100 nm auf.

Die genannten Materialien sind dabei besonders gut für eher schlecht leitfähige Elektroden geeignet. Zum Beispiel für Elektroden, die ein TCO enthalten oder aus einem solchen bestehen. Prinzipiell sind die Materialen für Anode und Kathode geeignet.

Gemäß zumindest einer Ausführungsform des Leuchtmittels umfasst der organische Schichtstapel eine dotierte organische Schicht mit einem Dotierstoff, die zwischen der mindestens einen zur Lichterzeugung geeigneten organischen Schicht und einer der Elektroden angeordnet ist. Besonders bevorzugt bildet die dotierte organische Schicht eine äußerste Schicht des organischen Schichtstapels, die besonders bevorzugt eine gemeinsame Grenzfläche mit der jeweils zugewandten Elektrode ausbildet. Bei der dotierten organischen Schicht kann es sich um eine n-dotierte Schicht oder um eine p-dotierte Schicht handeln. Ist die dotierte Schicht so angeordnet, dass sie zur Kathode weist oder an die Kathode angrenzt, handelt es sich in der Regel um eine n-dotierte Schicht. Ist die dotierte Schicht hingegen so angeordnet, dass sie zur Anode weist oder an diese angrenzt, so handelt es sich in der Regel um eine p-dotierte Schicht.

Bevorzugt handelt es sich bei dem Dotierstoff der dotierten Schicht um möglichst große Atome oder Moleküle, die in dem Fall eines n-Dotierstoffes geeignet sind, Elektronen abzugeben und im Fall eines p-Dotierstoffes geeignet sind, Löcher abzugeben. Weiterhin weist der Dotierstoff bevorzugt eine geringe Diffusionskonstante innerhalb des organischen Schichtstapels auf, wie dies in der Regel beispielsweise bei großen Atomen oder Molekülen der Fall ist.

Die Dotierung erhöht zum Einen vorteilhafterweise die Leitfähigkeit der dotierten organischen Schicht und führt im Falle einer n-dotierten Schicht angrenzend an die Kathode zu einer besseren Injektion von Elektronen aus der Kathode in den organischen Schichtstapel beziehungsweise im Fall einer p-dotierten Schicht angrenzend an die Anode zu einer besseren Lochinjektion aus der Anode in den organischen Schichtstapel. Bevorzugt werden als n-Dotierstoffe Cäsium, Barium und Lithiumfluorid verwendet. Als p-Dotierstoff eignen sich zum Beispiel die folgenden Materialien: F4TCNQ, HIL von Mitsubishi (MCC-PC1.020).

Gemäß zumindest einer Ausführungsform des Leuchtmittels ist der aktive Bereich innerhalb einer Verkapselung angeordnet. Da die organischen Materialien des organischen Schichtstapels und häufig auch Elektrodenmaterialien, insbesondere Materialien der Elektronen injizierenden Kathode, reaktiv gegenüber atmosphärischen Gasen, wie beispielsweise Feuchtigkeit und Sauerstoff sind, ist es für die Lebensdauer des Leuchtmittels in der Regel besonders wichtig, gut gegen Sauerstoff und Feuchtigkeit sowie andere atmosphärische Gase abgeschlossen zu sein, in der Regel mit Hilfe einer Verkapselung. Insbesondere der aktive Bereich, der den organischen Schichtstapel und die Elektroden umfasst, muss hier in der Regel geschützt werden.

Als Verkapselung kann beispielsweise eine Kappe dienen, die im Bereich des aktiven Schichtstapels eine Kavität aufweist und die auf dem Substrat innerhalb eines den aktiven Bereich umgebenden Befestigungsbereiches des Substrates montiert wird, beispielsweise durch Kleben. Die Kavität der Kappe bildet bevorzugt einen Hohlraum über dem aktiven Bereich aus, in dem der organische Schichtstapel und die beiden Elektroden angeordnet sind. Weiterhin steht die Kappe mit der Unterseite ihrer Kavität bevorzugt nicht in direktem Kontakt mit der zweiten Elektrode auf dem organischen Schichtstapel.

Weiterhin kann als Verkapselung auch eine Platte dienen, die innerhalb eines den aktiven Bereich umgebenden Befestigungsbereichs des Substrates mit diesem verbunden ist, beispielsweise durch Kleben. Eine solche Platte kann in direktem Kontakt mit der zweiten Elektrode angeordnet sein. Beispielsweise kann die Platte mittels einer Klebstoffschicht auf der zweiten Elektrode befestigt sein.

Um einen Abstand zwischen der Kappe oder der Platte derart zu erzeugen, dass die Kappe oder die Platte nicht in direktem Kontakt mit der zweiten Elektrode steht, beinhaltet der aktive Bereich gemäß einer Ausführungsform Abstandshalter. Bei den Abstandshaltern kann es sich beispielsweise um kugelförmige Partikel handeln, die auf dem organischen Schichtstapel oder der zweiten Elektrode angeordnet sind. Ferner kann als Verkapselung auch eine Folie dienen. Die Folie kann innerhalb eines den aktiven Bereich umgebenden Befestigungsbereichs des Substrates mit diesem verbunden sein - beispielsweise durch Kleben. Eine solche Folie kann in direktem Kontakt mit der zweiten Elektrode angeordnet sein. Beispielsweise kann die Folie mittels einer Klebstoffschicht auf der zweiten Elektrode befestigt sein.

Um einen Abstand zwischen der Folie und der zweiten Elektrode oder dem organischen Schichtstapel zu erzeugen, derart, dass die Folie nicht in direktem Kontakt mit der zweiten Elektrode steht, beinhaltet der aktive Bereich gemäß einer Ausführungsform Abstandshalter. Bei den Abstandshaltern kann es sich beispielsweise um kugelförmige Partikel handeln, die auf dem organischen Schichtstapel oder der zweiten Elektrode angeordnet sind.

Die Folie ist zum Beispiel aus einem transparenten Kunststoff oder einem Glas gebildet. Vorzugsweise weist die Folie eine Dicke von höchstens 1 mm, besonders bevorzugt von höchstens 0,5 mm auf.

Ferner kann als Verkapselung auch ein Laminat dienen, das zumindest eine Schicht aus einem Glas umfasst, auf die zumindest eine Schicht aus einem Kunststoff aufgebracht ist. Vorzugsweise ist die Glas-Schicht an ihren beiden Hauptflächen von je einer Kunststoffschicht bedeckt. Es handelt sich bei dem Laminat dann um ein Kunststoff-Glas-Kunststoff Laminat.

Das Laminat kann innerhalb eines den aktiven Bereich umgebenden Befestigungsbereichs des Substrates mit diesem - beispielsweise durch Kleben - verbunden sein. Ein solches Laminat kann in direktem Kontakt mit der zweiten Elektrode angeordnet sein. Beispielsweise kann das Laminat mittels einer Klebstoffschicht auf der zweiten Elektrode befestigt sein.

Um einen Abstand zwischen dem Laminat und der zweiten Elektrode oder dem organischen Schichtstapel zu erzeugen, derart, dass das Laminat nicht in direktem Kontakt mit der zweiten Elektrode steht, beinhaltet der aktive Bereich gemäß einer Ausführungsform Abstandshalter. Bei den Abstandshaltern kann es sich beispielsweise um kugelförmige Partikel handeln, die auf dem organischen Schichtstapel oder der zweiten Elektrode angeordnet sind.

Gemäß zumindest einer Ausführungsform ist die Verkapselung durch eine Dünnfilmverkapselung gebildet. Die Dünnfilmverkapselung weist zumindest eine Barriereschicht auf. Die Barriereschicht ist dazu vorgesehen, den organischen Schichtstapel sowie empfindliche Elektrodenmaterialien vor dem Eindringen schädlicher Stoffe, wie beispielsweise Feuchtigkeit und Sauerstoff zu schützen.

Eine Dünnfilmverkapselung umfasst weiterhin zumindest eine Dünnfilmschicht, wie beispielsweise die Barriereschicht, die mittels eines Dünnfilmverfahrens, wie Sputtern, Verdampfen, sowie Plasma unterstützter CVD (kurz für "chemical vapour deposition"), ALD (kurz für "Atomic layer deposition"),MOVPE (kurz für "metal organic vapour phase epitaxy"), Flash evaporation, und/oder Laser Ablation aufgebracht ist. Solche Dünnfilmschichten haben bevorzugt eine Dicke zwischen 0,5 und 5 µm, wobei die Grenzen eingeschlossen sind.

Eine Dünnfilmverkapselung kann beispielsweise direkt auf die zweite Elektrode aufgebracht sein. Eine Dünnfilmverkapselung bietet in der Regel den Vorteil, im Vergleich mit einer Kappe oder einer Platte besonders dünn und Platz sparend ausgebildet werden zu können.

Gemäß zumindest einer Ausführungsform enthält die Barriereschicht eines der folgenden Materialien oder besteht aus einem solchen: Siliziumoxid, Siliziumnitrid. Diese Materialien sind insbesondere geeignet, eine Barriere gegenüber äußeren Einflüssen, wie beispielsweise dem Eindringen von Sauerstoff und Feuchtigkeit, zu bilden.

Gemäß zumindest einer Ausführungsform umfasst die Dünnfilmverkapselung mehrere alternierende Barriereschichten, wobei zumindest zwei hinsichtlich ihrer Materialzusammensetzung unterschiedliche Barriereschichten in regelmäßiger Abfolge angeordnet sind. Mit anderen Worten umfasst die Dünnfilmverkapselung bei dieser Ausführungsform erste und zweite Barriereschichten, wobei die Materialzusammensetzung der ersten Barriereschichten von der Materialzusammensetzung der zweiten Barriereschichten verschieden ist. Die ersten Barriereschichten können beispielsweise Siliziumoxid aufweisen oder aus diesem Material bestehen und die zweiten Barriereschichten können beispielsweise Siliziumnitrid aufweisen oder aus diesem Material bestehen. Die ersten und die zweiten Barriereschichten sind weiterhin alternierend hinsichtlich ihrer Materialzusammensetzung angeordnet.

Eine solche alternierende Schichtenfolge von Barriereschichten innerhalb der Dünnfilmverkapselung bietet den Vorteil, dass die Dünnfilmverkapselung besonders dicht ausgebildet wird. Dies ist in der Regel darauf zurückzuführen, dass Pinholes - das heißt kleine Löcher - die beim Aufbringen der jeweiligen Barriereschicht in dieser entstehen können, durch die darüber liegende Barriereschicht abgedeckt beziehungsweise durch deren Material sogar aufgefüllt werden können. Weiterhin ist die Wahrscheinlichkeit, dass ein Pinhole aus der einen Barriereschicht mit einem Pinhole aus der benachbarten Barriereschicht eine durchgängige Verbindung herstellt, äußerst gering. Dies gilt insbesondere für Barriereschichten, die hinsichtlich ihrer Materialzusammensetzung alternierend angeordnet sind.

Besonders bevorzugt weist die eine der alternierenden Barriereschichten Siliziumoxid und die andere alternierende Barriereschicht Siliziumnitrid auf.

Gemäß zumindest einer weiteren Ausführungsform umfasst die Dünnfilmverkapselung zumindest eine Polymerzwischenschicht, die zwischen zwei Barriereschichten angeordnet ist.

Für die Polymerzwischenschicht eignen sich zum Beispiel mehrkomponentige Harzsysteme, die als Monomere aufgedampft werden und sich flüssig abscheiden. Dadurch wird eine hohe Planarität der Polymerzwischenschicht erreicht. Nachfolgend wird die abgeschiedene Schicht mittels UV-Strahlung vernetzt. Aufgabe der Polymerzwischenschicht ist die Planarisierung in der Dünnfilmverkapselung, um das Übereinanderliegen von Pinholes in den anorganischen alternierenden Barriereschichten zu unterbinden. Dadurch wird die Wasserund Sauerstoffpermeabilität der Dünnfilmverkapselung abgesenkt.

Die Dicke der Polymerzwischenschicht kann vorzugsweise zwischen 50 und 100 nm liegen, wobei die Grenzen eingeschlossen sind. Besonders bevorzugt ist die Polymerzwischenschicht Licht durchlässig, falls ein Top Emitter vorliegt oder Transparenz des Leuchtmittels gefordert ist.

Besonders bevorzugt umfasst die Dünnfilmverkapselung eine Schutzlackschicht als äußerste Schicht. Die Schutzlackschicht kann zum Beispiel mittels eines Sprühverfahrens mit Maskenprozess auf die Dünnfilmverkapselung aufgebracht werden.

Alternativ kann beispielsweise als Schutzlackschicht eine Epoxidharzfolie auf die Dünnfilmverkapselung aufklebt werden. In diesem Fall trägt die Schutzlackschicht insbesondere auch zur Wasserdichtigkeit bei. Auf die Epoxidharzfolie kann ein Dünnglas auflaminiert werden, das die Wasserdichtigkeit weiter verbessert.

Gemäß einer weiteren Ausführungsform ist zwischen der Dünnfilmverkapselung und der zweiten Elektrode eine haftvermittelnde Schicht angeordnet, bei der es sich bevorzugt ebenfalls um eine Dünnfilmschicht handelt. Die haftvermittelnde Schicht hat die Aufgabe, die Haftung der Dünnfilmverkapselung auf der zweiten Elektrode oder einer anderen gegebenenfalls auf der zweiten Elektrode angebrachten Schicht zu verbessern. Hierzu weist die haftvermittelnde Schicht beispielsweise Schwefel- und/oder Stickstoffatome beziehungsweise Schwefel- und/oder Stickstoffverbindungen auf. Weiter ist es möglich, dass die haftvermittelnde Schicht beispielsweise Aluminiumoxid enthält oder aus Aluminiumoxid besteht.

Gemäß zumindest einer weiteren Ausführungsform ist zwischen der zweiten Elektrode und der Dünnfilmverkapselung eine organische Planarisierungsschicht angeordnet.

Für die organische Planarisierungsschicht eignen sich zum Beispiel mehrkomponentige Harzsysteme, die als Monomere aufgedampft werden und sich flüssig abscheiden. Dadurch wird eine hohe Planarität der organischen Planarisierungsschicht erreicht. Nachfolgend wird die abgeschiedene Schicht mittels UV-Strahlung vernetzt. Aufgabe der organischen Planarisierungsschicht ist die Planarisierung in der Dünnfilmverkapselung, um das Übereinanderliegen von Pinholes in den anorganischen alternierenden Barriereschichten zu unterbinden. Dadurch wird die Wasser- und Sauerstoffpermeabilität der Dünnfilmverkapselung abgesenkt. Die Dicke der organischen Planarisierungsschicht kann vorzugsweise zwischen 50 und 100 nm liegen, wobei die Grenzen eingeschlossen sind.

Ist zwischen der zweiten Elektrode und der Dünnfilmverkapselung ein haftvermittelnde Schicht angeordnet, so ist die organische Planarisierungsschicht bevorzugt zwischen der haftvermittelnden Schicht und der zweiten Elektrode angeordnet, wobei die haftvermittelnde Schicht die Haftung zwischen der Planarisierungsschicht und der Dünnfilmverkapselung verbessern soll.

Die organische Planarisierungsschicht kann beispielsweise Streuzentren, wie Diffuserpartikel, beispielsweise Silikakugeln aufweisen. Außer Silikakugeln eignen sich auch andere lichtdurchlässige Materialien, die anderen Brechungsindex als die umgebende Matrix aufweisen, wie zum Beispiel Glaskugeln.

Die Diffuserpartikel sind vorgesehen, Licht zu streuen, zum Beispiel sollen laterale Strukturen des OLED-Schichtaufbaus - die beispielsweise aufgrund des Elektrodendesigns auftreten können - verwischt werden, damit für den Betrachter ein homogener Eindruck entsteht. Weiterhin kann die Abstrahlcharakteristik durch die Lichtstreuung beeinflusst werden.

Die Diffuserpartikel weisen vorzugsweise einen Durchmesser von wenigsten 0,5 bis höchstens 5 µm auf. Die umgebenden Schichten sind in ihrer Dicke bevorzugt entsprechend angepasst, so dass die Diffuserpartikel in die Schichten eingebettet sind.

Soll ein Leuchtmittel geschaffen werden, das im Wesentlichen durchlässig ist für das von dem organischen Schichtstapel im Betrieb ausgesandte Licht oder ein Leuchtmittel, das Licht von seiner Oberseite aussendet, so ist die Verkapselung bevorzugt ebenfalls für das vom Leuchtmittel im Betrieb ausgesandte Licht durchlässig ausgebildet.

Gemäß zumindest einer Ausführungsform weist die Verkapselung Glas auf oder besteht aus Glas. Eine solche Verkapselung ist in der Regel durchlässig für das von dem organischen Schichtstapel ausgesandte Licht. Insbesondere kann eine Glaskappe oder eine Glasplatte als Verkapselung verwendet werden, die durchlässig für das von dem organischen Schichtstapel erzeugte Licht ist.

Gemäß zumindest einer Ausführungsform enthält die organische Planarisierungsschicht ein Lumineszenzkonversionsmaterial.

Das Lumineszenzkonversionsmaterial wandelt zum Beispiel blaues Licht teilweise in gelbes Licht um, wodurch dann ein weißes Mischlicht entsteht, das vom Leuchtmittel abgestrahlt wird. Eine Einbettung des Lumineszenzkonversionsmaterials in die Planarisierungsschicht oder andere funktionelle Schichten wie die Verkapselung oder das Substrat erweist sich als besonders vorteilhaft, weil dadurch Prozessschritte bei der Herstellung eingespart werden können. Dadurch ist die Herstellung besonders kostengünstig.

Lumineszenzkonversionsmaterialien sind Materialien, die einfallendes Licht eines ersten Wellenlängenbereiches absorbieren und Licht eines zweiten, vom ersten verschiedenen Wellenlängenbereiches aussenden, der in der Regel längere Wellenlängen umfasst als der erste Wellenlängenbereich.

Als Lumineszenzkonversionsmaterialien können organische Materialien, wie beispielsweise Perylen-Leuchtstoffe verwendet werden. Weitere organische Materialien, die zum Beispiel auch für Farbstofflaser in entsprechendem Wellenlängen-Bereich eingesetzt werden können, sind als Lumineszenzkonversionsmaterialien geeignet.

Darüber hinaus eignen sich Lumineszenzkonversionsmaterialien, deren Moleküle ein aromatisches System und bevorzugt konjugierte Doppelbindungen enthalten. Das Grundgerüst dieser Lumineszenzkonversionsmaterialien ist zum Beispiel aus Chromen, Xanthen, Cumarin, Thioindol, und/oder Benzol gebildet.
Insbesondere eigenen sich zum Beispiel die folgenden Materialien: Rhodamin 6G, DCM = 4-(Dicyanomethylene)-2-methyl-6-(p-dimethylamino-styryl)-4H-pyran.

Insbesondere sind dabei Moleküle mit anormalem Stokes-Shift erwünscht, der eine verringerte beziehungsweise keine Überlappung der Bereiche der Lumineszenz und der anregenden Strahlung bewirkt. Weiter geeignet sind so genannte Triplett-Emitter, da hier kein Überlapp zwischen anregender Strahlung und Lumineszenz auftritt. Ein weiterer positiver Effekt bei Triplett-Emittern ist, dass Absorptionsverluste vermieden werden, zum Beispiel Rhodamin B ist hier besonders geeignet.

Weiterhin sind auch die folgenden anorganische Materialien geeignet als Lumineszenzkonversionsmaterialien verwendet zu werden: mit Metallen der seltenen Erden dotierte Granate, mit Metallen der seltenen Erden dotierte Erdalkalisulfide, mit Metallen der seltenen Erden dotierte Thiogallate, mit Metallen der seltenen Erden dotierte Aluminate, mit Metallen der seltenen Erden dotierte Orthosilikate, mit Metallen der seltenen Erden dotierte Chlorosilikate, mit Metallen der seltenen Erden dotierte Erdalkalisiliziumnitride, mit Metallen der seltenen Erden dotierte Oxynitride und mit Metallen der seltenen Erden dotierte Aluminiumoxinitride.

Gemäß zumindest einer weiteren Ausführungsform umfasst das Leuchtmittel ein Gettermaterial. Das Gettermaterial ist vorteilhafterweise dazu geeignet, Feuchtigkeit und/oder Sauerstoff zu binden. Als Gettermaterialien können beispielsweise BaO, CaO, Zeolith, Al-Alkoxy-Verbindungen und Barium dienen.

Das Gettermaterial kann beispielsweise innerhalb des aktiven Bereiches angeordnet sein. Weiterhin kann das Gettermaterial alternativ auch außerhalb des aktiven Bereiches angeordnet sein. Das Gettermaterial kann beispielsweise den aktiven Bereich umschließen und etwa ringförmig um den aktiven Bereich zwischen dem Substrat und der Verkapselung angeordnet sein. Auf diese Art und Weise kann das Eindringen schädlicher Stoffe durch das Gettermaterial besonders effektiv vermieden werden.

Weiterhin kann ein Gettermaterial bei Verwendung einer Kappe oder einer Platte zur Verkapselung auch auf der zu dem aktiven Schichtstapel weisenden Seite der Kappe beziehungsweise der Platte aufgebracht sein. Soll ein Leuchtmittel erzeugt werden, das im Wesentlichen für das vom organischen Schichtstapel erzeugte Licht durchlässig ist, so ist hierbei auch das Gettermaterial bevorzugt durchlässig für das von dem organischen Schichtstapel erzeugte Licht. Hierzu sind beispielsweise Al-Alkoxy-Verbindungen als Gettermaterial geeignet.

Umfasst das Leuchtmittel eine Verkapselung, die das Eindringen schädlicher Stoffe in das Leuchtmittel besonders gut verhindert, wie das beispielsweise bei einer Dünnfilmverkapselung der Fall ist, so ist das Leuchtmittel bevorzugt frei von jeglichem Gettermaterial.

Gemäß zumindest einer Ausführungsform umfasst das Leuchtmittel eine elektrische Zuleitung auf dem Substrat, die eine der Elektroden und eine bevorzugt außerhalb des aktiven Bereiches liegende Anschlussstelle elektrisch leitend verbindet. Bevorzugt wird das Leuchtmittel über die Anschlussstelle, beispielsweise mithilfe eines Steckers, elektrisch kontaktiert.

Gemäß zumindest einer Ausführungsform ist die elektrische Zuleitung durchlässig für das von dem Schichtstapel ausgesandte Licht ausgebildet. Eine solche Zuleitung ist insbesondere dazu geeignet, in einem Leuchtmittel verwendet zu sein, das vollständig durchlässig für das von dem Schichtstapel ausgesandte Licht ausgebildet ist.

Die elektrische Zuleitung kann beispielsweise ein Metall enthalten oder aus einem solchen bestehen. Soll die elektrische Zuleitung durchlässig für das von dem Schichtstapel ausgesandte Licht ausgebildet sein, so ist das Metall in diesem Fall derart dünn aufgebracht, dass eine semitransparente Metallschicht entsteht, die durchlässig für Licht des organischen Schichtstapels ist.

Weiterhin kann die elektrische Zuleitung des Leuchtmittels auch ein transparentes leitendes Oxid enthalten oder aus einem solchen bestehen. Da transparente leitende Oxide für sichtbares Licht durchlässig sind, ist eine solche elektrische Zuleitung in der Regel ebenfalls durchlässig für das von dem Schichtstapel ausgesandte Licht und bevorzugt für externes sichtbares Licht.

Gemäß zumindest einer Ausführungsform ist das Leuchtmittel im Wesentlichen durchlässig für das von dem organischen Schichtstapel erzeugte Licht ausgebildet. In diesem Fall ist das Leuchtmittel dazu vorgesehen, das von dem organischen Schichtstapel erzeugte Licht von seiner Oberseite und von seiner Unterseite auszusenden. Weiterhin ist das Leuchtmittel in diesem Fall bevorzugt so ausgebildet, dass es im ausgeschalteten Zustand gut durchlässig für sichtbares externes Licht ist und keine Elemente umfasst, die große Anteile sichtbaren Lichts absorbieren oder reflektieren. Das Leuchtmittel ist in diesem Fall für einen Betrachter im ausgeschalteten Zustand nur schlecht wahrnehmbar. Das heißt das Leuchtmittel ist dann vorzugsweise klar durchsichtig und nicht diffus streuend ausgebildet.

Ist das Leuchtmittel durchlässig für das von dem organischen Schichtstapel ausgesandte Licht, so sind die Elemente des Leuchtmittels, wie der organische Schichtstapel, die Elektroden, das Substrat, die Verkapselung, gegebenenfalls das Gettermaterial und die Zuleitungen ebenfalls durchlässig für das von dem organischen Schichtstapel erzeugte Licht, besonders bevorzugt durchlässig für sichtbares Licht.

Gemäß zumindest einer Ausführungsform des Leuchtmittels dient als Substrat eine Fensterverglasung. Dies kann insbesondere dann von Vorteil sein, wenn das Leuchtmittel durchlässig für das von dem organischen Schichtstapel erzeugte Licht ausgebildet ist.

Ein Leuchtmittel, das für das von dem organischen Schichtstapel erzeugte Licht durchlässig ausgebildet ist, kann in einem Fenster, einem Deckenelement, einer Windschutzscheibe, einer Tür, einem Raumteiler, einem Glasbaustein, einer Mauer oder einer Trennwand integriert sein und beispielsweise in Gebäuden, Möbeln, Kraftfahrzeugen oder Flugzeugen zum Einsatz kommen.

Gemäß einer weiteren Ausführungsform dient eine Fensterverglasung als Verkapselung.

Besonders bevorzugt sind Substrat und Verkapselung als Fensterverglasung ausgebildet. Bei dieser Ausführungsform kann das Leuchtmittel, das bevorzugt durchlässig für das von dem organischen Schichtstapel ausgesandte Licht ausgebildet ist oder eine Beleuchtungseinrichtung mit einem solchen Leuchtmittel, möglichst einfach als Verglasung in einer Glasscheibe integriert werden.

Glasscheiben mit einem Leuchtmittel, das zumindest für ein vom organischen Schichtstapel ausgesandte Licht durchlässig ausgebildet ist oder einer Beleuchtungseinrichtung mit einem solchen Leuchtmittel, können beispielsweise zur Signaldarstellung in Türen von Hotels, auf Messen oder Museen dienen. Hierdurch lassen sich durch das Leuchtmittel Informationen darstellen, die durch das Leuchtmittel nach Bedarf angezeigt werden können. Auf diese Art und Weise können vorteilhafterweise Aufkleber, beispielsweise auf Türen, vermieden werden. Weiterhin ist durch die leuchtende Information des Leuchtmittels eine wesentlich bessere Signalwirkung gegeben als durch einen Aufkleber.

Weiterhin können mit Hilfe von Leuchtmitteln, die durchlässig für ein vom organischen Schichtstapel ausgesandtes Licht ausgebildet sind, Werbedarstellungen, wie beispielsweise Firmenlogos, einfach in Schaufenstern integriert oder Informationen in Windschutzscheiben von Kraftfahrzeugen oder Flugzeugen eingespielt werden.

Weiterhin können Leuchtmittel, die zumindest teilweise durchlässig für das von dem organischen Schichtstapel erzeugte Licht sind, in Deckenelementen beispielsweise in Museen oder Kongresszentren genutzt werden. Hierdurch kann bei ausgeschaltetem Leuchtmittel Tageslicht durch das Deckenelement in den jeweiligen Raum eindringen, während das Deckenelement mit dem Leuchtmittel nachts oder in der Dämmerung zur Beleuchtung genutzt werden kann.

Gemäß der Ausführungsform der Erfindung ist das Substrat des Leuchtmittels milchig ausgeführt.

Gemäß einer weiteren Ausführungsform ist die Verkapselung milchig ausgeführt.

Zum Beispiel ist eine Oberfläche von Substrat und/oder Verkapselung rau ausgebildet und/oder es sind Streuzentren in das Substrat/die Verkapselung eingebracht.

Weiter ist es möglich eine Zusatzfolie/-schicht mit so genannten "Polymer Dispersed Liquid Crystals" auf das Substrat und/oder die Verkapselung aufzubringen. Damit ist die Milchigkeit elektrisch ein- und ausschaltbar. Bei Anlegen einer Spannung ist diese Schicht klar, bei Abschalten wird sie milchig.

Eine milchige Ausführung von Substrat beziehungsweise Verkapselung, beispielsweise als milchige Fensterverglasung, kann insbesondere bei den oben genannten Anwendungen vorteilhaft sein, wenn das jeweilige Fenster keine klare Durchsicht aus Designgründen oder Funktionsgründen erfordert.

Gemäß einem Beispiel umfasst das Leuchtmittel zumindest ein reflektierendes Element. Das reflektierende Element ist bevorzugt entlang einer der Hauptebenen des Leuchtmittels ausgebildet. Besonders bevorzugt ist das reflektierende Element vollständig entlang der Hauptebene des Leuchtmittels ausgebildet. Das reflektierende Element kann auf der Unterseite des Leuchtmittels, beispielsweise auf der von dem organischen Schichtstapel wegweisenden Seite des Substrats oder auf der Oberseite des Leuchtmittels, beispielsweise auf der von dem organischen Schichtstapel wegweisenden Seite der Verkapselung, angeordnet sein. Weiterhin kann das reflektierende Element beispielsweise zwischen der ersten Elektrode und dem Substrat oder zwischen der zweiten Elektrode und der Verkapselung angeordnet sein. Durch die Anordnung eines reflektierenden Elementes innerhalb des Leuchtmittels wird in der Regel eine der Hauptflächen von dem in dem organischen Schichtstapel erzeugten Licht abgeschnitten, das heißt dass das in dem organischen Schichtstapel erzeugte Licht nur von einer der Hauptflächen, also von Unterseite oder Oberseite, ausgesandt wird. Diese Hauptfläche wird im Folgenden auch "lichtemittierende Vorderseite" genannt. Es sei an dieser Stelle darauf hingewiesen, dass mit dem Begriff "lichtemittierende Vorderseite" nicht zwingend gemeint ist, dass die gesamte Hauptfläche von der das im organischen Schichtstapel erzeugte Licht ausgesandt wird, lichtemittierend ausgebildet ist. Vielmehr kann auch nur ein Teil der Fläche der Vorderseite lichtemittierend sein. Vorliegend wird die leuchtende Fläche der lichtemittierenden Vorderseite, der Unterseite und der Oberseite auch als "Leuchtfläche" bezeichnet.

Die übrigen Elemente des Leuchtmittels, zumindest aber die Elemente des Leuchtmittels, die das in dem organischen Schichtstapel erzeugte Licht auf dem Weg zur lichtemittierenden Vorderseite durchläuft, sind bevorzugt durchlässig für das in dem organischen Schichtstapel erzeugte Licht ausgebildet. Besonders bevorzugt sind diese Elemente generell durchlässig für sichtbares Licht ausgebildet.

Umfasst ein Leuchtmittel, bei dem diejenigen Elemente lichtdurchlässig ausgebildet sind, die das von dem organischen Schichtstapel erzeugte Licht auf dem Weg zur lichtemittierenden Vorderseite durchläuft, zumindest ein reflektierendes Element, so kann das Leuchtmittel vorteilhafterweise im angeschalteten Zustand als Beleuchtungsquelle dienen und im ausgeschalteten Zustand, aufgrund des reflektierenden Elementes in Kombination mit den übrigen für sichtbares Licht durchlässigen Elemente des Leuchtmittels, als Spiegel. Bei diesem Leuchtmittel ist es so vorteilhafterweise möglich, zwischen Spiegelfunktion und Beleuchtungsfunktion umzuschalten.

Ein Leuchtmittel, das ein reflektierendes Element umfasst, wird vorliegend auch "reflektierendes Leuchtmittel" genannt. Das Leuchtmittel kann hierbei ein zusätzliches reflektierendes Element aufweisen oder eines der Elemente des Leuchtmittels, wie beispielsweise Substrat, Elektroden oder Verkapselung kann als reflektierendes Element ausgebildet sein.

Gemäß einem Beispiel umfasst das Leuchtmittel eine reflektierende Schichtenfolge als reflektierendes Element.

Die reflektierende Schichtenfolge kann beispielsweise einen dielektrischen Spiegel umfassen oder aus einem solchen bestehen. Weiter ist es möglich, dass die reflektierende Schichtenfolge eine Silberschicht und eine Schicht aus mechanisch widerstandsfähigerem Kupfer umfasst. Vorzugsweise ist die reflektierende Schicht dann von den funktionellen Schichten des Leuchtmittels wie Elektroden oder dem organischen Schichtstapel elektrisch isoliert.

Die reflektierende Schichtenfolge kann auf der Unterseite des Leuchtmittels, beispielsweise auf der von dem organischen Schichtstapel wegweisenden Seite des Substrats oder auf der Oberseite des Leuchtmittels, beispielsweise auf der von dem organischen Schichtstapel wegweisenden Seite der Verkapselung, angeordnet sein. Weiterhin kann die reflektierende Schichtenfolge beispielsweise zwischen der ersten Elektrode und dem Substrat oder zwischen der zweiten Elektrode und der Verkapselung angeordnet sein.

Die reflektierende Schichtenfolge kann beispielsweise auch die äußerste Schicht einer der Elektroden bilden.

Gemäß zumindest einer Ausführungsform umfasst das Leuchtmittel eine entspiegelnde Schichtenfolge. Eine solche entspiegelnde Schichtenfolge ist bevorzugt auf einer der Außenflächen, also auf der Oberseite oder der Unterseite des Leuchtmittels aufgebracht. Strahlt das Leuchtmittel nur von einer der Hauptflächen, nämlich von der lichtemittierenden Vorderseite, Licht ab, so ist die entspiegelnde Schichtenfolge bevorzugt auf der lichtemittierenden Vorderseite aufgebracht.

Eine entspiegelnde Schichtenfolge umfasst bevorzugt ein dielektrisches Material oder besteht aus einem solchen. Beispielsweise kann die Schichtenfolge dabei zumindest eine Schicht umfassen, die ein Siliziumnitrid oder Siliziumoxid umfasst.

Gemäß einem Beispiel ist die erste oder die zweite Elektrode reflektierend ausgebildet. In diesem Fall bildet die reflektierende Elektrode das reflektierende Element aus. Bevorzugt weist die reflektierende Elektrode Silber, Aluminium und/oder Gold auf oder besteht aus einem dieser Materialien.

Weiterhin kann die Verkapselung reflektierend ausgebildet sein und als reflektierendes Element dienen. In diesem Fall sendet das Leuchtmittel das in dem organischen Schichtstapel erzeugte Licht durch das Substrat aus.

Gemäß einem Beispiel umfasst die reflektierende Verkapselung eine Metallkappe oder besteht aus einer solchen. Besonders bevorzugt ist die Metallkappe an ihrer zu dem organischen Schichtstapel weisenden Innenseite poliert.

Gemäß einem Beispiel ist die reflektierende Verkapselung durch eine reflektierende Dünnfilmverkapselung mit zumindest einer Barriereschicht gebildet. Bei diesem Beispiel umfasst die oben bereits beschriebene Dünnfilmverkapselung zumindest eine reflektierende Schicht. Diese reflektierende Schicht umfasst bevorzugt ein Metall oder besteht aus einem solchen. Besonders bevorzugt umfasst die reflektierende Dünnfilmverkapselung zumindest eine der folgenden Schichten als reflektierende Schicht: eine Silberschicht, eine Kupferschicht. Besonders bevorzugt umfasst die Dünnfilmverkapselung eine Silber- und eine Kupferschicht als reflektierende Schicht.

Weiterhin kann die reflektierende Dünnfilmverkapselung eine spiegelnde Schichtenfolge, wie beispielsweise einen Bragg-Spiegel, als reflektierende Schicht umfassen. Die Dünnfilmverkapselung kann dazu - wie oben beschrieben - alternierende Schichten unterschiedlicher Materialien umfassen, die eine besonders dichte Verkapselung und zugleich einen Bragg-Spiegel oder einen dielektrischen Spiegel bildet. Gemäß einer weiteren Ausführungsform umfasst das Leuchtmittel ein Gettermaterial, das durchlässig für das von dem organischen Schichtstapel emittierte Licht, bevorzugt weiterhin generell durchlässig für sichtbares Licht, ausgebildet ist.

Gemäß einem Beispiel ist das Gettermaterial, das zumindest durchlässig für das von dem Schichtstapel emittierte Licht ist, von der reflektierenden Verkapselung umfasst.

Das Gettermaterial hat die Aufgabe, Stoffe, wie beispielsweise Sauerstoff und/oder Feuchtigkeit, zu binden, die trotz der Verkapselung in das Leuchtmittel eindringen können.

Das Gettermaterial ist bevorzugt so von der Verkapselung umfasst, dass es in den zu verkapselnden Raum, also zum organischen Schichtstapel weist. Wird als Verkapselung eine Metallkappe verwendet, so ist das Gettermaterial bevorzugt an der zu dem organischen Schichtstapel weisenden Innenseite der Metallkappe, beispielsweise in Form einer Schicht angebracht. Damit die Metallkappe gute Reflexionseigenschaften aufweist, ist ein Gettermaterial besonders vorteilhaft, das durchlässig für das von dem Schichtstapel emittierte Licht ist.

Zur Befestigung einer Kappe als Verkapselung auf dem Substrat wird beispielsweise ein Klebstoff verwendet, der um den aktiven Bereich angeordnet wird. Ein solcher Klebstoff, aber auch ein anderes Verbindungsmittel, kann weiterhin mit einem Gettermaterial versetzt sein. Da das Verbindungsmittel häufig durchlässiger für schädliche Stoffe, wie Feuchtigkeit und Sauerstoff, ist als die Kappe, bietet dies den Vorteil, dass diese Stoffe schon beim Eindringen in das Leuchtmittel durch das Gettermaterial gebunden werden können.

Eine Dünnfilmverkapselung, insbesondere mit den oben beschriebenen alternierenden Barriereschichten, ist in der Regel derart dicht ausgebildet, dass kein Gettermaterial verwendet werden muss.

Gemäß einem weiteren Beispiel ist das Substrat reflektierend ausgebildet. In diesem Fall bildet das Substrat bevorzugt das oben beschriebene reflektierende Element aus. In diesem Fall sind bevorzugt alle anderen Elemente des Leuchtmittels, die oberhalb des Substrates angeordnet sind, zumindest durchlässig für das von dem organischen Schichtstapel ausgesandte Licht ausgebildet. Als reflektierendes Substrat kann beispielsweise eine Metallfolie oder eine Metallplatte dienen.

Leuchtmittel, die ein reflektierendes Element umfassen und deren weitere Elemente, die von dem im organischen Schichtstapel erzeugten Licht auf dem Weg zur lichtemittierenden Vorderseite durchlaufen werden, durchlässig für sichtbares Licht ausgebildet sind, können wie bereits oben erwähnt als Spiegel oder als Beleuchtungsquelle genutzt werden. Das Leuchtmittel kann hierbei so ausgebildet sein, dass die gesamte Fläche der lichtemittierenden Vorderseite im Betrieb des Leuchtmittels als Beleuchtungsquelle dient und im ausgeschalteten Zustand als Spiegel eingesetzt wird. Weiterhin ist es auch möglich, die gesamte Fläche der lichtemittierenden Vorderseite des Leuchtmittels im Betrieb gleichzeitig als Spiegel und Beleuchtungsquelle einzusetzen. Weiterhin kann die Fläche der lichtemittierenden Vorderseite segmentiert werden, so dass zumindest ein gewisser Bereich als Spiegel und zumindest ein anderer Bereich im Betrieb als Beleuchtungsquelle vorgesehen ist.

Leuchtmittel, die Spiegel- und Beleuchtungsfunktion aufweisen, umfassen in der Regel zumindest eine Elektrode, die durchlässig für das von dem organischen Schichtstapel erzeugte Licht ausgebildet ist und von diesem auf dem Weg zur lichtemittierenden Vorderseite durchlaufen wird.

Gemäß einem Beispiel ist diese lichtdurchlässige Elektrode strukturiert ausgebildet, so dass eine gewünschte Form der Leuchtfläche innerhalb der Vorderseite des Leuchtmittels vorgegeben ist. Die Form der Leuchtfläche kann beispielsweise gemäß einem Logo oder einem Symbol ausgebildet sein, so dass diese oder andere Informationen vor dem Hintergrund einer spiegelnden Fläche im Betrieb erscheinen. In einem Spiegel für Kraftfahrzeuge, wie einem Rück- oder Seitenspiegel, können so beispielsweise Warnungen, wie Abstandsmeldungen beim Einparken, in den Spiegel eingeblendet werden.

Weiterhin kann ein Leuchtmittel mit Spiegel- und Beleuchtungsfunktion von einem Bad- oder einem Garderobenspiegel umfasst oder als Bad- beziehungsweise Garderobenspiegel ausgebildet sein. Der Bad- oder Garderobenspiegel kann beispielsweise mehrteilig mit einem Hauptspiegel in der Mitte und zwei seitlichen Spiegelflügeln ausgeführt sein. Die seitlich angebrachten Spiegelflügel können hierbei beispielsweise als Leuchtmittel mit Spiegel und Beleuchtungsfunktion ausgebildet sein und bei guten Lichtverhältnissen als Spiegel dienen. Bei schlechten Lichtverhältnissen kann dann ein oder beide Spiegelflügel als Lichtquelle hinzugeschaltet werden, um den Betrachter auszuleuchten. Vorteilhafterweise kann ein solcher beleuchteter Spiegelflügel auch als dekoratives Beleuchtungselement dienen.

Weiterhin kann ein Leuchtmittel mit Beleuchtungs- und Spiegelfunktion in einem Suchspiegel enthalten sein. Ein solcher Suchspiegel ist im einfachsten Fall ein Halteelement mit einem abgewinkelten Spiegelelement an einem Ende, wie beispielsweise ein zahnärztlicher Spiegel. Gemäß einem Beispiel umfasst das Spiegelelement ein Leuchtmittel mit Beleuchtungs- und Spiegelfunktion. Die Kombination aus Spiegelfunktion und Beleuchtungsfunktion bei dem Spiegelelement des Suchspiegels bietet hierbei vorteilhafterweise die Möglichkeit, sowohl an schwer zugänglichen Stellen sehen als auch diese Bereiche auszuleuchten zu können. Solche Suchspiegel können beispielsweise Anwendung als zahnärztliche Utensilien finden oder im häuslichen Bereich etwa zur Suche nach verlorenen Gegenständen hinter beziehungsweise unter schwer verrückbaren Möbeln eingesetzt werden. Weiterhin bietet der Einsatz eines Leuchtmittels mit Spiegel- und Beleuchtungsfunktion in einem Suchspiegel den Vorteil, dass Spiegel und Lampe gleichzeitig mit einer Hand geführt werden können.

Ein Leuchtmittel mit Spiegel- und Beleuchtungsfunktion kann weiterhin in einem Spiegel eines tragbaren Kosmetiksets integriert sein. Falls kein Außenlicht zur Verfügung steht, kann die Beleuchtung des Spiegels aktiviert werden, um bessere Lichtverhältnisse für den Betrachter zu schaffen.

Weiterhin können Leuchtmittel mit Spiegel- und Beleuchtungsfunktion als Dekorationselemente, wie beispielsweise als blinkende Spiegel, Verwendung finden. Ein blinkender Spiegel kann beispielsweise in einem blinkenden Weihnachtsstern Verwendung finden.

Gemäß zumindest einer Ausführungsform des Leuchtmittels ist das Leuchtmittel flexibel ausgebildet. Ein flexibel ausgebildetes Leuchtmittel zeichnet sich unter anderem dadurch aus, dass es bis zu einem gewissen Grad biegbar ist, ohne dabei beschädigt zu werden. Vorzugsweise ist das flexibel ausgebildete Leuchtmittel mehrmals biegbar, ohne dabei beschädigt zu werden. Das Leuchtmittel ist dann also geeignet, eine Mehrzahl von Biegezyklen unbeschadet zu überstehen.

Besonders bevorzugt ist das Leuchtmittel derart flexibel ausgebildet, dass es auf eine Rolle aufwickelbar und von der Rolle abwickelbar ist, ohne dabei beschädigt zu werden.

Gemäß zumindest einer Ausführungsform des Leuchtmittels ist die Verkapselung des Leuchtmittels flexibel ausgeführt. Flexibel bedeutet dabei unter anderem, dass die Verkapselung bis zu einem gewissen Grad biegbar ist, ohne dass die Verkapselung beim Biegen beschädigt wird. Bei der flexiblen Verkapselung handelt es sich zum Beispiel um eine dünne Glasschicht, ein Laminat oder eine dünne Schicht - beispielsweise eine Folie - aus einem Kunststoff oder einem Metall. Ferner kann es sich bei der flexiblen Verkapselung um eine Dünnfilmverkapselung handeln, wie sie weiter oben beschrieben ist. Die Dünnfilmverkapselung umfasst vorzugsweise zumindest eine Barriereschicht, wie sie weiter oben beschrieben ist.

Gemäß zumindest einer Ausführungsform ist die flexible Verkapselung lichtdurchlässig ausgebildet, das heißt die flexible Verkapselung ist zumindest für einen Teil des im organischen Schichtstapel des Leuchtmittels erzeugten Lichts durchlässig, so dass dieser Teil des Lichts das Leuchtmittel durch die flexible Verkapselung hindurch verlassen kann. Gemäß zumindest einer Ausführungsform des Leuchtmittels ist das Substrat des Leuchtmittels flexibel. Flexibel bedeutet dabei unter anderem, dass das Substrat bis zu einem gewissen Grad biegbar ist, ohne dass das Substrat beim Biegen beschädigt wird.

Gemäß einem Beispiel ist das Substrat des Leuchtmittels aus einem Metall gebildet. Das Substrat umfasst dann bevorzugt zumindest eines der folgenden Materialien: Aluminium, Edelstahl, Gold, Silber. Besonders vorteilhaft erweist sich bei der Verwendung eines metallischen Substrats als Substrat für das Leuchtmittel unter anderem, dass die gute Reflektivität des Materials zu einer Erhöhung der Lichtleistung des Leuchtmittels beitragen kann. Zumindest ein Teil des Lichts, das im Betrieb des Leuchtmittels aus dem aktiven Bereich des Leuchtmittels auf das metallische Substrat trifft, kann von diesem in Richtung der Licht emittierenden Vorderseite des Leuchtmittels reflektiert werden.

Vorzugsweise ist das Metall flexibel ausgebildet. Das Substrat kann dazu beispielsweise als Blech ausgebildet sein. Das Substrat ist dann vorzugsweise als Mittelblech mit einer Dicke von wenigstens 3 mm und höchstens 4,75 mm oder als Feinblech mit einer Dicke von höchstens 3 mm ausgeführt.

Weiter ist es möglich, dass das flexible Substrat als Metallfolie ausgeführt ist. Das Substrat weist dann vorzugsweise eine Dicke von höchstens 1 mm, besonders bevorzugt höchstens 0,5 mm auf.

Gemäß zumindest einer Ausführungsform des Leuchtmittels sind sowohl das Substrat als auch die Verkapselung flexibel ausgebildet. Verkapselung und Substrat sind dazu vorzugsweise gemäß einer der oben beschrieben Ausführungsform ausgebildet. Zum Beispiel können Substrat und/oder Verkapselung als Folie ausgeführt sein. Weiter ist es möglich, dass das Substrat als Folie und die Verkapselung als Dünnfilmverkapselung ausgebildet ist.

Gemäß einem Beispiel umfasst das Leuchtmittel ein flexibles Substrat, das aus einem metallischen Material gebildet ist. Beispielsweise ist das flexible Substrat als Blech ausgeführt. Der ersten Hauptfläche des flexiblen Substrats ist die erste Elektrode des Leuchtmittels nachgeordnet. Dabei ist es möglich, dass zwischen dem Substrat und der ersten Elektrode weitere Schichten angeordnet sind. Zum Beispiel kann eine elektrisch isolierende Schicht zwischen dem Substrat und der ersten Elektrode angeordnet sein, mit der zumindest die erste Hauptfläche des Substrats beschichtet ist. Die elektrisch isolierende Schicht entkoppelt die erste Elektrode elektrisch vom Substrat.

Der ersten Elektrode ist bei diesem Beispiel der organische Schichtstapel des Leuchtmittels nachgeordnet. Der organische Schichtstapel ist zum Beispiel direkt auf die erste Elektrode aufgebracht. Der organische Schichtstapel umfasst eine organische Schicht, die zur Lichterzeugung vorgesehen ist.

Dem organischen Schichtstapel folgt die zweite Elektrode nach. Die zweite Elektrode ist zum Beispiel direkt auf den organischen Schichtstapel aufgebracht. Die zweite Elektrode ist vorzugsweise - wie weiter oben beschrieben lichtdurchlässig ausgebildet.

Der zweiten Elektrode ist bei diesem Beispiel eine - weiter oben beschriebene - Planarisierungsschicht nachgeordnet. Beispielsweise ist die Planarisierungsschicht direkt auf der zweiten Elektrode angeordnet. Die Planarisierungsschicht enthält vorzugsweise ein organisches Material. Weiter kann die Planarisierungsschicht eines der folgenden Materialien enthalten: Streuzentren wie zum Beispiel Diffuserpartikel, Lumineszenzkonversionsmaterial, Farbfiltermaterial.

Der Planarisierungsschicht folgt eine Barriereschicht nach. Vorzugsweise folgt der Planarisierungsschicht eine Mehrzahl von Barriereschichten nach. Die Barriereschichten bilden als Teil einer Dünnfilmverkapselung die flexible Verkapselung des Leuchtmittels und sind beispielsweise direkt auf die Planarisierungsschicht aufgebracht.

Gemäß einem Beispiel ist das Substrat des Leuchtmittels als Kunststofffolie ausgebildet. Das heißt das Substrat weist eine Dicke von bevorzugt höchstens 1 mm, besonders bevorzugt höchstens 0,5 mm auf und enthält oder besteht aus einem Kunststoff.

Gemäß einem Beispiel umfasst das Leuchtmittel ein flexibles Substrat, das als eine Folie, vorzugsweise als eine Kunststofffolie ausgebildet ist. die Kunststofffolie kann dabei aus einem Kunststoff bestehen oder einen Kunststoff enthalten. Beispielsweise ist es möglich, dass das Substrat eine Metallfolie als Grundkörper umfasst, die mit einem Kunststoffmaterial beschichtet ist. Besonders bevorzugt besteht die Kunststofffolie aus einem lichtdurchlässigen Kunststoff, der für zumindest einen Teil des im organischen Schichtenstapel des Leuchtmittels im Betrieb erzeugten Lichts durchlässig ist.

Der ersten Hauptfläche der Kunststofffolie ist eine erste Elektrode nachgeordnet. Vorzugsweise ist die erste Elektrode direkt auf die erste Hauptfläche des Substrats - das heißt die Folie - aufgebracht. Die erste Elektrode ist dabei vorzugsweise - wie weiter oben beschrieben - lichtdurchlässig ausgebildet.

Der ersten Elektrode ist der organische Schichtstapel des Leuchtmittels nachgeordnet. Beispielsweise ist der organische Schichtstapel direkt auf die erste Elektrode aufgebracht. Der organische Schichtstapel umfasst eine äußerste organische Schicht. Die äußerste organische Schicht ist mit einem Dotierstoff dotiert. Bevorzugt handelt es sich bei dem Dotierstoff der dotierten Schicht - wie weiter oben beschrieben - um möglichst große Atome oder Moleküle, die in dem Fall eines n-Dotierstoffes geeignet sind, Elektronen abgeben und im Fall eines p-Dotierstoffes geeignet sind, Löcher abzugeben. Weiterhin weist der Dotierstoff bevorzugt eine geringe Diffusionskonstante innerhalb des organischen Schichtstapels auf, wie dies in der Regel beispielsweise bei großen Atomen oder Molekülen der Fall ist. Dabei ist unter anderem Cäsium ein besonders geeigneter Dotierstoff.

Dem organischen Schichtstapel ist die zweite Elektrode nachgeordnet. Die zweite Elektrode ist vorzugsweise direkt auf den organischen Schichtstapel aufgebracht. Die zweite Elektrode ist dabei - wie weiter oben beschrieben - lichtdurchlässig ausgebildet. Vorzugsweise ist das Leuchtmittel bei dieser Ausführungsform frei von jeglichem Gettermaterial.

Gemäß einer Ausführungsform des Leuchtmittels umfasst dieses eine flexible Verkapselung. Vorzugsweise ist die flexible Verkapselung lichtdurchlässig, das heißt sie ist zumindest für einen Teil des im aktiven Bereich im Betrieb des Leuchtmittels erzeugten Lichts durchlässig.

Das Leuchtmittel macht sich dabei unter anderem die Idee zunutze, dass ein flexibles Leuchtmittel mit einem lichtdurchlässigen Substrat, lichtdurchlässiger erster Elektrode, lichtdurchlässiger zweiter Elektrode und lichtdurchlässiger Verkapselung besonders vielseitig einsetzbar ist. Beispielsweise kann ein derart ausgebildetes Leuchtmittel als lichtdurchlässige Umhüllung anderer Leuchtmittel - etwa als Lampenschirm für eine Glühlampe - Verwendung finden. Das von der Glühlampe erzeugte Licht kann das flexible, lichtdurchlässige Leuchtmittel zu einem Großteil durchdringen. Mittels des Leuchtmittels kann dem Licht der Glühlampe Licht einer anderen Farbe beigemischt werden.

Gemäß einem Beispiel ist das Substrat des Leuchtmittels als Laminat ausgeführt. Bevorzugt ist das Substrat dabei flexibel ausgebildet. Das Laminat umfasst vorzugsweise zumindest eine erste Schicht und zumindest eine zweite Schicht. Besonders bevorzugt unterscheidet sich dabei das Material, aus dem die erste Schicht gebildet ist, von dem Material, aus dem die zweite Schicht gebildet ist.

Gemäß einem Beispiel ist das Substrat des Leuchtmittels als ein Laminat mit einer ersten Schicht, die aus einem Kunststoff besteht, gebildet. Auf die erste Schicht ist eine zweite Schicht aufgebracht, die aus einem Glas besteht. Vorzugsweise ist direkt auf die zweite Schicht eine dritte Schicht aufgebracht, die aus einem Kunststoff besteht. Besonders bevorzugt besteht die dritte Schicht aus dem gleichen Kunststoff wie die erste Schicht. Das heißt das Substrat ist gemäß diesem Beispiel als ein Kunststoff-Glas-Kunststoff-Laminat ausgeführt. Vorzugsweise ist das Laminat flexibel ausgebildet. Dazu sind die Kunststoffschichten als Folie oder dünne Beschichtung des Glas-Grundkörpers ausgeführt. Der Glas-Grundkörper ist durch eine dünne, flexible Glasscheibe gebildet.

Gemäß einem Beispiel weist das Leuchtmittel ein flexibles Kunststoff-Glas-Kunststoff-Laminat als Substrat auf. Dem Substrat folgt eine erste Elektrode nach. Die erste Elektrode ist dabei direkt auf die erste Hauptfläche des Substrats aufgebracht.

Der ersten Elektrode ist der organische Schichtstapel des Leuchtmittels nachgeordnet. Der organische Schichtstapel ist zum Beispiel direkt auf die erste Elektrode aufgebracht. Der organische Schichtstapel umfasst eine organische Schicht, die zur Lichterzeugung vorgesehen ist.

Dem organischen Schichtstapel folgt die zweite Elektrode nach. Die zweite Elektrode ist zum Beispiel direkt auf den organischen Schichtstapel aufgebracht. Die zweite Elektrode ist vorzugsweise - wie weiter oben beschrieben - lichtdurchlässig ausgebildet.

Der zweiten Elektrode ist eine - weiter oben beschriebene - Planarisierungsschicht nachgeordnet. Beispielsweise ist die Planarisierungsschicht direkt auf der zweiten Elektrode angeordnet. Die Planarisierungsschicht enthält vorzugsweise ein organisches Material. Weiter kann die Planarisierungsschicht eines der folgenden Materialien enthalten: Streuzentren wie zum Beispiel Diffuserpartikel, Lumineszenzkonversionsmaterial, Farbfiltermaterial.

Der Planarisierungsschicht folgt eine Barriereschicht nach. Vorzugsweise folgt der Planarisierungsschicht eine Mehrzahl von Barriereschichten nach. Die Barriereschichten bilden als Teil einer Dünnfilmverkapselung die flexible Verkapselung des Leuchtmittels und sind beispielsweise direkt auf die Planarisierungsschicht aufgebracht.

Gemäß einem Beispiel ist das Substrat des Leuchtmittels durch die Lamelle einer Jalousie gebildet. Das heißt die Lamelle einer Jalousie dient als Substrat für das Leuchtmittel. Vorzugsweise dienen alle Lamellen der Jalousie dann als Substrat für jeweils ein Leuchtmittel. Die Jalousie ist beispielsweise an einem Fenster oder einer Tür derart angebracht, dass die ersten Hauptflächen der durch die Lamellen der Jalousie gebildeten Substrate in das Innere des Raums gerichtet ist, der das Fenster oder die Tür aufweist. Die Jalousie kann dann beispielsweise bei geschlossener Jalousie zur Beleuchtung des Innenraums mit einem - vorzugsweise sonnenlichtähnlichem - Licht Verwendung finden.

Gemäß zumindest einer Ausführungsform des Leuchtmittels ist auf die der ersten Hauptfläche des Substrats des Leuchtmittels abgewandten zweiten Hauptfläche des Substrats eine Klebeschicht aufgebracht. Die Klebeschicht ist bevorzugt vor dem Befestigen des Leuchtmittels an seinem Bestimmungsort von einer Schutzfolie bedeckt. Das Leuchtmittel kann nach Abziehen der Schutzfolie im Sinne eines Abzieh- oder Klebebildes an seinem Bestimmungsort dauerhaft befestigt werden. Die Haftung wird dabei von der Klebeschicht auf der zweiten Hauptfläche des Substrats vermittelt. Insbesondere eignet sich dabei ein flexibel ausgestaltetes Leuchtmittel - wie es zum Beispiel weiter oben beschrieben ist - da auf diese Weise auch unebene Flächen, beispielsweise abgerundete oder kurvige Flächen mit dem Leuchtmittel beklebt werden können.

Gemäß zumindest einer Ausführungsform des Leuchtmittels umfasst das Leuchtmittel zumindest einen ersten Farb-Unterbereich. Der erste Farb-Unterbereich ist geeignet, Licht einer ersten Farbe zu emittieren. Ferner umfasst das Leuchtmittel zumindest einen zweiten Farb-Unterbereich. Der zweite Farb-Unterbereich ist geeignet, Licht einer zweiten Farbe zu emittieren, die von der ersten Farbe verschieden ist. Das heißt das Leuchtmittel umfasst zumindest zwei Farb-Unterbereiche, die jeweils geeignet sind, Licht voneinander unterschiedlicher Farbe zu emittieren.

Ein Leuchtmittel mit mindestens zwei Farb-Unterbereichen wird vorliegend auch "mehrfarbig" genannt. Die Farb-Unterbereiche eines mehrfarbigen Leuchtmittels können beliebig zueinander angeordnet sein, beispielsweise nebeneinander oder vertikal übereinander.

Dabei ist es weiter möglich, dass das Leuchtmittel eine Mehrzahl erster Farb-Unterbereiche umfasst. Die ersten Farb-Unterbereiche sind jeweils geeignet, Licht der ersten Farbe zu emittieren. Das Leuchtmittel kann dann weiter eine Mehrzahl zweiter Farb-Unterbereiche umfassen, die jeweils geeignet sind, Licht der zweiten Farbe zu emittieren.

Dem Leuchtmittel liegt dabei unter anderem die Idee zugrunde, durch die Aufteilung in zumindest zwei Farb-Unterbereiche ein Leuchtmittel ermöglicht wird, das Licht wenigstens zweier verschiedener Farben emittieren kann.

Es ist außerdem auch möglich, dass das Leuchtmittel geeignet ist, Mischlicht der beiden unterschiedlichen Farben zu emittiert. Dies bedeutet, dass ein Betrachter mischfarbiges Licht wahrnimmt und die einzelnen Farb-Unterbereiche nicht unterscheiden kann. Dies kann beispielsweise dadurch erreicht werden, dass die Abmessungen lateral nebeneinander angeordneter Farb-Unterbereiche hinreichend klein gewählt werden oder dadurch dass die Farb-Unterbereiche vertikal übereinander angeordnet werden. Die ersten und die zweiten Farb-Unterbereiche des organischen Schichtstapels können hierbei gleichzeitig oder in kurzer Folge sequentiell Licht emittieren.

Gemäß zumindest einer Ausführungsform des Leuchtmittels sind die Farb-Unterbereiche in einer gemeinsamen Ebene angeordnet. Das heißt die Farb-Unterbereiche sind lateral nebeneinander oder lateral beabstandet zueinander angeordnet. Die Farb-Unterbereiche können beispielsweise nach Art von Pixeln einer Anzeigevorrichtung angeordnet sein. Im Vergleich zu Pixeln einer Anzeigevorrichtung weisen die Farb-Unterbereiche jedoch eine größere Leuchtfläche auf. Vorzugsweise beträgt die Leuchtfläche eines jeden Farb-Unterbereichs des Leuchtmittels wenigstens einen Quadratmillimeter.

Sind die Farb-Unterbereiche in einer gemeinsamen Ebene angeordnet, wird ein Farb-Unterbereich beispielsweise dadurch gebildet, dass der aktive Bereich des Substrates in verschiedene Unterbereiche aufgeteilt ist, wobei jeder Unterbereich des Substrates einem Farb-Unterbereich zugeordnet ist. Auf die Unterbereiche ist eine erste Elektrode aufgebracht, auf der sich der organische Schichtenstapel befindet. Auf den organischen Schichtenstapel ist weiterhin die zweite Elektrode aufgebracht. Zumindest eine der Elektroden kann hierbei strukturiert sein, bevorzugt entsprechend der Unterbereiche. Eine Strukturierung zumindest einer Elektrode kann hierbei eine getrennte Ansteuerung der einzelnen Farb-Unterbereiche ermöglichen.

Weiterhin kann der organische Schichtstapel entsprechend den Unterbereichen strukturiert sein, bevorzugt derart, dass jeder Unterbereich des Substrates einen separaten organischen Schichtstapel umfasst.

Gemäß einer Ausführungsform des Leuchtmittels umfassen hierbei die organischen Schichtenstapel verschiedener Farb-Unterbereiche jeweils voneinander verschiedene lichterzeugende Schichten, die sich hinsichtlich ihres Emittermaterials unterscheiden und die geeignet sind, Licht verschiedener Farben zu erzeugen.

Die Unterbereiche des Substrates, die den Farb-Unterbereichen entsprechen, sind gemäß zumindest einer Ausführungsform durch Stege voneinander getrennt. Die Stege weisen bevorzugt ein elektrisch isolierendes Material, beispielsweise einen Photolack, auf.

Gemäß zumindest einer Ausführungsform des Leuchtmittels umfasst der Farb-Unterbereich des Leuchtmittels einen Farbfilter. Der Farbfilter ist geeignet, Licht eines bestimmten Wellenlängenbereichs zu filtern. Das bedeutet, Licht dieses Wellenlängenbereichs wird vom Farbfilter zumindest teilweise absorbiert. Auf diese Weise kann beispielsweise aus weißem Licht ein erster Farbanteil gefiltert werden, ein zweiter Farbanteil kann den Farbfilter im Wesentlichen ungehindert durchstrahlen. Der Farb-Unterbereich mit dem Farbfilter emittiert dann im wesentlichen Licht des zweiten Farbanteils.

Der Farbfilter ist zum Beispiel in Form von Partikeln eines oder mehrerer Farbfiltermaterialien in ein Matrixmaterial eingebettet.

Insbesondere Farb-Unterbereiche, die innerhalb einer Ebene angeordnet sind, können zweckmäßigerweise einen Farbfilter umfassen. Der Farbfilter ist hierbei in der Regel zwischen der ersten Elektrode und der Unterseite des Leuchtmittels angeordnet, wenn das Leuchtmittel vorgesehen ist, Licht von seiner Unterseite zu emittieren und zwischen der zweiten Elektrode und der Oberseite des Leuchtmittels, wenn das Leuchtmittel vorgesehen ist, Licht von seiner Oberseite auszusenden. Ist das Leuchtmittel vorgesehen, von seiner Oberseite und von seiner Unterseite Licht zu emittieren, so kann auch zwischen der ersten Elektrode und der Unterseite, sowie zwischen der zweiten Elektrode und der Oberseite jeweils ein Farbfilter vorgesehen sein. Der Farbfilter des Farb-Unterbereiches kann beispielsweise innerhalb eines Unterbereiches des Substrates auf dieses aufgebracht sein. Weiterhin kann der Farbfilter auch auf der Außenseite des Substrates innerhalb eines zum Unterbereich korrespondierenden Bereichs des Substrates oder innerhalb eines zum Unterbereich korrespondierenden Bereiches der Verkapselung angeordnet sein.

Gemäß zumindest einer Ausführungsform des Leuchtmittels umfasst das Leuchtmittel einen ersten Farb-Unterbereich, der einen ersten Farbfilter umfasst und einen zweiten Farb-Unterbereich, der einen zweiten Farbfilter umfasst, wobei der erste Farbfilter vom zweiten Farbfilter verschieden ist. Auf diese Weise kann für die beiden Farb-Unterbereiche das gleiche organische Emittermaterial Verwendung finden. Die Farbe des von den Farb-Unterbereichen emittierten Lichts ist dann durch den jeweiligen Farbfilter eines jeden Farb-Unterbereichs bestimmt. Auf diese Weise ist ein Leuchtmittel mit einem ersten Farb-Unterbereich und einem zweiten Farb-Unterbereich realisiert, wobei der erste Farb-Unterbereich Licht einer ersten Farbe emittiert und der zweite Farb-Unterbereich Licht einer zweiten Farbe emittiert und die erste Farbe von der zweiten Farbe verschieden ist. Zum Beispiel ist die zur Lichterzeugung vorgesehen Schicht des organischen Schichtstapels geeignet, weißes Licht zu emittieren. Die Farbfilter filtern dann unterschiedliche Farbanteile aus diesem weißen Licht.

Ein Emittermaterial, das geeignet ist, weißes Licht zu emittieren ist beispielsweise in der Druckschrift D. Buchhauser et al., "Characterization of White-Emitting Copolymers for PLED-Displays", Proc. of SPIE, Vol. 5519, pp. 70 -81, (2004), beschrieben. Bei dem hier beschriebenen Emittermaterial handelt es sich um einen Breitbandemitter basierend auf einem polymeren Material, das Copolymere aufweist. Die Copolymere umfassen als Backbone Polyspirobifluorene, die geeignet sind, Licht aus dem blauen Spektralbereich zu emittieren. An die Polyspirobifluorene sind weiterhin grün emittierende und rot emittierende Einheiten kovalent gekoppelt.

Gemäß zumindest einer Ausführungsform des Leuchtmittels umfasst das Leuchtmittel zumindest einen Farb-Unterbereich, der ein Lumineszenzkonversionsmaterial enthält. Das Lumineszenzkonversionsmaterial ist geeignet, Licht eines ersten Wellenlängenbereichs in Licht eines zweiten Wellenlängenbereichs umzuwandeln, wobei der erste Wellenlängenbereich zumindest stellenweise vom zweiten Wellenlängenbereich verschieden ist. Das Lumineszenzkonversionsmaterial ist dabei vorzugsweise zur Abwärtskonversion vorgesehen. Das bedeutet, das Lumineszenzkonversionsmaterial absorbiert Licht wenigstens einer ersten Wellenlänge, die vom ersten Wellenlängenbereich umfasst ist, und re-emittiert Licht wenigstens einer zweiten Wellenlänge, die vom zweiten Wellenlängenbereich umfasst ist, wobei die erste Wellenlänge kleiner als die zweite Wellenlänge ist. Geeignete Lumineszenzkonversionsmaterialien sind - beispielsweise die oben im Zusammenhang mit der Planarisierungsschicht bereits beschriebenen organischen und anorganischen Materialien.

Gemäß zumindest einer Ausführungsform des Leuchtmittels umfasst das Leuchtmittel zumindest zwei Farb-Unterbereiche, die jeweils ein Lumineszenzkonversionsmaterial umfassen, wobei voneinander verschiedene Farb-Unterbereiche voneinander verschiedene Lumineszenzkonversionsmaterialien umfassen. Beispielsweise umfasst der aktive Bereich einen ersten Farb-Unterbereich, der ein erstes Lumineszenzkonversionsmaterial umfasst und einen zweiten Farb-Unterbereich, der ein zweites Lumineszenzkonversionsmaterial umfasst, wobei das erste Lumineszenzkonversionsmaterial vom zweiten Lumineszenzkonversionsmaterial verschieden ist. Auf diese Weise ist der erste Farb-Unterbereich geeignet, Licht einer ersten Farbe zu emittieren und der zweite Farb-Unterbereich ist geeignet, Licht einer zweiten Farbe zu emittieren, wobei die erste Farbe von der zweiten Farbe verschieden ist.

Insbesondere Farb-Unterbereiche, die innerhalb einer Ebene angeordnet sind, können zweckmäßigerweise ein Lumineszenzkonversionsmaterial umfassen. Das Lumineszenzkonversionsmaterial ist hierbei in der Regel zwischen der ersten Elektrode und der Unterseite des Leuchtmittels angeordnet, wenn das Leuchtmittel vorgesehen ist, Licht von seiner Unterseite zu emittieren und zwischen der zweiten Elektrode und der Oberseite des Leuchtmittels, wenn das Leuchtmittel vorgesehen ist, Licht von seiner Oberseite auszusenden.

Ist das Leuchtmittel vorgesehen, von seiner Oberseite und von seiner Unterseite Licht zu emittieren, so kann auch zwischen der ersten Elektrode und der Unterseite, sowie zwischen der zweiten Elektrode und der Oberseite jeweils ein Lumineszenzkonversionsmaterial vorgesehen sein. Das Lumineszenzkonversionsmaterial des Farb-Unterbereiches kann beispielsweise innerhalb eines Unterbereiches des Substrates auf dieses aufgebracht sein. Weiterhin kann das Lumineszenzkonversionsmaterial auch auf der Außenseite des Substrates innerhalb eines zum Unterbereich korrespondierenden Bereichs des Substrates oder innerhalb eines zum Unterbereich korrespondierenden Bereiches der Verkapselung angeordnet sein.

Gemäß zumindest einer Ausführungsform des Leuchtmittels sind die Farb-Unterbereiche des Leuchtmittels vertikal übereinander angeordnet. Jeder Farb-Unterbereich umfasst wenigstens eine organische Schicht des Schichtstapels des Leuchtmittels, die geeignet ist, Licht zu erzeugen. Die unterschiedlichen zur Lichterzeugung vorgesehenen Schichten des organischen Schichtstapels können sich dann beispielsweise hinsichtlich eines Emittermaterials voneinander unterscheiden.

Gemäß zumindest einer Ausführungsform des Leuchtmittels umfassen unterschiedliche Farb-Unterbereiche des Leuchtmittels unterschiedliche Emittermaterialien. Das heißt der erste Farb-Unterbereich umfasst ein erstes organisches Emittermaterial. Der zweite Farb-Unterbereich umfasst dann ein zweites organisches Emittermaterial, wobei das erste organische Emittermaterial vom zweiten organischen Emittermaterial verschieden ist. Aufgrund der unterschiedlichen Emittermaterialien sind die unterschiedlichen Farb-Unterbereiche dann zur Erzeugung von Licht voneinander unterschiedlichen Farben geeignet.

Gemäß zumindest einer Ausführungsform des Leuchtmittels umfasst das Leuchtmittel zumindest einen dritten Farb-Unterbereich, der geeignet ist, Licht einer dritten Farbe zu emittieren, wobei die dritte Farbe von der ersten Farbe und der zweiten Farbe verschieden ist. Das heißt das Leuchtmittel umfasst zumindest drei unterschiedliche Farb-Unterbereiche, die paarweise Licht unterschiedlicher Farbe emittieren. Bevorzugt umfasst das Leuchtmittel dann eine Mehrzahl von dritten Farb-Unterbereichen, die jeweils geeignet sind, Licht der dritten Farbe zu emittieren.

Gemäß zumindest einer Ausführungsform umfasst das Leuchtmittel zumindest einen vierten Farb-Unterbereich, der geeignet ist, Licht einer vierten Farbe zu emittieren, wobei die vierte Farbe von der ersten Farbe, der zweiten Farbe und der dritten Farbe verschieden ist. Das bedeutet, das Leuchtmittel umfasst zumindest vier unterschiedliche Farb-Unterbereiche, die paarweise Licht unterschiedlicher Farbe emittieren. Bevorzugt umfasst das Leuchtmittel dann eine Mehrzahl von vierten Farb-Unterbereichen, die jeweils geeignet sind, Licht der vierten Farbe zu emittieren.

Gemäß zumindest einer Ausführungsform des Leuchtmittels umfasst das Leuchtmittel mehr als vier unterschiedliche Farb-Unterbereiche, wobei sich die unterschiedlichen Farb-Unterbereiche durch die Farbe des von ihnen emittierten Lichts voneinander unterscheiden.

Gemäß zumindest einer Ausführungsform des Leuchtmittels umfasst das Leuchtmittel zumindest einen Farb-Unterbereich, der geeignet ist, weißes Licht zu emittieren. Bevorzugt umfasst das Leuchtmittel eine Mehrzahl von Farb-Unterbereichen, die jeweils geeignet sind, Licht weißer Farbe zu emittieren.

Gemäß zumindest einer Ausführungsform des Leuchtmittels sind gleichartige Farb-Unterbereiche des Leuchtmittels gemeinsam ansteuerbar. Unter gleichartigen Farb-Unterbereichen sind dabei Farb-Unterbereiche zu verstehen, die gleich aufgebaut sind und dadurch geeignet sind, Licht gleicher Farbe zu emittieren. Gleichartige Farb-Unterbereiche zeichnen sich beispielsweise durch das gleiche organische Emittermaterial und/oder den gleichen Farbfilter und/oder das gleiche Lumineszenzkonversionsmaterial aus. Zum Beispiel sind alle ersten Farb-Unterbereiche, die geeignet sind, Licht der ersten Farbe zu emittieren, gemeinsam ansteuerbar.

Gemeinsam ansteuerbar bedeutet, dass diese Farb-Unterbereiche zu gleichen Zeiten bestromt werden können. Die gleichen Farb-Unterbereiche können dann zum Beispiel für gleiche Zeiten, für gleiche Zeitdauern, mit der gleichen Stromstärke bestromt werden. Das kann beispielsweise dadurch erreicht sein, dass gleichartige Farb-Unterbereiche elektrisch miteinander verbunden sind. Zum Beispiel ist eine der Elektroden des Leuchtmittels dann derart strukturiert, dass alle gleichartigen Farb-Unterbereich mittels dieser Elektrode elektrisch leitend miteinander verbunden sind.

Gemäß zumindest einer Ausführungsform des Leuchtmittels sind ungleichartige Farb-Unterbereiche unabhängig voneinander ansteuerbar. Das heißt beispielsweise der erste und der zweite Farb-Unterbereich können unabhängig voneinander bestromt werden, so dass zu ersten Zeiten der erste Farb-Unterbereich bestromt wird und zu zweiten Zeiten der zweite Farb-Unterbereich bestromt wird. Beispielsweise können alle ersten Farb-Unterbereiche und alle zweiten Farb-Unterbereiche abwechselnd bestromt werden, so dass das Leuchtmittel geeignet ist, abwechselnd Licht der ersten und der zweiten Farbe zu emittieren. Bei gleichzeitigem Betrieb des ersten Farb-Unterbereichs und des zweiten Farb-Unterbereichs emittiert das Leuchtmittel dann Licht, beispielsweise Mischlicht, der ersten und zweiten Farbe.

Gemäß zumindest einer Ausführungsform des Leuchtmittels umfasst das Leuchtmittel eine Steuervorrichtung, die vorgesehen ist, den Betriebszustand des Leuchtmittels einzustellen. Bei der Steuervorrichtung kann es sich beispielsweise um einen Schalter handeln, mit dem das Leuchtmittel ein- und ausschaltbar ist. Vorzugsweise ist die Steuervorrichtung aber geeignet, mehr als zwei Betriebszustände des Leuchtmittels einzustellen. Beispielsweise kann die Steuervorrichtung geeignet sein, unterschiedliche Farb-Unterbereiche des Leuchtmittels getrennt voneinander anzusteuern.

Gemäß zumindest einer Ausführungsform des Leuchtmittels umfasst die Steuervorrichtung einen Micro-Controller.

Gemäß zumindest einer Ausführungsform des Leuchtmittels ist die Steuervorrichtung auf der ersten Hauptfläche des Substrats des Leuchtmittels angeordnet. Die Steuervorrichtung kann dann beispielsweise ein separates Bauelement sein, das beabstandet zum organischen Schichtstapel des Leuchtmittels auf der ersten Hauptfläche des Substrats angeordnet ist. Weiterhin ist es möglich, dass die Steuervorrichtung zumindest ein organisches Material enthält und gemeinsam mit dem Schichtstapel des Leuchtmittels hergestellt ist. Dies ermöglicht eine besonders Platz sparende und kostengünstige Integration der Steuervorrichtung in das Leuchtmittel.

Gemäß zumindest einer Ausführungsform des Leuchtmittels ist die Steuervorrichtung zusammen mit dem organischen Schichtstapel des Leuchtmittels in einer gemeinsamen Verkapselung verkapselt. Dies erweist sich als besonders vorteilhaft, wenn die Steuervorrichtung wie oben beschrieben ein organisches Material enthält.

Die Verkapselung des Leuchtmittels schützt die Steuervorrichtung vor Beschädigung durch atmosphärische Gase, Feuchtigkeit und mechanische Belastung. Eine gemeinsam mit dem organischen Schichtstapel des Leuchtmittels verkapselte Steuervorrichtung, die ein organisches Material enthält, ermöglicht unter anderem ein vorteilhaft kompakt aufgebautes, flexibles Leuchtmittel. Als Verkapselung kommt insbesondere eine der weiter oben beschriebenen Verkapselungen wie Kappen, dünne Platten, Folien oder eine Dünnfilmverkapselung in Frage.

Gemäß zumindest einer Ausführungsform des Leuchtmittels ist die Steuervorrichtung dazu vorgesehen, zumindest zwei Farb-Unterbereiche des Leuchtmittels unabhängig voneinander anzusteuern. Die Steuervorrichtung ist dann geeignet, zwei verschiedene Farb-Unterbereiche des Leuchtmittels zu unterschiedlichen Zeiten, für unterschiedliche Zeitdauern und/oder mit Strom unterschiedlicher Stärke zu bestromen.

Gemäß zumindest einer Ausführungsform des Leuchtmittels umfasst die Steuervorrichtung eine Pulsweitenmodulationsschaltung. Die Pulsweitenmodulationsschaltung ist geeignet, den aktiven Bereich und/oder Farb-Unterbereiche des aktiven Bereichs des Leuchtmittels mit einem pulsweitenmodulierten Signal zu beaufschlagen.

Bei einem pulsweitenmodulierten Signal handelt es sich um ein elektrisches Signal, vorzugsweise um ein Rechtecksignal, ein Sägezahnsignal, ein Dreiecksignal, oder ein Sinussignal, das innerhalb einer festen Grundperiode für eine bestimmte Zeit tein angeschaltet und für die restliche Dauer der Grundperiode tₐᵤₛ ausgeschaltet ist. Die Dauer, die das Signal eingeschaltet ist, wird vorliegend auch als Pulsdauer bezeichnet. Der Wert des Signals während der Pulsdauer wird vorliegend weiterhin auch als Pulshöhe bezeichnet. Das Verhältnis aus Einschaltzeit und Grundperiode tₑᵢₙ/(tₑᵢₙ+ tₐᵤₛ) bezeichnet man als Tastverhältnis. Es gibt den prozentualen zeitlichen Anteil an, über den das Rechtecksignal innerhalb der Grundperiode angeschaltet ist.

Die Pulshöhe, Pulsdauer und/oder Richtung des pulsweitenmodulierten Signals ändert sich daher beispielsweise periodisch. Dabei sind die Pulsdauer, der Abstand zwischen den Pulsen sowie die Pulshöhe vorzugsweise einstellbar. Weiter kann auch der Sperrspannungspegel sowie die Frequenz Die Einstellung dieser Parameter der Pulsweitenmodulationsschaltung kann beispielsweise durch einen Micro-Controller erfolgen, der Teil der Steuervorrichtung ist.

Gemäß zumindest einer Ausführungsform des Leuchtmittels ist die Steuervorrichtung durch einen Benutzer regelbar. Der Benutzer kann dann beispielsweise die Parameter der Pulsweitenmodulationsschaltung der Steuervorrichtung einstellen.

Gemäß zumindest einer Ausführungsform des Leuchtmittels ist die Farbe des vom Leuchtmittel emittierten Lichts mittels der Steuervorrichtung einstellbar. Beispielsweise bestromt die Steuervorrichtung dazu bestimmte Farb-Unterbereiche des Leuchtmittels, so dass sich der gewünschte Farbeindruck des vom Leuchtmittel emittierten Lichts ergibt.

Besonders einfach ist dies beispielsweise dann möglich, wenn das Leuchtmittel einen ersten und einen zweiten Farb-Unterbereich umfasst, die antiparallel zueinander geschaltet sind. Durch Bestromung des organischen Schichtstapels mit Strom einer ersten Richtung wird dann der erste Farb-Unterbereich in Durchlassrichtung betrieben, der zweite Farb-Unterbereich ist zu dieser Zeit in Sperrrichtung geschaltet, so dass kein Strom durch den zweiten Farb-Unterbereich fließt. Durch einfaches Ändern der Stromrichtung wird zu einer zweiten Zeit der zweite Farb-Unterbereich in Durchlassrichtung bestromt, so dass Licht der zweiten Farbe vom Leuchtmittel emittiert wird. Der erste Farb-Unterbereich ist für die zweite Zeitspanne in Sperrrichtung geschaltet, so dass kein Strom durch den ersten Farb-Unterbereich fließt.

Gemäß zumindest einer Ausführungsform des Leuchtmittels ist die Farbe und Helligkeit des vom Leuchtmittel emittierten Lichts von der Stromdichte des Stroms, mit dem das Leuchtmittel bestromt wird, abhängig. Dazu weist das Leuchtmittel beispielsweise wenigstens zwei Farb-Unterbereiche auf, die vorzugsweise vertikal übereinander angeordnet sind. Die Feldstärke des zwischen der ersten und zweiten Elektrode im Betrieb des Leuchtmittels erzeugten elektrischen Feldes bestimmt dann, in welchem Farb-Unterbereich eine Rekombination der Ladungsträger im aktiven Bereich des Leuchtmittels stattfindet. Auf diese Weise kann beispielsweise durch die Pulshöhe und die Pulsdauer eines durch den aktiven Bereich fließenden Stroms die Farbe und die Helligkeit des emittierten Lichts eingestellt werden.

Gemäß zumindest einer Ausführungsform ist die Steuervorrichtung vorgesehen, die Stromdichte des Stroms, mit dem das Leuchtmittel bestromt wird, einzustellen. Das heißt die Steuervorrichtung ist vorzugsweise geeignet, die Stärke des Stroms, mit dem das Leuchtmittel bestromt wird, und/oder die Dauer des Stroms, mit dem das Leuchtmittel bestromt wird, einzustellen. Die Farbe und Helligkeit des vom Leuchtmittel emittierten Lichts hängt dann vorzugsweise von der Stärke des Stroms, mit dem das Leuchtmittel bestromt wird, und/oder der Dauer der Bestromung des Leuchtmittels ab. Dabei ist es möglich, dass zwei, drei, vier oder mehr Farben unabhängig voneinander angesteuert werden können.

Gemäß zumindest einer Ausführungsform umfasst das Leuchtmittel einen Sensor, der geeignet ist, den Farbort und/oder die Helligkeit des vom Leuchtmittel im Betrieb abgestrahlten Lichts zu ermitteln. Der Sensor kann beispielsweise auf der ersten Hauptfläche innerhalb des aktiven Bereichs des Substrats des Leuchtmittels angeordnet sein. Insbesondere ist es möglich, dass der Sensor ein organisches Material enthält und zusammen mit dem organischen Schichtstapel des Leuchtmittels hergestellt ist. Der Sensor kann dann beispielsweise gemeinsam mit dem organischen Schichtstapel des Leuchtmittels durch eine gemeinsame Verkapselung verkapselt sein. Bei dem Sensor handelt es sich bevorzugt um eine Fotodiode oder einen Fototransistor.

Alternativ ist es möglich, dass der Sensor als separates Bauelement ausgeführt ist. Der Sensor kann dann beispielsweise auf der ersten Hauptfläche oder der der ersten Hauptfläche abgewandten zweiten Hauptfläche des Substrats angeordnet sein. Der Sensor ist in diesem Fall nicht notwendigerweise gemeinsam mit dem organischen Schichtstapel des Leuchtmittels verkapselt.

Gemäß zumindest einer Ausführungsform des Leuchtmittels umfasst das Leuchtmittel eine Steuervorrichtung, die vorgesehen ist, das Leuchtmittel abhängig von den vom Sensor ermittelten Messwerten zu bestromen. Das heißt die Steuervorrichtung ist geeignet, das Leuchtmittel abhängig vom Farbort und/oder der Helligkeit des vom Leuchtmittel im Betrieb abgestrahlten Lichts zu regeln. Das Leuchtmittel umfasst beispielsweise einen wie oben beschriebenen organischen Schichtstapel, bei dem die Farbe des vom Leuchtmittel emittierten Lichts von der Stromdichte des Stroms abhängig ist, mit dem das Leuchtmittel bestromt wird. Die Steuervorrichtung ist dann geeignet, einen bestimmten Farbort und eine bestimmte Helligkeit des erzeugten Lichts einzustellen, indem sie die Stromdichte des Stroms, mit dem das Leuchtmittel bestromt wird, abhängig von dem vom Sensor ermittelten Messwerten nachregelt. Auf diese Weise ist die Steuervorrichtung geeignet, mittels einer Regelschleife eine bestimmte Farbe des vom Leuchtmittel erzeugten Lichts einzustellen. Die Farbe kann dabei von einem Benutzer des Leuchtmittels oder einem Micro-Controller der Steuervorrichtung vorgegeben sein.

Gemäß zumindest einer Ausführungsform des Leuchtmittels umfasst das Leuchtmittel zumindest eine Anschlussstelle, die zur elektrischen Kontaktierung des Leuchtmittels vorgesehen ist. Die Anschlussstelle ist mit zumindest einer Elektrode des Leuchtmittels - beispielsweise mittels einer weiter oben beschriebenen elektrischen Zuleitung - elektrisch leitend verbunden. Über die Anschlussstelle ist das Leuchtmittel von außerhalb des Leuchtmittels elektrisch kontaktierbar. Die Anschlussstelle kann beispielsweise mit einer Spannungsquelle, einer Stromquelle oder einer Steuervorrichtung elektrisch leitend verbunden werden.

Gemäß zumindest einer Ausführungsform des Leuchtmittels ist die Anschlussstelle an der, der ersten Hauptfläche des Substrats des Leuchtmittels abgewandten, zweiten Hauptfläche des Substrats angeordnet. Die Anschlussstelle ist dabei beispielsweise mittels Vias oder Durchbrüchen im Substrat mit zumindest einer der Elektroden des Leuchtmittels elektrisch leitend verbunden.

Alternativ ist es möglich, dass eine elektrisch leitende Verbindung zwischen der Anschlussstelle und zumindest einer Elektrode des Leuchtmittels über die Seitenflächen des Substrats geführt ist. In diesem Fall kann auf Vias oder Durchbrüche im Substrat verzichtet werden.

Die Verbindung zwischen zumindest einer Elektrode des Leuchtmittels und der Anschlussstelle kann durch elektrische Zuleitungen erfolgen. Die elektrischen Zuleitungen sind zum Beispiel als elektrisch leitende Beschichtung von Teilen des Leuchtmittels, als in das Substrat integrierte Leiterbahnen oder als Kontaktdrähte ausgebildet.

Gemäß zumindest einer Ausführungsform des Leuchtmittels ist zumindest eine Anschlussstelle des Leuchtmittels an einer Seitenfläche des Substrats angeordnet. Die Seitenfläche des Substrats verbindet vorzugsweise die erste Hauptfläche des Substrats mit der zweiten Hauptfläche des Substrats. Für den Fall, dass das Leuchtmittel mehr als eine Anschlussstelle aufweist, können alle Anschlussstellen des Leuchtmittels entweder an einer Seitenfläche des Substrats oder an der zweiten Hauptfläche des Substrats angeordnet sein. Ferner ist es möglich, dass sich sowohl an den Seitenflächen des Substrats als auch an der zweiten Hauptfläche des Substrats Anschlussstellen befinden.

Gemäß zumindest einer Ausführungsform des Leuchtmittels ist zumindest eine Anschlussstelle des Leuchtmittels als Anschlussstift ausgeführt. Der Anschlussstift kann an der zweiten Hauptfläche des Substrats oder an einer Seitenfläche des Substrats angeordnet sein. Der Anschlussstift enthält oder besteht aus einem elektrisch leitenden Material, wie zum Beispiel einem Metall.

Gemäß zumindest einer Ausführungsform des Leuchtmittels ist zumindest eine Anschlussstelle des Leuchtmittels als Anschlussstecker ausgeführt. Der Anschlussstecker kann an der zweiten Hauptfläche des Substrats oder an einer Seitenfläche des Substrats angeordnet sein. Der Anschlussstecker ist zum Beispiel nach Art eines Cinch-Steckers oder nach Art eines Klinken-Steckers ausgebildet. Dabei ist es insbesondere möglich, dass der Anschlussstecker mindestens zwei elektrisch voneinander isolierte Kontaktbereiche aufweist. Der erste Kontaktbereich ist dann elektrisch leitend mit der ersten Elektrode des Leuchtmittels - beispielsweise über erste elektrische Zuleitungen - verbunden. Der zweite Kontaktbereich ist entsprechend leitend mit der zweiten Elektrode des Leuchtmittels - beispielsweise über zweite elektrische Zuleitungen - verbunden.

Gemäß zumindest einer Ausführungsform des Leuchtmittels ist zumindest eine Anschlussstelle des Leuchtmittels als Ausnehmung ausgeführt. Bei der Ausnehmung handelt es sich beispielsweise um ein Loch oder eine Bohrung, die an einer Seitenfläche des Substrats oder an der zweiten Hauptfläche des Substrats in das Substrat eingebracht ist.

Die Seitenflächen der Ausnehmung sind dabei zumindest stellenweise elektrisch leitend ausgebildet. Die Seitenflächen der Ausnehmung können zum Beispiel elektrisch leitend beschichtet sein.

Gemäß zumindest einer Ausführungsform des Leuchtmittels ist zumindest eine Anschlussstelle des Leuchtmittels als Buchse ausgeführt. Die Buchse kann zum Beispiel nach Art einer Cinch-Buchse oder einer Klinken-Buchse ausgeführt sein. Die Buchse weist dann zwei elektrisch leitende, elektrisch voneinander isolierte Kontaktbereiche auf. Der erste Kontaktbereich ist dann mit der ersten Elektrode des Leuchtmittels - zum Beispiel über erste elektrische Zuleitungen - elektrisch leitend verbunden. Der zweite Kontaktbereich ist mit der zweiten Elektrode des Leuchtmittels - beispielsweise über zweite elektrische Zuleitungen - elektrisch leitend verbunden.

Gemäß zumindest einer Ausführungsform des Leuchtmittels weist das Leuchtmittel zumindest eine Anschlussstelle auf, die eine Mehrzahl von Anschlusspins umfasst. Die Anschlussstelle umfasst dann zumindest einen ersten Anschlusspin, der elektrisch leitend mit der ersten Elektrode des Leuchtmittels verbunden ist. Ferner umfasst die Anschlussstelle einen zweiten Anschlusspin, der elektrisch leitend mit der zweiten Elektrode des Leuchtmittels verbunden ist. Darüber hinaus kann die Anschlussstelle weitere Anschlusspins umfassen, die beispielsweise mit einer Steuervorrichtung des Leuchtmittels elektrisch leitend verbunden sind. Auf diese Weise ist es möglich, dass die Steuervorrichtung über die entsprechenden Anschlusspins von außerhalb des Leuchtmittels ansteuerbar ist.

Gemäß zumindest einer Ausführungsform des Leuchtmittels weist das Leuchtmittel eine Steuervorrichtung auf und eine Anschlussstelle, die elektrisch leitend mit der Steuervorrichtung verbunden ist. Über die Anschlussstelle können elektrische Signale zur Steuervorrichtung geleitet werden. Auf diese Weise ist die Steuervorrichtung von außerhalb des Leuchtmittels - beispielsweise durch einen Benutzer - einstellbar.

Gemäß zumindest einer Ausführungsform des Leuchtmittels ist zumindest eine Anschlussstelle des Leuchtmittels als Anschlussschiene ausgeführt, die sich entlang einer Seitenfläche des Substrats erstreckt. Die Anschlussschiene ist vorzugsweise mit zumindest einer Elektrode des Leuchtmittels elektrisch leitend verbunden.

Die Anschlussschiene kann beispielsweise zylinderförmig oder nach Art eines aufgeschnittenen Zylinders ausgeführt sein. Vorzugsweise erstreckt sich die Anschlussschiene über zumindest 60 % der Länge der Seitenfläche des Substrats, an der die Anschlussschiene angeordnet ist. Besonders bevorzugt erstreckt sich die Anschlussschiene über zumindest 80 % der Länge der Seitenfläche des Substrats, an der die Anschlussschiene angeordnet ist.

Gemäß zumindest einer Ausführungsform des Leuchtmittels ist zumindest eine der Anschlussstellen zur mechanischen Befestigung des Leuchtmittels vorgesehen. Das Leuchtmittel kann mittels dieser Anschlussstelle beispielsweise mit anderen Leuchtmitteln oder mit einem Träger mechanisch verbunden sein. Besonders bevorzugt ist die Anschlussstelle sowohl zur mechanischen als auch zur elektrischen Befestigung des Leuchtmittels vorgesehen. Das heißt das Leuchtmittel ist über dieselbe Anschlussstelle elektrisch kontaktiert und mechanisch mit einem anderen Leuchtmittel oder einem Träger verbunden.

Es wird darüber hinaus eine Beleuchtungseinrichtung angegeben. Die Beleuchtungseinrichtung umfasst zumindest ein Leuchtmittel, wie es in Verbindung mit zumindest einem der oben beschriebenen Ausführungsformen erläutert ist.

Gemäß einem Beispiel der Beleuchtungseinrichtung umfasst die Beleuchtungseinrichtung zumindest zwei Leuchtmittel, die elektrisch und mechanisch miteinander verbunden sind. Dabei ist es möglich, dass die Leuchtmittel direkt elektrisch und mechanisch miteinander verbunden sind. Es ist jedoch auch möglich, dass die Leuchtmittel elektrisch und mechanisch über einen Träger der Beleuchtungseinrichtung miteinander verbunden sind.

Gemäß einem Beispiel der Beleuchtungseinrichtung umfasst die Beleuchtungseinrichtung ein erstes Leuchtmittel und ein zweites Leuchtmittel. Das erste Leuchtmittel weist zumindest eine Anschlussstelle auf, die als Anschlussstift ausgeführt ist. Der Anschlussstift ist an einer Seitenfläche des Substrats des ersten Leuchtmittels angeordnet. Das zweite Leuchtmittel weist zumindest eine Anschlussstelle auf, die als Ausnehmung in einer Seitenfläche des Substrats des zweiten Leuchtmittels ausgebildet ist. Der Anschlussstift des ersten Leuchtmittels greift in die Ausnehmung des zweiten Leuchtmittels. Das erste und das zweite Leuchtmittel sind über ihre Anschlussstellen - den Anschlussstift und die Ausnehmung - elektrisch leitend miteinander verbunden.

Die Beleuchtungseinrichtung kann darüber hinaus weitere Leuchtmittel umfassen, die in der beschriebenen Weise mit dem ersten oder dem zweiten Leuchtmittel elektrisch leitend verbunden sind.

Gemäß einem Beispiel der Beleuchtungseinrichtung sind das erste und das zweite Leuchtmittel mittels den Anschlussstellen durch eine Presspassung auch mechanisch miteinander verbunden.

Dazu ist beispielsweise eine erste Anschlussstelle des ersten Leuchtmittels als Anschlussstift ausgebildet. Eine zweite Anschlussstelle des zweiten Leuchtmittels ist dann als Ausnehmung ausgebildet. Der Durchmesser des Anschlussstiftes des ersten Leuchtmittels ist größer gleich dem Durchmesser der Ausnehmung des zweiten Leuchtmittels gewählt. Durch Pressen des Anschlussstiftes des ersten Leuchtmittels in die Ausnehmung des zweiten Leuchtmittels wird dann eine mechanisch feste Verbindung zwischen dem ersten und dem zweiten Leuchtmittel erzeugt. Bevorzugt sind das erste und das zweite Leuchtmittel durch den Anschlussstift und die korrespondierende Ausnehmung mechanisch und elektrisch miteinander verbunden.

Gemäß zumindest einem Beispiel der Beleuchtungseinrichtung sind das erste und das zweite Leuchtmittel mittels den Anschlussstellen durch eine Steckverbindung mechanisch miteinander verbunden. Dazu weist beispielsweise das erste Leuchtmittel eine erste Anschlussstelle auf, die als Anschlussstecker ausgebildet ist. Das zweite Leuchtmittel weist eine zweite Anschlussstelle auf, die als Buchse ausgebildet ist. Durch Einstecken des Anschlusssteckers des ersten Leuchtmittels in die Anschlussbuchse des zweiten Leuchtmittels wird eine Steckverbindung erzeugt, mittels der das erste Leuchtmittel mechanisch mit dem zweiten Leuchtmittel verbunden ist. Vorzugsweise sind das erste Leuchtmittel und das zweite Leuchtmittel mittels der Steckverbindung auch elektrisch miteinander verbunden. Die Steckverbindung zwischen dem ersten und dem zweiten Leuchtmittel ist vorzugsweise lösbar ausgebildet, bevorzugt so, dass das erste und das zweite Leuchtmittel durch Aufbringen einer geringen mechanischen Kraft wieder voneinander gelöst werden können. Auf diese Weise kann beispielsweise ein defektes Leuchtmittel auf einfache Weise aus der Beleuchtungseinrichtung entfernt und durch ein neues Leuchtmittel ersetzt werden.

Gemäß zumindest einer Ausführungsform der Beleuchtungseinrichtung umfasst die Beleuchtungseinrichtung einen Träger mit dem das zumindest eine Leuchtmittel der Beleuchtungseinrichtung mechanisch verbunden ist.

Gemäß zumindest einer Ausführungsform der Beleuchtungseinrichtung umfasst die Beleuchtungseinrichtung einen Träger mit dem das zumindest eine Leuchtmittel der Beleuchtungseinrichtung elektrisch verbunden ist. Dabei ist es möglich, dass die Leuchtmittel der Beleuchtungseinrichtung über dem Träger auch untereinander elektrisch miteinander verbunden sind.

Gemäß zumindest einer Ausführungsform der Beleuchtungseinrichtung umfasst die Beleuchtungseinrichtung einen Träger, mit dem das zumindest eine Leuchtmittel der Beleuchtungseinrichtung mechanisch und elektrisch verbunden ist. Für den Fall, dass die Beleuchtungseinrichtung eine Mehrzahl von Leuchtmittel aufweist, sind die Leuchtmittel mittels des Trägers mechanisch miteinander verbunden. Darüber hinaus ist es auch möglich, dass die Leuchtmittel mittels des Trägers auch elektrisch miteinander verbunden sind.

Gemäß zumindest einer Ausführungsform ist der Träger als Trägerplatte ausgeführt. Das heißt der Träger ist durch einen massiven Körper gebildet, der zwei einander gegenüberliegende Hauptflächen aufweist, die durch Seitenflächen miteinander verbunden sind.

Gemäß zumindest einer Ausführungsform der Beleuchtungseinrichtung ist der Träger als Gitter ausgeführt. Der Träger kann dabei nach Art einer Trägerplatte ausgeführt sein, die eine Mehrzahl von Durchbrüchen aufweist. Auf diese Weise ist ein Träger realisiert, der ein möglichst geringes Gewicht aufweist.

Gemäß zumindest einer Ausführungsform der Beleuchtungseinrichtung ist der Träger als Seilsystem ausgeführt. Der Träger umfasst dann zumindest zwei Seile, die ein elektrisch leitendes Material enthalten oder aus einem elektrisch leitenden Material bestehen. Die Leuchtmittel der Beleuchtungseinrichtung sind mittels den Seilen des Trägers elektrisch kontaktierbar. Beispielsweise verlaufen die Seile der Beleuchtungseinrichtung parallel oder im Wesentlichen parallel zueinander. Ein oder mehrere Leuchtmittel können dann zwischen je zwei Seilen des Trägers angeordnet und elektrisch verbunden sein.

Gemäß zumindest einer Ausführungsform der Beleuchtungseinrichtung ist der Träger als Stangensystem ausgeführt. Der Träger umfasst dann zumindest zwei Stangen, die ein elektrisch leitendes Material enthalten oder aus einem elektrisch leitenden Material bestehen. Die Leuchtmittel der Beleuchtungseinrichtung sind dann mittels der Stangen elektrisch kontaktierbar. Beispielsweise verlaufen die Stangen der Beleuchtungseinrichtung parallel oder im Wesentlichen parallel zueinander. Ein oder mehrere Leuchtmittel können dann zwischen je zwei Stangen des Trägers angeordnet und elektrisch verbunden sein.

Gemäß einem Beispiel der Beleuchtungseinrichtung ist zumindest ein Leuchtmittel der Beleuchtungseinrichtung mittels einer Anschlussstelle, die als Anschlussstift ausgeführt ist, mechanisch und elektrisch mit dem Träger verbunden. Vorzugsweise sind dann alle Leuchtmittel der Beleuchtungseinrichtung mittels zumindest einer Anschlussstelle, die als Anschlussstift ausgeführt ist, mechanisch und elektrisch mit dem Träger verbunden. Dazu kann der Träger beispielsweise eine Vielzahl von Ausnehmungen aufweisen. Die als Anschlussstifte ausgeführten Anschlussstellen der Leuchtmittel greifen dann in korrespondierende Ausnehmungen des Trägers. Die mechanische Verbindung zwischen den Leuchtmitteln und dem Träger ist dabei vorzugsweise durch eine Presspassung gegeben.

Gemäß einem Beispiel der Beleuchtungseinrichtung ist zumindest ein Leuchtmittel der Beleuchtungseinrichtung mittels zumindest einer Anschlussstelle, die als Anschlussstecker ausgeführt ist, mechanisch und elektrisch mit dem Träger verbunden. Vorzugsweise sind dann alle Leuchtmittel der Beleuchtungseinrichtung mittels zumindest einer Anschlussstelle, die als Anschlussstecker ausgeführt ist, mechanisch und elektrisch mit dem Träger verbunden. Dazu kann der Träger beispielsweise eine Vielzahl von Ausnehmungen aufweisen, die jeweils als Anschlussbuchsen ausgeführt sind. Die Anschlussstecker der Leuchtmittel greifen dann in korrespondierende Buchsen des Trägers. Die mechanische Verbindung zwischen den Leuchtmitteln und dem Träger ist dabei vorzugsweise lösbar ausgebildet, derart, dass die Leuchtmittel durch Aufbringen geringer mechanischer Kraft vom Träger gelöst werden können. Auf diese Weise können beschädigte Leuchtmittel besonders einfach ausgetauscht werden.

Gemäß einem Beispiel der Beleuchtungseinrichtung ist zumindest ein Leuchtmittel der Beleuchtungseinrichtung mittels zumindest einer Anschlussstelle, die als Anschlussschiene ausgeführt ist, mechanisch und elektrisch mit dem Träger verbunden. Vorzugsweise sind dann alle Leuchtmittel der Beleuchtungseinrichtung mittels wenigstens je einer Anschlussschiene mit dem Träger verbunden. In diesem Fall ist der Träger vorzugsweise als Seilsystem oder Stangensystem ausgeführt.

Beispielsweise umfasst der Träger zwei parallel zueinander verlaufende Seile oder Stangen, die elektrisch leitend ausgebildet sind. Zumindest ein Leuchtmittel der Beleuchtungseinrichtung umfasst dann wenigstens zwei Anschlussstellen, die als Anschlussschienen ausgeführt sind. Die Anschlussschienen verlaufen an einander abgewandten Seitenflächen des Leuchtmittels. Jede Anschlussschiene greift in ein Seil oder eine Stange des Trägers, so dass das Leuchtmittel zwischen den Seilen oder den Stangen des Trägers angeordnet ist. Vorzugsweise ist eine Mehrzahl von Leuchtmittel auf diese Weise mit dem Träger verbunden.

Gemäß einem Beispiel umfasst die Beleuchtungseinrichtung ein erstes Leuchtmittel und ein zweites Leuchtmittel, wobei das erste und das zweite Leuchtmittel im Betrieb Licht unterschiedlicher Farbe emittieren. Dabei ist es zum einen möglich, dass sich das erste und das zweite Leuchtmittel hinsichtlich des verwendeten organischen Emittermaterials, eines Lumineszenzkonversionsmaterials oder eines Farbfilters voneinander unterscheiden. Das erste und das zweite Leuchtmittel sind dann also unterschiedlich ausgeführt.

Es ist jedoch auch möglich, das für das erste und das zweite Leuchtmittel wie weiter oben beschriebene Leuchtmittel Verwendung finden, die geeignet sind, im Betrieb Licht zumindest einer ersten und einer zweiten Farbe zu emittieren. Dies kann beispielsweise wie weiter oben beschrieben dadurch realisiert sein, dass das erste und das zweite Leuchtmittel jeweils zumindest zwei Farb-Unterbereiche umfasst, die geeignet sind, Licht voneinander verschiedener Farbe zu emittieren. Das heißt die Beleuchtungseinrichtung umfasst zumindest ein mehrfarbiges Leuchtmittel, wie es weiter oben näher beschrieben ist.

Gemäß einem Beispiel umfasst die Beleuchtungseinrichtung eine Mehrzahl von Leuchtmittel, die geeignet sind, Licht voneinander verschiedener Farben zu emittieren. Das heißt die Beleuchtungseinrichtung umfasst eine Vielzahl mehrfarbiger Leuchtmittel.

Gemäß einem Beispiel der Beleuchtungseinrichtung ist den Leuchtmitteln der Beleuchtungseinrichtung in einer Abstrahlrichtung der Leuchtmittel ein optisches Element nachgeordnet, das einen Diffuser umfasst. Beispielsweise ist in diesem Fall der Träger als eine Trägerplatte ausgebildet. Auf die Trägerplatte ist dann eine Mehrzahl von Leuchtmittel aufgebracht, die mechanisch und elektrisch mit der Trägerplatte verbunden sind. Der der Trägerplatte abgewandten Seite der Leuchtmittel ist ein optisches Element nachgeordnet, das einen Diffuser umfasst. Das optische Element kann beispielsweise durch eine lichtdurchlässige Platte - zum Beispiel eine Glasplatte - gebildet sein, in welche lichtstreuende Teilchen eingebracht sind. Alternativ ist es möglich, dass die Oberfläche der lichtdurchlässigen Platte aufgeraut ist, so dass aufgrund von Lichtbrechung beim Durchtritt durch die Platte eine diffuse Streuung des durchtretenden Lichts stattfindet. Das optische Element - zum Beispiel die Diffuser-Platte kann mechanisch am Träger der Beleuchtungseinrichtung befestigt sein.

Das dem zumindest einen Leuchtmittel der Beleuchtungseinrichtung nachgeordnete optische Element ist dabei vorzugsweise geeignet, das von den Leuchtmitteln erzeugte Licht derart zu mischen, dass der modulare Aufbau der Beleuchtungseinrichtung aus mehreren Leuchtmitteln für einen Betrachter nicht mehr erkennbar ist. Die Beleuchtungseinrichtung erscheint dann als habe die Beleuchtungseinrichtung eine einzige leuchtende Fläche, wobei Form und Flächeninhalt der leuchtenden Fläche durch Form und Lichtdurchtrittsfläche des optischen Elements bestimmt sind.

Gemäß einem Beispiel weist die Beleuchtungseinrichtung eine Vielzahl von Leuchtmittel auf, die matrixartig angeordnet sind. "Matrixartig angeordnet" bedeutet, dass die Leuchtmittel zeilenweise und spaltenweise angeordnet sind. Die Beleuchtungseinrichtung weist zudem eine Steuervorrichtung auf, die geeignet ist, jedes der Leuchtmittel der Beleuchtungseinrichtung unabhängig von den übrigen Leuchtmitteln anzusteuern. Die Steuervorrichtung kann also jedes Leuchtmittel der Beleuchtungseinrichtung für vorgebbare Zeitspannen, zu vorgebbaren Zeiten mit einem vorgebbaren Betriebsstrom bestromen.

Aufgrund der matrixartigen Anordnung der Leuchtmittel sowie der Steuervorrichtung, die geeignet ist, jedes der Leuchtmittel unabhängig von den anderen Leuchtmitteln der Beleuchtungseinrichtung anzusteuern, ist die Beleuchtungseinrichtung geeignet, eine grobkörnige Anzeigevorrichtung zu bilden. Jedes Leuchtmittel entspricht dann einem Pixel der Anzeigevorrichtung. Die Beleuchtungseinrichtung ist auf diese Weise zur Verwendung als grobkörniges Display, Werbelogo oder Signalgeber geeignet. Die Beleuchtungseinrichtung kann ferner im Sinne einer Sieben-Segment-Anzeige zur Darstellung von Ziffern und Buchstaben vorgesehen sein. Die Beleuchtungseinrichtung eignet sich auch besonders gut als Notbeleuchtung, die mit Symbolen oder Wörtern beispielsweise einen Fluchtweg anzeigt. Die Leuchtmittel der als grobkörnige Anzeigevorrichtung ausgebildeten Beleuchtungseinrichtung sind bevorzugt wie oben beschrieben über Anschlussstellen mit einem Träger mechanisch und elektrisch verbunden und/oder über Anschlussstellen untereinander elektrisch und mechanisch verbunden.

Besonders bevorzugt umfasst die als grobkörnige Anzeigevorrichtung ausgebildete Beleuchtungseinrichtung dabei zumindest ein mehrfarbiges Leuchtmittel, das geeignet ist, während einer ersten Zeitspanne Licht einer ersten Farbe zu emittieren und während einer zweiten Zeitspanne Licht einer zweiten Farbe zu emittieren, wobei sich die erste Farbe von der zweiten Farbe unterscheidet. Dies kann beispielsweise - wie weiter oben beschrieben - dadurch ermöglicht sein, dass das Leuchtmittel mehrere Farb-Unterbereiche aufweist, die geeignet sind, Licht voneinander unterschiedlicher Farbe zu erzeugen. Alternativ ist es möglich, dass die Farbe des vom Leuchtmittel im Betrieb erzeugten Lichts zum Beispiel von der Stromdichte abhängt, mit der das Leuchtmittel betrieben wird.

Der Einsatz von Leuchtmittel, die geeignet sind, Licht unterschiedlicher Farben zu emittieren, ermöglicht die Verwendung der Beleuchtungseinrichtung als eine grobkörnige Anzeigevorrichtung, die besonders vielseitig einsetzbar ist.

Gemäß einem Beispiel der Beleuchtungseinrichtung enthält der Träger der Beleuchtungseinrichtung ein textiles Material. Die Leuchtmittel der Beleuchtungseinrichtung sind dann zumindest mechanisch mit dem Träger verbunden. Die mechanische Verbindung kann zum Beispiel durch eine Klettverbindung zwischen dem textilen Material und einer Klettschicht, die auf die zweite Hauptfläche des Leuchtmittels aufgebracht ist, vermittelt sein.

Darüber hinaus ist es möglich, dass Leiterbahnen - beispielsweise dünne Metalldrähte - in das textile Material integriert sind. Die Leiterbahnen können beispielsweise mit dem Material des Trägers verwoben sein. Über diese Leiterbahnen ist eine elektrische Kontaktierung der Leuchtmittel der Beleuchtungseinrichtung über den Träger möglich. Alternativ können die Leuchtmittel der Beleuchtungseinrichtung eine eigene Stromversorgung in Form einer Batterie, eines Akkus oder eines Kondensators tragen.

Die Leuchtmittel der Beleuchtungseinrichtung mit dem Träger, der ein textiles Material enthält, sind vorzugsweise flexibel ausgebildet. Besonders bevorzugt sind die Leuchtmittel ähnlich flexibel wie der Träger ausgebildet. Das heißt die Leuchtmittel können sich einer Verformung des Trägers, auf dem sie aufgebracht sind - zum Beispiel durch eine Faltung - weitgehend anpassen.

Gemäß einem Beispiel der Beleuchtungseinrichtung ist der Träger, der ein textiles Material enthält, als Vorhang ausgeführt. Auf dem Vorhang ist dann zumindest ein - beispielsweise flexibles - Leuchtmittel aufgebracht. Dabei ist es möglich, dass ein Großteil der dem zumindest einem Leuchtmittel zugewandten Oberfläche des Vorhangs vom zumindest einem Leuchtmittel bedeckt ist.

Bei zugezogenem Vorhang bildet die von dem zumindest einen Leuchtmittel bedeckte Hauptfläche des Vorhangs die Leuchtfläche der Beleuchtungseinrichtung.

Beispielsweise ist der Vorhang vor einem Fenster angebracht. Der Vorhang bildet dann eine Beleuchtungseinrichtung, deren Leuchtfläche ungefähr dem Flächeninhalt des Fensters, das durch den Vorhang abgedeckt wird, entspricht. Auf diese Weise ist durch die Beleuchtungseinrichtung eine Raumbeleuchtung realisiert, die in Größe und Lichteinstrahlrichtung dem Fenster entspricht. Ein Raum mit solch einem Vorhang wird von der Beleuchtungseinrichtung bevorzugt mit tageslichtähnlichem Licht beleuchtet.

Gemäß einem Beispiel der Beleuchtungseinrichtung ist der Träger, der ein textiles Material enthält, als Bekleidungsstück ausgeführt. Auf dem Bekleidungsstück ist zumindest ein Leuchtmittel mechanisch befestigt. Die mechanische Verbindung kann zum Beispiel durch eine Klettverbindung zwischen dem textilen Material des Bekleidungsstücks und einer Klettschicht, die auf die zweite Hauptfläche des Leuchtmittels aufgebracht ist, vermittelt sein. Das Leuchtmittel ist dabei vorzugsweise - wie weiter oben beschrieben - flexibel ausgeführt und weist eine Flexibilität auf, die in etwa der Flexibilität des Bekleidungsstücks entspricht. Vorzugsweise ist das Leuchtmittel - wie weiter oben beschrieben - geeignet, Licht von zumindest zwei unterschiedlichen Farben zu erzeugen. Das Leuchtmittel kann dann als Signalvorrichtung dienen, mit der der Träger des Bekleidungsstücks Informationen optisch darstellen kann. Dazu ist das Leuchtmittel mit einer Steuervorrichtung verbunden, die vom Träger des Bekleidungsstücks eingestellt werden kann.

Alternativ oder zusätzlich ist es möglich, dass das Steuermittel den Betriebszustand des Leuchtmittels - das heißt beispielsweise die Farbe des vom Leuchtmittel emittierten Lichts - in Abhängigkeit von bestimmten Messwerten einstellt. Die Beleuchtungseinrichtung umfasst dazu zumindest einen Sensor, der geeignet ist, Körperfunktionen des Trägers des Bekleidungsstücks wie die Pulsfrequenz, den Hautwiderstand und/oder die Körpertemperatur des Trägers zu ermitteln. Abhängig von den ermittelten Werten stellt die Steuervorrichtung dann den Betriebszustand des Leuchtmittels ein. Das Leuchtmittel ist dann also geeignet, Informationen über Körperfunktionen des Trägers des Bekleidungsstücks optisch wiederzugeben.

Weiter kann die Beleuchtungseinrichtung, deren Träger als Bekleidungsstück ausgeführt ist, dazu dienen, die Sichtbarkeit der Person, die das Bekleidungsstück trägt - beispielsweise im Straßenverkehr - zu verbessern. Ein solches Bekleidungsstück eignet sich besonders gut für Radfahrer und Fußgänger.

Darüber hinaus wird beispielsweise eine optische Anzeigevorrichtung angegeben. Die optische Anzeigevorrichtung umfasst ein bildgebendes Element und zumindest zwei Leuchtmittel, die gemäß zumindest einer der oben beschriebenen Ausführungsformen ausgeführt sind. Die Leuchtmittel bilden dabei eine Hinterleuchtungsvorrichtung für das bildgebende Element. Die Hinterleuchtungsvorrichtung ist vorzugsweise wie zumindest eine der weiter oben beschriebenen Beleuchtungseinrichtungen ausgebildet.

Gemäß einem Beispiel der Anzeigevorrichtung umfasst die Hinterleuchtungsvorrichtung der Anzeigevorrichtung zumindest zwei Leuchtmittel, die elektrisch und mechanisch miteinander verbunden sind. Dabei ist es möglich, dass die Leuchtmittel direkt elektrisch und mechanisch miteinander verbunden sind. Es ist jedoch auch möglich, dass die Leuchtmittel elektrisch und mechanisch über einen Träger der Hinterleuchtungsvorrichtung der Anzeigevorrichtung miteinander verbunden sind. Die Leuchtmittel der Hinterleuchtungsvorrichtung sind dann wie weiter oben beschrieben über Anschlussstellen, die als Anschlussstifte, Anschlussstecker, Anschlusspins, Anschlusslöcher, oder Buchsen ausgebildet sein können, untereinander und/oder mit einem Träger mechanisch verbunden und/oder elektrisch verbunden.

Bei dem bildgebenden Element der Anzeigevorrichtung kann es sich zum Beispiel um ein LCD-Panel handeln. Das bildgebende Element ist den Leuchtmitteln der Hinterleuchtungsvorrichtung in deren Abstrahlrichtung direkt nachgeordnet. Das heißt das bildgebende Element wird von den Leuchtmitteln dann direkt hinterleuchtet. Der modulare Aufbau der Hinterleuchtungsvorrichtung für das bildgebende Element aus zwei oder mehr Leuchtmitteln ermöglicht die Hinterleuchtung einer besonders großen Fläche. Auf diese Weise ist eine besonders große Anzeigevorrichtung realisierbar. Ferner können defekte Leuchtmittel der Hinterleuchtungsvorrichtung - aufgrund des modularen Aufbaus der Hinterleuchtungsvorrichtung der Anzeigevorrichtung - besonders einfach ausgetauscht werden.

Gemäß einem Beispiel der optischen Anzeigevorrichtung ist zumindest eines der Leuchtmittel der Anzeigevorrichtung geeignet, im Betrieb weißes Licht zu emittieren. Vorzugsweise sind dann alle Leuchtmittel der Hinterleuchtungsvorrichtung der Anzeigevorrichtung geeignet, weißes Licht zu emittieren.

Gemäß einem Beispiel der Anzeigevorrichtung mischt sich das von den Leuchtmitteln der Anzeigevorrichtung im Betrieb emittierte Licht zu weißem Licht. Das heißt die Anzeigevorrichtung umfasst dann beispielsweise Leuchtmittel, die geeignet sind, grünes Licht zu emittieren, Leuchtmittel, die geeignet sind, rotes Licht zu emittieren, und Leuchtmittel, die geeignet sind, blaues Licht zu emittieren. Diese Leuchtmittel sind dann vorzugsweise derart angeordnet, dass sich durch Durchmischung des Lichts der einzelnen Leuchtmittel ein weißer Farbeindruck einstellt. Dazu kann zwischen den Leuchtmitteln und dem bildgebenden Element ein optisches Element angeordnet sein, das einen Diffuser umfasst. Zum Beispiel handelt es sich bei dem optischen Element um eine Diffuser-Platte, die - wie weiter oben beschrieben - zur Durchmischung des von den Leuchtmitteln erzeugten Lichts geeignet ist.

Die erfindungsgemäße Beleuchtungseinrichtung umfasst eines der hier beschriebenen Leuchtmittel als erste Lichtquelle und eine weitere zweite Lichtquelle.

Das Leuchtmittel ist hierbei bevorzugt so ausgeführt, dass es zumindest für das von dem organischen Schichtstapel erzeugte Licht sowie für Licht der zweiten Lichtquelle durchlässig ausgebildet ist.

Gemäß der Erfindung handelt es sich bei der zweiten Lichtquelle um ein Leuchtdioden-Modul - kurz "LED-Modul".

Das LED-Modul umfasst mehrere Leuchtdioden die auf einem Träger angeordnet sind. Bei dem Träger kann es sich beispielsweise um eine Leiterplatte, wie zum Beispiel eine Metallkernplatine handeln. Weiterhin kann ein LED-Modul eine strahlformende Optik umfassen, die den LEDs in deren Abstrahlrichtung nachgeordnet ist. Die strahlformende Optik ist beispielsweise zumindest teilweise, nach Art eines der folgenden optischen Elemente gebildet: zusammengesetzter parabolischer Konzentrator (Compound Parabolic Concentrator, CPC), zusammengesetzter elliptischer Konzentrator (Compound Elliptic Concentrator, CEC), zusammengesetzter hyperbolischer Konzentrator (Compound Hyperbolic Concentrator, CHC). Weiterhin kann es sich bei der strahlformenden Optik um eine Linse handeln.

Das Leuchtmittel sendet Licht einer ersten Farbe aus und die zweite Lichtquelle sendet Licht einer von der ersten Farbe verschiedenen zweiten Farbe aus.

Das Leuchtmittel und/oder die zweite Lichtquelle ist dimmbar ausgeführt.

Dimmen des Leuchtmittels sowie der zweiten Lichtquelle kann beispielsweise durch die Verwendung einer PWM-Schaltung erreicht werden, die pulsweiten modulierten Signal (PWM-Signale) erzeugt, oder mit einem konventionellen Dimmer.

Gemäß zumindest einer Ausführungsform ist das Leuchtmittel flexibel ausgeführt.

Gemäß zumindest einer Ausführungsform ist das Leuchtmittel als Lampenschirm ausgebildet, der beispielsweise um oder über der zweiten Lichtquelle angeordnet ist.

Das Leuchtmittel und die zweite Lichtquelle sind so zueinander angeordnet, dass Licht der zweiten Lichtquelle durch das Leuchtmittel hindurch tritt.

Eine Beleuchtungseinrichtung, bei der:
- das Leuchtmittel Licht einer ersten Farbe aussendet und die zweite Lichtquelle Licht einer von der ersten Farbe verschiedenen zweiten Farbe,
- zumindest eine der beiden Lichtquellen dimmbar ist, und
- das Leuchtmittel und die zweite Lichtquelle so zueinander angeordnet sind, dass Licht der zweiten Lichtquelle durch das Leuchtmittel hindurch tritt,
wird im Folgenden als "farbveränderliche Beleuchtungseinrichtung" bezeichnet.

Bevorzugt ist das Leuchtmittel der farbveränderlichen Beleuchtungseinrichtung durchlässig für sichtbares Licht, insbesondere für das von dem organischen Schichtstapel erzeugte Licht und für das von der zweiten Lichtquelle ausgesandte Licht, ausgebildet.

Die farbveränderliche Beleuchtungseinrichtung ist dazu geeignet, mischfarbiges Licht auszusenden, das Licht des Leuchtmittels und Licht der zweiten Lichtquelle umfasst. Dies bietet den Vorteil, dass über Variation von Farbe und Helligkeit des Leuchtmittels und/oder der zweiten Lichtquelle Farbort und Helligkeit der Beleuchtungseinrichtung variiert werden können. Hierbei kann entweder die Helligkeit einer der Lichtquellen - Leuchtmittel oder zweite Lichtquelle - konstant gehalten werden und die Helligkeit der anderen Lichtquelle variiert werden oder es können die Helligkeiten beider Lichtquellen verändert werden. So kann Farbe und Helligkeit des Lichtes der Beleuchtungseinrichtung auf einfache Art und Weise an eine bestimmte Situation oder Stimmung angepasst werden.

Gemäß zumindest einer Ausführungsform der farbveränderlichen Beleuchtungseinrichtung sendet das Leuchtmittel Licht aus dem gelben Spektralbereich und die zweite Lichtquelle Licht aus dem blauen Spektralbereich aus. Ebenso ist auch denkbar, dass das Leuchtmittel Licht aus dem blauen Spektralbereich und die zweite Lichtquelle Licht aus dem gelben Spektralbereich aussendet. So wird vorteilhafterweise eine farbveränderliche Beleuchtungseinrichtung erzielt, die Licht mit einem Farbort im weißen Bereich der CIE-Normfarbtafel aussendet. Durch Variation der Helligkeit der zweiten Lichtquelle und/oder des Leuchtmittels - also durch Angleichen der Farbanteil des blauen Lichtes und des gelben Lichtes an dem mischfarbigen Licht der farbveränderlichen Beleuchtungseinrichtung - kann der Farbort des mischfarbigen Lichtes der farbveränderlichen Beleuchtungseinrichtung in weiten Bereichen der CIE-Normfarbtafel variiert und insbesondere an einen gewünschten Wert angepasst werden. Insbesondere können so verschiedene Weißtöne des mischfarbigen Lichtes eingestellt werden und der entsprechenden Situation angepasst werden.

Weiterhin können das Leuchtmittel und die zweite Lichtquelle einer farbveränderlichen Beleuchtungseinrichtung, neben gelb und blau, auch andere voneinander verschiedene Farben aufweisen. Falls beide Lichtquellen - Leuchtmittel und zweite Lichtquelle - dimmbar ausgeführt sind, kann so die Farbe das mischfarbigen Lichtes der Beleuchtungseinrichtung von der Farbe des Lichtes des Leuchtmittels bis zur Farbe des Lichtes der zweiten Lichtquelle fließend eingestellt werden.

Insbesondere ist es dabei möglich, dass das Leuchtmittel als weiter oben beschriebenes mehrfarbiges Leuchtmittel mit zumindest zwei Farb-Unterbereichen ausgeführt ist.

Solch ein mehrfarbiges Leuchtmittel ermöglicht eine farbveränderliche Beleuchtungseinrichtung die beispielsweise besonders viele Weißtöne und/oder weißes Licht mit hohem Farbwiedergabeindex (CRI - color rendering index) erzeugen kann.

Gemäß zumindest einer Ausführungsform der farbveränderlichen Beleuchtungseinrichtung sendet das Leuchtmittel Licht einer ersten Farbe aus dem warmweißen Bereich der CIE-Normfarbtafel aus und die zweite Lichtquelle Licht einer zweiten Farbe aus dem kaltweißen Bereich der CIE-Normfarbtafel. Es ist ebenso möglich, dass das Leuchtmittel Licht einer ersten Farbe aus dem kaltweißen Bereich der CIE-Normfarbtafel aussendet und die zweite Lichtquelle Licht einer zweiten Farbe aus dem warmweißen Bereich der CIE-Normfarbtafel. Der Farbort des mischfarbigen Lichtes dieser farbveränderlichen Beleuchtungseinrichtung kann zwischen kaltweiß und warmweiß eingestellt werden. Eine solche farbveränderliche Beleuchtungseinrichtung kann beispielsweise im privaten Bereich als Lichtquelle eingesetzt werden, wobei etwa in Arbeitssituationen ein eher kaltweißes Licht zum Einsatz kommt, das in Entspannungsphasen durch den Benutzer schnell und einfach durch Dimmen der kaltweißen Lichtquelle und Erhöhen des warmweißen Anteils am mischfarbigen Licht zu warmweißen Licht verändert werden kann.

Besonders bevorzugt ist das Leuchtmittel der farbveränderlichen Beleuchtungseinrichtung als Lampenschirm ausgebildet. Dieser ist beispielsweise um oder über der zweiten Lichtquelle angeordnet. Besonders bevorzugt ist das Leuchtmittel hierbei flexibel ausgeführt.

Gemäß zumindest einer Ausführungsform ist das Leuchtmittel derart flexibel ausgeführt, dass die Form des Leuchtmittels während der Anwendung verändert werden kann.

Eine farbveränderliche Beleuchtungseinrichtung mit einer zweite Lichtquelle, die überwiegend der Dekoration dient, wie beispielsweise eine Lavalampe, wird bevorzugt zu Dekorationszwecken verwendet, beispielsweise in Bars oder als Bodenbeleuchtung von Tanzflächen verwendet.

Weiterhin können farbveränderliche Beleuchtungseinrichtungen zu medizinischen Zwecken in der Lichttherapie eingesetzt werden.

Gemäß einem Beispiel der Beleuchtungseinrichtung sind eine lichtemittierende Hauptfläche des Leuchtmittels und eine lichtemittierende Vorderseite der zweiten Lichtquelle in einer gemeinsamen Ebene angeordnet. Hierbei kann es sich bei der zweiten Lichtquelle beispielsweise um ein LED-Modul handeln, das innerhalb der strahlungsemittierenden Vorderseite des Leuchtmittels angeordnet ist. Besonders bevorzugt ist das LED-Modul hierbei mittig innerhalb der strahlungsemittierenden Hauptfläche des Leuchtmittels angeordnet. Eine solche Anordnung kann beispielsweise als Dekorationselement verwendet sein.

Darüber hinaus wird beispielsweise ein Ablagemöbel angegeben. Das Ablagemöbel umfasst ein strahlungsemittierendes Bauelement. Beim dem strahlungsemittierenden Bauelement kann es sich insbesondere um ein Leuchtmittel nach zumindest einer der hier beschriebenen Ausführungsformen handeln. Insbesondere kann es sich bei dem Ablagemöbel auch um eine Beleuchtungseinrichtung nach zumindest einer der hier beschrieben Ausführungsformen handeln. Das heißt, das Ablagemöbel kann beliebige Merkmale der hier beschriebenen Leuchtmittel und Beleuchtungseinrichtungen aufweisen. Im Folgenden werden Beispiele beschrieben, die sich insbesondere auf ein Ablagemöbel beziehen. Auch die hier beschriebenen Leuchtmittel und Beleuchtungseinrichtungen können beliebige Merkmale der hier beschriebenen Ablagemöbel aufweisen.

Bei einer Ablagefläche, auf der Gegenstände oder Objekte beispielsweise zur Lagerung oder zur Ausstellung positioniert sind, kann es wünschenswert sein, besagte Gegenstände oder Objekte neben der Möglichkeit, diese auf der Ablagefläche anzuordnen, auch zu beleuchten. Der Wunsch nach einer Beleuchtung kann dabei funktionale wie auch ästhetische Gründe haben. Dazu ist üblicherweise in der Umgebung der Ablagefläche, also etwa darüber oder daneben, eine Beleuchtungseinrichtung so angebracht, dass eine gewünschte Beleuchtung der Ablagefläche sowie eventuell auch der Umgebung erzielt wird.

Ein Ablagemöbel gemäß einem Beispiel umfasst insbesondere
- ein flächig ausgeformtes Ablageelement mit zumindest einer Ablagefläche und zumindest einem strahlungsemittierenden Bauelement mit einem aktiven Bereich, der im Betrieb elektromagnetische Strahlung aussendet, und
- zumindest eine Haltevorrichtung zum Halten des Ablageelements.

Dabei kann insbesondere die Ablagefläche dazu dienen, Gegenstände darauf zu positionieren und/oder zu lagern.

Bei einem Beispiel ist das strahlungsemittierende Bauelement flächig ausgeformt. Dabei kann "flächig ausgeformt" bedeuten, dass sich das strahlungsemittierende Bauelement zusammenhängend über einen Flächenbereich erstreckt, der zumindest eine Fläche von mehreren Quadratmillimetern, bevorzugt mehreren Quadratzentimetern und besonders bevorzugt zumindest einem oder mehreren Quadratdezimetern oder mehr aufweist. Insbesondere kann ein flächig ausgeformtes strahlungsemittierendes Bauelement eine Fläche aufweisen, die in der Größenordnung der Ablagefläche ist.

Bei einem Beispiel ist das strahlungsemittierende Bauelement ein organisches strahlungsemittierendes Bauelement, insbesondere eine organische Leuchtdiode (OLED). Eine OLED kann dabei eine organische Schicht oder eine Schichtenfolge mit zumindest einer organischen Schicht aufweisen mit einem aktiven Bereich, der im Betrieb elektromagnetische Strahlung aussenden kann. Weiterhin kann eine OLED eine erste Elektrode und eine zweite Elektrode aufweisen, wobei die organische Schicht oder die Schichtenfolge mit zumindest einer organischen Schicht mit dem aktiven Bereich zwischen der ersten und zweiten Elektrode angeordnet sein kann. Die erste und die zweite Elektrode können dabei geeignet sein, "Löcher" beziehungsweise Elektronen in den aktiven Bereich zu injizieren, die dort unter Emission von elektromagnetischer Strahlung rekombinieren können.

Weiterhin kann die erste Elektrode auf einem Substrat angeordnet sein. Über der ersten Elektrode kann die organische Schicht oder die Schichtenfolge mit einer oder mehreren funktionalen Schichten aus organischen Materialien aufgebracht sein. Die funktionalen Schichten, die den aktiven Bereich umfassen können, können dabei beispielsweise Elektronentransportschichten, elektrolumineszierende Schichten und/oder Lochtransportschichten aufweisen. Über den funktionalen Schichten beziehungsweise über der zumindest einen organischen Schicht kann die zweite Elektrode aufgebracht sein.

Beispielsweise kann das Substrat Glas, Quarz, Kunststofffolien, Metall, Metallfolien, Siliziumwafer oder ein beliebiges anderes geeignetes Substratmaterial umfassen. Beispielsweise kann das Substrat auch als Schichtenfolge oder Laminat mehrerer Schichten ausgeführt sein. Ist das organische strahlungsemittierende Bauelement als so genannter "Bottom-Emitter" ausgeführt, das heißt, dass die im aktiven Bereich erzeugte elektromagnetische Strahlung durch das Substrat abgestrahlt werden kann, so kann das Substrat vorteilhafterweise eine Transparenz für zumindest einen Teil der elektromagnetischen Strahlung aufweisen.

Gemäß einem Beispiel weist mindestens eine der Elektroden ein transparentes leitendes Oxid, ein Metall oder ein leitendes organisches Material auf oder besteht aus einem solchen.

In der Bottom-Emitter-Konfiguration kann vorteilhafterweise die erste Elektrode transparent für zumindest einen Teil der elektromagnetischen Strahlung sein. Eine transparente erste Elektrode, die als Anode ausgeführt sein kann und somit als positive Ladungen oder "Löcher" injizierendes Material dienen kann, kann beispielsweise ein transparentes leitendes Oxid aufweisen oder aus einem transparenten leitenden Oxid bestehen. Transparente leitende Oxide (transparent conductive oxides, kurz "TCO") sind transparente, leitende Materialien, in der Regel Metalloxide, wie beispielsweise Zinkoxid, Zinnoxid, Cadmiumoxid, Titanoxid, Indiumoxid oder Indiumzinnoxid (ITO). Neben binären Metallsauerstoffverbindungen, wie beispielsweise ZnO, SnO₂ oder In₂O₃ gehören auch ternäre Metallsauerstoffverbindungen, wie beispielsweise Zn₂SnO₄, CdSnO₃, ZnSnO₃, MgIn₂O₄, GaInO₃, Zn₂In₂O₅ oder In₄Sn₃O₁₂ oder Mischungen unterschiedlicher transparenter leitender Oxide zu der Gruppe der TCOs. Weiterhin müssen die TCOs nicht zwingend einer stöchiometrischen Zusammensetzung entsprechen und können auch p- oder n-dotiert sein. Alternativ oder zusätzlich kann die erste Elektrode auch ein Metall, beispielsweise Silber, aufweisen.

Die Schichtenfolge mit zumindest einer organischen Schicht kann Polymere, Oligomere, Monomere, organische kleine Moleküle ("organic small molecules") oder andere organische nichtpolymere Verbindungen oder Kombinationen daraus aufweisen. Insbesondere kann es vorteilhaft sein, wenn eine funktionale Schicht der Schichtenfolge als Lochtransportschicht ausgeführt ist um eine effektive Löcherinjektion in eine elektrolumineszierende Schicht oder einen elektrolumineszierenden Bereich zu ermöglichen. Solche Strukturen den aktiven Bereich oder die weiteren funktionalen Schichten und Bereiche betreffend sind dem Fachmann insbesondere hinsichtlich Materialien, Aufbau, Funktion und Struktur bekannt und werden daher an dieser Stelle nicht näher erläutert.

Die zweite Elektrode kann als Kathode ausgeführt sein und somit als Elektronen induzierendes Material dienen. Als Kathodenmaterial können sich unter anderem insbesondere Aluminium, Barium, Indium, Silber, Gold, Magnesium, Calcium oder Lithium sowie Verbindungen, Kombinationen und Legierungen davon als vorteilhaft erweisen. Zusätzlich oder alternativ kann die zweite Elektrode auch transparent ausgeführt sein. Das bedeutet insbesondere, dass die OLED auch als "Top-Emitter" ausgeführt sein kann, das heißt, dass die im aktiven Bereich erzeugte elektromagnetische Strahlung auf der dem Substrat abgewandten Seite des organischen strahlungsemittierenden Bauelements abgestrahlt werden kann.

Soll eine Elektrode, die die metallische Schicht aufweist oder aus einer solchen besteht, durchlässig für das von dem organischen Schichtstapel ausgesandte Licht ausgebildet sein, so kann es vorteilhaft sein, wenn die metallische Schicht hinreichend dünn ausgebildet ist. Bevorzugt liegt die Dicke einer solchen semitransparenten metallischen Schicht zwischen 1 nm und 100 nm, wobei die Grenzen eingeschlossen sind.

Weiterhin kann die erste Elektrode als Kathode und die zweite Elektrode als Anode ausgeführt sein, wobei das organische strahlungsemittierende Bauelement dabei als Bottom- oder Top-Emitter ausgeführt sein kann. Auch kann das organische strahlungsemittierende Bauelement gleichzeitig als Top-Emitter und als Bottom-Emitter ausgebildet sein.

Darüber hinaus kann das organische strahlungsemittierende Bauelement eine Verkapselung aufweisen, um für die Elektroden und/oder den funktionalen Bereich einen Schutz vor Feuchtigkeit und/oder oxidierenden Substanzen wie etwa Sauerstoff zu erreichen. Dabei kann die Verkapselung das gesamte organische strahlungsemittierende Bauelement einschließlich des Substrats umgeben. Alternativ kann das Substrat und/oder zumindest eine Elektroden einen Teil der Verkapselung bilden. Die Verkapselung kann dabei eine oder mehrere Schichten umfassen, wobei die Schichten der Verkapselung beispielsweise Planarisierungsschichten, Barriereschichten, Wasser und/oder Sauerstoff absorbierende Schichten, Verbindungsschichten oder Kombinationen daraus sein können.

Alternativ kann das strahlungsemittierende Bauelement als elektrolumineszierende Folie ausgebildet sein. Dabei kann ein aktiver Bereich, der ein anorganisches Material, beispielsweise basierend auf Zinksulfid, aufweist, zwischen einer ersten und einer zweiten Elektrode angeordnet sein. Die Elektroden können dabei Merkmale und Strukturen wie im Zusammenhang mit den organischen strahlungsemittierenden Bauelementen beschrieben, aufweisen. Der aktive Bereich kann eine geeignete Dotierung, etwa Kupfer oder Europium, aufweisen.

Die vom aktiven Bereich des strahlungsemittierenden Bauelements erzeugte elektromagnetische Strahlung kann insbesondere ein Spektrum mit Wellenlängen in einem ultravioletten bis infraroten Spektralbereich aufweisen. Insbesondere kann es vorteilhaft sein, wenn das Spektrum zumindest eine für einen Betrachter sichtbare Wellenlänge umfasst. Das Spektrum der elektromagnetischen Strahlung kann vorteilhafterweise auch mehrere Wellenlängen umfassen, so dass bei einem Betrachter ein mischfarbiger Leuchteindruck entstehen kann. Dazu kann es möglich sein, dass das strahlungsemittierende Bauelement selbst elektromagnetische Strahlung mit mehreren Wellenlängen erzeugen kann oder dass ein Teil der vom organischen strahlungsemittierenden Bauelement erzeugten elektromagnetischen Strahlung oder die gesamte vom strahlungsemittierenden Bauelement erzeugte elektromagnetische Strahlung mit einer ersten Wellenlänge, etwa in einem blauen und/oder grünen Spektralbereich, durch einen Wellenlängenkonversionsstoff in eine zweite Wellenlänge, etwa in einem gelben und/oder roten Spektralbereich umgewandelt wird. Dazu kann dem aktiven Bereich eine Schicht oder ein Bereich nachgeordnet sein, der einen Wellenlängenkonversionsstoff aufweist. Insbesondere kann ein Wellenlängenkonversionsstoff in Teilbereiche strukturiert dem aktiven Bereich nachgeordnet sein, so dass in verschiedenen Teilbereichen des strahlungsemittierenden Bauelements verschiedenfarbige Leuchteindrücke bei einem Betrachter erweckt werden können. Geeignete Wellenlängenkonversionsstoffe und Schichten mit Wellenlängenkonversionsstoffen sowie deren Strukturierungen sind hinsichtlich ihrem Aufbau und ihrer Funktion dem Fachmann bekannt und werden an dieser Stelle nicht näher erläutert.

Bei einem weiteren Beispiel ist die erste und/oder die zweite Elektrode des strahlungsemittierenden Bauelements strukturiert, beispielsweise in Form von Elektrodenstreifen, die auch parallel zueinander verlaufen können. Das kann insbesondere bedeuten, dass die erste und/oder die zweite Elektrode Teilbereiche aufweist, die unabhängig voneinander an eine Strom- und/oder Spannungsquelle angeschlossen werden können. Dadurch kann das strahlungsemittierende Bauelement je nach Kontaktierung der Teilbereiche der ersten und/oder zweiten Elektrode verschiedene Betriebszustände aufweisen, das heißt, es können verschiedene Leuchtmuster und Leuchtverteilungen des strahlungsemittierenden Bauelements erzeugt werden. Darüber hinaus kann beispielsweise der aktive Bereich des strahlungsemittierenden Bauelements, bei einem organischen strahlungsemittierenden Bauelement etwa die organische Schicht oder die Schichtenfolge mit zumindest einer organischen Schicht , in den verschiedenen Teilbereichen der ersten und/oder der zweiten Elektrode jeweils verschiedene Materialien aufweisen und zum Beispiel auch strukturiert sein, so dass das strahlungsemittierende Bauelement in verschiedenen Betriebszuständen beispielsweise elektromagnetische Strahlung mit verschiedenen Wellenlängen aussenden kann. Dadurch kann bei einem Betrachter je nach Kontaktierung der Teilbereiche der ersten und/oder zweiten Elektrode mit einer Strom- und/oder Spannungsquelle ein verschiedenfarbiger oder auch ein mischfarbiger Leuchteindruck erzeugt werden.

Insbesondere kann die erste Elektrode so strukturiert sein, dass sie als parallele Streifen ausgebildet ist. Dabei können Gruppen von parallelen Streifen gemeinsam jeweils Teilbereiche bilden, die unabhängig voneinander an eine Strom- und/oder Spannungsquelle angeschlossen werden können. Alternativ oder zusätzlich kann auch die zweite Elektrode derartig strukturiert sein. Bevorzugt können die erste und die zweite Elektrode jeweils als parallele Streifen strukturiert sein, wobei die parallelen Streifen der ersten Elektrode senkrecht zu den parallelen Streifen der zweiten Elektrode sein können. Alternativ können die Streifen der ersten Elektrode und die Streifen der zweiten Elektrode auch parallel zueinander sein. Dabei können die erste und/oder die zweite Elektrode jeweils unabhängige Teilbereiche von parallelen Streifen aufweisen, so dass eine Mehrzahl von Beleuchtungsmustern erzeugt werden kann. Weiterhin kann es auch möglich sein, das beispielsweise die erste Elektrode flächig ausgebildet ist und die zweite Elektrode in Form von Piktogrammen strukturiert ist oder umgekehrt, so dass der Leuchteindruck bei einem Betrachter in Verbindung mit einem bildhaften Eindruck wahrgenommen werden kann.

Bei einem weiteren Beispiel kann das Ablageelement zumindest Teilbereiche aufweisen, die transparent für die vom strahlungsemittierenden Bauelement erzeugte elektromagnetische Strahlung sind. Bei einer bevorzugten Ausführungsform kann "transparent" bedeuten, dass ein transparentes Element oder Bauteil zumindest für einen Teilbereich des Spektrums der emittierten Strahlung des organischen strahlungsemittierenden Bauelements durchlässig ist. Bevorzugt kann "transparent" auch durchlässig für das gesamte Spektrum bedeuten. Ein Ablageelement mit zumindest transparenten Teilbereichen kann beispielsweise Glas oder transparenten Kunststoff aufweisen oder auch aus Glas oder einem transparenten Kunststoff sein. Alternativ kann das Ablageelement zumindest Teilbereiche aufweisen, die opak für die vom strahlungsemittierenden Bauelement erzeugte elektromagnetische Strahlung sind. Dazu kann das Ablageelement opakes Glas, einen opaken Kunststoff, Metall oder Holz oder eine Kombination daraus aufweisen oder aus solchen Materialien oder einer Kombination daraus sein.

Das strahlungsemittierende Bauelement kann Bestandteil des Ablageelements sein und beispielsweise in das flächig ausgeformte Ablageelement integriert sein. Dabei ist es möglich, dass das strahlungsemittierende Bauelement im Inneren des Ablageelements angeordnet ist und die im Betrieb emittierte elektromagnetische Strahlung über einer der Außenflächen des Ablageelements nach Außen emittiert. Diese Außenflächen sind dann zumindest teilweise transparent für die vom dem organischen strahlungsemittierenden Bauelement erzeugte elektromagnetische Strahlung.

Bei einem weiteren Beispiel weist das Ablageelement ein Glassubstrat auf, auf der das strahlungsemittierende Bauelement angebracht ist, sowie eine weitere Glasplatte, die auf der dem Glassubstrat abgewandten Seite des organischen strahlungsemittierenden Bauelements angeordnet ist und die beispielsweise eine Verkapselung oder einen Teil einer Verkapselung für das strahlungsemittierende Bauelement ermöglichen kann. Dabei kann die dem strahlungsemittierenden Bauelement abgewandte Seite des Glassubstrats oder die dem strahlungsemittierenden Bauelement abgewandte Seite der Glasplatte die Ablagefläche aufweisen. Alternativ kann das Ablageelement auch ein Kunststoffsubstrat und/oder eine Kunststoffplatte aufweisen.

Insbesondere kann das Ablageelement als Substrat für ein strahlungsemittierendes Bauelement ausgebildet sein. Alternativ kann ein organisches strahlungsemittierendes Bauelement mit einem Substrat auf dem Ablageelement aufgebracht sein. Alternativ oder zusätzlich kann auch die Verkapselung des strahlungsemittierenden Bauelements als Ablagefläche ausgebildet sein. Insbesondere kann das strahlungsemittierende Bauelement eine Strahlungsaustrittsfläche für die im aktiven Bereich erzeugte elektromagnetische Strahlung aufweisen. Diese Austrittsfläche kann zumindest ein Teil einer Außenfläche des Ablageelements sein. Dabei kann die Außenfläche die Ablagefläche sein. Das kann bedeuten, dass Gegenstände, die auf der Ablagefläche angeordnet sein können, von der Ablagefläche her beleuchtet werden können. Alternativ oder zusätzlich kann die Außenfläche beispielsweise auch eine von der Ablagefläche verschiedene Seite des Ablageelements sein. Alternativ oder zusätzlich kann die Austrittsfläche auch eine Außenfläche sein, die auf einer der Ablagefläche abgewandten Seite angeordnet ist. Das kann bedeuten, dass Bereiche oder Gegenstände, die sich auf der der Ablagefläche abgewandten Seite befinden, beleuchtet werden können.

Bei einem weiteren Beispiel weist das Ablageelement eine Oberseite, eine Unterseite und Seitenflächen auf. Dabei kann das organische strahlungsemittierende Bauelement auf zumindest einer der Oberseite, der Unterseite und den Seitenflächen angebracht sein.

Eine Haltevorrichtung weist beispielsweise eine Schiene, einen Haltewinkel, einen Tragarm, eine Strebe, einen Pfosten, eine Möbelwand oder eine Kombination daraus auf. Insbesondere kann die Haltevorrichtung auch mehrere der genannten Elemente oder eine Kombination daraus aufweisen. Darüber hinaus kann auch eine Haltevorrichtung ein strahlungsemittierendes Bauelement aufweisen.

In einem weiteren Beispiel weist das Ablageelement Haltelemente auf, mittels derer das Ablageelement an die Haltevorrichtung montierbar ist. Bei einer Ausführungsform kann "montierbar" bedeuten, dass das Ablageelement starr an der Haltevorrichtung befestigt werden kann. Lediglich beispielhaft sei dabei für eine starre Befestigung etwa eine Schraub-, Klemm- oder Steckverbindung sowie Hängen oder Kleben genannt. Alternativ oder zusätzlich kann "montierbar" auch bedeuten, dass das Ablageelement so an der Haltevorrichtung angeordnet ist, dass es nicht-starr befestigt ist. Lediglich beispielhaft sei diesbezüglich etwa erwähnt, dass das Ablageelement auf der Haltevorrichtung oder einem Teil der Haltevorrichtung abgelegt werden kann. Die Haltelemente können insbesondere beispielsweise Haken, Ösen, Schienen, Öffnungen, Löcher, Gewinde oder Auflageflächen oder Kombinationen daraus aufweisen oder sein.

In einem weiteren Beispiel weist das Ablageelement zumindest zwei elektrische Kontakte zur elektrischen Kontaktierung des strahlungsemittierenden Bauelements auf. Die zumindest zwei elektrischen Kontakte können dabei bevorzugt geeignet sein, die erste und/oder die zweite Elektrode zu kontaktieren. Besonders bevorzugt werden die erste und die zweite Elektrode beziehungsweise Teilbereiche der ersten und/oder zweiten Elektrode durch verschiedene elektrische Kontakte kontaktiert. Weiterhin kann zur elektrischen Kontaktierung eines elektrischen Kontakts mit einer Elektrode oder einem Teilbereich einer strukturierten Elektrode eine elektrische Leitung erforderlich sein. Die elektrischen Kontakte können dabei beispielsweise streifenförmig, rund oder n-eckig ausgeführt sein, wobei n eine ganze Zahl größer oder gleich 3 ist.

In einem Beispiel umfassen die Haltelemente die elektrischen Kontakte. Dadurch können beispielsweise die Halterung des Ablageelements und die elektrische Kontaktierung des strahlungsemittierenden Bauelements in einer Platz sparenden, kompakten und/oder ästhetisch ansprechenden Art und Weise realisierbar sein.

In einem weiteren Beispiel weist die Haltevorrichtung Halterungsteile auf, an die das Ablageelement mittels dessen Haltelemente an die Haltevorrichtung montierbar ist. Die Halterungsteile können dabei beispielsweise Haken, Ösen, Schienen, Unterlegflächen, Zapfen, Schraub-, Steck- oder Klemmverbindungen oder Winkelverbinder oder Kombinationen daraus aufweisen oder sein.

In einem weiteren Beispiel weist die Haltevorrichtung zumindest zwei elektrische Zuleitungskontakte zur elektrischen Kontaktierung der organischen strahlungsemittierenden Bauelements auf, wobei die elektrischen Kontakte des Ablageelements mit den elektrischen Zuleitungskontakten elektrisch verbunden sind, wenn das Ablagemöbel aufgebaut bzw. montiert ist. Besonders bevorzugt umfassen die Halterungsteile die elektrischen Zuleitungskontakte.

In weiteren Beispielen können die elektrischen Kontakte und die elektrischen Zuleitungskontakte beispielsweise als zueinander passende Teile von Steck-, Klemm- oder Schraubverbindungen ausgebildet sein. Dadurch kann insbesondere eine zuverlässige und stabile elektrisch leitende Kontaktierung des strahlungsemittierenden Bauelements ermöglicht werden. Alternativ können die elektrischen Kontakte und/oder die elektrischen Zuleitungskontakte auch als ebene Kontaktflächen ausgebildet sein oder Federelemente aufweisen.

In einem weiteren Beispiel kann das Ablageelement eine n-eckige Form aufweisen, wobei n eine ganze Zahl größer oder gleich 3 ist. Besonders bevorzugt kann das Ablageelement eine quadratische oder eine rechteckige Form aufweisen. Weiterhin kann die Form auch beispielsweise kreisförmig oder elliptisch sein oder eine Kombination der genannten Formen. Insbesondere kann die Ablagefläche des Ablageelements eines der genannten Formen oder eine Kombination daraus aufweisen, in diesem Fall besonders bevorzugt beispielsweise eine quadratische oder eine rechteckige Form mit abgerundeten Ecken. Dabei kann in jeder oder zumindest einer Ecke des Ablageelements oder der Ablagefläche ein Halteelement und/oder ein elektrischer Kontakt angeordnet sein. Insbesondere kann das Ablagemöbel in jeder oder zumindest einer Ecke des Ablageelements oder der Ablagefläche eine Haltevorrichtung aufweisen oder von einer Haltevorrichtung kontaktiert werden.

Insbesondere kann die Haltevorrichtung geeignet sein, das Ablageelement so zu halten, dass zumindest Teilbereiche der Ablagefläche parallel zu einem Boden sind, über dem das Ablageelement angeordnet werden kann. Beispielsweise kann dazu das Ablagemöbel auf dem Boden abstellbar beziehungsweise aufstellbar sein. Alternativ oder zusätzlich kann die Haltevorrichtung geeignet sein, das Ablageelement so zu halten, dass zumindest Teilbereiche der Ablagefläche im Wesentlichen senkrecht zu einer Wand stehen, an oder vor der das Ablagemöbel montierbar oder aufstellbar ist. Dabei kann "im Wesentlichen senkrecht" bedeuten, dass die Ablagefläche in einem solchen Winkel zur Wand stehen sollte, dass auf der Ablagefläche angeordnete Gegenstände auf dieser verbleiben können. Da es möglich sein kann, dass die Wand nicht gänzlich parallel zur Schwerkraftrichtung steht, kann es daher erforderlich sein, dass der Winkel zwischen der Wand und der Ablagefläche in vergleichbarem Maße von 90 Grad abweicht.

In einem weiteren Beispiel weist das Ablagemöbel eine Mehrzahl von Ablageelementen auf. Ein solches Ablagemöbel kann beispielsweise ein Regal oder ein Schrank mit mehreren Ablageelementen sein. Insbesondere kann es dabei möglich sein, dass ein strahlungsemittierendes Bauelement eines Ablageelements die Ablagefläche eines anderen, beispielsweise darunter angeordneten Ablageelements beleuchten kann. Die Mehrzahl von Ablageelementen kann dabei so angeordnet sein, das die Ablageflächen der jeweiligen Ablageelemente parallel zueinander angeordnet sind.

Weiterhin kann das Ablageelement einen Boden eines Ablagemöbels bilden oder von diesem umfasst sein. Dadurch kann es beispielsweise möglich sein, dass Gegenstände, die unterhalb oder seitlich versetzt zum Ablagemöbel positioniert sind, durch das strahlungsemittierende Bauelement beleuchtet werden können.

Ein Ablageelement kann rein beispielhaft ein Einlegeboden für ein Regal, einen Schrank oder eine Kommode sein, oder auch ein Schubladenboden, ein Schrankboden oder ein wandmontierbares Ablagebrett. Ein Ablagemöbel kann diesbezüglich beispielsweise ein Regal, ein Schrank, eine Kommode, eine Schublade, ein Küchenschrank, insbesondere ein wandmontierbarer Küchenoberschrank, ein Badmöbel oder ein Bücherboard sein.

Im Folgenden wird die Erfindung anhand von Ausführungsbeispielen und den dazugehörigen Figuren näher erläutert.
- Figur 1: zeigt eine schematische Schnittdarstellung eines organischen Schichtstapels zwischen einer ersten und einer zweiten Elektrode gemäß einem Ausführungsbeispiel,
- Figur 2A: zeigt eine schematische Schnittdarstellung eines Leuchtmittels gemäß einem Ausführungsbeispiel,
- Figur 2B: zeigt eine schematische perspektivische Darstellung einer Elektrode gemäß einem Ausführungsbeispiel,
- Figur 2C: zeigt eine schematische Schnittdarstellung entlang der Linie A-A' der Figur 2B,
- Figur 3: zeigt eine schematische Schnittdarstellung einer Dünnfilmverkapselung,
- Figur 4A: zeigt eine schematische Schnittdarstellung eines Leuchtmittels gemäß einem weiteren Ausführungsbeispiel,
- Figur 4B: zeigt eine schematische Draufsicht auf das Substrat des Leuchtmittels gemäß Figur 4A,
- Figur 4C: zeigt eine schematische Schnittdarstellung eines Leuchtmittels gemäß einem weiteren Ausführungsbeispiel,
- Figur 4D: zeigt eine schematische Draufsicht auf das Substrat eines Leuchtmittels gemäß der Figur 4C,
- Figur 5A: zeigt eine schematische Schnittdarstellung eines Leuchtmittels gemäß einem weiteren Ausführungsbeispiel,
- Figur 5B: zeigt eine schematische Darstellung des Aufbaus eines lichtdurchlässigen Leuchtmittels,
- Figur 6: zeigt eine schematische perspektivische Ansicht einer Tür gemäß einem Beispiel,
- Figur 7: zeigt eine schematische perspektivische Darstellung eines Schaufensters gemäß einem Beispiel,
- Figur 8: zeigt eine schematische perspektivische Frontansicht eines Kraftfahrzeuges gemäß einem Beispiel,
- Figur 9: zeigt eine schematische perspektivische Darstellung eines Museumsraumes gemäß einem Beispiel,
- Figur 10: zeigt eine schematische Schnittdarstellung eines Leuchtmittels gemäß einem Ausführungsbeispiel,
- Figur 11: zeigt eine schematische perspektivische Darstellung eines Raumes mit einem Raumteiler gemäß einem Beispiel,
- Figur 12A: zeigt eine schematische Schnittdarstellung eines Displays mit einem Leuchtmittel gemäß einem Beispiel,
- Figur 12B: zeigt eine schematische Draufsicht auf ein Fernsehgerät,
- Figur 13A: zeigt eine schematische perspektivische Darstellung eines Regals gemäß einem Beispiel,
- Figur 13B: zeigt einen vergrößerten Ausschnitt der Figur 13A,
- Figur 14: zeigt eine schematische Schnittdarstellung eines reflektiven Displays gemäß einem Beispiel,
- Figur 15: zeigt eine schematische Schnittdarstellung eines Leuchtmittels gemäß einem Beispiel,
- Figur 16: zeigt eine schematische Schnittdarstellung eines Leuchtmittels gemäß einem Beispiel,

- Figur 17A: zeigt eine schematische Schnittdarstellung einer Dünnfilmverkapselung gemäß einem Ausführungsbeispiel,
- Figur 17B: zeigt eine schematische Schnittdarstellung einer reflektierenden Verkapselung gemäß einem Beispiel,
- Figur 17C: zeigt eine schematische Schnittdarstellung durch eine Dünnfilmverkapselung gemäß einem weiteren Beispiel,
- Figur 18A: zeigt eine schematische perspektivische Darstellung eines Kraftfahrzeugspiegels gemäß einem Beispiel,
- Figur 18B: zeigt eine schematische perspektivische Darstellung des Kraftfahrzeugspiegels gemäß der Figur 18A,
- Figur 19: zeigt eine schematische perspektivische Darstellung eines mehrteiligen Spiegels gemäß einem Beispiel,
- Figur 20: zeigt eine schematische perspektivische Darstellung eines mehrteiligen Spiegels gemäß einem weiteren Beispiel,
- Figur 21: zeigt eine schematische perspektivische Darstellung eines Suchspiegels gemäß einem Beispiel,
- Figur 22: zeigt eine schematische perspektivische Darstellung eines Schminkspiegels gemäß einem Beispiel,
- Figur 23: zeigt eine schematische Draufsicht auf ein dekoratives Element gemäß einem Beispiel,
- Figur 24: zeigt eine schematische perspektivische Darstellung eines Spiegels gemäß einem weiteren Beispiel,
- Figur 25: zeigt eine schematische Schnittdarstellung eines flexiblen Leuchtmittels gemäß einem Beispiel,
- Figur 26: zeigt eine schematische Schnittdarstellung eines flexiblen Leuchtmittels gemäß einem weiteren Beispiel,
- Figur 27: zeigt eine schematische Schnittdarstellung eines Leuchtmittels gemäß einem Beispiel,
- Figur 28A: zeigt eine schematische Draufsicht auf ein Fenster mit einer Jalousie gemäß einem Beispiel,
- Figur 28B: zeigt eine schematische Schnittdarstellung durch eine Lamelle der Jalousie der Figur 28A,
- Figur 29A: zeigt eine schematische Ansicht eines Fensters, das von einem Vorhang gemäß einem Beispiel bedeckt ist,
- Figur 29B: zeigt den Vorhang gemäß der Figur 29A in einer schematischen Schnittdarstellung,
- Figur 29C: zeigt eine schematische Schnittdarstellung eines Vorhangs gemäß einem weiteren Beispiel,
- Figur 30: zeigt eine schematische Ansicht eines Fensters mit einem Vorhang gemäß einem weiteren Beispiel,
- Figur 31: zeigt eine schematische Schnittdarstellung eines Leuchtmittels gemäß einem Ausführungsbeispiel,
- Figur 32: zeigt eine schematische perspektivische Darstellung eines Möbelstücks gemäß einem Beispiel,
- Figur 33: zeigt eine schematische perspektivische Darstellung eines flexiblen Leuchtmittels gemäß einem Ausführungsbeispiel in aufgerolltem Zustand,
- Figur 34A: zeigt eine schematische Darstellung einer Beleuchtungseinrichtung gemäß einem Beispiel,
- Figur 34B: zeigt eine schematische Schnittdarstellung der Beleuchtungseinrichtung der Figur 34A entlang der Schnittlinie A-A',
- Figur 35A: zeigt eine schematische Draufsicht auf ein Leuchtmittel gemäß einem Ausführungsbeispiel,
- Figur 35B: zeigt eine schematische Schnittdarstellung des Leuchtmittels gemäß der Figur 35A entlang der Schnittlinie A-A',
- Figur 35C: zeigt eine schematische Draufsicht auf ein mehrfarbiges Leuchtmittel gemäß einem Ausführungsbeispiel,
- Figur 36: zeigt eine schematische Schnittdarstellung eines Leuchtmittels gemäß einem weiteren Ausführungsbeispiel,
- Figur 37: zeigt eine weitere schematische Schnittdarstellung eines mehrfarbigen Leuchtmittels gemäß einem weiteren Ausführungsbeispiel,
- Figur 38: zeigt eine schematische Draufsicht auf erste und zweite Elektroden gemäß einem weiteren Ausführungsbeispiel eines mehrfarbigen Leuchtmittels,
- Figur 39: zeigt eine schematische Draufsicht auf ein mehrfarbiges Leuchtmittel gemäß einem weiteren Ausführungsbeispiel,
- Figur 40A: zeigt eine schematische Draufsicht auf eine Beleuchtungseinrichtung gemäß einem Beispiel,
- Figur 40B: zeigt eine schematische Ausschnittsvergrößerung der Figur 40A,
- Figur 41: zeigt eine schematische Draufsicht auf ein Leuchtmittel gemäß einem weiteren Ausführungsbeispiel,
- Figur 42: zeigt eine schematische Schnittdarstellung eines Leuchtmittels gemäß einem weiteren Ausführungsbeispiel,
- Figur 43: zeigt eine schematische Schnittdarstellung eines weiteren Leuchtmittels gemäß einem weiteren Ausführungsbeispiel,
- Figur 44: zeigt ein weiteres Ausführungsbeispiel eines Leuchtmittels in einer schematischen Draufsicht,
- Figur 45: zeigt eine schematische Schnittdarstellung eines Leuchtmittels gemäß einem weiteren Ausführungsbeispiel,
- Figur 46: zeigt das Leuchtmittel gemäß der Figur 45 in einer schematischen perspektivischen Darstellung,
- Figur 47: zeigt eine schematische Darstellung der CIE-Normfarbtafel,
- Figur 48A: zeigt eine schematische Darstellung eines Flirtindikators gemäß einem Beispiel mit einem mehrfarbigen Leuchtmittel,
- Figur 48B: zeigt eine schematische Darstellung des Leuchtmittels gemäß der Figur 48A zusammen mit einer Steuervorrichtung,
- Figur 49: zeigt eine schematische Schnittdarstellung eines Leuchtmittels gemäß einem Ausführungsbeispiel,
- Figur 50: zeigt schematisch eine weitere Verwendungsmöglichkeit eines mehrfarbigen Leuchtmittels,
- Figur 51: zeigt eine schematische perspektivische Darstellung der Verwendung von mehrfarbigen Leuchtmitteln,
- Figur 52: zeigt eine schematische perspektivische Darstellung eines Leuchtmittels gemäß einem Ausführungsbeispiel,
- Figur 53: zeigt eine schematische Darstellung einer Anschlussstelle gemäß einem Ausführungsbeispiel, wie sie etwa bei dem Leuchtmittel der Figur 52 verwendet sein kann,
- Figur 54: zeigt eine weitere schematische perspektivische Darstellung einer Anschlussstelle gemäß einem Ausführungsbeispiel, wie sie bei der Figur 52 verwendet sein kann,
- Figur 55: zeigt eine schematische Draufsicht auf eine Anschlussstelle, wie sie bei dem Leuchtmittel des Ausführungsbeispiels der Figur 52 verwendet sein kann,
- Figur 56: zeigt eine schematische perspektivische Darstellung eines Leuchtmittels gemäß einem weiteren Ausführungsbeispiel,
- Figur 57: zeigt eine schematische perspektivische Darstellung eines Leuchtmittels gemäß einem weiteren Ausführungsbeispiel,
- Figur 58: zeigt eine schematische Draufsicht auf eine Anschlussstelle gemäß einem Ausführungsbeispiel, wie sie bei dem Leuchtmittel der Figur 57 verwendet sein kann,
- Figur 59: zeigt eine weitere schematische Draufsicht auf eine Anschlussstelle gemäß einem Ausführungsbeispiel, wie sie bei dem Leuchtmittel der Figur 57 verwendet sein kann,
- Figur 60: zeigt eine schematische Draufsicht auf eine weitere Ausführungsform der Anschlussstelle, wie sie bei dem Leuchtmittel der Figur 55 verwendet sein kann,
- Figur 61: zeigt eine schematische perspektivische Darstellung eines Leuchtmittels gemäß einem weiteren Ausführungsbeispiel,
- Figur 62A: zeigt eine weitere schematische perspektivische Darstellung eines Leuchtmittels gemäß einem Ausführungsbeispiel,
- Figur 62B: zeigt schematisch einen vergrößerten Ausschnitt der Figur 62A,
- Figur 63A: zeigt eine schematische Draufsicht auf ein Leuchtmittel gemäß einem weiteren Ausführungsbeispiel,
- Figur 63B: zeigt eine schematische Ausschnittsvergrößerung einer Anschlussstelle des Leuchtmittels gemäß der Figur 63A,
- Figur 64: zeigt eine schematische Draufsicht auf eine Beleuchtungseinrichtung gemäß einem Beispiel,
- Figuren 65 und 66: zeigen schematische perspektivische Darstellungen einer Beleuchtungseinrichtung gemäß einem weiteren Beispiel,

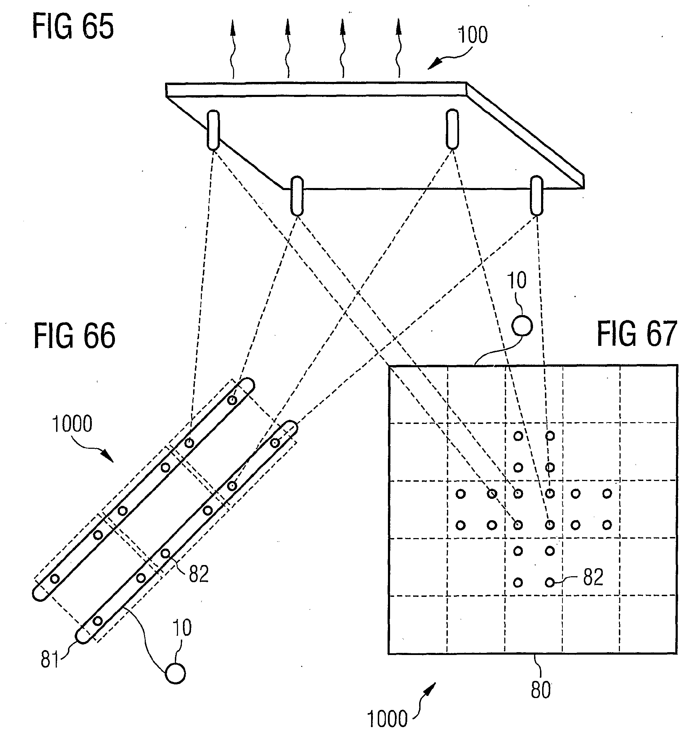

- Figuren 65 und 67: zeigen schematische Darstellungen einer weiteren Beleuchtungseinrichtung gemäß einem Beispiel,

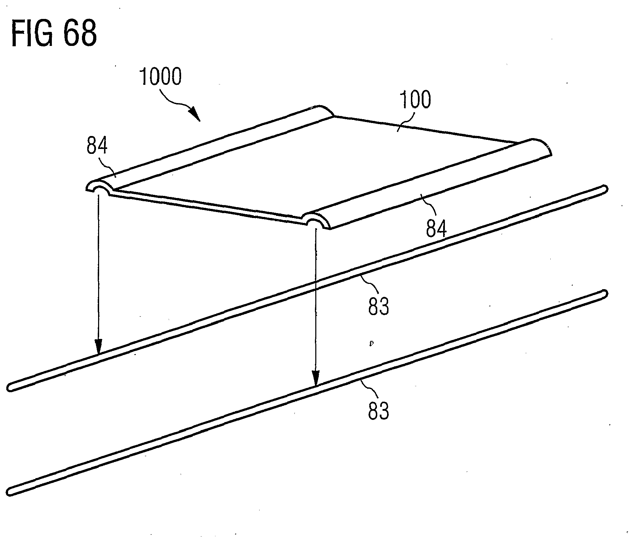

- Figur 68: zeigt eine schematische perspektivische Darstellung einer Beleuchtungseinrichtung gemäß einem weiteren Beispiel,

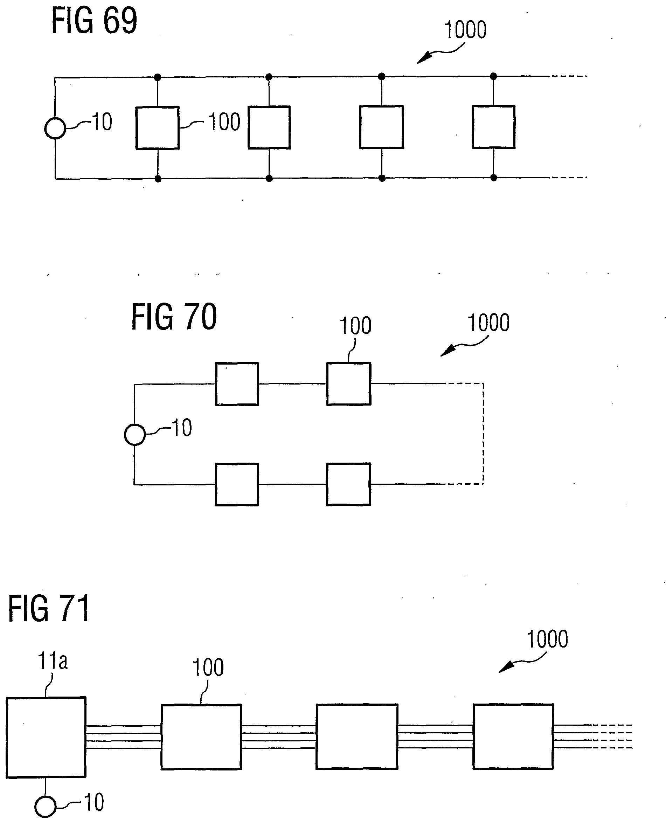

- Figur 69: zeigt eine schematische Darstellung einer Schaltskizze gemäß einem Beispiel,
- Figur 70: zeigt eine weitere schematische Schaltskizze gemäß einem weiteren Beispiel,
- Figur 71: zeigt eine schematische Darstellung einer Beleuchtungseinrichtung gemäß einem weiteren Beispiel,

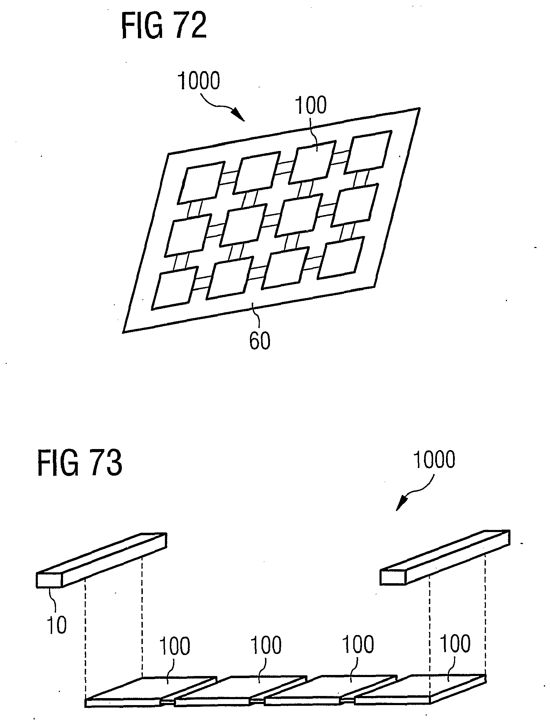

- Figur 72: zeigt eine schematische perspektivische Darstellung einer Beispiel gemäß einem weiteren Ausführungsbeispiel,
- Figur 73: zeigt eine schematische perspektivische Darstellung einer Beleuchtungseinrichtung gemäß einem weiteren Beispiel,

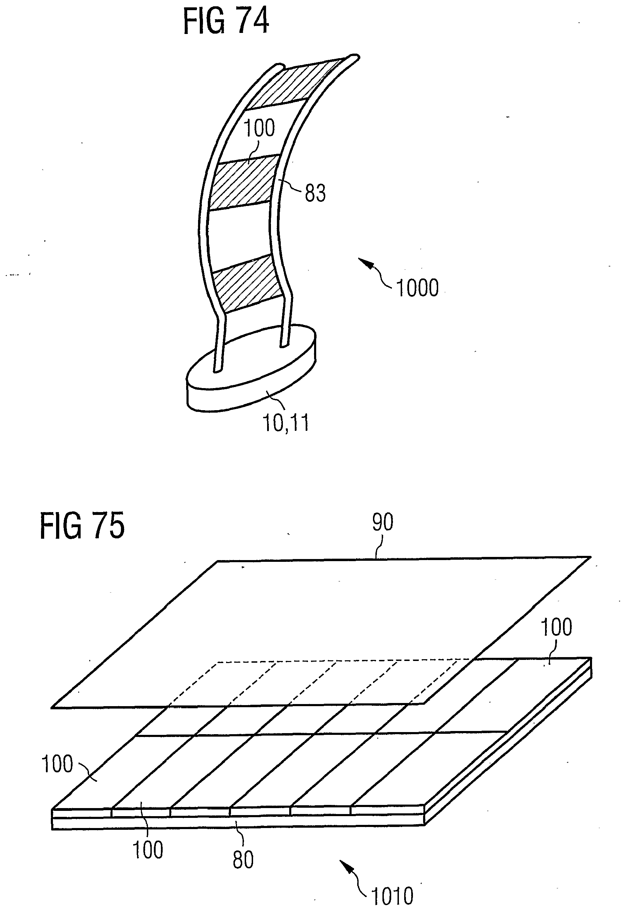

- Figur 74: zeigt eine schematische perspektivische Darstellung einer Beleuchtungseinrichtung gemäß einem weiteren Beispiel,
- Figur 75: zeigt eine schematische perspektivische Darstellung einer Anzeigevorrichtung gemäß einem Beispiel,

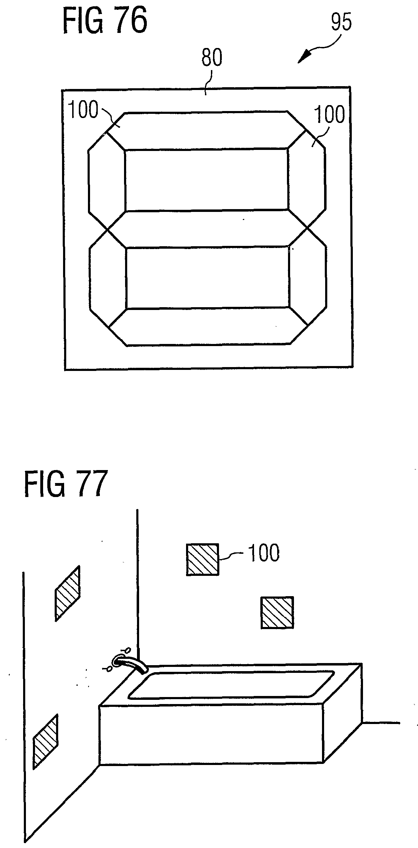

- Figur 76: zeigt eine schematische Draufsicht auf ein grobkörniges Display gemäß einem Beispiel,
- Figur 77: zeigt eine schematische Ansicht eines Badezimmers gemäß einem Beispiel,

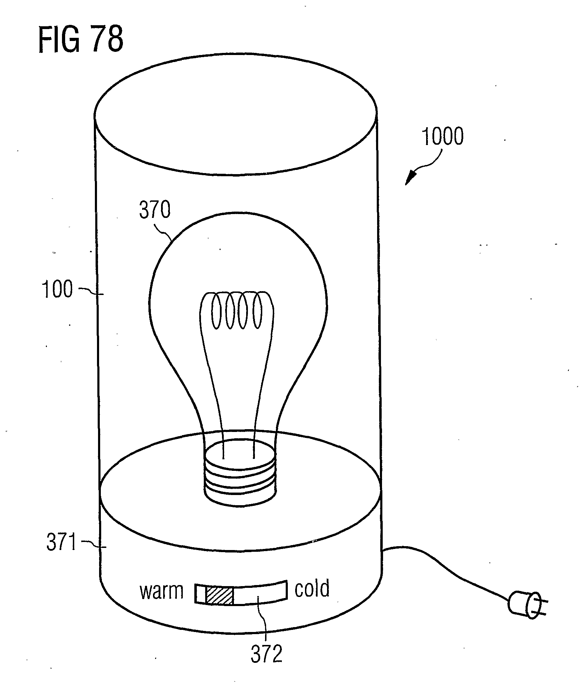

- Figur 78: zeigt eine schematische perspektivische Darstellung einer Beleuchtungseinrichtung mit einem Leuchtmittel und einer zweiten Lichtquelle gemäß einem Beispiel,

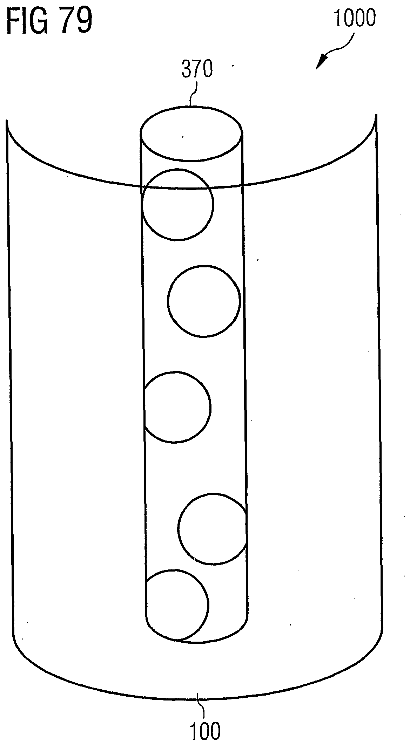

- Figur 79: zeigt eine schematische perspektivische Darstellung einer Beleuchtungseinrichtung mit einem Leuchtmittel und einer zweiten Lichtquelle gemäß einem weiteren Beispiel,
- Figur 80A: zeigt eine schematische perspektivische Darstellung einer Beleuchtungseinrichtung gemäß einem Ausführungsbeispiel,
- Figur 80B: zeigt eine schematische Schnittdarstellung der Beleuchtungseinrichtung der Figur 80A,

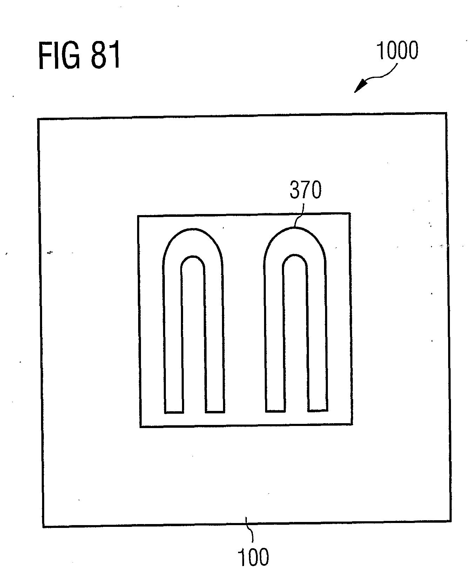

- Figur 81: zeigt eine schematische Draufsicht auf eine Beleuchtungseinrichtung gemäß einem weiteren Beispiel,

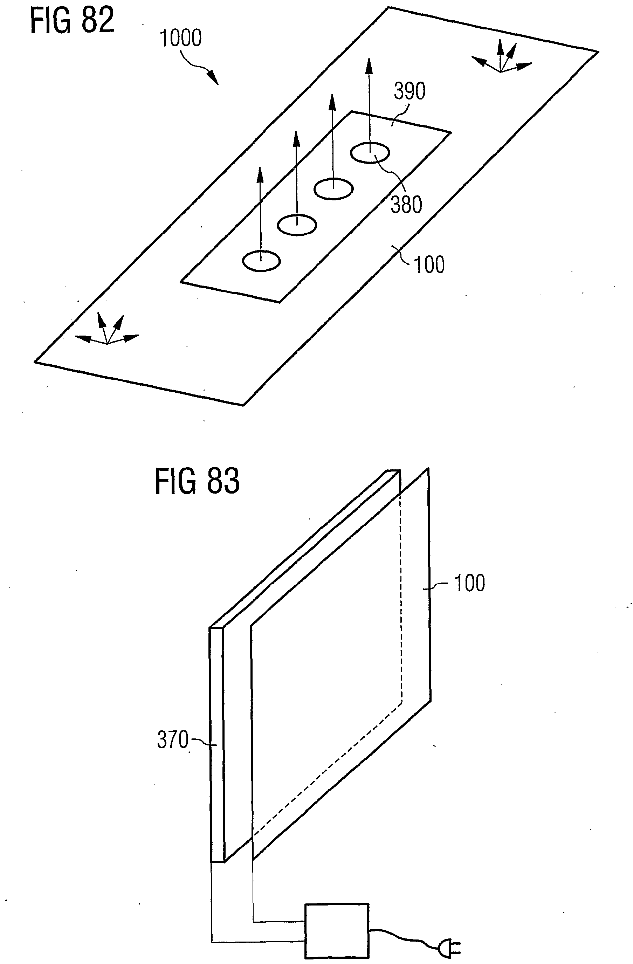

- Figur 82: zeigt eine schematische perspektivische Darstellung einer Beleuchtungseinrichtung mit einem Leuchtmittel und einer zweiten Lichtquelle gemäß einem weiteren Ausführungsbeispiel,
- Figur 83: zeigt eine schematische perspektivische Darstellung einer Beleuchtungseinrichtung mit einem Leuchtmittel und einer zweiten Lichtquelle gemäß einem Beispiel,

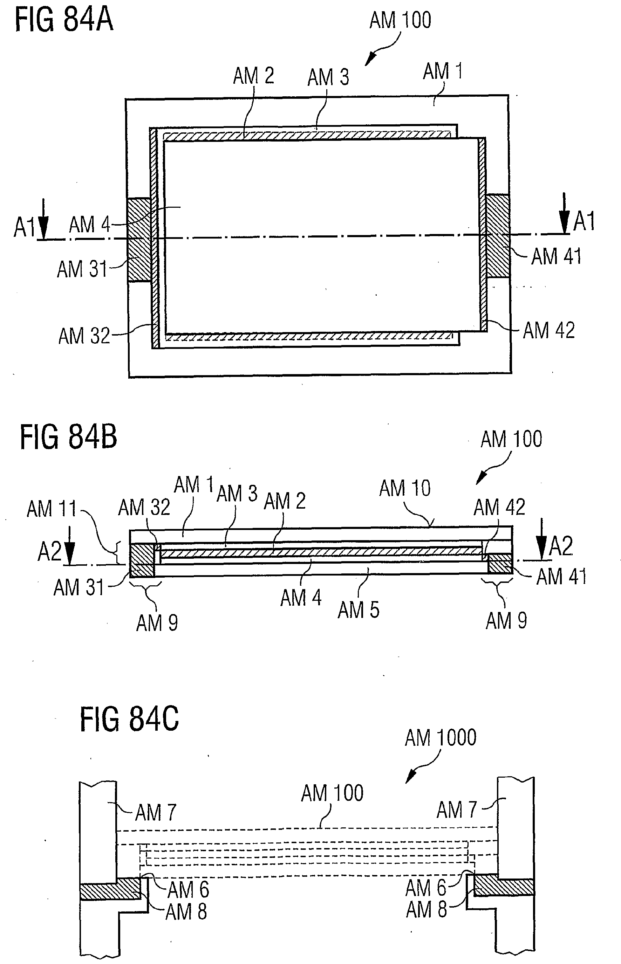

- Figuren 84A bis 84C: zeigen schematische Darstellungen eines Ablageelements und eines Ablagemöbels gemäß einem Beispiel,

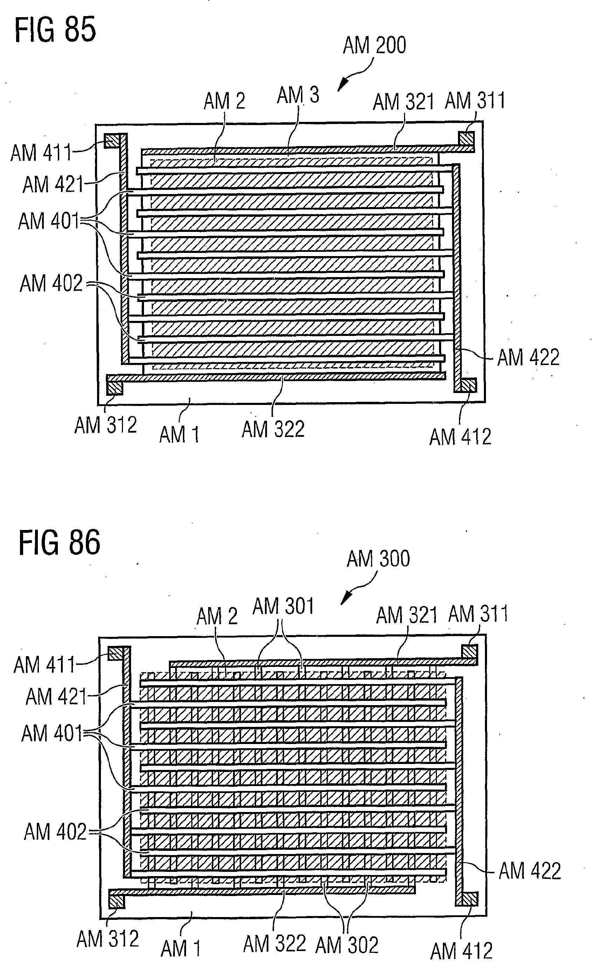

- Figur 85: zeigt eine schematische Darstellung eines Ablageelements gemäß einem weiteren Beispiel,
- Figur 86: zeigt eine schematische Darstellung eines Ablageelements gemäß einem weiteren Beispiel,

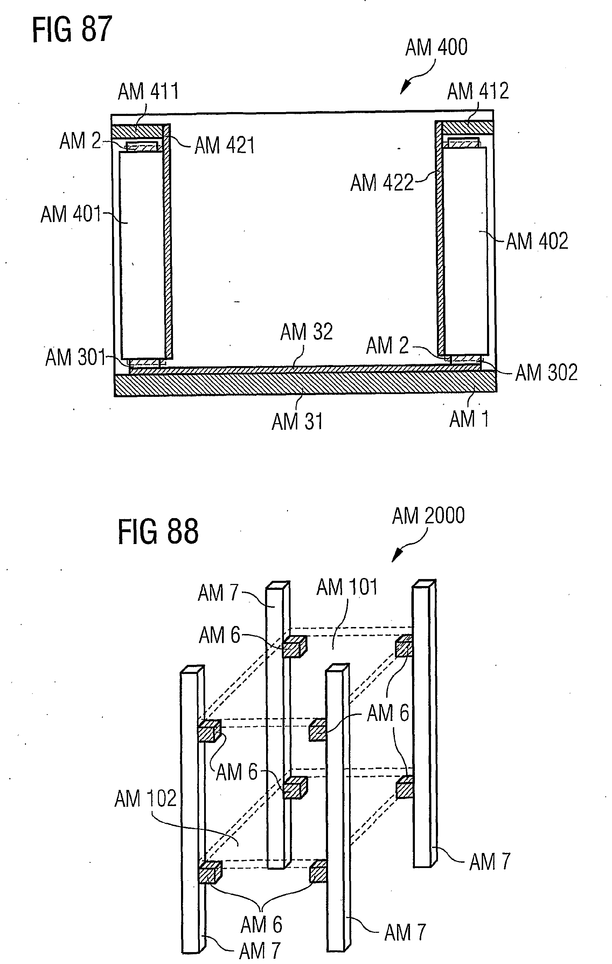

- Figur 87: zeigt eine schematische Darstellung eines Ablageelements gemäß einem weiteren Beispiel,
- Figur 88: zeigt eine schematische Darstellung eines Ablagemöbels gemäß einem weiteren Beispiel,

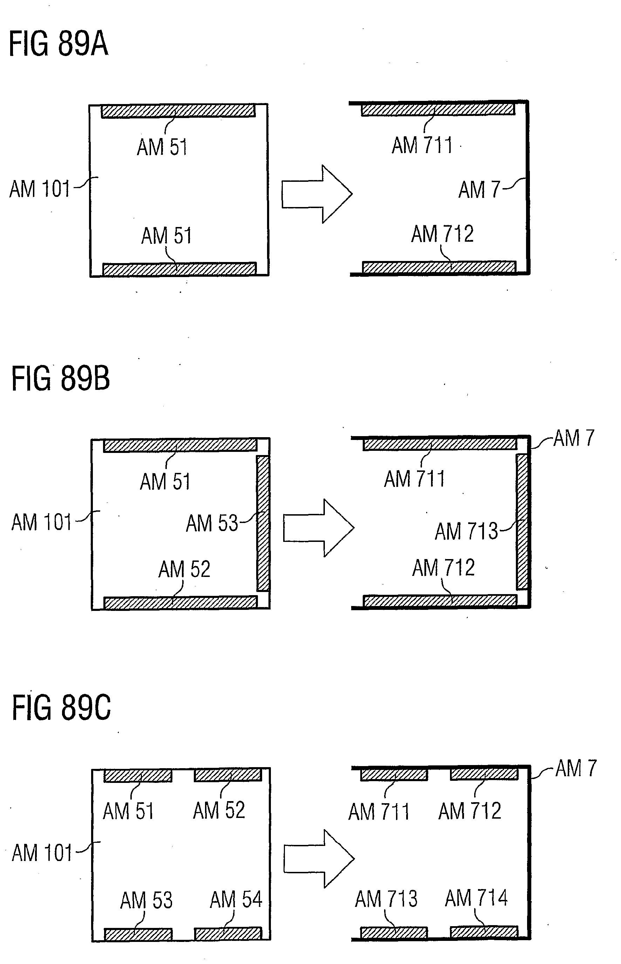

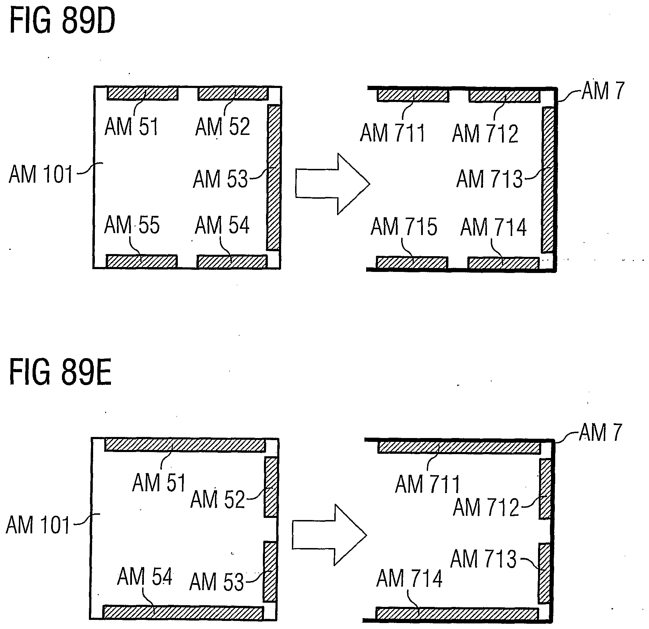

- Figuren 89A bis 89E: zeigen schematische Darstellungen von Ablagemöbeln gemäß weiteren Beispielen.

In den Ausführungsbeispielen und Figuren sind gleiche oder gleich wirkende Bestandteile jeweils mit den gleichen Bezugszeichen versehen. Die dargestellten Elemente sind nicht als maßstabsgerecht anzusehen, vielmehr können einzelne Elemente zum besseren Verständnis übertrieben groß dargestellt sein.

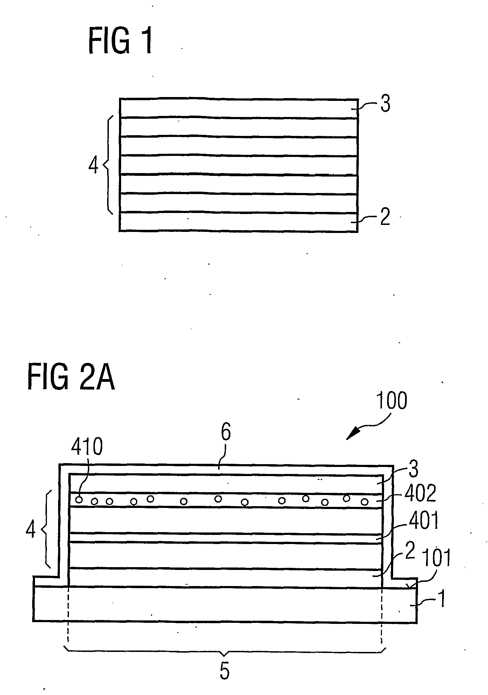

Die Figur 1 zeigt eine schematische Schnittdarstellung eines organischen Schichtstapels 4 zwischen einer ersten 2 und einer zweiten Elektrode 3 gemäß einem Ausführungsbeispiel. Die erste Elektrode ist durchlässig für sichtbares Licht ausgebildet und weist ein TCO (transparent conductive oxide) auf, beispielsweise ITO (indium tin oxide). Weiterhin dient die erste Elektrode 2 als Anode. Die zweite Elektrode 3 dient vorliegend als Kathode. Sie weist beispielsweise ein Aluminium oder Silber auf.

Auf der ersten Elektrode 2 ist ein organischer Schichtstapel 4 mit folgenden Schichten aufgebracht, wobei die im Folgenden aufgeführte Reihenfolge der Schichten deren Reihenfolge innerhalb des organischen Schichtstapels angefangen von der Kathode entspricht: eine 1-TNATA-Schicht (1-TNATA = 4,4',4''-Tris(N(naphth-1-yl)-N-phenyl-amino)triphenylamin) mit einer Dicke von zirka 40 nm, eine sp-TAD-Schicht (spTAD= 2,2',7,7'-diphenylamino-spiro-9,9'-biflouren) mit einer Dicke von zirka 20 nm, SEB-010:SEB020-Schicht mit einer Dicke von zirka 10 nm, eine TMM-004:Ir(ppy)3(15 %)-Schicht (Irppy = fac-tris(2-phenly-pyridyl)irirdium complex) mit einer Dicke von zirka 10 nm und TMM-04:TER012-Schicht mit einer Dicke von zirka 30 nm. Der vorliegende organische Schichtstapel ist geeignet, weißes Licht zu emittieren.

Die Figur 2A zeigt eine schematische Schnittdarstellung eines Leuchtmittels gemäß einem Ausführungsbeispiel. Das Leuchtmittel umfasst ein Substrat 1 mit einer ersten Hauptfläche 101, auf die die erste Elektrode 2 innerhalb eines aktiven Bereiches 5 des Substrates 1 aufgebracht ist.

Auf der ersten Elektrode 2 ist ein organischer Schichtstapel 4 mit mindestens einer zur Lichterzeugung geeigneten Schicht 401 angeordnet, auf den die zweite Elektrode 3 aufgebracht ist. Vorliegend handelt es sich bei der ersten Elektrode 2 auf dem Substrat 1 um die Anode und bei der zweiten Elektrode 3 auf dem organischen Schichtstapel 4 um die Kathode. Der organische Schichtstapel 4 weist auf seiner zur Kathode weisenden äußeren Seite eine dotierte Schicht 402 mit einem Dotierstoff 410 auf, der als Elektronendonator fungiert. Hierdurch wird die Injektion von Elektronen von der Kathode in den organischen Schichtstapel vorteilhafterweise erhöht. Als Dotierstoff 410 kann beispielsweise Cäsium, Barium oder Lithium-Fluorid verwendet werden.

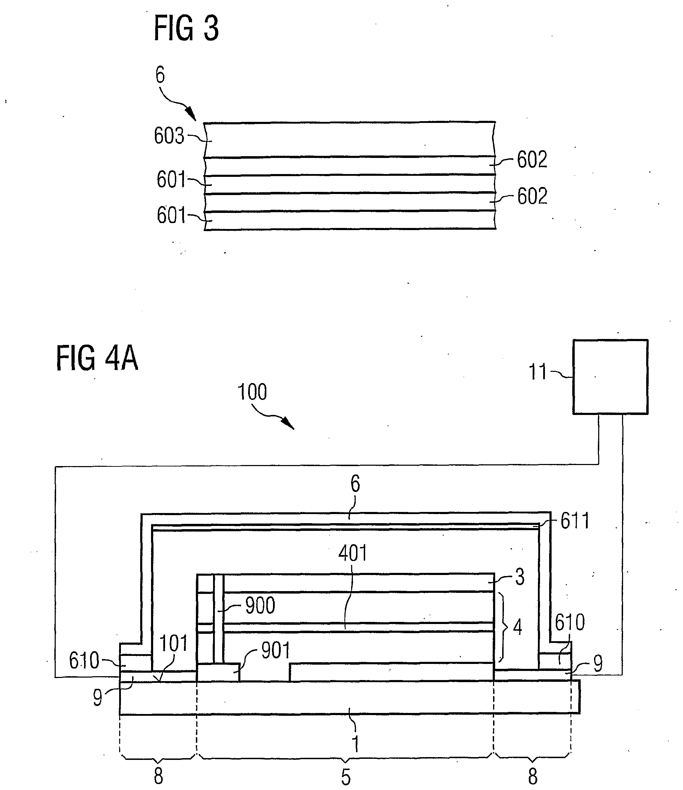

Weiterhin umfasst das Leuchtmittel gemäß der Figur 2A eine Dünnfilmverkapselung 6. Der aktive Bereich 5 mit dem organischen Schichtstapel 4 ist innerhalb der Dünnfilmverkapselung 6 angeordnet. Die Dünnfilmverkapselung 6 ist direkt auf die zweite Elektrode 3 aufgebracht. Eine Dünnfilmverkapselung, wie sie beispielsweise bei dem Leuchtmittel der Figur 2A verwendet sein kann, ist beispielsweise in Verbindung mit Figur 3 beschrieben.

Das Leuchtmittel gemäß der Figur 2A ist durchlässig für sichtbares Licht ausgebildet, insbesondere für ein vom organischen Schichtstapel 4 erzeugtes Licht. Zu diesem Zweck ist das Substrat 1 durchlässig für sichtbares Licht ausgebildet. Es kann beispielsweise Glas oder einen Kunststoff aufweisen oder aus einem solchen bestehen. Beispielsweise kann als Substrat ein dünnes Glasplättchen oder eine flexible Kunststofffolie verwendet werden, die eines der im allgemeinen Beschreibungsteil aufgeführten Kunststoffmaterialien aufweist oder aus einem solchen besteht. Das Substrat des Leuchtmittels in der erfindungsgemäßen Beleuchtungseinrichtung ist eine milchige Glasscheibe das für sichtbares Licht durchlässig ausgebildet ist.

Auch die erste Elektrode 2 auf dem Substrat ist durchlässig für sichtbares Licht ausgebildet. Die erste Elektrode 2 kann beispielsweise aus einem TCO bestehen oder ein solches aufweisen. Das organische Material des organischen Schichtstapels 4 ist in der Regel durchlässig für sichtbares Licht ausgebildet. Insbesondere ist vorliegend die dotierte Schicht durchlässig für sichtbares Licht ausgebildet. Der organische Schichtstapel 4 kann beispielsweise die Schichten des organischen Schichtstapels der Figur 1 umfassen. Die zweite Elektrode 3 ist ebenfalls durchlässig für sichtbares Licht, insbesondere für ein vom organischen Schichtstapel 4 erzeugtes Licht ausgebildet. Die zweite Elektrode 3 ist vorliegend als Kathode ausgebildet. Diese kann beispielsweise eine metallische Schicht aufweisen, die Aluminium oder Silber enthält und eine Dicke von zirka 30 nm hat.

Weiterhin kann eine Elektrode 2, 3, die durchlässig für sichtbares Licht ausgebildet ist, ein leitendes organisches Material umfassen oder aus einem solchen bestehen. Hierbei ist zum Beispiel PEDOT:PSS als organisches Elektrodenmaterial geeignet. PEDOT:PSS kann dabei zum Beispiel die Anode ausbilden. Im Falle einer geeigneten Leitfähigkeitsdotierung ist es aber auch mögliche, dass die Kathode aus PEDOT:PSS besteht oder dieses Material enthält.

Sollte die Leitfähigkeit des Elektrodenmaterials, insbesondere des organischen Materials, nicht ausreichen, um genügend Ladungsträger in den organischen Schichtstapel zu injizieren, so können dünne Metallbahnen zwischen der Elektrode und dem organischen Schichtstapel angeordnet werden.

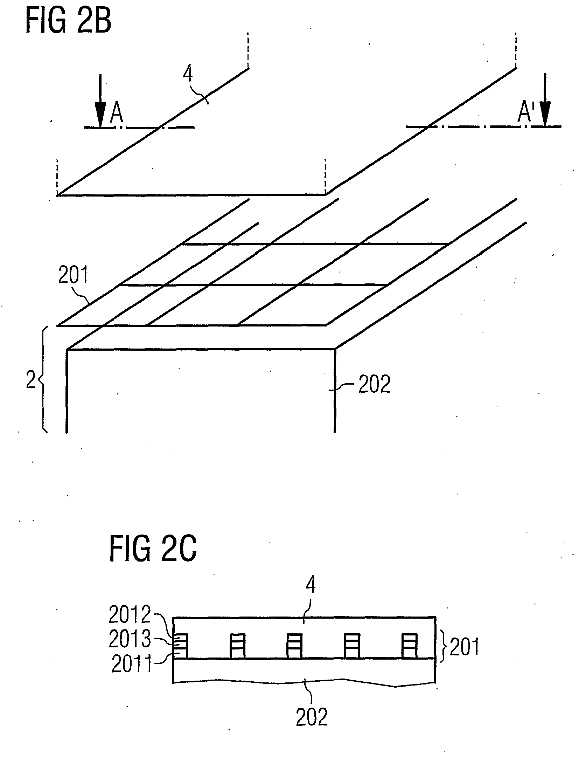

Die Figur 2B zeigt eine schematische perspektivische Darstellung einer Elektrode 2 gemäß einem Ausführungsbeispiel, die eine Schicht mit organischem leitenden Material und dünne Metallbahnen 201 aufweist, die zwischen der organischen Elektrodenschicht 202 und dem organischen Schichtstapel 4 angeordnet sind. Die Figur 2C zeigt eine schematische Schnittdarstellung entlang der Linie AA' der Figur 2B.

Die Metallbahnen 201 sind bei dem vorliegenden Ausführungsbeispiel in Form eines Gitters ausgebildet. Die Dicke der Metallbahnen beträgt bevorzugt einige µm. Der Abstand zwischen direkt benachbarten Gitterpunkten beträgt hier bei bevorzugt zwischen 1 mm und 100 mm, wobei die Grenzen eingeschlossen sind.

Weiterhin weisen die elektrisch leitenden Bahnen 201 einen Mehrschichtaufbau auf, beispielsweise mit drei metallischen Bahnen, wie in Figur 2C gezeigt. Bei den beiden äußeren Bahnen 2011, 2012 handelt es sich um Schutzschichten für die mittlere Schicht 2013, etwa gegen Korrosion. Sie können beispielsweise Chrom, Molybdän, Kupfer oder Silber aufweisen oder aus einem dieser Materialien bestehen. Die mittlere Schicht 2013 des Mehrschichtaufbaus kann beispielsweise Aluminium aufweisen oder aus Aluminium bestehen.

Der Mehrschichtaufbau weist dabei eine Dicke von vorzugsweise wenigstens 50 nm und höchstens 100 nm auf.

Weiterhin ist auch die Dünnfilmverkapselung 6 des Leuchtmittels gemäß der Figur 2A durchlässig für sichtbares Licht, insbesondere für ein vom organischen Schichtstapel 4 erzeugtes Licht ausgebildet. Eine schematische Schnittdarstellung durch eine Dünnfilmverkapselung 6, wie sie beispielsweise gemäß der Figur 2A verwendet werden kann, ist in Figur 3 gezeigt. Die Dünnfilmverkapselung 6 umfasst vorliegend jeweils zwei erste Barriereschichten 601, die Siliziumoxid aufweisen oder aus Siliziumoxid bestehen sowie zwei zweite Barriereschichten 602, die Siliziumnitrid aufweisen beziehungsweise aus Siliziumnitrid bestehen. Die ersten Barriereschichten 601 und die zweiten Barriereschichten 602 der Dünnfilmverkapselung 6 sind hierbei alternierend hinsichtlich ihrer Materialzusammensetzung angeordnet. Die Dünnfilmverkapselung 6 hat bevorzugt eine Dicke zwischen 0,5 und 5 µm, wobei die Grenzen eingeschlossen sind.

Die Barriereschichten können beispielsweise aufgedampft, gesputtert oder mittels einem Plasma-unterstützten Prozess, wie chemical vapor deposition (CVD) auf der zweiten Elektrode abgeschieden werden. Die Barriereschichten weisen bevorzugt eine Dicke von je wenigstens 30 nm bis höchstens 300 nm auf. Besonders bevorzugt ist eine einzelne Barriereschicht zirka 100 nm dick. Bevorzugt umfasst eine Dünnfilmverkapselung wenigstens zwei bis höchstens acht Barriereschichten. Typischerweise umfasst die Dünnfilmverkapselung drei oder vier Barriereschichten.

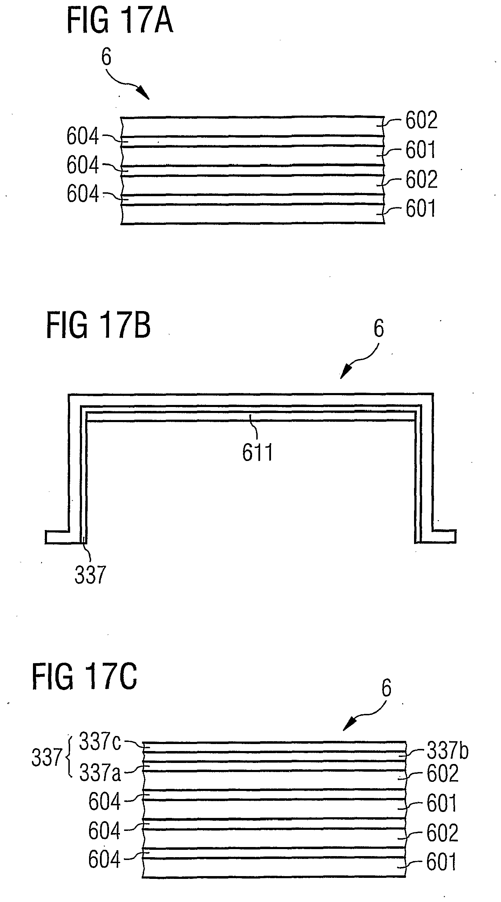

Die Dünnfilmverkapselung kann weiterhin Polymerzwischenschichten aufweisen, wie sie anhand der Figur 17 weiter unten im Text beschrieben werden.

Auf die Barriereschichten ist weiterhin eine Schutzlackschicht 603 aufgebracht. Die Schutzlackschicht 603 kann beispielsweise mittels Drehschleudern (spin-coating), Sprühen, Rakeln, Siebdruck oder ähnlichen Techniken aufgebracht werden. Nach dem Aufbringen wird die Schutzlackschicht 603 durch Zufuhr von Wärme oder UV-Strahlung ausgehärtet. Als Materialien für die Schutzlackschicht 603 eigenen sich Acrylate, Polyacrylate, Polyimide und ähnliche Materialien. Die Dicke der Schutzlackschicht beträgt beispielsweise zwischen wenigstens 30 und höchstens 40 µm.

Das Leuchtmittel der Figur 2A ist geeignet, Licht gleichzeitig von einer Oberseite und von einer der Oberseite gegenüberliegenden Unterseite auszusenden, da das im organischen Schichtstapel 4 erzeugte Licht auf dem Weg zur Oberseite und zur Unterseite nur Elemente durchläuft, die durchlässig für sichtbares Licht ausgebildet sind.

Die Figur 4A zeigt eine schematische Schnittdarstellung eines Leuchtmittels gemäß einem weiteren Ausführungsbeispiel. Das Leuchtmittel gemäß der Figur 4A weist ein Substrat 1 mit einem aktiven Bereich 5 auf, auf den eine erste Elektrode 2 aufgebracht ist. Auf der ersten Elektrode 2 ist ein organischer Schichtstapel 4 mit mindestens einer zur Lichterzeugung geeigneten Schicht 401 angeordnet. Auf dem organischen Schichtstapel 4 ist eine weitere, zweite Elektrode 3 angeordnet. Das Substrat, die erste und die zweite Elektrode sowie der organische Schichtstapel sind vorliegend durchlässig für sichtbares Licht, insbesondere für ein von dem organischen Schichtstapel 4 erzeugtes Licht ausgebildet, wie beispielsweise anhand der Figur 2A bereits beschrieben.

Der aktive Bereich 5 des Substrates 1, auf dem der organische Schichtstapel 4 zwischen der ersten 2 und der zweiten 3 Elektrode angeordnet ist, ist von einem Befestigungsbereich umgeben. Innerhalb des Befestigungsbereichs 8 umfasst das Substrat 1 elektrisch leitende Zuleitungen 9, die mit der ersten Elektrode 2 und der zweiten Elektrode 3 elektrisch leitend verbunden sind. Bei den Zuleitungen 9 zur ersten Elektrode 2 kann es sich beispielsweise um Strukturen der ersten Elektrode 2 handeln, die bis in den Befestigungsbereich 8 hinein verlängert sind. In diesem Fall weisen die elektrischen Zuleitungen 9 in der Regel dasselbe Material auf, wie die erste Elektrode 2. Die Zuleitungen 9 zu der zweiten Elektrode 3 sind vorliegend mit einer von der ersten Elektrode 2 elektrisch isolierten weiteren Elektrodenstruktur 901 innerhalb des aktiven Bereiches 5 des Substrates 1 elektrisch leitend verbunden, beispielsweise indem die Zuleitungen 9 ebenfalls durch Verlängerungen der weiteren Elektrodenstruktur 901 in den Befestigungsbereich 8 gebildet werden. Die zweite Elektrode 3 auf dem organischen Schichtstapel 4 ist beispielsweise mittels einer Durchkontaktierung 900 mit der weiteren Elektrodenstruktur 901 elektrisch leitend verbunden.

Innerhalb des Befestigungsbereiches 8 ist über den elektrischen Zuleitungen 9 eine Klebstoffschicht 610 angeordnet, mit der eine Kappe, die als Verkapselung 6 dient, auf dem Substrat befestigt ist. Die Kappe weist eine Kavität über dem aktiven Bereich 5 auf, in dem der aktive Schichtenstapel 4 angeordnet ist. Vorliegend steht die Kappe nicht in direktem Kontakt mit der zweiten Elektrode 3. Weiterhin ist die Kappe, wie das Substrat 1, die erste 2 und die zweite Elektrode 3 sowie der organische Schichtstapel 4 ebenfalls durchlässig für sichtbares Licht, insbesondere für ein vom organischen Schichtstapel 4 erzeugtes Licht, ausgebildet. Sie kann beispielsweise aus Glas oder einem der bereits im Zusammenhang mit dem Substrat 1 im allgemeinen Beschreibungsteil erwähnten lichtdurchlässigen Kunststoffe gebildet sein.

Auf der zu dem organischen Schichtstapel weisenden Innenseite der Kappe ist eine Getter-Schicht 611 aufgebracht, die durchlässig für sichtbares Licht ausgebildet ist. Als GetterMaterial kann beispielsweise eines der oben beschrieben Materialien verwendet werden. Insbesondere eignen sich für eine transparente Getter-Schicht 611 Partikel eines Getter-Materials - zum Beispiel Calciumoxid -, die in eine transparente Matrix eingebettet sind. Für die Matrix eignen sich zum Beispiel lösungsmittelfreie, aushärtbare Kunststoffmaterialien. Die Getter-Schicht 611 weist bevorzugt eine Dicke von höchstens 300 µm auf, besonders bevorzugt zwischen wenigstens 50 und höchstens 100 µm.

Die elektrischen Zuleitungen 9 auf dem Substrat 1 sind vorliegend mit einer Steuervorrichtung 11 elektrisch leitend verbunden.

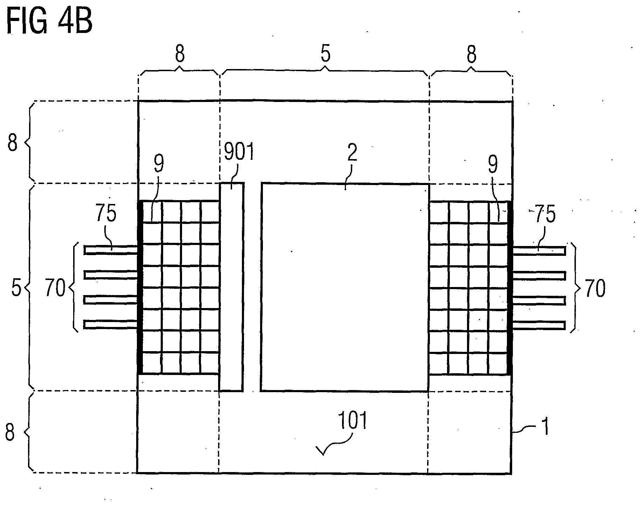

Die Figur 4B zeigt eine schematische Draufsicht auf das Substrat 1 gemäß Figur 4A. Innerhalb des aktiven Bereiches 5 sind die erste Elektrode 2 und die weitere Elektrodenstruktur 901 angeordnet. Seitlich des aktiven Bereiches 5 innerhalb des Befestigungsbereiches 8 befinden sich jeweils elektrische Zuleitungen 9, die vorliegend gitterförmig ausgebildet sind. Die elektrischen Zuleitungen auf der einen Seite des Substrats 1 sind Fortsetzungen der weiteren Elektrodenstruktur 901, während die elektrischen Zuleitungen 9 auf der anderen Seite des Substrats Fortsetzungen der ersten Elektrode 2 sind. Die elektrischen Zuleitungen umfassen vorliegend ein TCO, beispielsweise ITO.

Weiterhin ist es auch möglich, dass die elektrischen Zuleitungen 9 ein Metall aufweisen oder aus einem solchen bestehen. Beispielsweise enthalten oder bestehen die Zuleitungen 9 aus zumindest einem der folgenden Materialien oder Materialkombinationen: Cr/Al/Cr, Cu/Cr, Mo/Al/Mo; Cr, Cu, Al, Ag, Au, Pt.

Weisen die elektrischen Zuleitungen 9 ein Metall auf, so ist der Füllgrad des Gitters in der Regel derart gering gewählt, dass die elektrischen Zuleitungen von einem Betrachter nicht wahrgenommen werden. Auf diese Weise können die elektrischen Zuleitungen 9 vorteilhafterweise durchlässig für sichtbares Licht ausgebildet werden. Der Füllgrad des Gitters ist dabei vorzugsweise kleiner 10 %, besonders bevorzugt kleiner 2 %.

Die elektrischen Zuleitungen 9 sind elektrisch leitend mit elektrischen Anschlussstellen 70, vorliegend Pins 75, verbunden, die seitlich des Substrates 1 angeordnet sind. Über die Pins 75 kann das Leuchtmittel mit einer Buchse elektrisch kontaktiert oder, wie in Figur 4A dargestellt, mit der Steuervorrichtung 11 verbunden sein.

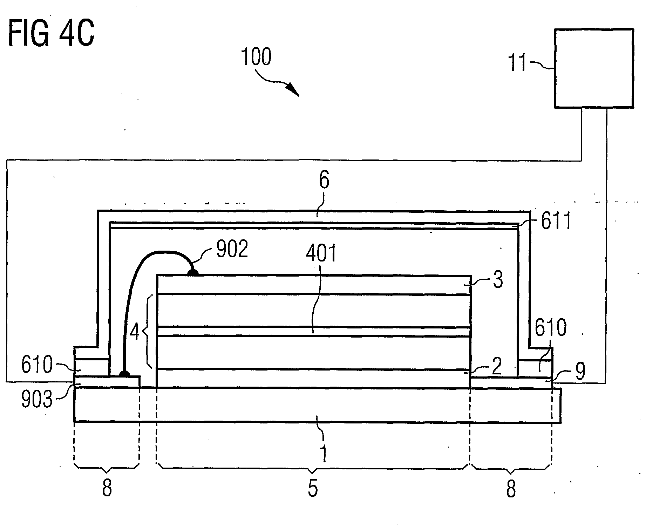

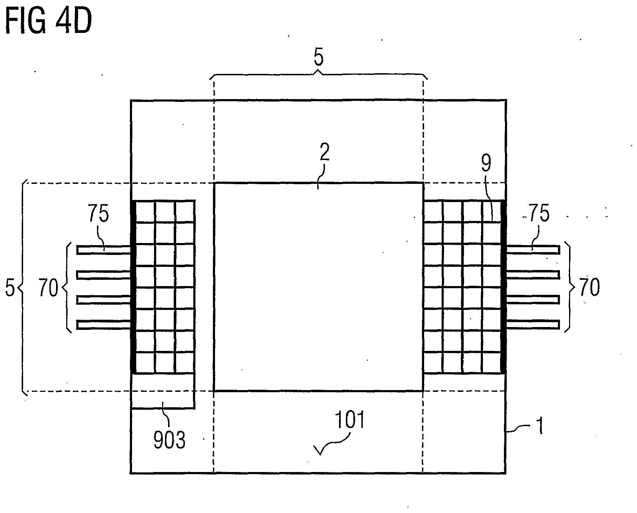

Die Figur 4C zeigt eine schematische Schnittdarstellung eines Leuchtmittels 100 gemäß einem weiteren Ausführungsbeispiel. Die Figur 4D zeigt eine schematische Draufsicht auf das Substrat des Leuchtmittels gemäß Figur 4C. Das Leuchtmittel 100 entspricht bis auf die im Folgenden beschriebenen Unterschiede dem Leuchtmittel der Figuren 4A und 4B.

Im Unterschied zu dem Leuchtmittel der Figuren 4A und 4B weist der organische Schichtstapel 4 keine Durchkontaktierung auf. Weiterhin umfasst das Substrat keine weitere Elektrodenstruktur.

Stattdessen ist die erste Elektrode 2 ganzflächig unterhalb des organischen Schichtstapels 4 innerhalb des aktiven Bereiches 5 auf dem Substrat 1 ausgebildet. Auf der einen Seite des aktiven Bereiches 5 innerhalb des Befestigungsbereiches sind elektrische Zuleitungen 9 angeordnet, die mit der ersten Elektrode 2 elektrisch leitend verbunden sind. Bei diesen elektrischen Zuleitungen 9 kann es sich beispielsweise um fortgesetzte Strukturen der ersten Elektrode 2 handeln. Auf der anderen Seite sind elektrische Zuleitungen 9 auf dem Substrat 1 angebracht, die elektrisch nicht mit der ersten Elektrode 2 verbunden sind. Weiterhin umfassen die elektrischen Zuleitungen auf dieser Seite ein Bondpad 903, auf dem ein Bonddraht 902 angeordnet ist, der mit der zweiten Elektrode 3 elektrisch leitend verbunden ist.

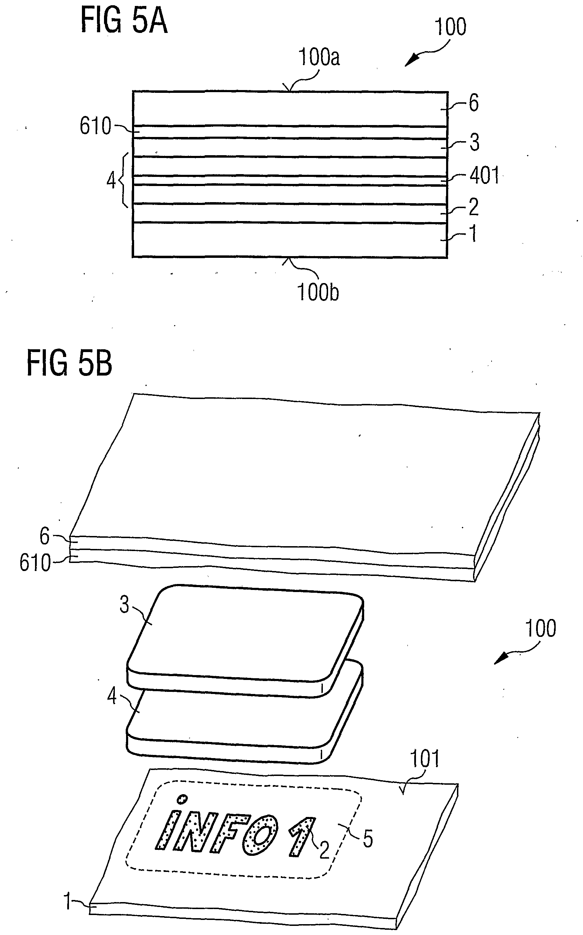

Die Figur 5A zeigt eine schematische Schnittdarstellung durch ein Leuchtmittel 100 gemäß einem weiteren Ausführungsbeispiel. Das Leuchtmittel 100 umfasst als Substrat 1 eine Fensterverglasung. Auf dem Substrat ist eine erste Elektrode 2 aufgebracht, auf die weiterhin ein organischer Schichtstapel 4 mit mindestens einer zur Lichterzeugung geeigneten Schicht 401 aufgebracht ist. Bei dem organischen Schichtstapel 4 kann es sich beispielsweise um einen Schichtstapel 4 handeln, wie er bereits anhand der Figur 1 beschrieben wurde. Auf den organischen Schichtstapel 4 ist eine zweite Elektrode 3 aufgebracht. Als Verkapselung 6 umfasst das Leuchtmittel gemäß der Figur 5A eine zweite Fensterverglasung, die auf die zweite Elektrode 3 mit einer Klebstoffschicht 610 aufgeklebt ist. Als Klebstoff ist beispielsweise ein transparenter Klebstoff geeignet. Dieser Klebstoff ist vorzugsweise ebenfalls durchlässig für sichtbares Licht ausgebildet. Als Klebstoffe eignen sich zum Beispiel Nagase oder Three-Bond.

Substrat 1, Elektroden 2, 3, Verkapselung 6, organischer Schichtstapel 4 und Klebstoffschicht 610 sind durchlässig für sichtbares Licht ausgebildet. Das Leuchtmittel 100 ist somit dazu geeignet, von seiner Oberseite 100a und seiner Unterseite 100b Licht abzustrahlen. Weiterhin kann ein Betrachter durch das Leuchtmittel 100 hindurch sehen, wenn es nicht in Betrieb ist. Das Leuchtmittel ist daher geeignet, als Verglasung beispielsweise in Türen, Fenstern, Raumteilern, Möbeln oder ähnlichem eingesetzt zu werden, wobei die Verglasung als Beleuchtungsquelle dienen kann.

Die Figur 5B zeigt eine schematische Darstellung des Aufbaus eines Leuchtmittels 100, das im Wesentlichen durchlässig für sichtbares Licht ausgebildet ist und in eine Verglasung integriert ist. Als Substrat 1 dient vorliegend eine Glasscheibe mit einem aktiven Bereich 5, auf den eine erste Elektrode 2 aufgebracht ist. Die Elektrode ist vorliegend ebenfalls durchlässig für sichtbares Licht ausgebildet und umfasst ein TCO, beispielsweise ITO. Um bestimmte Formen, beispielsweise einen Schriftzug oder ein Logo darzustellen, ist die erste Elektrode 2 gemäß der gewünschten Form strukturiert, vorliegend in dem Schriftzug "Info 1".

Innerhalb des aktiven Bereiches ist auf die erste Elektrode ein organischer Schichtstapel 4, beispielsweise wie er in Figur 1 bereits beschrieben wurde, aufgebracht. Auf den organischen Schichtstapel wird eine zweite Elektrode 3, die ebenfalls durchlässig für sichtbares Licht ist und vorliegend als Kathode dient, aufgebracht. Die zweite Elektrode 3 wird ganzflächig auf den organischen Schichtstapel 4 aufgebracht. Es ist weiterhin jedoch auch denkbar, dass die erste Elektrode 2 ganzflächig auf das Substrat und die zweite Elektrode 3 in der Form, die die Leuchtfläche des Leuchtmittels ausbilden soll, auf den organischen Schichtenstapel 4 aufgebracht ist. Auf die zweite Elektrode 3 ist eine zweite Glasscheibe als Verkapselung 6 aufgebracht. Die Abmessungen der Verkapselung 6 sind dabei bevorzugt gleich zu den Abmessungen des Substrates 1 gewählt. Auf diese Art und Weise entsteht eine Verglasung mit einem Leuchtmittel 100, dessen Leuchtfläche auf gewünschte Art und Weise, beispielsweise in Form eines Schriftzuges oder eines Logos ausgebildet ist.

Die zweite Glasscheibe, die als Verkapselung 6 dient, kann beispielsweise mittels einer für sichtbares Licht durchlässigen Klebstoffschicht 610 auf dem Substrat befestigt werden. Die Klebstoffschicht 610 kann hierbei ganzflächig auf das Substrat und auf die zweite Glasscheibe aufgebracht werden, oder nur innerhalb eines Befestigungsbereiches 8 außerhalb des aktiven Bereiches 5.

Die Kontaktierung des aktiven Bereiches 5 kann beispielsweise mittels elektrisch leitenden Zuleitungen 9, wie sie anhand der Figuren 4A bis 4D beschrieben wurden, erfolgen.

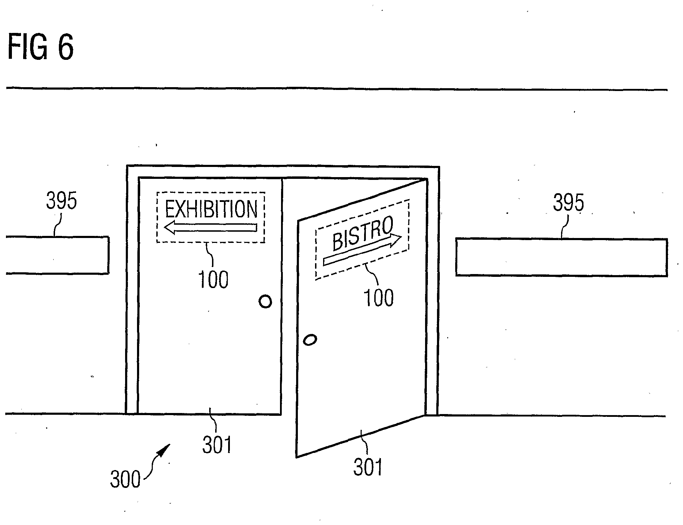

Die Figur 6 zeigt eine schematische perspektivische Ansicht einer Tür 300 gemäß einem Beispiel. Die Tür 300 weist zwei Türflügel 301 auf, die durchlässig für sichtbares Licht ausgebildet sind. Diese weisen beispielsweise Glas auf oder sind aus Glas gebildet. In jeden Türflügel 301 ist ein Leuchtmittel 100 integriert, das durchlässig für sichtbares Licht ausgebildet ist. Mit Hilfe der Leuchtmittel 100, deren Leuchtfläche vorliegend jeweils eine Beschriftung formen, ist es möglich, leuchtende Wegweiser in Türen 300 zu integrieren. Solche Türen 300 mit leuchtenden Wegweisern können beispielsweise in Museen, Kongresszentren, Hotels oder ähnlichem zum Einsatz kommen. Das Leuchtmittel kann vorliegend entweder in die Tür 300 integriert sein, wie anhand der Figuren 5A und 5B bereits beschrieben, oder es kann sich bei den Leuchtmitteln 100 auch um flexible Leuchtmittel handeln, die für sichtbares Licht durchlässig ausgebildet und beispielsweise mit einer Klebstoffschicht auf der Tür angebracht sind. Ein flexibles Leuchtmittel, das geeignet ist, aufgeklebt zu werden, ist beispielsweise in Verbindung mit Figur FM9 beschrieben.

Sind die Leuchtmittel 100 in die Tür 300 integriert, so können auf dem Substrat 1, also der Fensterverglasung, auf der die erste Elektrode 2 aufgebracht ist, elektrische Zuleitungen 9 aufgebracht sein, wie sie beispielsweise in Verbindung mit den Figuren 4A bis 4D bereits beschrieben wurden. Die elektrischen Zuleitungen 9 können beispielsweise mit Anschlussstellen 70 elektrisch leitend verbunden sein, die als Teile der Türscharniere ausgebildet sind, wobei die elektrisch leitenden Teile innerhalb der Türscharniere verlaufen. Die Türscharniere können ihrerseits mit elektrischen Kabeln verbunden sein, die innerhalb des Türrahmens verlaufen.

Weiter ist in der Figur 6 eine Notbeleuchtung 395 gezeigt, die ein hier beschriebenes Leuchtmittel 100 oder eine hier beschriebene Beleuchtungseinrichtung 1000 umfasst. Die Notbeleuchtung 395 wird beispielsweise bei einem Stromausfall aktiviert und umfasst eine autonome Stromversorgung oder wird von einem Notstromaggregat mit dem nötigen Betriebsstrom versorgt. Die hier beschriebenen Leuchtmittel 100 und Beleuchtungseinrichtungen 1000 eigenen sich besonders gut zur Verwendung als Notbeleuchtung, da sie mit relativ geringer Leistungsaufnahme Licht ausreichender Helligkeit erzeugen können.

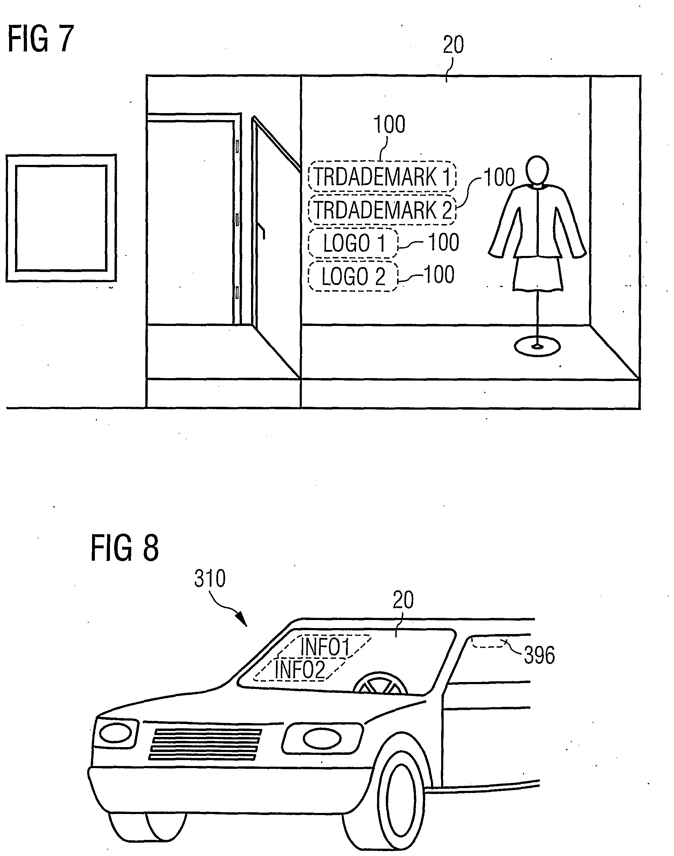

Figur 7 zeigt eine schematische perspektivische Darstellung eines Schaufensters gemäß einem Beispiel mit vier Leuchtmittel 100, die durchlässig für sichtbares Licht ausgebildet sind. Mit den Leuchtmitteln können Markennamen "Trademark 1" und "Trademark 2" und Logos "Logo 1" und "Logo 2" angezeigt werden. Wie bereits im Zusammenhang mit den Figuren 5A und 5B beschrieben, kann es sich bei den Leuchtmitteln 100 um Leuchtmittel handeln, die in die Verglasung des Schaufensters integriert sind oder ein flexibles Leuchtmittel, das mit einer Klebstoffschicht auf die Innenseite der Verglasung aufgeklebt ist.

Die Figur 8 zeigt eine schematische Frontansicht eines Kraftfahrzeuges 310 gemäß einem Beispiel. In ein Fenster 20, zum Beispiel die Windschutzscheibe, integriert sind hierbei zwei Leuchtmittel 100, die durchlässig für sichtbares Licht ausgebildet sind und geeignet sind, Informationen "Info 1" und "Info 2" für den Fahrer darzustellen. Alternativ ist es auch möglich - wie bereits in Zusammenhang mit den Figuren 7 und 6 beschrieben -, dass die beiden Leuchtmittel 100 flexibel ausgebildet sind und auf die Windschutzscheibe von innen aufgeklebt werden.

Weiter zeigt die Figur 8 eine Kfz-Innenbeleuchtung 396. Die Kfz-Innenbeleuchtung ist zum Beispiel durch ein hier beschriebenes Leuchtmittel 100 oder eine hier beschriebene Beleuchtungseinrichtung 1000 gebildet.

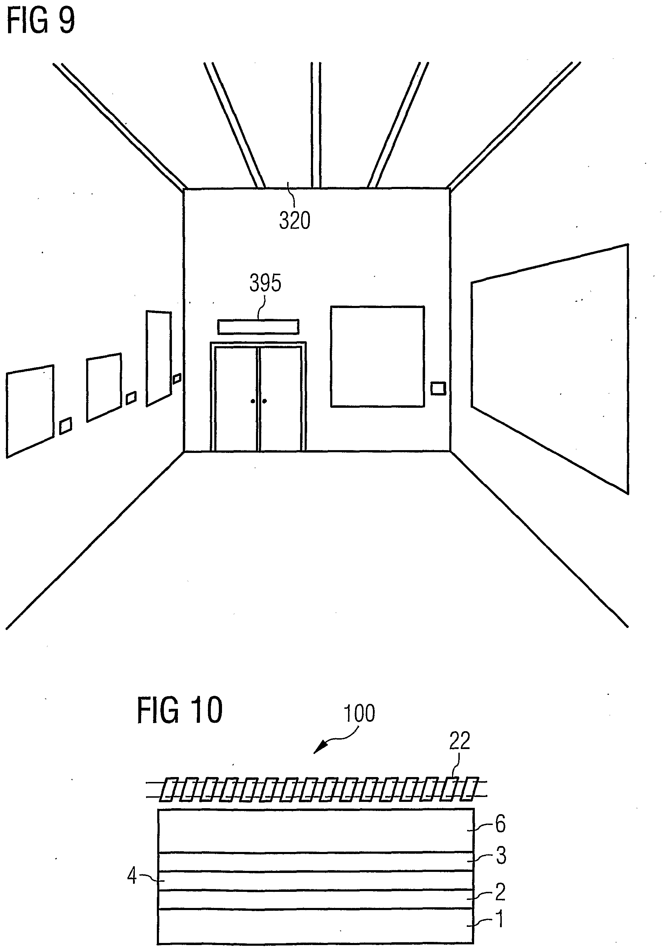

Die Figur 9 zeigt eine schematische perspektivische Darstellung eines Museumsraumes, dessen Deckenelemente 320 eine Verglasung umfassen. Die Verglasung eines Deckenelementes weist teilflächig oder ganzflächig ein Leuchtmittel 100 oder eine Beleuchtungseinrichtung 1000 auf, das durchlässig ist für sichtbares Licht. Bei der Verglasung kann es sich beispielsweise um eine Verglasung mit einem integrierten Leuchtmittel 100 handeln, wie sie anhand der Figuren 5A und 5B bereits beschrieben wurde. Alternativ kann das Leuchtmittel auch auf die Innenseite der Verglasung aufgebracht werden, beispielsweise durch Kleben.

Die Verglasung der Deckenelemente des Museumsraumes gemäß der Figur 9 ist somit geeignet, eine Beleuchtung des Raumes bei Tag mittels Tageslicht zu ermöglichen. Bei schlechten Lichtverhältnissen, beispielsweise während der Nacht, können die Leuchtmittel 100 der Verglasung als zusätzliche Lichtquellen für den Raum genutzt werden.

Die Verglasung der Deckenelemente des Museumsraumes der Figur 9 kann weiterhin milchig ausgestaltet sein. Hierzu wird entweder die Verglasung, die als Substrat dient oder die Verglasung, die als Verkapselung dient oder beide milchig ausgeführt.

Die Figur 10 zeigt eine schematische Schnittdarstellung eines Leuchtmittels 100 gemäß einem Ausführungsbeispiel. Bei dem Leuchtmittel 100 gemäß Figur 10 sind Verkapselung 6 und Substrat 1 als Verglasung ausgebildet, wie beispielsweise bei dem Leuchtmittel gemäß den Figuren 5A und 5B. Eine solche Verglasung kann beispielsweise als Fensterscheibe eines Fensters 20, aber auch einer Tür 300 oder eines Möbelstücks dienen. Bei Tag kann eine solche Verglasung als Fenster 20 genutzt werden, das heißt sichtbares Licht von außen kann ungehindert in den Raum eindringen. Bei Nacht kann das Leuchtmittel 100 aktiviert werden, so dass die Verglasung als Beleuchtungsquelle für den Raum dient. Weiterhin ist auf der Außenseite der Verglasung eine Spiegeljalousie 22 zum Schutz der Privatsphäre vorgesehen, die verhindert, dass ungebetene Blicke von außen eindringen können. Zusätzlich ist die Spiegeljalousie 22 geeignet, von dem Leuchtmittel 100 ausgesandtes Licht zu reflektieren. Aufgrund der Rückreflexion durch die Spiegeljalousie 22 erhöht sich vorteilhafterweise der Nutzungsgrad des Lichtes, das von dem Leuchtmittel 100 ausgesandt wird. Weiterhin ist es auch möglich, dass es sich bei der Jalousie 22 um eine klassische Jalousie oder um einen PDLC-Shutter handelt. Neben einem PDLC-Shutter kommen auch andere Glasarten in Frage, die sich durch Anlegen einer elektrischen Spannung verdunkeln lassen.

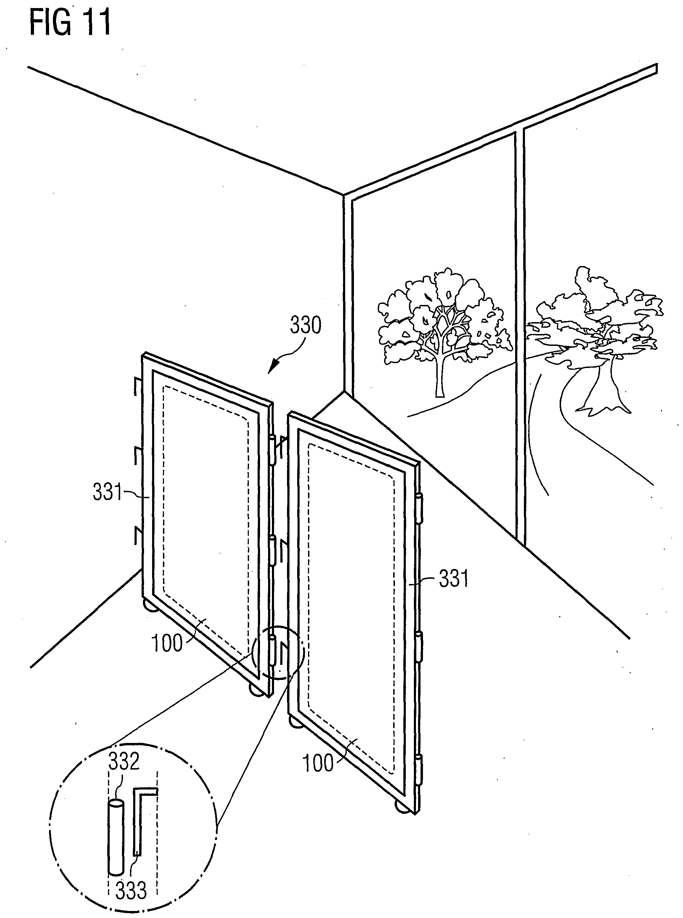

Figur 11 zeigt eine schematische perspektivische Darstellung eines Raumes mit einem Raumteiler gemäß einem Beispiel. Der Raumteiler 330 weist zwei Raumteilerelemente 331 auf mit einer Verglasung innerhalb eines Rahmens, wobei die Verglasung ein Leuchtmittel 100 umfasst, das durchlässig für sichtbares Licht ausgebildet ist. Das Leuchtmittel 100 ist entweder in die Verglasung integriert, wie beispielsweise in Verbindung mit den Figuren 5A und 5B beschrieben oder auf die Verglasung aufgeklebt. Die Raumteilerelemente 331 können aufgrund ihrer Beleuchtungsfunktion vorteilhafterweise dazu genutzt werden, Raumbereiche, die durch die Raumteiler abgetrennt werden, zu beleuchten.

Vorliegend ist der Raumteiler 330 modular aufgebaut. Er umfasst zwei Raumteilerelemente 331, die durch Steckverbindungen miteinander verbunden werden können. Hierzu umfasst der Rahmen des Raumteilerelementes auf seiner einen Seitenfläche eine Hülse 332, die beispielsweise nach Art eines Zylinders ausgeführt ist. Die Seitenfläche des Rahmens, die der Seitenfläche mit der Hülse 332 gegenüberliegt, ist mit Stiften 333 versehen, die derart ausgeführt sind, dass sie in die Hülsen 332 eingepasst werden können. Durch Einstecken der Stifte eines Raumteilerelementes in die Hülsen eines weiteren Raumteilerelementes können jeweils zwei Raumteilerelemente 331 miteinander verbunden werden. Dabei ist insbesondere auch eine elektrische Verbindung der Raumteilerelemente 331 mittels den Hülsen 332 und den Stiften 333 möglich. Der Raumteiler 330 bildet eine großflächige Beleuchtungseinrichtung.

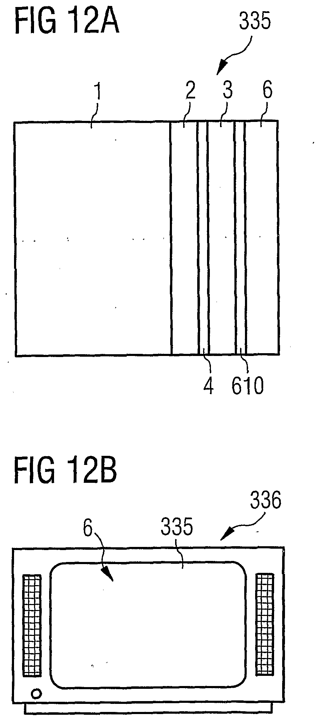

Figur 12 zeigt eine schematische Schnittdarstellung eines Displays gemäß einem Beispiel. Bei dem Display 335 kann es sich beispielsweise um das Display eines Fernsehers, eines LCD-, eines OLED-, oder eines Plasma-Bildschirms handeln. Die Frontglasscheibe des Displays wird als Substrat 1 für ein Leuchtmittel verwendet, das durchlässig für sichtbares Licht ausgebildet ist. Auf die Frontglasscheibe ist die erste Elektrode 2 aufgebracht, die ein TCO umfasst und daher durchlässig für sichtbares Licht ausgebildet ist. Auf der ersten Elektrode 2 ist ein organischer Schichtstapel 4 aufgebracht, wie er beispielsweise anhand der Figur 1 beschrieben ist. Auf diesen organischen Schichtstapel ist eine zweite Elektrode 3, vorliegend ebenfalls ein TCO umfassend, aufgebracht.

Als TCO für die Kathode ist zum Beispiel eines der folgenden TCO-Materialien besonders geeignet: ITO, ATO, Zinkoxid.

Auf die zweite Elektrode 3 ist eine weitere Glasplatte als Verkapselung 6 aufgebracht. Diese kann beispielsweise mit einer Klebstoffschicht 610 auf die zweite Elektrode 3 aufgeklebt sein. Die organischen Schichten sind vorliegend derart ausgebildet, dass die Abstrahlung aus dem organischen Schichtstapel vorwiegend durch die verkapselnde Glasscheibe erfolgt. Vorliegend kann das Leuchtmittel 100, das in die Frontscheibe des Displays 335 integriert ist, im ausgeschalteten Zustand des Displays als Beleuchtungsquelle genutzt werden. Das Leuchtmittel ist hierzu bevorzugt dimmbar ausgeführt. Im ausgeschalteten Zustand des Leuchtmittels kann der Inhalt des Displays 335 durch einen Betrachter wahrgenommen werden, da das Leuchtmittel durchlässig für sichtbares Licht ausgebildet ist.

Die Figur 12B zeigt eine schematische Draufsicht auf ein Fernsehgerät 336 mit einem Display 335, wie es in Verbindung mit der Figur 12A beschrieben ist.

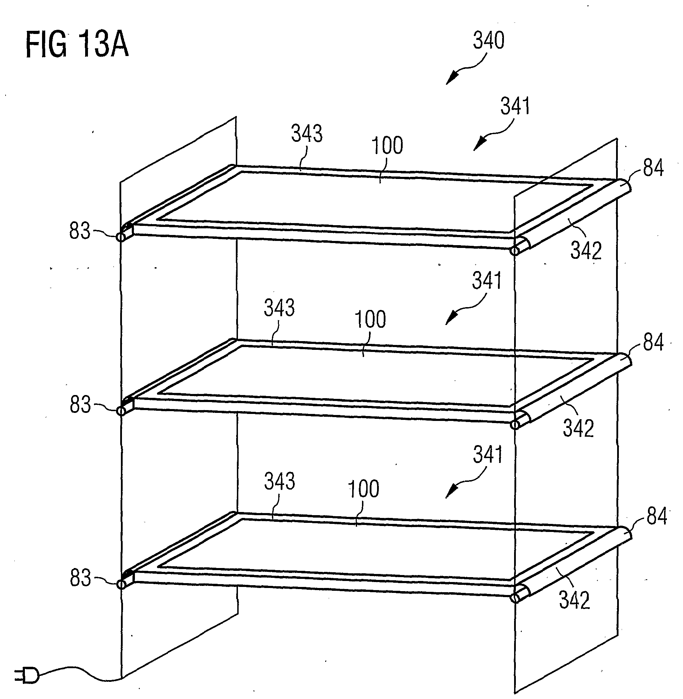

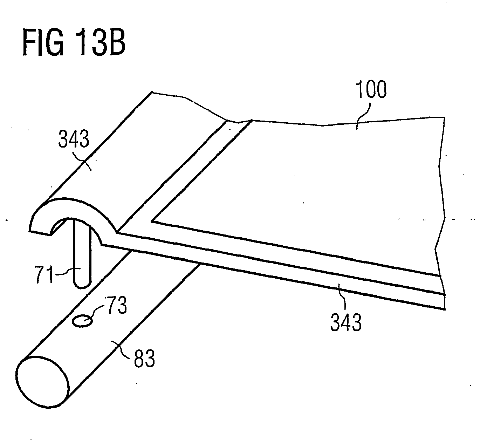

Figur 13A zeigt eine schematische perspektivische Darstellung eines Regals 340 gemäß einem Beispiel. Die Figur 13B zeigt einen Ausschnitt der Figur 13A. Das Regal 340 umfasst zwei Seitenteile mit Stangen 83, die im Inneren hohl ausgebildet sind und elektrische Kabel umfassen. Die Seitenteile mit den Stangen 83 bilden ein Stangensystem aus, wie es beispielsweise auch anhand der Figur 68 beschrieben ist. Diese Stangen 83 sind vorgesehen, Regalbretter 341 zu tragen. Hierzu umfassen die Regalbretter 341 jeweils an den Seiten entsprechend geformte Halterungen 342. Diese sind vorliegend entsprechend der Stangen der Regalseitenteile nach Art eines aufgeschnittenen Zylinders ausgebildet. Es ist jedoch auch denkbar, dass die Stangen 83 und die Halterungen 342 eckig ausgebildet sind. Die Regalbretter 341 umfassen vorliegend einen Rahmen 343, in den eine Verglasung mit einem für sichtbares Licht durchlässigen Leuchtmittel 100 eingebracht ist. Zur elektrischen Kontaktierung umfassen die Halterungen 342 der Regalbretter vorliegend einen Stift 71, der in eine elektrisch leitende Ausnehmung 73 innerhalb der Stangen 83 eingesetzt wird, wie in Figur 13B dargestellt. Die Stangen 83 der Seitenteile sind bevorzugt hohl ausgebildet. So können die Kabel, die zur Kontaktierung der Stecker verwendet werden, innerhalb der Stangen geführt werden. Regalbretter, wie sie das Regal 340 gemäß der Figur 13B zeigt, können beispielsweise auch in Vitrinen oder anderen Möbelstücken und Ablagemöbel zum Einsatz kommen.

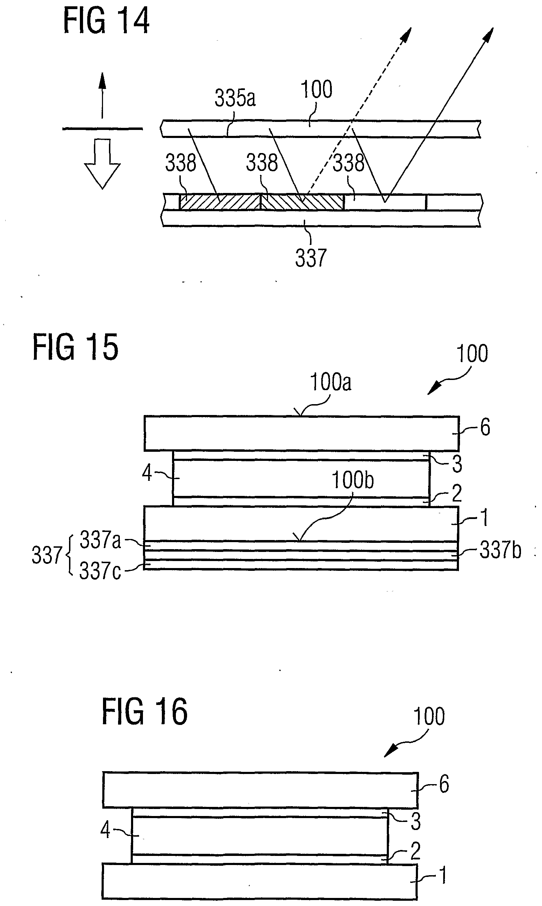

Figur 14 zeigt eine schematische Schnittdarstellung eines reflektiven Displays 335. Ein reflektives Display 335 umfasst auf seiner Rückseite ein reflektierendes Element 337, auf dem Pixel 338 angeordnet sind. Reflektive Displays 335 benötigen keine Hinterleuchtung, sondern reflektieren aufgrund des reflektiven Elementes 337 Umgebungslicht derart, dass der Displayinhalt dargestellt werden kann. Daher sind reflektive Displays 335 vom Umgebungslicht abhängig. Im Dunkeln sind diese nicht mehr ablesbar. Auf die strahlungsemittierende Vorderseite 335a des reflektiven Displays 335 ist ein für sichtbares Licht durchlässiges Leuchtmittel aufgebracht, wie beispielsweise anhand der Figur 5A beschrieben. Dieses Leuchtmittel ist vorliegend derart ausgebildet, dass es überwiegend Strahlung in Richtung des reflektiven Elementes aussendet. Zur besseren Farbwiedergabe kann das Leuchtmittel 100 leicht eingefärbt sein, zum Beispiel in der Farbe eines leichten Magenta. Hierzu ist beispielsweise die Verkapselung 6 oder das Substrat 1 oder beides in der gewünschten Farbe eingefärbt. Das Leuchtmittel wird bevorzugt mit einem Index Matching Material auf der Vorderseite 335a des reflektiven Displays angebracht, um Reflexionen zu vermeiden. Lässt sich das Leuchtmittel in der Farbe variieren, beispielsweise derart, dass der Farbraum RGB abgedeckt ist und kann das reflektive Display 335 weiterhin schnell genug geschalten werden, ist auch ein zeitsequentieller Betrieb in RGB möglich. Bei diesem zeitsequentiellen Betrieb wird das Display bevorzugt mit Frequenzen von wenigstens 70 Hz, besonders bevorzugt wenigstens 100 Hz betrieben.

Die Figur 15 zeigt eine schematische Schnittdarstellung eines Leuchtmittels 100 gemäß einem Beispiel. Die Elektroden 2, 3, das Substrat 1, die Verkapselung 6 und der organische Schichtstapel 4 sind durchlässig für sichtbares Licht, insbesondere für das von dem organischen Schichtstapel 4 erzeugte Licht, ausgebildet. Auf die Außenseite des Substrats 1, das beispielsweise durch eine Glasplatte gebildet sein kann, ist ein reflektierendes Element 337, bei dem es sich vorliegend um eine reflektierende Schichtenfolge handelt. Die reflektierende Schichtenfolge umfasst eine Kupferschicht 337b, eine Silberschicht 337a und eine Schutzlackschicht 337c, wobei die Silberschicht 337a auf das Substrat 1 aufgebracht ist, die Kupferschicht 337b auf die dem Substrat abgewandte Seite der Silberschicht 337a und die Schutzlackschicht auf die Kupferschicht 337b. Da die reflektierende Schichtenfolge entlang der Unterseite 100b des Leuchtmittels 100 ausgebildet ist, kann das Leuchtmittel 100 von dieser kein Licht mehr aussenden, sondern nur noch von seiner Oberseite 100a. Weiterhin reflektiert das reflektierende Element Licht, dass durch die erste Elektrode 2 und das Substrat 1 hindurch tritt in Richtung der Oberseite 100a des Leuchtmittels 100.

Alternativ zu der oben beschriebenen Schichtenfolge mit einer Silberschicht, einer Kupferschicht und einer Schutzlackschicht kann als reflektierendes Element 337 beispielsweise auch ein dielektrischer Spiegel verwendet sein, der wie die Schichtenfolge oben auf die Außenseite des Substrates aufgebracht ist.

Das reflektierende Element 337, wie eine reflektierende Schichtenfolge oder ein dielektrischer Spiegel, kann beispielsweise weiterhin auf der Außenseite der Verkapselung 6 aufgebracht oder zwischen Substrat 1 und erster Elektrode 2 sowie zwischen Verkapselung 6 und zweiter Elektrode 3 angebracht sein. Ist das reflektierende Element auf der Außenseite der Verkapselung 6 oder zwischen Verkapselung 6 und zweiter Elektrode 3 angeordnet, so sendet das Leuchtmittel 100 Licht von seiner Unterseite 100b aus.

Ein Leuchtmittel 100, wie es in der Figur 15 dargestellt ist, erlaubt es insbesondere, als Spiegel zu dienen, wenn das Leuchtmittel deaktiviert ist und im Betrieb des Leuchtmittels 100 als Beleuchtungsquelle. Bei einem solchen Leuchtmittel 100 kann entweder die gesamte lichtemittierende Vorderseite 100a als Beleuchtung oder als Spiegel dienen. Weiterhin ist es auch möglich, dass die gesamte lichtemittierende Vorderseite 100a als Beleuchtung und als Spiegel dient. Weiterhin kann die lichtemittierende Vorderseite 100a auch in Bereiche aufgeteilt sein, so dass ein Teil der lichtemittierenden Vorderseite 100a als Spiegel dient und ein weiterer Teil als Beleuchtungsquelle.

Beispielsweise kann das Leuchtmittel aber auch so ausgebildet sein, dass es Licht sowohl von seiner Vorderseite 100a als auch von seiner Rückseite 100b abstrahlt. Beispielsweise unter Verwendung des so genannten Cavity-Effekts ist es möglich, dass dabei von unterschiedlichen Seiten des Leuchtmittels Licht mit unterschiedlichen Lichteigenschaften austritt. Ein derartiges Leuchtmittel ist zum Beispiel in der deutschen Patentanmeldung 102006046196.7 beschrieben, deren Offenbarungsgehalt hiermit ausdrücklich per Rückbezug aufgenommen wird.

Figur 16 zeigt eine schematische Schnittdarstellung eines Leuchtmittels 100 gemäß einem weiteren Beispiel.

Folgende Elemente des Leuchtmittels 100 sind durchlässig für sichtbares Licht ausgebildet: Verkapselung 6, Substrat 1, erste Elektrode 2 und organischer Schichtstapel 4. Als Substrat 1 kann beispielsweise eine Glasplatte oder eine Kunststofffolie verwendet werden, die durchlässig für sichtbares Licht ausgebildet ist.

Die erste Elektrode 2 kann beispielsweise aus einem TCO gebildet sein.

Bei dem organischen Schichtstapel 4 kann es sich um einen Schichtstapel handeln, wie er anhand der Figur 1 bereits beschrieben wurde.

Bei der Verkapselung 6 kann es sich beispielsweise um eine Glaskappe, eine Glasplatte, eine Kunststoffkappe oder eine Kunststoffplatte handeln.

Weiterhin kann auf der zu dem organischen Schichtstapel 4 weisenden Innenseite der Kappe oder der Platte ein Gettermaterial aufgebracht sein, das ebenfalls durchlässig für sichtbares Licht ausgebildet ist. Weiterhin kann es sich bei der Verkapselung 6 um eine Dünnfilmverkapselung handeln, die mindestens eine Barriereschicht aufweist. Die Barriereschicht kann beispielsweise aus SiO_{X} oder SiN_{X} bestehen oder eines dieser Materialien aufweisen. Weiterhin kann die Dünnfilmverkapselung 6 auch erste und zweite Barriereschichten 601, 602 aufweisen, die hinsichtlich ihrer Materialzusammensetzung alternieren. Zwischen den alternierenden Barriereschichten können beispielsweise Polymerzwischenschichten angeordnet sein, siehe dazu zum Beispiel auch die Figur 3.

Figur 17A zeigt eine schematische Schnittdarstellung einer Dünnfilmverkapselung 6 mit alternierenden Barriereschichten 601, 602, wobei jeweils zwischen zwei benachbarten Barriereschichten unterschiedlicher Materialzusammensetzung eine Polymerzwischenschicht 604 angebracht ist. Bei den Barrierezwischenschichten kann es sich beispielsweise um zwei Barriereschichten 601 handeln, die SiO_{X} aufweisen und um zwei Barriereschichten 602, die SiN_{X} aufweisen, wie sie in Verbindung mit Figur 3 bereits beschrieben wurden. Wie bei dem Ausführungsbeispiels gemäß der Figur 3 sind die Barriereschichten 601, 602 alternierend hinsichtlich ihrer Materialzusammensetzung angeordnet, das heißt, dass erste Barriereschichten 601 mit zweiten Barriereschichten 602 innerhalb der Dünnfilmverkapselung 6 abwechseln, wobei die ersten und die zweiten Barriereschichten 601, 602 unterschiedliche Materialzusammensetzung aufweisen. Im Unterschied zu der Dünnfilmverkapselung 6 gemäß der Figur 3 sind die Barriereschichten 601, 602 jedoch durch Polymerzwischenschichten 604 voneinander getrennt.

Alternativ zu der Verwendung eines separaten reflektierenden Elementes 337, wie beispielsweise der oben beschriebenen reflektierenden Schichtenfolge oder des dielektrischen Spiegels, ist die zweite Elektrode 3 des Leuchtmittels gemäß der Figur 16 reflektierend für sichtbares Licht ausgebildet. Hierzu umfasst die zweite Elektrode 3 beispielsweise Aluminium oder Silber oder besteht aus einem dieser Materialien. Ein derartiges Leuchtmittel ist ebenso dazu geeignet, als Spiegel und/oder Beleuchtungsquelle zu dienen, wie das Leuchtmittel gemäß der Figur 15.

Um ein Leuchtmittel zu erhalten, das als Spiegel und/oder als Beleuchtungsquelle dienen kann und kein zusätzliches reflektierendes Element aufweist, ist es auch möglich, die zweite Elektrode 3 durchlässig für sichtbares Licht auszubilden, beispielsweise indem ein TCO als Elektrodenmaterial verwendet wird, und stattdessen die Verkapselung 6, das Substrat 1 oder die erste Elektrode 2 reflektierend auszubilden.

Bei einer reflektierenden Verkapselung 6 kann es sich beispielsweise um eine polierte Metallkappe handeln.

Figur 17B zeigt eine schematische Schnittdarstellung durch eine reflektierende Verkapselung 6 gemäß einem Beispiel. Hierbei handelt es sich um eine Kappe, die entweder bereits reflektierend ausgebildet ist, beispielsweise indem sie aus einem polierten Metall gebildet ist, oder um eine Kappe, die nicht reflektierend ausgebildet ist. Auf die zu dem organischen Schichtstapel 4 weisenden Innenseite der Kappe ist ein reflektierendes Element 337, zum Beispiel eine reflektierende Schicht aufgebracht. Bei der reflektierenden Schicht auf der Innenseite der Kappe kann es sich beispielsweise um eine metallische Schicht handeln, die etwa Silber aufweist oder aus Silber besteht. Weiterhin kann die reflektierende Schicht auch mehrere Schichten aufweisen. Auf der reflektierenden Schicht ist weiterhin eine Getterschicht 611 aus einem Gettermaterial aufgebracht, das durchlässig für sichtbares Licht ausgebildet ist.

Figur 17C zeigt eine schematische Schnittdarstellung durch eine Dünnfilmverkapselung 6 gemäß einem weiteren Beispiel. Die Dünnfilmverkapselung 6 weist wie die Dünnfilmverkapselung 6 gemäß Figur 17A alternierende Barriereschichten 601, 602 auf, die durch Polymerzwischenschichten 604 voneinander getrennt sind. Im Unterschied zu der Dünnfilmverkapselung 6 gemäß Figur 17A weist die Dünnfilmverkapselung 6 gemäß Figur 17C ein reflektierendes Element 337, zum Beispiel eine reflektierende Schichtenfolge auf, wie sie anhand der Figur 15 bereits beschrieben wurde. Die reflektierende Schichtenfolge umfasst eine Silberschicht 337a, die auf die äußerste Barriereschicht 602 aufgebracht ist. Auf die Silberschicht 337a ist eine Kupferschicht 337b aufgebracht, auf der wiederum eine Schutzlackschicht 337c angeordnet ist. Aufgrund der reflektierenden Schichtenfolge ist die Dünnfilmverkapselung reflektierend ausgebildet und kann als reflektierende Verkapselung verwendet werden.

Eine weitere Möglichkeit, ein Leuchtmittel 100 auszubilden, bei dem zwischen Spiegelfunktion und Beleuchtungsfunktion hin und her geschalten werden kann, besteht darin, das Substrat 1 reflektierend auszubilden, während die anderen Elemente des Leuchtmittels, die das im organischen Schichtstapel 4 erzeugte Licht auf dem Weg zur lichtemittierenden Vorderseite 100a durchlaufen muss, insbesondere die zweite Elektrode 3, der organische Schichtstapel 4 und die Verkapselung 6 durchlässig für sichtbares Licht ausgebildet sind. Ein reflektierendes Substrat 1 kann beispielsweise Metall aufweisen oder aus einem Metall bestehen. Als reflektierendes Substrat 1 kann beispielsweise eine Metallfolie, wie eine Edelstahlfolie verwendet sein. Insbesondere kann als Substrat ein Spiegel verwendet sein. Weiter eignet sich ein Laminat aus Kunststofffolien, auf die eine Metallfolie - beispielsweise aus Aluminium - auflaminiert ist, als reflektierendes Substrat. Weiter kann es sich bei dem Substrat um ein reflektierend beschichtetes Glassubstrat handeln.

Alternativ oder zusätzlich zu einem reflektierenden Substrat 1 kann auch die erste Elektrode 2 reflektierend ausgebildet sein. Eine solche kann beispielsweise eines der folgenden Materialien aufweisen oder aus einem solchen bestehen: Aluminium, Silber.

Weiter ist es auch möglich, dass die Dünnfilmverkapselung 6 an sich einen dielektrischen Spiegel oder einen Bragg-Spiegel bildet. Das Material der ersten und der zweiten Barriereschichten 601, 602 sowie die Dicke dieser Schichten ist dann entsprechend gewählt.

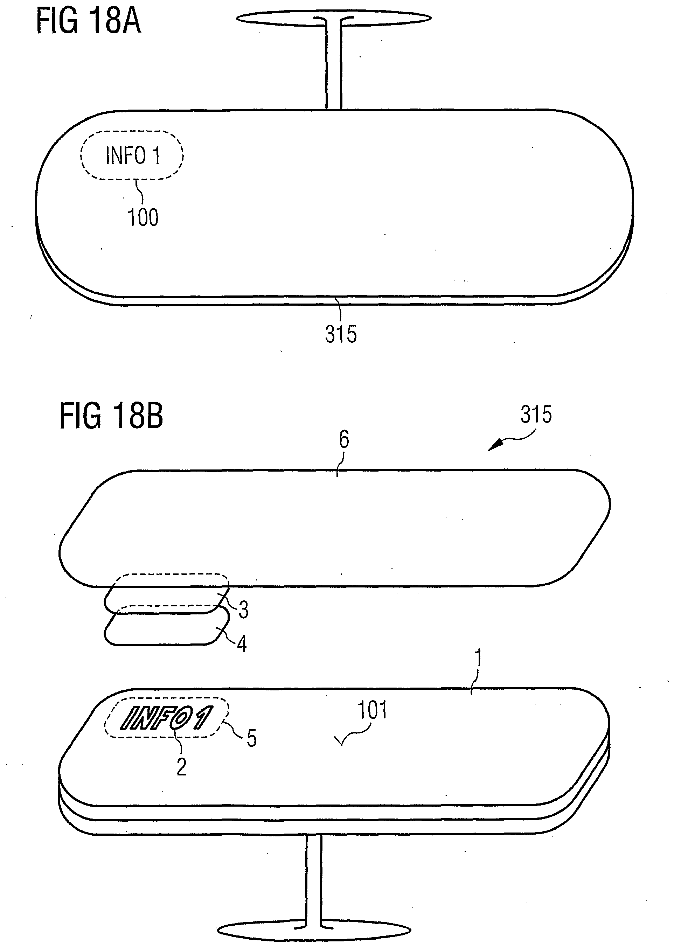

Die Figur 18A zeigt eine perspektivische schematische Darstellung eines Kraftfahrzeugspiegels 315 mit einem Leuchtmittel 100, bei dem zwischen Beleuchtungsfunktion und Spiegelfunktion umgeschaltet werden kann, wie sie beispielsweise in Verbindung mit den Figuren 15 bis 17C beschrieben wurden. Das Leuchtmittel weist vorliegend eine Leuchtfläche auf, die gemäß des Schriftzuges "Info 1"ausgebildet ist. Hierzu kann eine der Elektroden 2, 3 strukturiert sein, wie anhand der Figur 5B beschrieben. Im Unterschied zu der Figur 5B weist das Leuchtmittel 100 gemäß der Figur 18A jedoch ein reflektierendes Element 337 auf, beispielsweise eine zusätzliche reflektierende Schichtenfolge. Weiterhin kann auch eines der Elemente des Leuchtmittels 100, beispielsweise eine der Elektroden 2, 3, das Substrat 1 oder die Verkapselung 6 reflektierend ausgebildet sein, wie oben beschrieben. Auf diese Weise können Logos, Symbole oder andere Informationen vor dem Hintergrund einer Spiegelfläche nach Belieben leuchtend angezeigt werden. In dem Kraftfahrzeugspiegel 315 könnten mit Hilfe dieser Leuchtmittel 100 beispielsweise Warnungen, wie etwa Abstandsmeldungen beim Einparken, eingeblendet werden.

Die Figur 18B zeigt eine schematische perspektivische Darstellung des Kraftfahrzeugspiegels 315 gemäß der Figur 18A. Als Substrat 1 ist bei dem Kraftfahrzeugspiegel ein Spiegel verwendet. Das Substrat 1 ist mit einem Halter verbunden. Innerhalb eines aktiven Bereiches 5 auf dem Substrat ist eine erste Elektrode 2 aufgebracht. Die erste Elektrode 2 ist durchlässig für sichtbares Licht ausgebildet, beispielsweise indem sie aus einem TCO gebildet ist. Weiterhin ist die erste Elektrode 2 gemäß dem Schriftzug "Info 1" strukturiert. Auf die strukturierte erste Elektrode 2 ist ein organischer Schichtstapel 4 aufgebracht, der durchlässig für sichtbares Licht ist. Auf den organischen Schichtstapel 4 ist weiterhin die zweite Elektrode 3 aufgebracht, die ebenfalls durchlässig für sichtbares Licht ausgebildet ist. Als Verkapselung 6 ist eine Glasplatte verwendet, die über der zweiten Elektrode angebracht ist. Der organische Schichtstapel 4 und die zweite Elektrode 3 sind vollflächig innerhalb des aktiven Bereiches 5 aufgebracht. Damit das Leuchtmittel 100 eine Leuchtfläche aufweist, die gemäß einem Schriftzug strukturiert ist, ist es ausreichend, die erste Elektrode 2 zu strukturieren. Die Verwendung eines Spiegels als Substrat 1 erlaubt es, das Leuchtmittel auf einfache Art und Weise in den Kraftfahrzeugspiegel 315 zu integrieren.

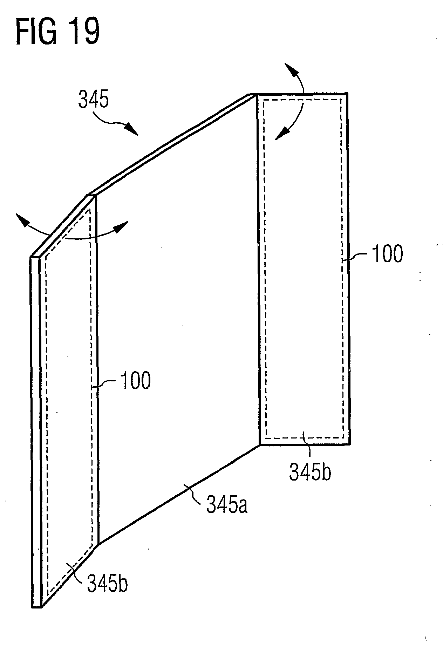

Figur 19 zeigt eine schematische perspektivische Darstellung eines mehrteiligen Spiegels 345 gemäß einem Beispiel. Ein solcher kann beispielsweise als Bad- oder Garderobenspiegel verwendet werden. Der Spiegel 345 umfasst einen Mittelteil 345a und zwei seitlich des Mittelteils angeordnete schwenkbare Seitenflügel 345b (in der Figur durch Pfeile angedeutet). Die Seitenflügel 345b umfassen jeweils ein Leuchtmittel 100, bei dem zwischen reflektierender und beleuchtender Funktion umgeschaltet werden kann und dessen Leuchtfläche die Fläche des Seitenflügels jeweils nahezu ganzflächig ausfüllt. Bei guten Lichtverhältnissen können die Seitenflügel 345b als normale Spiegel genutzt werden. Bei schlechten Lichtverhältnissen, beispielsweise im Dunkeln oder im Zwielicht, kann einer der beiden Seitenflügel oder beide Seitenflügel 345b des Spiegels als Beleuchtungsquelle zugeschaltet werden, um den Betrachter anzuleuchten. Weiterhin können die beleuchteten Seitenflügel 345b als dekoratives Beleuchtungselement dienen.

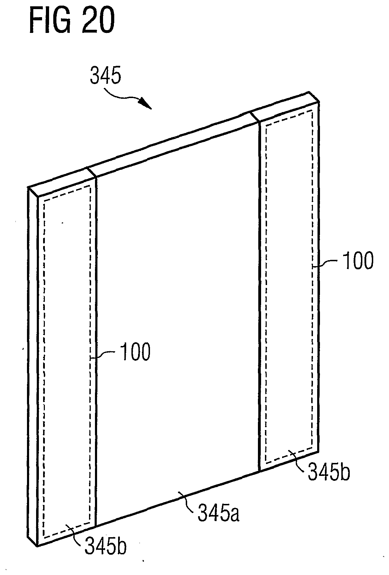

Figur 20 zeigt wie die Figur 19 eine schematische perspektivische Darstellung eines mehrteiligen Spiegels 345 gemäß einem weiteren Beispiel. Bei diesem Spiegel handelt es sich ebenfalls um einen dreiteiligen Spiegel mit einem Mittelteil 345a und zwei seitlich des Mittelteils angeordneten Seitenflügel 345b, in die Leuchtmittel 100 eingebracht sind, bei denen zwischen spiegelnder und beleuchtender Funktion hin und her geschalten werden kann.

Auch ein solcher Spiegel kann beispielsweise als Bad- oder Garderobenspiegel verwendet werden.

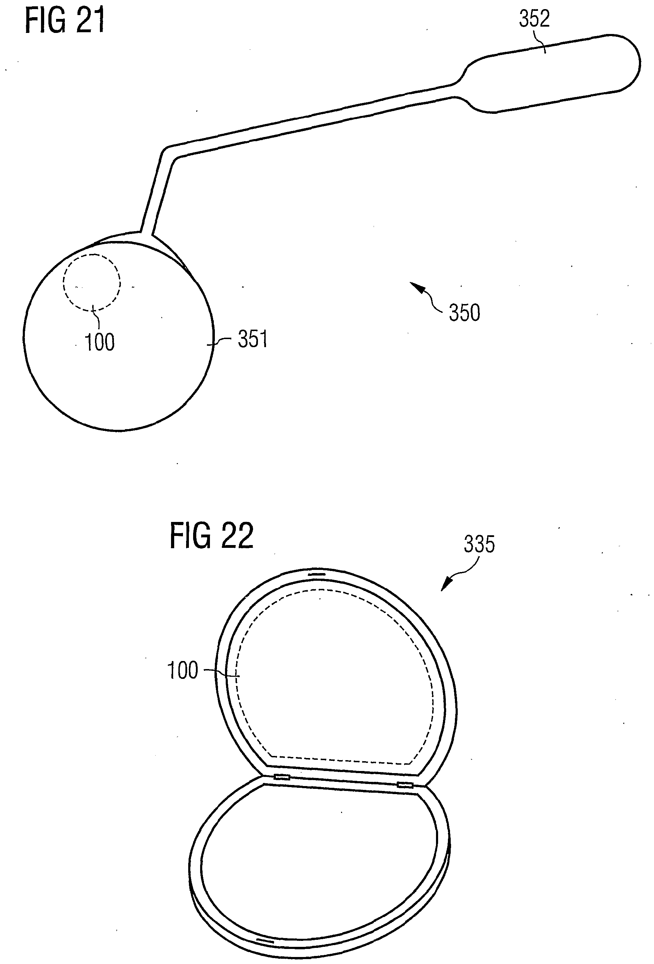

Figur 21 zeigt eine schematische perspektivische Darstellung eines Suchspiegels 350 gemäß einem Beispiel. Der Suchspiegel 350 umfasst ein Spiegelelement 351 und ein Halteelement 352, an dem das Spiegelelement befestigt ist. Das Haltelement 352 ist hierbei geknickt ausgeführt, um mittels dem Spiegelelement 351 schwer zugängliche Stellen einsehen zu können. Bei einem solchen Suchspiegel kann es sich beispielsweise um einen zahnärztlichen Spiegel handeln.

Der Suchspiegel 350 umfasst auf seinem Spiegelelement 351 ein Leuchtmittel 100, bei dem zwischen reflektierender und beleuchtender Funktion hin und her geschalten werden kann. Das Leuchtmittel kann einen Teil der Spiegelfläche oder nahezu die gesamte Spiegelfläche umfassen. Er bietet daher die Möglichkeit, schwer zugängliche Orte gleichzeitig auszuleuchten und einzusehen. Ein solcher Spiegel kann auch im häuslichen Bereich Verwendung finden, beispielsweise zur Suche nach verlorenen Gegenständen hinter/unter schwer verrückbaren Möbeln.

Figur 22 zeigt eine schematische perspektivische Darstellung eines Schminkspiegels gemäß einem Beispiel. Der Schminkspiegel ist vorliegend in ein Kosmetikset, wie eine Puderdose, integriert. Weiterhin umfasst der Schminkspiegel ein Leuchtmittel, bei dem zwischen spiegelnder und beleuchtender Funktion hin und her geschalten werden kann. Bei schlechten Sichtverhältnissen kann das Leuchtmittel aktiviert werden. Bei niedriger Helligkeit ist der Schminkspiegel 355 daher gleichzeitig als Kosmetikspiegel und als Gesichtsbeleuchtung nutzbar. Das Leuchtmittel 100 kann einen Teil oder nahezu die gesamte Spiegelfläche umfassen.

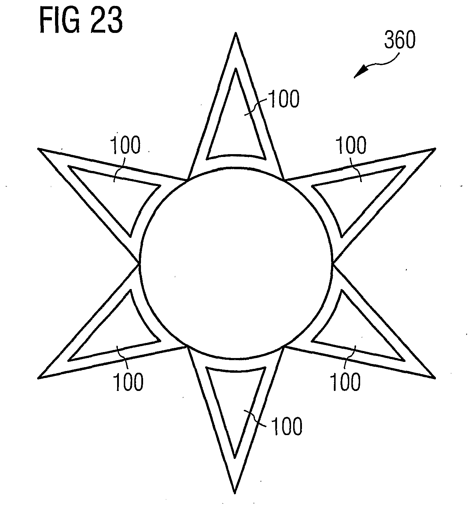

Die Figur 23 zeigt eine schematische Draufsicht auf ein dekoratives Element 360 gemäß einem Beispiel. Das dekorative Element 360 ist vorliegend als blinkender Weihnachtsstern ausgebildet. Eine Grundfläche des Sterns ist spiegelnd ausgebildet, wobei in Teilbereiche des Sterns Leuchtmittel eingebracht sind, bei denen zwischen reflektierender und beleuchtender Funktion hin und her geschaltet werden kann. Diese Leuchtmittel können beispielsweise auch farbig ausgebildet sein. Dabei kann es sich insbesondere auch um mehrfarbige Leuchtmittel 100 handeln, wie sie weiter unten beschrieben sind.

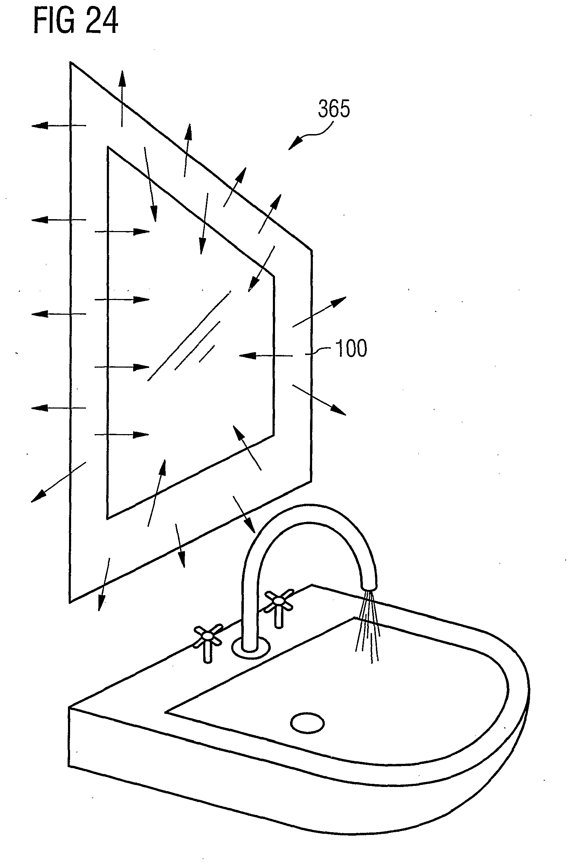

Die Figur 24 zeigt eine schematische perspektivische Darstellung eines Spiegels 365 gemäß einem weiteren Beispiel. Der Spiegel 365 ist vorliegend zur Verwendung im häuslichen Nassbereich vorgesehen. Der Spiegel weist vorliegend einen Außenbereich auf, der mit einem Leuchtmittel 100 versehen ist, bei dem zwischen beleuchtender und spiegelnder Funktion hin und her geschaltet werden kann.

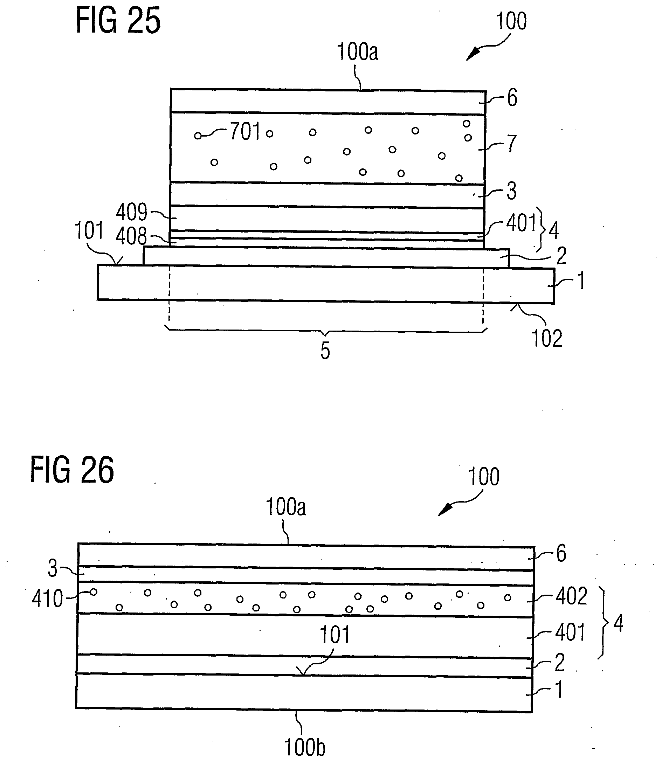

Die Figur 25 zeigt in einer schematischen Schnittdarstellung ein Leuchtmittel 100 gemäß einem Beispiel eines hier beschriebenen Leuchtmittels.

Bei dem in der Figur 25 dargestellten Leuchtmittel 100 handelt es sich um ein flexibles Leuchtmittel. Das flexibel ausgebildete Leuchtmittel 100 zeichnet sich unter anderem dadurch aus, dass es bis zu einem gewissen Grad biegbar ist, ohne durch das Biegen beschädigt zu werden. Vorzugsweise ist das flexibel ausgebildete Leuchtmittel mehrmals biegbar, ohne dabei beschädigt zu werden. Das Leuchtmittel ist dann also geeignet, eine Mehrzahl von Biegezyklen unbeschadet zu überstehen.

Das Leuchtmittel 100 der Figur 25 umfasst ein Substrat 1. Bei dem Substrat 1 handelt es sich um ein flexibles, metallisches Substrat 1. Das metallische Substrat 1 enthält oder besteht aus einem der folgenden Metalle: Aluminium, Edelstahl, Gold, Silber. Vorzugsweise ist das Substrat 1 dabei als Metallfolie mit einer Dicke von höchstens 1 mm, besonders bevorzugt höchstens 0,5 mm ausgeführt. Weiter ist es möglich, dass das flexible, metallische Substrat 1 als Mittelblech mit einer Dicke von wenigstens 3 mm und höchstens 4,75 mm oder als Feinblech mit einer Dicke von höchstens 3 mm ausgeführt ist.

Direkt auf die erste Hauptfläche 101 des Substrats 1 ist eine erste Elektrode 2 aufgebracht. Bei der ersten Elektroden 2 handelt es sich zum Beispiel um eine Kathode des Leuchtmittels 100.

Die Kathode ist geeignet, Elektronen in den der Kathode nachfolgenden organischen Schichtstapel einzuprägen. Die Kathode weist dazu ein Material auf, das sich durch eine geringe Austrittsarbeit für Elektronen auszeichnet. Die Kathode enthält oder besteht dabei vorzugsweise aus Alkalimetallen oder Erdalkalimetallen. Weiter kann die Kathode eine oder mehrere Schichten umfassen, die aus Silber, Aluminium und/oder Platin bestehen oder zumindest eines dieser Metalle enthalten.

Vorzugsweise direkt auf die Kathode ist der organische Schichtstapel 4 aufgebracht. Der organische Schichtstapel 4 umfasst zumindest eine Schicht 401, die geeignet ist, im Betrieb des Leuchtmittels 100 Licht zu erzeugen.

Der organische Schichtstapel 4 kann weitere organische Schichten, wie zum Beispiel eine Loch leitende Schicht 409 oder eine Elektronen leitende Schicht 408, umfassen. Die Elektronen leitende Schicht grenzt vorzugsweise direkt an die Kathode an. Die Loch leitende Schicht ist auf der der Kathode abgewandten Seite der Licht erzeugenden Schicht 401 des Schichtstapels 4 angeordnet und grenzt bevorzugt an die Anode des Leuchtmittels 100.

Vorzugsweise direkt auf dem organischen Schichtstapel 4 ist eine zweite Elektrode 3 angeordnet. Bei der zweiten Elektrode 3 handelt es sich zum Beispiel um eine Anode des Leuchtmittels 100.

Die Anode ist vorgesehen, Löcher in den organischen Schichtstapel zu injizieren. Die Anode weist ein Material auf, das eine hohe Austrittsarbeit für Elektronen aufweist. Beispielsweise Indium-Zinn-Oxid (ITO - Indium Tin Oxide) ist ein geeignetes Material zur Bildung der Anode.

Vorzugsweise direkt auf die zweite Elektrode 3 ist eine Planarisierungsschicht 7 aufgebracht. Die Planarisierungsschicht 7 besteht aus oder enthält ein organisches Material.

Gemäß dem in Verbindung mit der Figur 25 beschriebenen Beispiel sind in die Planarisierungsschicht zusätzliche Streuzentren 701 eingebracht. Bei den Streuzentren 701 kann es sich beispielsweise um Partikel zumindest eines der folgenden Materialien handeln: Lumineszenzkonversionsmaterial, Farbfiltermaterial, Diffusermaterial. Als Lumineszenzkonversionsmaterialien können beispielsweise die im allgemeinen Beschreibungsteil bereits erwähnten Materialien dienen.

Als Farbfiltermaterialen eigenen sich zum Beispiel FarbPigmente, die in einem Matrixmaterial dispergiert sind. Bei dem Matrixmaterial handelt es sich zum Beispiel um transparente Kunststoffe wie Acrylat, Polyacrylat oder Polyimid. Das Farbfiltermaterial lässt nur Licht einer bestimmten Farbe - zum Beispiel grünes, rotes oder blaues Licht durch.

Bei dem Diffusermaterial handelt es sich zum Beispiel um Licht streuende Partikel wie Titanoxid, Siliziumoxid oder Partikel der oben beschriebenen Lumineszenzkonversionsmaterialien, die in eine Matrix eingebettet sein können.

Vorzugsweise direkt auf die Planarisierungsschicht 7 ist eine Verkapselung 6 aufgebracht. Die Verkapselung 6 ist durch eine Mehrzahl von Barriereschichten gebildet, die vorzugsweise ein anorganisches Material enthalten. Die Barriereschichten bilden als Teil einer Dünnfilmverkapselung die flexible Verkapselung des Leuchtmittels. Beispielsweise sind auf die Planarisierungsschicht 7 abwechselnd erste und zweite Barriereschichten 601, 602 aufgebracht. Dabei bestehen die ersten Barriereschichten 601 aus einem Siliziumoxid, die zweiten Barriereschichten 602 bestehen dann aus einem Siliziumnitrid, siehe dazu auch die Figur 3, in der eine solche Dünnfilmverkapselung näher erläutert ist.

Insgesamt ist in Verbindung mit der Figur 25 ein flexibles Leuchtmittel 100 mit einem metallischen Substrat 1 beschrieben.

Das Leuchtmittel gemäß der Figur 25 ist dazu vorgesehen, Licht von seiner Oberseite 100a zu emittieren. Hierzu sind die Elemente, die das im organischen Schichtstapel erzeugte Licht auf seinem Weg zur Oberseite 100a durchlaufen muss, insbesondere der organische Schichtstapel 4 selber, die zweite Elektrode 3 und die Verkapselung 6 durchlässig für sichtbares Licht ausgebildet. Weiterhin ist ebenfalls die Planarisierungsschicht 7 durchlässig für sichtbares Licht ausgebildet.

Die erste Hauptfläche 101 des Substrats 1 des Leuchtmittels 100 kann durch Polieren der Hauptfläche 101 reflektierend für das im organischen Schichtstapel 4 erzeugte Licht ausgebildet sein. Bei dem in Verbindung mit der Figur 25 beschriebenen Leuchtmittel handelt es sich dann um ein flexibles, reflektierendes Leuchtmittel.

Die Figur 26 zeigt in einer schematischen Schnittdarstellung ein Beispiel eines hier beschriebenen Leuchtmittels.

Bei dem in Verbindung mit der Figur 26 beschriebenen Leuchtmittel 100 handelt es sich um ein flexibles Leuchtmittel. Das flexible Leuchtmittel 100 ist dabei vorzugsweise derart flexibel ausgebildet, dass es - ohne dabei beschädigt zu werden - auf eine Rolle aufrollbar und von einer Rolle abrollbar ist.

Das Leuchtmittel 100 umfasst ein Substrat 1. Das Substrat 1 ist als Kunststofffolie ausgebildet. Das heißt das Substrat 1 weist eine Dicke von höchstens 1 mm, bevorzugt höchstens 0,5 mm, besonders bevorzugt von zwischen wenigstens 50 bis höchstens 500 µm, zum Beispiel 250 µm auf und enthält oder besteht aus einem Kunststoff. Als Kunststoffe sind unter anderem PE, Polyimid und ähnliche Kunststoffe geeignet.

Vorzugsweise direkt auf die erste Hauptfläche 101 des Substrats 1 ist eine erste Elektrode 2 aufgebracht, die vorzugsweise durchlässig für sichtbares Licht ist. Das heißt die erste Elektrode 2 ist - wie weiter oben beschrieben - für das von Leuchtmittel im Betrieb erzeugte Licht zumindest teilweise durchlässig ausgebildet. Die erste Elektrode 2 kann dazu aus einem lichtdurchlässigen Material bestehen und/oder gitterförmig ausgebildet sein.

Vorzugsweise direkt auf die erste Elektrode 2 ist der organische Schichtstapel 4 aufgebracht. Der organische Schichtstapel 4 umfasst zumindest eine Licht erzeugende organische Schicht 401. Ferner umfasst der organische Schichtstapel 4 eine äußerste organische Schicht 402, die beispielsweise direkt an die zweite Elektrode 3 grenzt. Die äußerste organische Schicht ist mit einem Dotierstoff 410 dotiert. Bevorzugt handelt es sich bei dem Dotierstoff 410 der dotierten Schicht - wie weiter oben ausgeführt - um möglichst große Atome oder Moleküle, die geeignet sind, Elektronen - n-Dotierstoff - oder Löcher - p-Dotierstoff - abzugeben. Weiterhin weist der Dotierstoff eine geringe Diffusionskonstante innerhalb des organischen Schichtstapels 4 auf. Dazu ist der Dotierstoff aus möglichst großen Atomen oder Molekülen gebildet. Beispielsweise Cäsium erweist sich dabei als ein geeigneter Dotierstoff.

Vorzugsweise direkt auf den organischen Schichtstapel 4 ist die zweite Elektrode 3 aufgebracht. Die zweite Elektrode 3 ist - wie weiter oben beschrieben - lichtdurchlässig ausgebildet. Das heißt die zweite Elektrode 3 ist aus einem lichtdurchlässigen Material gebildet und/oder gitterförmig ausgebildet.

Vorzugsweise direkt auf die zweite Elektrode 3 ist eine lichtdurchlässige Verkapselung 6 aufgebracht. Die Verkapselung 6 ist vorzugsweise durch eine lichtdurchlässige Kunststofffolie gebildet. In diesem Fall kann die lichtdurchlässige Verkapselung 6 aus dem gleichen Material wie das Substrat 1 gebildet sein. Es ist jedoch auch denkbar, dass die Verkapselung aus einer oder mehreren Barriereschichten gebildet ist, wie sie beispielsweise in Verbindung mit der Figur 3 beschrieben sind. Die Verkapselung 6 ist in diesem Fall als flexible Dünnfilmverkapselung ausgeführt.

Insgesamt ist in Verbindung mit der Figur 26 ein lichtdurchlässiges, flexibles Leuchtmittel 100 beschrieben. Insbesondere aufgrund des als Kunststofffolie ausgebildeten, besonders flexiblen Substrats 1 und der als Kunststofffolie oder Dünnfilmverkapselung ausgebildeten, besonders flexiblen Verkapselung 6 ist das Leuchtmittel 100 derart flexibel, dass es auf eine Rolle aufrollbar und von einer Rolle abrollbar ist, ohne dabei beschädigt zu werden.

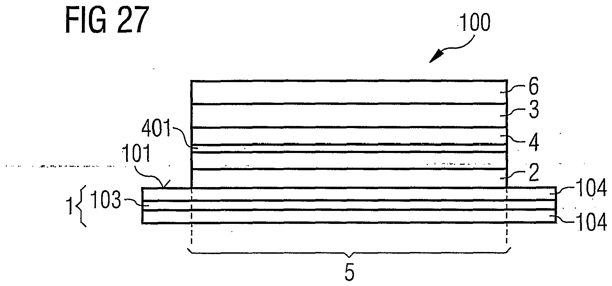

Die Figur 27 zeigt ein Beispiel eines hier beschriebenen Leuchtmittels 100 in einer schematischen Schnittdarstellung.

Bei dem unter Zuhilfenahme der Figur 27 erläuterten Leuchtmittel 100 handelt es sich um ein flexibles Leuchtmittel. Das flexible Leuchtmittel 100 der Figur 27 zeichnet sich unter anderem dadurch aus, dass es bis zu einem gewissen Grad biegbar ist, ohne dabei beschädigt zu werden. Vorzugsweise ist das flexibel ausgebildete Leuchtmittel mehrmals biegbar, ohne dabei beschädigt zu werden. Das Leuchtmittel ist dann also geeignet, eine Mehrzahl von Biegezyklen unbeschadet zu überstehen. Das Leuchtmittel 100 kann dabei derart flexibel ausgebildet sein, dass das Leuchtmittel - ohne dabei eine negative Beeinträchtigung zu erfahren - auf eine Rolle aufrollbar und von einer Rolle abrollbar ist.

Das Leuchtmittel 100 umfasst ein Substrat 1. Bei dem Substrat 1 handelt es sich um ein flexibles Laminat-Substrat. Das heißt das Substrat 1 des Leuchtmittels 100 ist als Laminat ausgeführt.

Das Laminat umfasst eine erste Schicht 104, die aus einem Kunststoff gebildet ist. Weiter umfasst das Laminat eine zweite Schicht 103, die aus einem Glas gebildet ist. Das Laminat umfasst ferner eine dritte Schicht 104, die wiederum aus einem Kunststoff gebildet ist. Beispielsweise sind die Schichten des Laminats miteinander verklebt. Es ist jedoch auch möglich, dass die zweite Schicht 103 des Laminats, die aus einem Glas gebildet ist, mit einem Kunststoff beschichtet ist. Das Substrat 1 des in Verbindung mit der Figur 27 beschriebenen Leuchtmittels 100 ist flexibel ausgebildet und kann darüber hinaus auch lichtdurchlässig sein. Gegenüber einer einfachen Kunststofffolie ist ein Laminat beispielsweise besonders gut geeignet, Feuchtigkeit von den Elektroden und dem organischen Schichtstapel 4 fernzuhalten. Vorzugsweise direkt auf die erste Hauptfläche 101 des Substrats 1 ist eine erste Elektrode 2 aufgebracht. Der ersten Elektroden 2 folgt der organische Schichtstapel 4 nach, der zumindest eine Licht erzeugende organische Schicht 4 umfasst.

Direkt auf den organischen Schichtstapel ist die zweite Elektrode 3 aufgebracht.

Der zweiten Elektrode 3 folgt die Verkapselung 6 des Leuchtmittels 100 nach. Bei der Verkapselung kann es sich um eine Dünnfilmverkapselung handeln, die - wie weiter oben beschrieben - eine oder mehrere Barriereschichten umfasst. Weiter kann es sich bei der Verkapselung um eine Folie - beispielsweise eine Kunststoff- oder Metallfolie handeln. Ferner ist es möglich, dass die Verkapselung ebenso wie das Substrat 1 des Leuchtmittels 100 als Laminat ausgeführt ist.

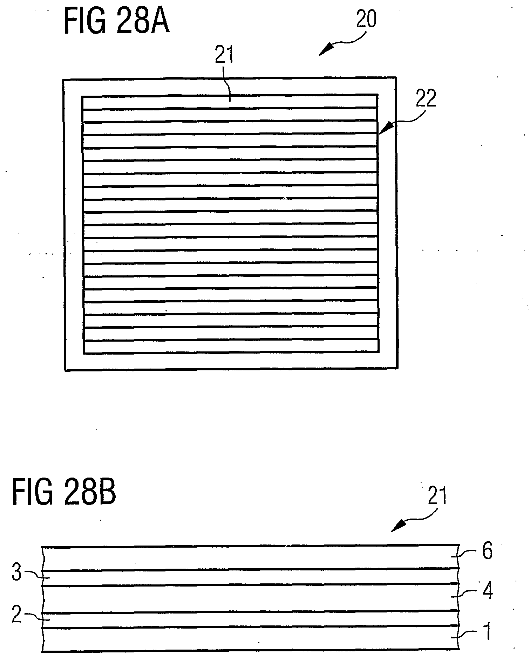

Die Figur 28A zeigt ein Fenster 20, das von einer Jalousie 22 abgedeckt ist, in einer schematischen Draufsicht gemäß einem Beispiel.

Die Figur 28B zeigt eine schematische Schnittdarstellung durch eine Lamelle 21 der Jalousie 22, wie sie in Figur 28A dargestellt ist. Die Lamelle 21 der Jalousie 22 ist als ein flexibles Leuchtmittel 100 ausgebildet, ähnlich wie es beispielsweise in Verbindung mit der Figur 25 beschrieben ist.

Vorzugsweise umfasst dieses Leuchtmittel 100 ein Substrat 1, das lichtundurchlässig ausgebildet ist. Bei dem Substrat 1 kann es sich beispielsweise um ein metallisches Substrat 1 oder ein Kunststoff-Substrat handeln. Als Substrat 1 kann dabei insbesondere die Lamelle einer herkömmlichen Jalousie Verwendung finden.

Auf die Lamelle als Substrat 1 des Leuchtmittels 100 ist dann eine Schichtenfolge aufgebracht, die zumindest eine erste Elektrode 2, einen organischen Schichtstapel 4, eine zweite Elektrode 3 und eine Verkapselung 6 umfasst. Die Verkapselung ist vorzugsweise lichtdurchlässig ausgebildet.

Bei geschlossener Jalousie 22 sind die Lamellen 21 der Jalousie 22 vorzugsweise derart relativ zum Fenster 20 orientiert, dass das lichtundurchlässige Substrat 1 nach außen und die lichtdurchlässige Verkapselung nach innen - das heißt in den Raum hinein - gerichtet ist. Auf diese Weise kann die derart ausgebildete Jalousie als Beleuchtungseinrichtung für den Raum Verwendung finden.

Dazu ist der organische Schichtstapel 4 vorzugsweise geeignet, tageslichtähnliches, weißes Licht zu erzeugen. Der organische Schichtstapel 4 kann beispielsweise, wie in Verbindung mit der Figur 1 erläutert, aufgebaut sein. Vorteilhaft ist auf diese Weise eine Beleuchtung realisiert, die in Abstrahlrichtung, Abstrahlcharakteristik und Lichteindruck tageslichtähnlich ist. Auf diese Weise ist der von der Jalousie 22 verdunkelte Raum mit einem besonders natürlich erscheinenden Licht ausleuchtbar. Mit Hilfe einer solchen Jalousie kann ein Raum also beispielsweise nach außen gegen neugierige Blicke geschützt und gleichzeitig beleuchtet werden. Weiterhin ist es auch möglich, dass der organische Schichtstapel 4 geeignet ist, farbiges Licht zu erzeugen. Eine solche Jalousie kann beispielsweise neben der Verdunkelungsfunktion auch dekorative Funktion haben.

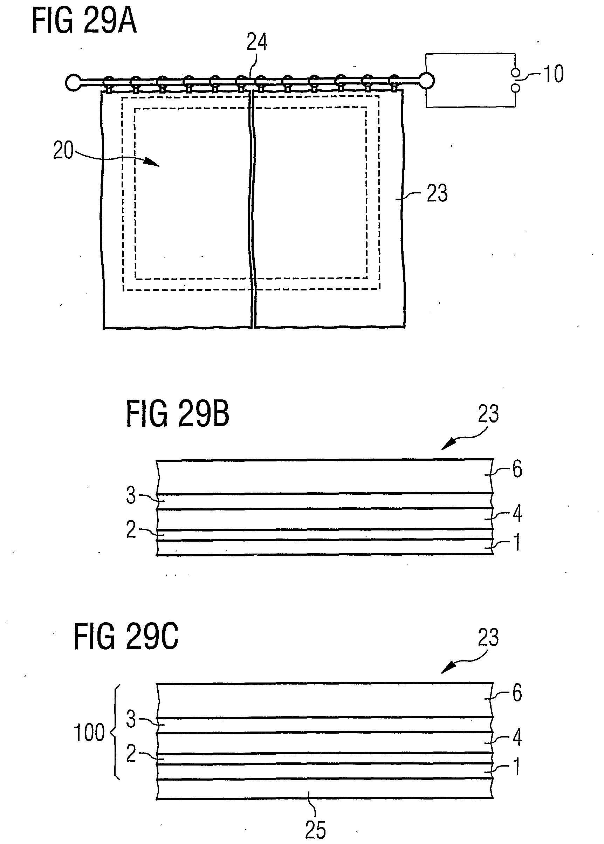

Die Figur 29A zeigt in einer schematischen Draufsicht ein Fenster 20, das von einem Vorhang 23 gemäß einem Beispiel verdeckt ist.

Die Figur 29B zeigt den Vorhang 23 in einer schematischen Schnittdarstellung.

Der Vorhang ist beispielsweise als ein flexibles Leuchtmittel 100 ausgebildet, wie es in Verbindung mit den Figuren 26 oder 27 beschrieben ist. Das heißt der Vorhang 23 umfasst ein flexibles Substrat 1, das durch eine Kunststofffolie oder ein Laminat gebildet ist. Das Substrat 1 ist vorzugsweise lichtundurchlässig ausgebildet.

Die Verkapselung des Leuchtmittels 100 ist als lichtdurchlässige Folie, als lichtdurchlässiges Laminat oder als lichtdurchlässige Dünnfilmverkapselung ausgebildet. Das lichtundurchlässige Substrat ist dabei zum Fenster gerichtet. Die lichtdurchlässige Verkapselung 6 ist in den Raum hinein, vom Fenster 20 weg gerichtet.

Der Vorhang 23 kann beispielsweise durch eine Stange 24 oder ein Seil mit einer Stromversorgung 10 verbunden und von dieser bestromt sein. Ein derart gebildeter Vorhang 23 ermöglicht das Ausleuchten eines Raums mit Licht, das hinsichtlich Abstrahlrichtung, Abstrahlcharakteristik und Farbe Tageslicht sehr ähnlich sein kann.

In Verbindung mit der Figur 29C ist in einer schematischen Schnittdarstellung ein weiteres Beispiel eines Vorhangs 23 beschrieben. In diesem Beispiel ist ein Leuchtmittel 100, auf einen textilen Träger, beispielsweise einen herkömmlichen textilen Vorhang 25, aufgebracht. In diesem Fall ist das Leuchtmittel 100 vorzugsweise als flexibles und gegebenenfalls lichtdurchlässiges Leuchtmittel 100 ausgebildet, wie es beispielsweise in Verbindung mit den Figuren 26 oder 27 beschrieben ist. Das textile Material des Vorhangs 25 ist dabei dem Fenster 20 zugewandt, das Leuchtmittel 100 ist dem Fenster 20 abgewandt.

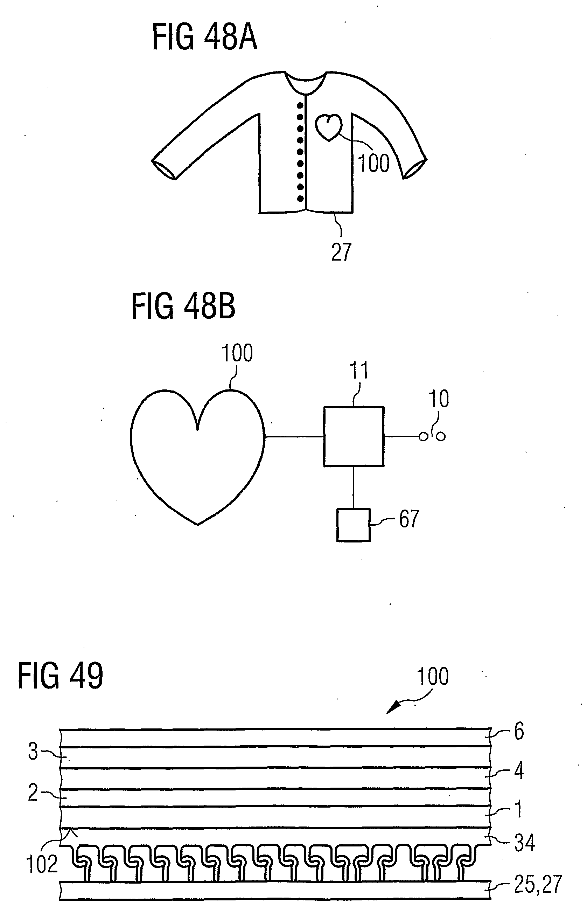

Die Befestigung des Leuchtmittels 100 auf dem Vorhang 25 erfolgt vorzugsweise über eine Klett-Verbindung. Dazu ist auf der zweiten Hauptfläche 102 des Substrats 1 des Leuchtmittels 100 ein Klettverschluss zum Beispiel aufgeklebt - vergleiche dazu auch das in Verbindung mit der Figur 49 beschriebene Ausführungsbeispiel eines hier beschriebenen Leuchtmittels 100. Das Leuchtmittel 100 lässt sich auf diese Weise gut vom textilen Vorhang 25 lösen, um beispielsweise den textilen Vorhang waschen oder ein defektes Leuchtmittel 100 besonders einfach austauschen zu können. Für den Fall, dass das Leuchtmittel lichtdurchlässig ausgebildet ist, ergibt sich vorteilhaft, dass der Vorhang durch das Leuchtmittel hindurch sichtbar bleibt.

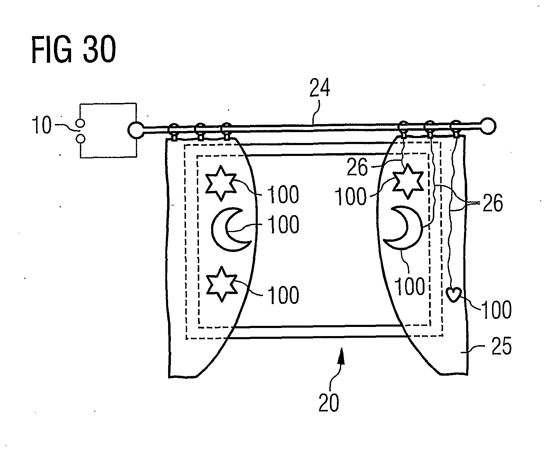

Die Figur 30 zeigt in einer schematischen Draufsicht ein Fenster 20 das von einem textilen Vorhang 25 verdeckt ist.

Im Unterschied zum Beispiel der Figur 29C bedecken die Leuchtmittel 100 in diesem Beispiel das textile Material nicht vollständig, sondern sind in Form einzelner, kleinerer Applikationen auf den Vorhang aufgebracht. Auf diese Weise ist es beispielsweise möglich, Leuchtmittel 100 von vorgebbarer Größe und Form auf den textilen Vorhang 25 aufzubringen. Die Leuchtmittel können dabei zum Beispiel stilisierte Sterne, Monde, Herzen oder auch Schriftzüge bilden. Ein derart gebildeter Vorhang 25 eignet sich besonders gut als Nachtlicht in einem Kinderzimmer, als Weihnachtsbeleuchtung oder zu Werbezwecken in einem Schaufenster. Bei dem Leuchtmittel 100 handelt es sich vorzugsweise um ein flexibles Leuchtmittel, das reflektierend und/oder mehrfarbig ausgebildet ist.

Eine Kontaktierung der einzelnen Leuchtmittel 100 kann über Leiterbahnen 26 erfolgen. Die Leiterbahnen 26 sind dazu am textilen Vorhang 25 befestigt oder in den Vorhang 25 eingewoben. Eine Bestromung der Leuchtmittel 100 ist wiederum über ein Seil oder eine Stange 24 möglich, die mit einer Stromversorgung 10 verbunden ist. Darüber hinaus ist es möglich, dass die Leuchtmittel 100 jeweils eine autonome Stromversorgung wie zum Beispiel eine Batterie tragen.

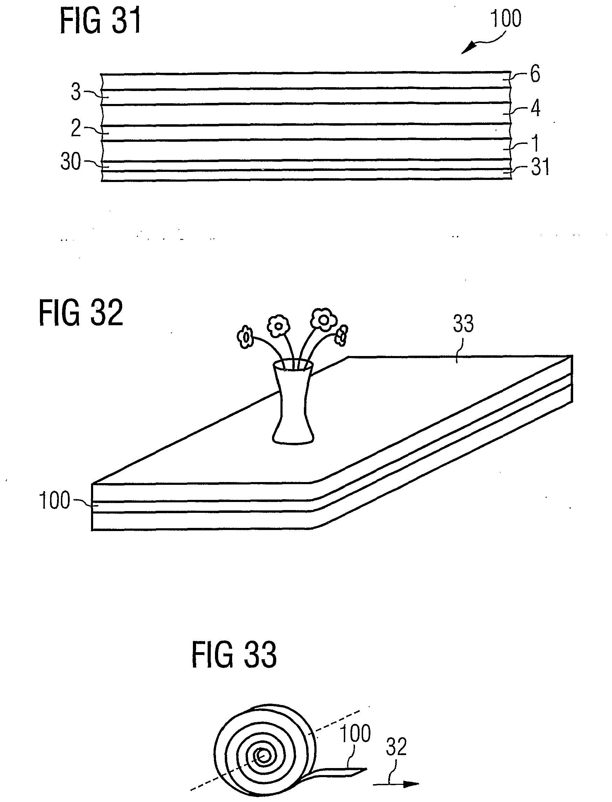

Die Figur 31 zeigt in einer schematischen Schnittdarstellung ein Ausführungsbeispiel eines hier beschriebenen Leuchtmittels. Das Leuchtmittel 100 ist beispielsweise ein flexibles Leuchtmittel 100 wie es in Verbindung mit den Figuren 25, 26 und 27 näher beschrieben ist.

Auf die der ersten Hauptfläche 101 des Substrats 1 abgewandte zweite Hauptfläche 102 des Substrats 1 ist eine Klebeschicht 30 aufgebracht. Die Klebeschicht ist von einer Schutzfolie 31 bedeckt. Die Schutzfolie ist von der Klebeschicht 30 abziehbar, so dass durch Abziehen der Schutzfolie 31 die Klebeschicht 30 freigelegt werden kann. Dadurch ist ein Leuchtmittel 100 realisiert, dass nach einfachem Abziehen der Schutzfolie 31 im Sinne eines Abziehbildes an einer vorgegebenen Stelle durch Aufkleben befestigt werden kann.

Die Figur 32 zeigt in einer schematischen Perspektivdarstellung ein Möbelstück 33, beispielsweise einen Tisch, ein Regal oder allgemein ein Ablagemöbel, das mit einem selbstklebenden Leuchtmittel 100 gemäß der Figur 31 beklebt ist.

Aufgrund der Flexibilität des Leuchtmittels 100 kann das Leuchtmittel 100 auch um Kanten, Rundungen oder Ränder des Möbelstücks 33 geklebt werden. Durch das Bekleben des Möbelstücks 33 mit dem flexiblen, selbstklebenden Leuchtmittel 100 ist ein Möbelstück realisiert, das als Beleuchtungseinrichtung 1000 fungiert.

In der schematischen Perspektivdarstellung der Figur 33 ist ein flexibles Leuchtmittel, wie es beispielsweise in der Figur 31 dargestellt ist, im aufgerollten Zustand gezeigt. Das heißt das Leuchtmittel 100 ist derart flexibel ausgebildet, dass es sich zu einer Rolle aufrollen und von einer Rolle 32 in Richtung des Pfeils 32 abrollen lässt. Dies ermöglicht neben einer besonders Platz sparenden Lagerung des Leuchtmittels 100 eine besonders einfache Verwendung des Leuchtmittels 100 beispielsweise zum Bekleben von Möbelstücken, Treppenabsätzen, Wänden, Kacheln, Fliesen oder Sanitäreinrichtungen.

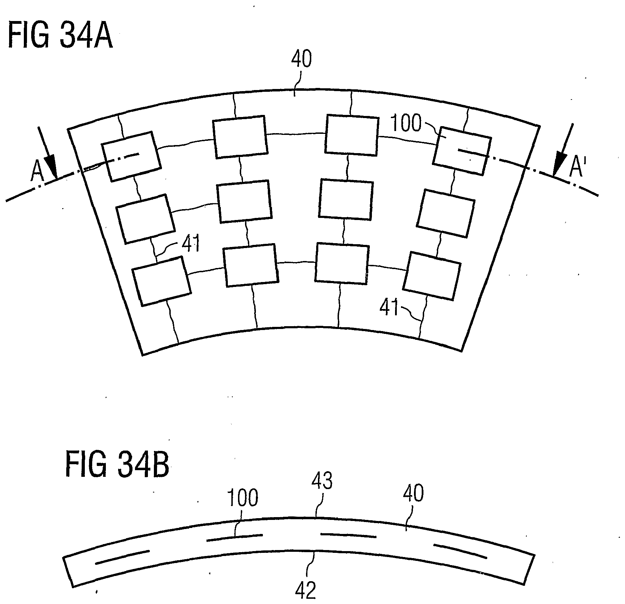

Die Figur 34A zeigt ein Beispiel einer hier beschriebenen Beleuchtungseinrichtung 1000 in einer schematischen Draufsicht.

Die Figur 34B zeigt die Beleuchtungseinrichtung 1000 in einer schematischen Schnittdarstellung entlang der Schnittlinie AA' .

Bei der Beleuchtungseinrichtung 1000 gemäß den Figuren 34A und 34B handelt es sich um eine flexible Beleuchtungseinrichtung. Die Flexibilität der Beleuchtungseinrichtung 1000 ist dabei dadurch erreicht, dass starre Leuchtmittel 100, das heißt Leuchtmittel 100 die an sich keine Flexibilität aufweisen, da sie beispielsweise ein starres Substrat 1 und/oder eine starre Verkapselung 6 aufweisen, in eine flexible Matrix 40 eingebettet sind.

Die Beleuchtungseinrichtung 1000 umfasst zwei flexible Träger 42, 43, zwischen denen die starren Leuchtmittel 100 und das Material der Matrix 40 angeordnet sind. Mindestens der Träger 43, durch den die Leuchtmittel 100 das im Betrieb erzeugte Licht emittieren, ist lichtdurchlässig. Der andere Träger 42 kann aus einem lichtundurchlässigen, zum Beispiel reflektierend ausgebildeten Material etwa einer Metallfolie gebildet sein.

Der Raum zwischen den beiden Trägern 42, 43 ist mit den starren Leuchtmitteln 100 und einem flexiblen Matrix-Material 40 gefüllt. Das lichtdurchlässige Matrix-Material kann Partikel zumindest eines der folgenden Materialien enthalten: Lumineszenzkonversionsmaterial, Farbfiltermaterial, Diffusermaterial.

Als Matrixmaterial eignen sich zum Beispiel Zeonex, Polystyrol, Polycarbonat oder andere Kunststoffe, die vorzugsweise mittels Spritzguss verarbeitet werden können.

Bei dem flexiblen Träger 42, 43 handelt es sich zum Beispiel um eine Plexiglasplatte, eine Kunststofffolie oder ein Kunststoff-Glas-Kunststoff-Laminat.

Die starren Leuchtmittel 100 können dabei so dicht aneinander angeordnet sein, dass sich - gegebenenfalls durch im Matrix-Material enthaltene Diffuserpartikel - ein homogener Lichteindruck der Beleuchtungseinrichtung 1000 ergibt. Das heißt einzelne Leuchtmittel 100 sind dann nicht mehr vom Betrachter wahrnehmbar, sondern die Beleuchtungseinrichtung 1000 weist eine einzige, homogene Leuchtfläche auf.

Alternativ ist es möglich, dass die Leuchtmittel 100 derart weit voneinander beabstandet angeordnet sind, dass Stege zwischen den Leuchtmitteln wahrnehmbar sind. Dabei kann der Raum zwischen einzelnen Leuchtmitteln mit einem Matrix-Material gefüllt sein, das Licht absorbierende Partikel aufweist. Bei den Licht absorbierenden Partikeln kann es sich beispielsweise um Ruß oder Partikel von Farbstoffen handeln.

Die Leiterbahnen 41, welche die einzelnen Leuchtmittel 100 der Beleuchtungseinrichtung 1000 miteinander verbinden, sind im Matrix-Material angeordnet. Dies gewährleistet die Biegsamkeit der Beleuchtungseinrichtung. Die Leiterbahnen 41 sind durch dünne, metallische Federn oder in Mäandern verlegte, dünne Drähte gebildet.

Die Träger 42, 43 der Beleuchtungseinrichtung 1000 können so tragfähig gewählt sein, dass die Beleuchtungseinrichtung 1000 Belastungen durch Gewichte bis zu einigen hundert Kilogramm unbeschadet übersteht. Auf diese Weise ist eine Verwendung der Beleuchtungseinrichtung 1000 als Bodenbelag möglich.

In einem weiteren Beispiel der Beleuchtungseinrichtung 1000, wie sie in Verbindung mit den Figuren 34A und 34B beschrieben ist, ist zumindest einer der beiden Träger der Beleuchtungseinrichtung 1000 starr ausgeführt. Der starre Träger kann beispielsweise eine vorgebbare Krümmung aufweisen, so dass sich eine dreidimensional geformte Beleuchtungseinrichtung 1000 ergibt, die in ihrer Form unveränderlich, also starr ist.

Für die Leuchtmittel 100 der Beleuchtungseinrichtung 1000 wie sie in Verbindung mit den Figuren 34A und 34B beschrieben sind, können alle hier beschriebenen Leuchtmittel 100 Verwendung finden. Auf diese Weise sind farbige, lichtdurchlässige, reflektierende oder mehrfarbige, flexible Beleuchtungseinrichtungen besonders einfach und kostengünstig herstellbar.

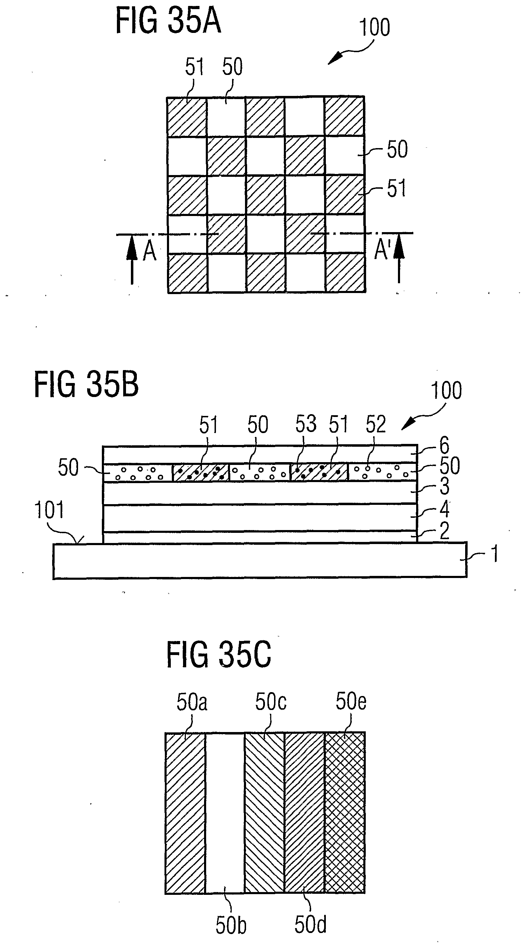

Die Figur 35A zeigt eine schematische Draufsicht auf ein Leuchtmittel 100 gemäß einem Ausführungsbeispiel eines hier beschriebenen Leuchtmittels 100.

Die Figur 35B zeigt eine schematische Schnittdarstellung des Leuchtmittels 100 der Figur 35A entlang der Schnitt-Linie AA' .

Bei dem Leuchtmittel, das in Verbindung mit den Figuren 35A und 35B beschrieben ist, handelt es sich um ein mehrfarbiges Leuchtmittel.

Wie in der Draufsicht der Figur 35A schematisch dargestellt, umfasst das Leuchtmittel erste und zweite Farb-Unterbereiche, die lateral nebeneinander angeordnet sind. Die ersten 50 und zweiten 51 Farb-Unterbereiche sind geeignet, Licht unterschiedlicher Farbe zu emittieren. Der erste Farb-Unterbereich 50 ist geeignet, Licht einer ersten Farbe zu emittieren. Der zweite Farb-Unterbereich 51 ist geeignet, Licht einer zweiten Farbe zu emittieren. Die erste Farbe unterscheidet sich dabei von der zweiten Farbe.

Im in Verbindung mit der Figur 35A beschriebenen Ausführungsbeispiel des Leuchtmittels sind die ersten und zweiten Farb-Unterbereiche 50, 51 in einem schachbrettartigen Muster zueinander angeordnet. Das heißt die ersten und zweiten Farb-Unterbereiche 50, 51 sind an den Gitterpunkten eines quadratischen Gitters derart angeordnet, dass jeder erste Farb-Unterbereich 50, der nicht am Rand des Leuchtmittels 100 angeordnet ist, vier zweite Farb-Unterbereiche 51 als nächste Nachbarn hat, die lateral an den ersten Farb-Unterbereich 50 angrenzen. Entsprechendes gilt für die zweiten Farb-Unterbereiche 51.

Die Farb-Unterbereiche 50, 51 sind dabei nach Art von Pixeln eines Displays gebildet. Die Größe eines jeden Farb-Unterbereichs beträgt vorzugsweise wenigstens 1 mm².

Wie in der schematischen Schnittdarstellung der Figur 35B verdeutlicht ist, können die ersten und zweiten Farb-Unterbereiche 50, 51 unterschiedliche Lumineszenzkonversionsmaterialien oder unterschiedliche Farbfiltermaterialien umfassen, die für den unterschiedlichen Farbeindruck der ersten und zweiten Farb-Unterbereiche verantwortlich sind. So umfassen die ersten Farb-Unterbereiche 50 beispielsweise ein erstes Lumineszenzkonversionsmaterial und/oder ein erstes Farbfiltermaterial 52. Die zweiten Farb-Unterbereiche 51 umfassen dann ein zweites Lumineszenzkonversionsmaterial und/oder ein zweites Farbfiltermaterial 53.

Die Lumineszenzkonversionsmaterialien beziehungsweise die Farbfiltermaterialien können dabei in einer Schicht des Leuchtmittels angeordnet sein, die parallel zur ersten Hauptfläche 101 des Substrats 1 des Leuchtmittels 100 verläuft und die derart angeordnet ist, dass zumindest ein Großteil der im organischen Schichtstapel 4 im Betrieb erzeugten elektromagnetischen Strahlung durch diese Schicht tritt.

Im in Verbindung mit der Figur 35B beschriebenen Ausführungsbeispiel umfasst das Leuchtmittel 100 ein Substrat 1, auf das eine erste Elektrode aufgebracht ist. Auf die dem Substrat abgewandte Seite der ersten Elektrode 2 ist der organische Schichtstapel 4 aufgebracht, der zumindest eine zur Lichterzeugung vorgesehene organische Schicht umfasst.

Dem organischen Schichtstapel 4 folgt auf seiner der ersten Elektrode 2 abgewandten Seite eine zweite Elektrode 4 nach.

Auf der dem organischen Schichtstapel 4 abgewandten Seite der zweiten Elektrode 3 ist die Schicht angeordnet, welche die ersten 52 und zweiten 53 Lumineszenzkonversionsmaterialien und/oder die ersten und zweiten Farbfiltermaterialien umfasst. Das Leuchtmittel 100 ist durch eine Verkapselung 6 hermetisch von der Umgebung abgekapselt.

Durch entsprechende Strukturierung der ersten 2 und/oder zweiten Elektrode 3 ist es möglich, dass die Farb-Unterbereiche unabhängig voneinander ansteuerbar sind.

Der Aufbau des Leuchtmittels 100 kann insbesondere wie in einem der übrigen beschriebenen Ausführungsbeispiele erfolgen. Es sind dadurch besonders einfach flexible, lichtdurchlässige und/oder reflektierende Leuchtmittel realisierbar, die zumindest zwei Farb-Unterbereiche aufweisen.

Als erste und/oder zweite Lumineszenzkonversionsmaterialien eignen sich beispielsweise die weiter oben beschriebenen Materialien.

Als erste und zweite Farbfiltermaterialien eignen sich beispielsweise die weiter oben beschriebenen Materialien.

Aus Gründen einer vereinfachten Darstellung sind im in Verbindung mit den Figuren 35A und 35B beschriebenen Ausführungsbeispiel lediglich zwei unterschiedliche Farb-Unterbereiche dargestellt. Es ist jedoch möglich, dass das Leuchtmittel 100 eine größere Zahl unterschiedlicher Farb-Unterbereiche aufweist, die geeignet sind, paarweise Licht unterschiedlicher Farbe zu erzeugen.

Im Extremfall unterscheidet sich die Farbe des Lichts eines jeden Farb-Unterbereichs von der Farbe des Lichts eines anderen Farb-Unterbereichs des Leuchtmittels. Dies ist schematisch in der Figur 35C dargestellt, die ein weiteres Ausführungsbeispiel eines hier beschriebenen, mehrfarbigen Leuchtmittels 100 anhand einer schematischen Draufsicht erläutert. In diesem Ausführungsbeispiel weist das Leuchtmittel fünf unterschiedliche Farb-Unterbereiche 50a bis 50e auf, die jeweils Licht paarweise unterschiedlicher Farben erzeugen.

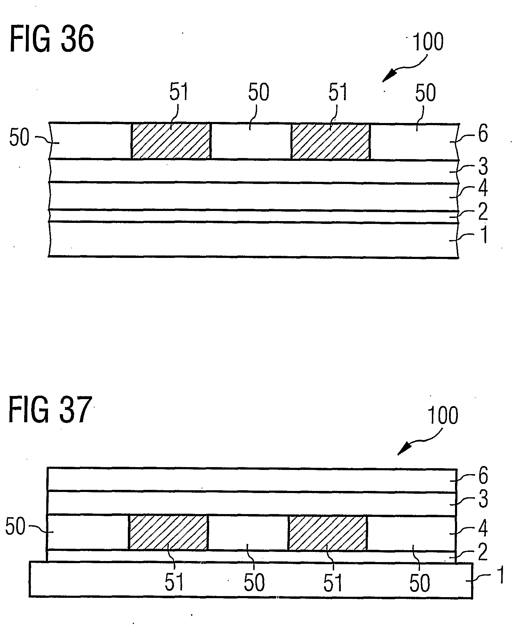

Die Figur 36 zeigt eine schematische Schnittdarstellung durch ein Leuchtmittel 100 gemäß einem weiteren Ausführungsbeispiel eines Leuchtmittels 100, wie es beispielsweise in der schematischen Draufsicht der Figur 35A dargestellt ist.

Bei dem Leuchtmittel, das in Verbindung mit der Figur 36 beschrieben ist, handelt es sich um ein mehrfarbiges Leuchtmittel.

Beim Ausführungsbeispiel des Leuchtmittels 100 der Figur 36 sind die Materialien - das heißt die ersten 52 und zweiten 53 Lumineszenzkonversionsmaterialien und/oder die ersten und zweiten Farbfiltermaterialien - in der Verkapselung 6 des Leuchtmittels 100 angeordnet. Beispielsweise kann die Verkapselung 6 des Leuchtmittels 100 durch eine Platte oder flexible Folie gebildet sein, in welche die Materialien eingebettet sind.

Dies ermöglicht ein Leuchtmittel 100, bei dem durch die Wahl der Verkapselung 6 der gewünschte Farbeindruck des Leuchtmittels 100 eingestellt werden kann. Der Aufbau des Leuchtmittels 100 kann hinsichtlich der übrigen Elemente des Leuchtmittels wie in einem der weiter oben oder weiter unten besprochenen Ausführungsbeispiele erfolgen. Es sind dadurch besonders einfach flexible, lichtdurchlässige und/oder reflektierende Leuchtmittel realisierbar, die zumindest zwei Farb-Unterbereiche aufweisen. Die funktionellen Komponenten des Leuchtmittels, wie zum Beispiel die erste 2 und zweite Elektrode 3 sowie der organische Schichtstapel 4, können unabhängig von der Verkapselung 6 gefertigt werden.

Die Figur 37 zeigt eine schematische Schnittdarstellung eines weiteren Ausführungsbeispiels eines hier beschriebenen, mehrfarbigen Leuchtmittels 100. Der aktive Bereich des Substrates umfasst vorliegend Unterbereiche, die jeweils einem Farb-Unterbereich entsprechen. Bei diesem Ausführungsbeispiel sind die unterschiedlichen Farb-Unterbereiche 50, 51 des Leuchtmittels 100 durch unterschiedliche Emittermaterialien im organischen Schichtstapel realisiert. Das heißt der organische Schichtstapel ist in lateraler Richtung strukturiert. Erste und zweite Farb-Unterbereiche unterscheiden sich zumindest hinsichtlich einer zur Lichterzeugung vorgesehenen organischen Schicht. Der erste Farb-Unterbereich 50 weist zum Beispiel ein erstes Emittermaterial auf, der zweite Farb-Unterbereich 51 weist dann ein zweites Emittermaterial auf, das sich vom ersten Emittermaterial unterscheidet. Der Aufbau des Leuchtmittels 100 kann dann hinsichtlich der übrigen Elemente des Leuchtmittels wie in einem der übrigen Ausführungsbeispiele erfolgen. Es sind dadurch besonders einfach flexible, lichtdurchlässige und/oder reflektierende Leuchtmittel realisierbar, die zumindest zwei Farb-Unterbereiche aufweisen.

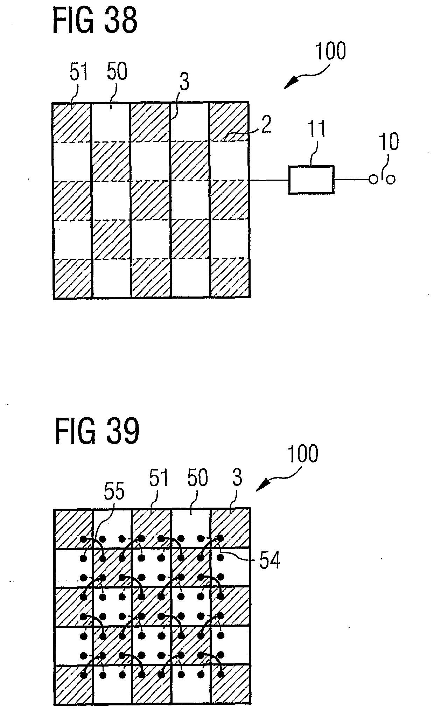

Die Figur 38 zeigt in einer schematischen Draufsicht die ersten und zweiten Elektroden 2, 3 für ein weiteres Ausführungsbeispiel eines mehrfarbigen Leuchtmittels 100. Wie der Figur 38 zu entnehmen ist, sind die ersten und zweiten Elektroden 2, 3 jeweils streifenförmig ausgebildet. Auf diese Weise können die einzelnen Farb-Unterbereiche 50, 51 unabhängig voneinander angesteuert werden. Das Leuchtmittel 100 ist in diesem Fall nach Art einer Passivmatrix-Anzeigevorrichtung aufgebaut. Die Ansteuerung der einzelnen Farb-Unterbereiche 50, 51 erfolgt mittels einer Steuervorrichtung 11, die außerhalb des Leuchtmittels 100 angeordnet sein kann oder in das Leuchtmittel 100 integriert ist. Das Leuchtmittel 100 wird über die Steuervorrichtung 11 von der Stromversorgung 10 bestromt.

Die Figur 39 zeigt ein weiteres Ausführungsbeispiel eines hier beschriebenen mehrfarbigen Leuchtmittels 100 in einer schematischen Draufsicht. In diesem Ausführungsbeispiel sind alle ersten Farb-Unterbereiche 50 und alle zweiten Farb-Unterbereiche 51 jeweils durch elektrische Verbindungen 54 beziehungsweise 55 miteinander verbunden. Das heißt beispielsweise alle ersten Farb-Unterbereiche 50 sind auf diese Weise gemeinsam und gleichzeitig ansteuerbar. Ebenso sind alle zweiten Farb-Unterbereiche 51 gemeinsam und gleichzeitig ansteuerbar. Die ersten und die zweiten Farb-Unterbereiche 50, 51 sind hingegen getrennt voneinander ansteuerbar. Ein derart ausgebildetes Leuchtmittel 100 weist also vier Betriebszustände auf:
- das Leuchtmittel kann ausgeschaltet sein, so dass keiner der Farb-Unterbereiche Licht erzeugt, also keiner der Farb-Unterbereiche leuchtet;
- alle ersten Farb-Unterbereiche 50 des Leuchtmittels 100 leuchten, die zweiten Farb-Unterbereiche 51 leuchten nicht,
- alle zweiten Farb-Unterbereiche 51 des Leuchtmittels 100 leuchten, die ersten Farb-Unterbereiche 50 leuchten nicht, und
- die ersten und die zweiten Farb-Unterbereiche 50, 51 leuchten, so dass das Leuchtmittel 100 Licht der ersten und der zweiten Farbe emittiert.

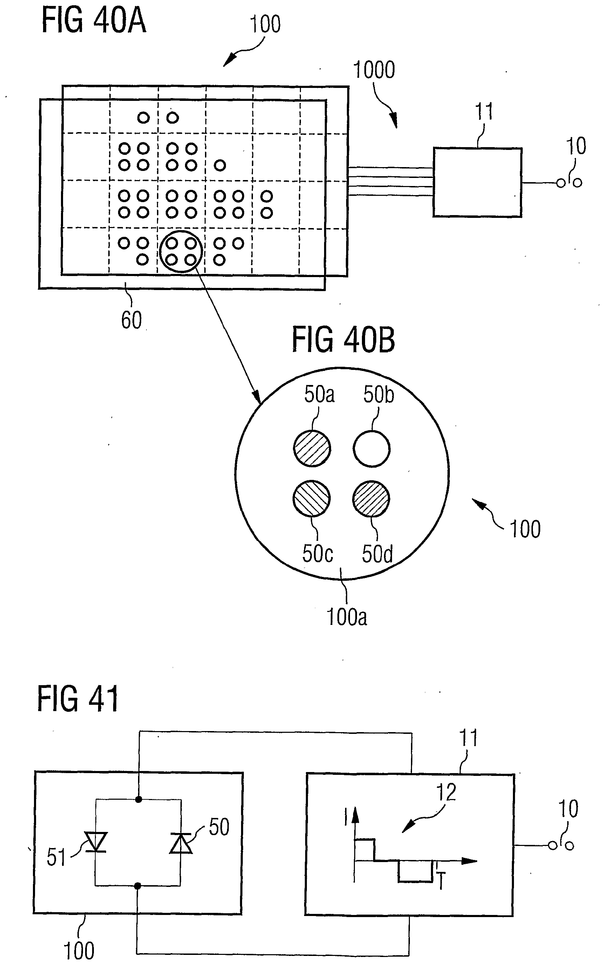

Die Figur 40A zeigt in einer schematischen Draufsicht ein Beispiel einer hier beschriebenen Beleuchtungseinrichtung 1000. Die Beleuchtungseinrichtung 1000 umfasst eine Mehrzahl von mehrfarbigen Leuchtmitteln 100, wie sie beispielsweise in Verbindung mit den Figuren 35A, 35B, 35C, 36, 37 oder 39 beschrieben sind.

Wie der Ausschnittsvergrößerung der Figur 40B zu entnehmen ist, umfasst jedes Leuchtmittel der Beleuchtungseinrichtung 1000 vier Farb-Unterbereiche 50a, 50b, 50c und 50d:
- Der erste Farb-Unterbereich 50a ist beispielsweise geeignet, im Betrieb der Beleuchtungseinrichtung 1000 Licht grüner Farbe zu emittieren.
- Der zweite Farb-Unterbereich 50b ist geeignet, im Betrieb der Beleuchtungseinrichtung 1000 Licht roter Farbe zu emittieren.
- Der dritte Farb-Unterbereich 50c ist geeignet, im Betrieb der Beleuchtungseinrichtung 1000 Licht blauer Farbe zu emittieren.
- Der vierte Farb-Unterbereich 50d ist geeignet, im Betrieb der Beleuchtungseinrichtung 1000 weißes Licht zu emittieren.

Die Farb-Unterbereiche eines jeden Leuchtmittels 100 der Beleuchtungseinrichtung 1000 sind dabei getrennt und unabhängig voneinander ansteuerbar. Dazu umfasst die Beleuchtungseinrichtung 1000 eine Steuervorrichtung 11, die beispielsweise einen Mikrocontroller enthalten kann. Die Steuervorrichtung 11 wird mittels der Stromversorgung 10 bestromt.

Optional ist den Leuchtmitteln 100 der Beleuchtungseinrichtung 1000 an ihrer Licht emittierenden Vorderseite 100a ein optisches Element 60 nachgeordnet. Bei dem optischen Element 60 handelt es sich vorzugsweise um eine Diffuserplatte. Das heißt Licht, welches das optische Element 60 durchstrahlt, wird vom optischen Element 60 gestreut. Auf diese Weise sind die einzelnen Farb-Unterbereiche im Betrieb der Beleuchtungseinrichtung 1000 vom Betrachter nicht mehr als separate Elemente wahrnehmbar, sondern die Beleuchtungseinrichtung 1000 erscheint, als habe sie eine einzige, homogene Leuchtfläche. Die Leuchtfläche der Beleuchtungseinrichtung 1000 setzt sich dabei aus den Licht emittierenden Vorderseiten der Leuchtmittel der Beleuchtungseinrichtung zusammen.

Das optische Element 60 ist ferner vorzugsweise zur Mischung des von den Farb-Unterbereichen 50a, 50b, 50c, 50d der einzelnen Leuchtmittel 100 erzeugten Lichts geeignet. Auf diese Weise ist die Beleuchtungseinrichtung 1000 geeignet, neben Licht der Farben der einzelnen Unterbereiche auch Mischlicht aus zwei oder mehreren dieser Farben zu erzeugen. Insgesamt ist auf diese Weise eine besonders flexibel einsetzbare Beleuchtungseinrichtung realisiert, die auf einfache Art geeignet ist, Licht einer Vielzahl unterschiedlicher Farben zu erzeugen.

Weisen die Leuchtmittel 100 der Beleuchtungseinrichtung 1000 zusätzlich zumindest einen Farb-Unterbereich 50d auf, der geeignet ist, weißes Licht zu erzeugen, so kann durch die Bestromung dieses Farb-Unterbereichs auch die Helligkeit des von der Beleuchtungseinrichtung 1000 abgestrahlten Lichts besonders einfach eingestellt werden.

Die Figur 41 zeigt in einer schematischen Draufsicht ein weiteres Beispiel eines hier beschriebenen Leuchtmittels 100.

Das Leuchtmittel 100 weist zumindest zwei Farb-Unterbereiche 51 und 50 auf. Die Farb-Unterbereiche können beispielsweise entsprechend den Farb-Unterbereichen der in Verbindung mit den Figuren 35A, 35B, 35C, 36, 37, 38, 39, 40A, 40B beschriebenen mehrfarbigen Leuchtmittel angeordnet sein.

Beim in Verbindung mit der Figur 41 beschriebenen Leuchtmittel 100 sind die ersten und zweiten Farb-Unterbereiche 50, 51 antiparallel zueinander geschaltet. Das heißt, wenn das Leuchtmittel 100 in einer ersten Richtung bestromt wird, sind beispielsweise die ersten Farb-Unterbereiche 50 in Durchlassrichtung geschaltet, so dass sie Licht der ersten Farbe erzeugen. Die zweiten Farb-Unterbereiche 51 sind dann in Sperrrichtung geschaltet, so dass in den zweiten Farb-Unterbereichen keine Lichterzeugung erfolgt.

Durch ein einfaches Umkehren der Stromrichtung können in einem nächsten Zeitschritt die zweiten Farb-Unterbereiche 51 in Durchlassrichtung bestromt werden, so dass Licht der zweiten Farbe erzeugt wird. Die ersten Farb-Unterbereiche 50 sind dann in Sperrrichtung geschaltet, so dass in den ersten Farb-Unterbereichen 50 keine Lichterzeugung stattfindet.

Die Farb-Unterbereiche 50 können dabei auf ein gemeinsames Substrat integriert sein. Darüber hinaus ist es auch möglich, dass es sich bei den Farbunterbereichen um einzelnen, kleine Leuchtmittel handelt, die antiparallel zueinander verschaltet sind.

Die Ansteuerung eines solchen Leuchtmittels 100 erfolgt vorzugsweise mittels einer Steuervorrichtung 11, in die eine Pulsweitenmodulationsschaltung 12 integriert ist. Die Pulsweitenmodulationsschaltung 12 ist geeignet, für erste Zeitspannen Strom zu erzeugen, der eine erste Stromrichtung aufweist. Für zweite Zeitspannen ist die Pulsweitenmodulationsschaltung 12 geeignet, Strom zu erzeugen, der eine zweite, der ersten Stromrichtung entgegengesetzt gerichtete Stromrichtung aufweist.

Die Steuervorrichtung 11 des Leuchtmittels 100 kann entweder in das Leuchtmittel 100 integriert sein oder sie ist außerhalb des Leuchtmittels angeordnet. Das Leuchtmittel 100 wird über die Steuervorrichtung 11 von einer Stromversorgung 10 bestromt.

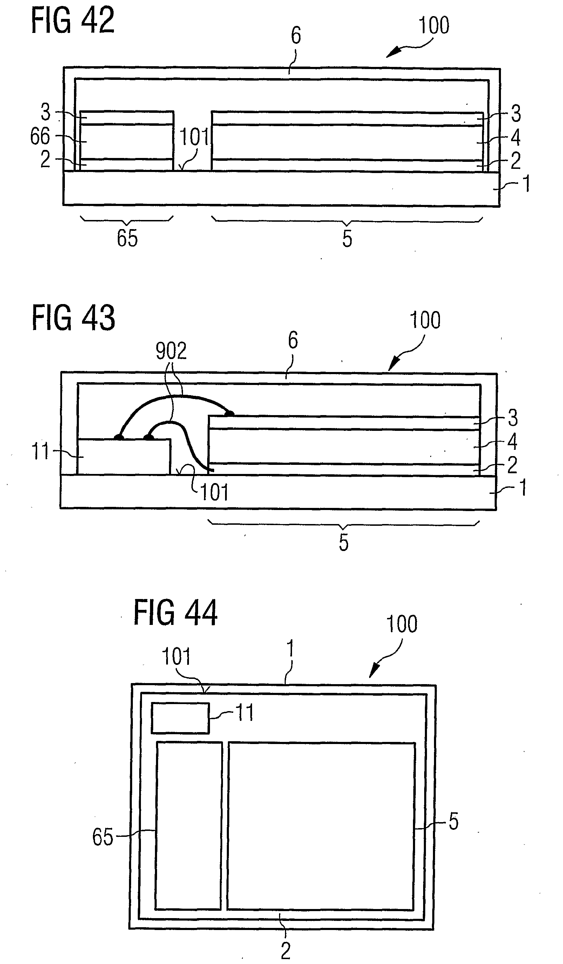

Die Figur 42 zeigt in einer schematischen Schnittdarstellung ein Leuchtmittel 100 gemäß einem weiteren Ausführungsbeispiel eines hier beschrieben Leuchtmittels 100.

Das Substrat des Leuchtmittels 100 umfasst einen aktiven Bereich 5. Der aktive Bereich umfasst zumindest eine erste Elektrode 2, einen organischen Schichtstapel 4 und eine zweite Elektrode 3.

Auf dem Substrat ist beabstandet zum organischen Schichtstapel ein Fotodetektor 65 angeordnet.

Der Fotodetektor 65 kann beispielsweise gemeinsam mit dem organischen Schichtstapel und den Elektroden auf dem aktiven Bereich 5 gefertigt sein. Der Fotodetektor 65 umfasst zumindest eine erste Elektrode 2, eine zweite Elektrode 3 und eine Foto-detektierende Schichtenfolge 66, die zwischen den beiden Elektroden angeordnet ist. Die Foto-detektierende Schichtenfolge 66 umfasst ein organisches Material. Die Foto-detektierende Schichtenfolge 66 umfasst also zumindest eine Schicht, die ein organisches Material enthält.

Dabei ist es insbesondere möglich, dass der Fotodetektor 65 genauso aufgebaut ist wie der organische Schichtstapel zwischen den beiden Elektroden des Leuchtmittels 100.

Der Fotodetektor 65 ist vorgesehen, die Helligkeit und/oder den Farbort des vom aktiven Bereich 5 erzeugten Lichts zu detektieren. Der Fotodetektor 65 kann dazu mit einer Steuervorrichtung 11 verbunden sein, die eine entsprechende Auswerteschaltung umfasst. Die Steuervorrichtung 11 ist vorzugsweise ebenfalls auf der ersten Hauptfläche 101 des Substrats 1 des Leuchtmittels 100 angeordnet. Alternativ ist es möglich, dass die Steuervorrichtung 11 außerhalb des Leuchtmittels 100 angeordnet ist.

Wie in der schematischen Schnittdarstellung der Figur 42 dargestellt, können der Fotodetektor 65 und der organische Schichtstapel von einer gemeinsamen Verkapselung 6 verkapselt sein. Bei der Verkapselung handelt es sich um eine der im Zusammenhang mit den weiter oben beschriebenen Leuchtmitteln 100 aufgeführten Verkapselungen. Das heißt die Verkapselung 6 ist beispielsweise durch ein Glas, eine Kunststofffolie, ein Kunststoff-Glas-Kunststoff-Laminat, eine Metallfolie, ein metallisches Blech, eine Kappe oder eine Dünnfilmverkapselung gebildet. Die Verkapselung 6 und/oder das Substrat 1 des Leuchtmittels 100 sind lichtdurchlässig ausgeführt.

In Verbindung mit der Figur 43 ist anhand einer schematischen Schnittdarstellung ein weiteres Ausführungsbeispiel eines hier beschriebenen Leuchtmittels erläutert.

In diesem Ausführungsbeispiel ist eine Steuervorrichtung 11 gemeinsam mit dem organischen Schichtstapel des Leuchtmittels 100 auf der ersten Hauptfläche 101 des Substrats 1 angeordnet. Die Steuervorrichtung 11 kann dabei beispielsweise ein organisches Material enthalten. Vorteilhaft kann die Steuervorrichtung dann mit den gleichen Fertigungsmethoden wie der aktive Bereich 5 gefertigt werden. Dies ermöglicht eine besonders kostengünstige Herstellung des Leuchtmittels 100. Die Steuervorrichtung 11 ist - entweder über zusätzliche elektrische Zuleitungen 9, wie zum Beispiel Bonddrähten 902 oder mittels der ersten und zweiten Elektroden 2, 3 mit dem organischen Schichtstapel des Leuchtmittels 100 elektrisch leitend verbunden. Die Steuervorrichtung 11 ist geeignet, den aktiven Bereich 5 des Leuchtmittels 100 in vorgebbarer Weise zu bestromen.

Insbesondere ist es auch möglich, dass die Steuervorrichtung 11 von außerhalb - beispielsweise durch einen Benutzer des Leuchtmittels 100 - einstellbar ist. Das heißt ein Benutzer kann einen bestimmten Betriebszustand des Leuchtmittels 100 über die Steuervorrichtung 11 einstellen. Wie die Figur 43 weiter zeigt, sind die Steuervorrichtung 11 und der organische Schichtstapel des Leuchtmittels 100 von einer gemeinsamen Verkapselung 6 verkapselt. Bei der Verkapselung 6 handelt es sich um eine der im Zusammenhang mit den weiter oben beschriebenen Leuchtmitteln 100 aufgeführten Verkapselungen 6. Das heißt die Verkapselung 6 ist beispielsweise durch ein Glas, eine Kunststofffolie, ein Kunststoff-Glas-Kunststoff-Laminat, eine Metallfolie, ein metallisches Blech, eine Kappe oder eine Dünnfilmverkapselung gebildet. Die Verkapselung 6 und/oder das Substrat 1 des Leuchtmittels 100 sind lichtdurchlässig ausgeführt.

Die Figur 44 zeigt ein weiteres Ausführungsbeispiel eines hier beschriebenen Leuchtmittels 100 in einer schematischen Draufsicht. In diesem Ausführungsbeispiel des Leuchtmittels sind sowohl ein Fotodetektor 65, wie er in Verbindung mit der Figur 42 erläutert ist, als auch eine Steuervorrichtung 11, wie sie in Verbindung mit der Figur 43 näher beschrieben ist, gemeinsam auf der ersten Hauptfläche 101 des Substrats 1 des Leuchtmittels 100 angeordnet. Dies ermöglicht ein besonders kompaktes und autonomes Leuchtmittel 100. Der Fotodetektor ist vorzugsweise mit der Steuervorrichtung 11 verbunden, die geeignet ist, abhängig von durch den Fotodetektor 65 ermittelten Messwerten den organischen Schichtstapel des Leuchtmittels 100 zu bestromen. Bei den Messwerten kann es sich beispielsweise um die Helligkeit und/oder den Farbort des vom organischen Schichtstapel 4 des Leuchtmittels 100 erzeugten Lichts handeln. Ferner ist es möglich, dass der Fotodetektor 65 zusätzlich oder alternativ zur Detektion des Umgebungslichts vorgesehen ist. Eine Bestromung des organischen Schichtstapels erfolgt in diesem Fall auch abhängig von der Umgebungshelligkeit.

Im in Verbindung mit der Figur 44 beschriebenen Ausführungsbeispiel des Leuchtmittels 100 ist es insbesondere möglich, dass der organische Schichtstapel, der Fotodetektor 65 sowie die Steuervorrichtung 11 zumindest jeweils ein organisches Material enthalten. Diese Elemente des Leuchtmittels 100 können durch die gleichen Fertigungsmethoden gefertigt sein. Dies ermöglicht eine besonders einfache und kostengünstige Herstellung des Leuchtmittels 100.

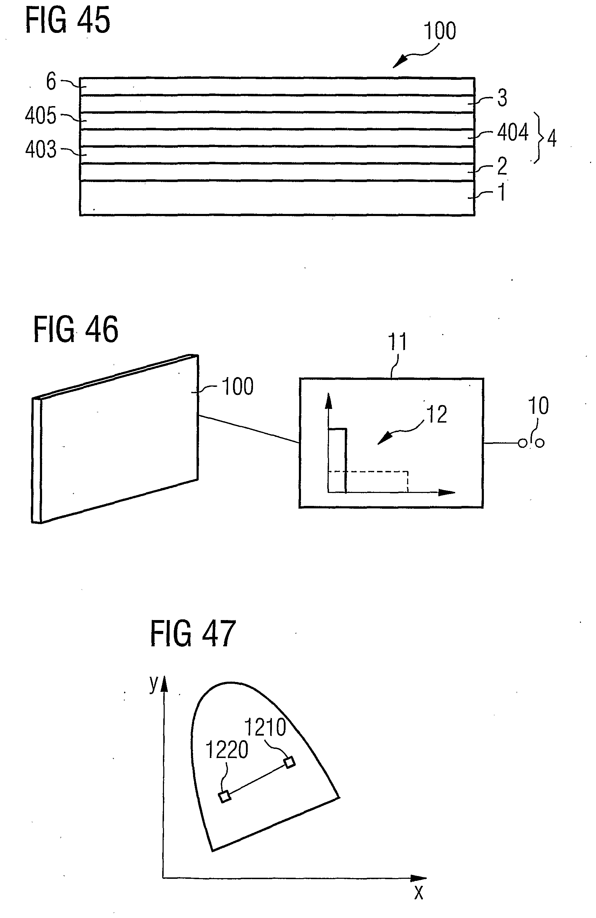

In Verbindung mit der schematischen Schnittdarstellung der Figur 45 ist ein weiteres Ausführungsbeispiel eines hier beschriebenen Leuchtmittels 100 erläutert.

Gemäß dem in Verbindung mit der Figur 45 beschriebenen Ausführungsbeispiel umfasst der organische Schichtstapel 4 - im Unterschied zu einigen der weiter oben beschriebenen Ausführungsbeispielen des Leuchtmittels - mehrere zur Lichterzeugung vorgesehene Schichten 403, 404, 405.

Jede dieser zur Lichterzeugung vorgesehenen Schichten bildet einen Farb-Unterbereich des Leuchtmittels 100. Das heißt die Farb-Unterbereiche des Leuchtmittels sind in diesem Ausführungsbeispiel vertikal übereinander angeordnet. Die unterschiedlichen, zur Lichterzeugung vorgesehenen Schichten unterscheiden sich vorzugsweise hinsichtlich ihres Emittermaterials. Die Schichten sind daher geeignet, im Betrieb des Leuchtmittels Licht voneinander unterschiedlicher Farbe zu erzeugen. Beispielsweise ist die erste zur Lichterzeugung vorgesehene Schicht 403 geeignet, rotes Licht zu erzeugen. Die zweite Schicht 404 ist dann geeignet, grünes Licht zu erzeugen. Die vierte zur Lichterzeugung vorgesehene Schicht 405 ist geeignet, blaues Licht zu erzeugen.

Folgende Emittermaterialien sind zum Beispiel zur Erzeugung von Licht der angegebenen Farbe geeignet:
- blau: DPVBi = 4,4'-Bis(2,2-diphenyl-ethen-1-yl)-diphenyl
- blau: SEB-020
- grün: Irppy = fac-tris(2-phenly-pyridyl)irirdium complex
- rot: TER-012
- rot: DCM2: 4-(Dicyanomethylene)-2-methyl-6-(julolidine-4-yl-vinyl)-4H-pyran

Die übrigen Elemente des Leuchtmittels 100 wie zum Beispiel das Substrat 1, die erste Elektrode 2, die zweite Elektrode 3 und die Verkapselung 6 sind entsprechend einem der sonstigen Ausführungsbeispiele von Leuchtmitteln 100 ausgeführt.

Die Figur 46 zeigt das in Verbindung mit der Figur 45 dargestellte Leuchtmittel 100 in einer schematischen Perspektivskizze. Das Leuchtmittel ist mit einer Steuervorrichtung 11 verbunden, die geeignet ist, die Farbe des vom Leuchtmittel 100 erzeugten Lichts einzustellen. Die Steuervorrichtung 100 umfasst dazu bevorzugt eine Pulsweitenmodulationsschaltung 12. Abhängig von der elektrischen Feldstärke, die sich bei einer Bestromung des Leuchtmittels 100 zwischen der ersten Elektrode 2 und der zweiten Elektrode 3 im Schichtenstapel 4 einstellt, kann die Rekombination der Ladungsträger im organischen Schichtstapel 4 derart gesteuert werden, dass die Rekombination überwiegend in einer bestimmten, vorgebbaren, zur Lichterzeugung vorgesehenen Schicht stattfinden. Das heißt auf diese Weise kann beispielsweise eingestellt werden, dass die Rekombination hauptsächlich in der zur Lichterzeugung vorgesehenen Schicht 404 stattfindet. Auf diese Weise wird dann überwiegend grünes Licht vom Leuchtmittel 100 erzeugt.

Die Feldstärke im organischen Schichtstapel 4 ist dabei durch die Pulsweitenmodulationsschaltung 12 der Steuervorrichtung 11 einstellbar. Die elektrische Feldstärke ist beispielsweise durch die Pulsdauer und die Pulshöhe des pulsweitenmodulierten Signals regelbar.

Wie die Figur 47 schematisch veranschaulicht, ist die Farbe in der CIE Normfarbtafel des vom Leuchtmittel 100 erzeugten Lichts davon abhängig, ob die Pulsweitenmodulationsschaltung 12 ein pulsweitenmoduliertes Signal mit einer kurzen Pulsdauer 1220 erzeugt oder das Leuchtmittel 100 mittels eines kontinuierlichen Stroms 1210 bestromt wird.

Die Pulshöhe des pulsweitenmodulierten Signals bestimmt dabei im Wesentlichen die Helligkeit des vom Leuchtmittel 100 erzeugten Lichts. Das heißt zusammenfassend, Farbe und Helligkeit des vom Leuchtmittel 100 erzeugten Lichts können mittels der Pulsweitenmodulationsschaltung 12 eingestellt werden.

Die Steuervorrichtung 11 kann zusätzlich mit einem Fotodetektor 65 verbunden sein. Der Fotodetektor 65 ist beispielsweise, wie in Verbindung mit den Figuren 42 und 43 beschrieben, geeignet, den Farbort und/oder die Helligkeit des vom Leuchtmittel 100 erzeugten Lichts zu detektieren. Die Einstellung eines bestimmten Farborts des vom Leuchtmittel 100 erzeugten Lichts ist dann durch eine Regelung in Abhängigkeit der vom Fotodetektor 65 ermittelten Werte möglich. Das heißt die Steuervorrichtung 11 umfasst einen Regelschaltkreis, der einen bestimmten Farbort des vom Leuchtmittel 100 erzeugten Lichts einstellen kann. Der gewünschte Farbort ist dabei vorzugsweise durch einen Benutzer von außerhalb des Leuchtmittels vorgebbar.

In Verbindung mit der Figur 48A ist eine Verwendungsmöglichkeit eines mehrfarbigen Leuchtmittels 100, wie es in Verbindung mit einem der vorherigen Ausführungsbeispiele beschrieben ist, anhand einer schematischen Draufsicht erläutert.

In diesem Beispiel ist das Leuchtmittel 100 auf ein textiles Bekleidungsstück 27 aufgebracht. Das Leuchtmittel 100 ist beispielsweise mit einem Klett-Verschluss 34, der an der zweiten Hauptfläche 102 des Substrats des Leuchtmittels angeordnet ist, am Bekleidungsstück 27 befestigt, siehe dazu auch die Figur 49.

Wie die Figur 48B in einer schematischen Darstellung veranschaulicht, ist das Leuchtmittel 100 mit einer Steuervorrichtung 11, die beispielsweise eine Pulsweitenmodulationsschaltung umfassen kann, verbunden. Der Träger des Bekleidungsstücks 27 kann Helligkeit und Farbe des vom Leuchtmittel 100 erzeugten Lichts über die Steuervorrichtung 11 einstellen. Ferner ist es möglich, dass die Steuervorrichtung 11 vorgesehen ist, abhängig von vom Sensor 67 ermittelten Messwerten Helligkeit und/oder Farbe des vom Leuchtmittel 100 erzeugten Lichts einzustellen.

Beim Sensor 67 kann es sich beispielsweise um einen Sensor handeln, der geeignet ist, Körpertemperatur, Pulsfrequenz und/oder Hautwiderstand des Trägers des Bekleidungsstücks 27 zu ermitteln.

Eine erhöhte Körpertemperatur kann beispielsweise durch die Erzeugung von rotem Licht durch das Leuchtmittel 100 signalisiert werden. Eine geringe Temperatur kann durch die Erzeugung von blauem Licht durch das Leuchtmittel 100 signalisiert werden.

Insgesamt bildet das Bekleidungsstück 27 zusammen mit dem Leuchtmittel 100 eine Beleuchtungseinrichtung, bei der das Bekleidungsstück 27 als Träger vorgesehen ist. Die Stromversorgung 10 des Leuchtmittels 100 kann beispielsweise durch eine Batterie erfolgen, die in das Bekleidungsstück 27 oder das Leuchtmittel 100 integriert ist.

Das Leuchtmittel 100 findet beispielsweise als Flirtindikator Verwendung. Der Träger des Bekleidungsstücks 27 mit dem Leuchtmittel 100 kann über die Einstellung der Farbe des vom Leuchtmittel 100 erzeugten Lichts dann seine Flirtbereitschaft signalisieren.

Ferner ist auch ein Einsatz eines solchen Bekleidungsstücks 27 mit Leuchtmittel 100 in medizinischen oder militärischen Anwendungen denkbar. Das Leuchtmittel 100 ermöglicht eine einfache Überwachung bestimmter Körperfunktionen wie Körpertemperatur, Hautwiderstand und Pulsfrequenz des Trägers des Bekleidungsstücks 27.

Die Figur 49 zeigt in einer schematischen Schnittdarstellung ein Ausführungsbeispiel eines hier beschriebenen Leuchtmittels. Das Leuchtmittel 100 ist beispielsweise ein flexibles und/oder mehrfarbiges Leuchtmittel 100 wie es in Verbindung mit dem weiter oben erläuterten Ausführungsbeispiel beschrieben ist.

Auf die der ersten Hauptfläche des Substrats 1 abgewandte zweite Hauptfläche 102 des Substrats 1 ist ein Klett-Verschluss 34 aufgebracht. Der Klett-Verschluss 34 ist zum Beispiel auf die der ersten Hauptfläche des Substrats 1 abgewandte zweite Hauptfläche 102 des Substrats 1 angeklebt. Mit dem Klett-Verschluss 34 ist das Leuchtmittel 100 mit einem textilen Material, zum Beispiel einem Bekleidungsstück 27 oder einem Vorhang 25 mechanisch verbunden.

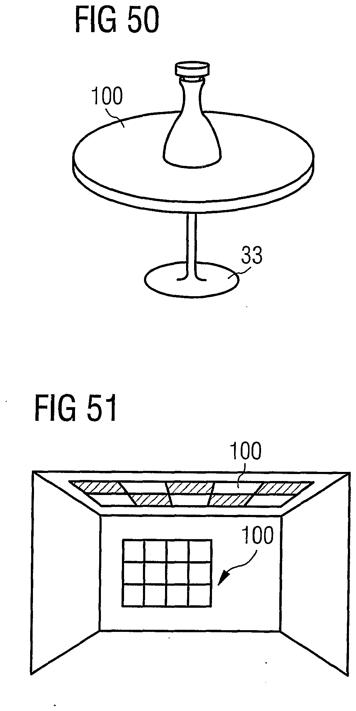

In Verbindung mit der Figur 50 ist eine weitere Verwendungsmöglichkeit eines mehrfarbigen Leuchtmittels, wie es beispielsweise im Zusammenhang mit einer der obigen Figuren beschrieben ist, anhand einer schematischen Perspektivskizze erläutert. Das Leuchtmittel 100 ist dabei an einem Möbelstück 33, beispielsweise auf einer Tischplatte, befestigt. Die Befestigung des Leuchtmittels 100 kann beispielsweise wie in Verbindung mit der Figur 32 erläutert mit einer Klebeschicht erfolgen. Je nach Wunsch des Benutzers kann die Farbe des vom Leuchtmittel 100 emittierten Lichts eingestellt werden. Ein solches Möbelstück 33 kann neben der Verwendung im Haushalt auch für Produktpräsentationen Verwendung finden.

Die Figur 51 zeigt in einer schematischen Perspektivskizze die Verwendung von mehrfarbigen Leuchtmitteln 100 als Raumbeleuchtung, beispielsweise als Decken- oder Wandleuchten.

Je nach Wunsch des Benutzers kann auf diese Weise der Raum mit Licht einer bestimmten Farbe und/oder einer bestimmten Farbtemperatur ausgeleuchtet werden. Dabei ist es insbesondere mögliche, dass es sich beim dem mehrfarbigen Leuchtmittel 100 um ein flexibles, lichtdurchlässiges und/oder reflektierendes Leuchtmittel 100 handelt.

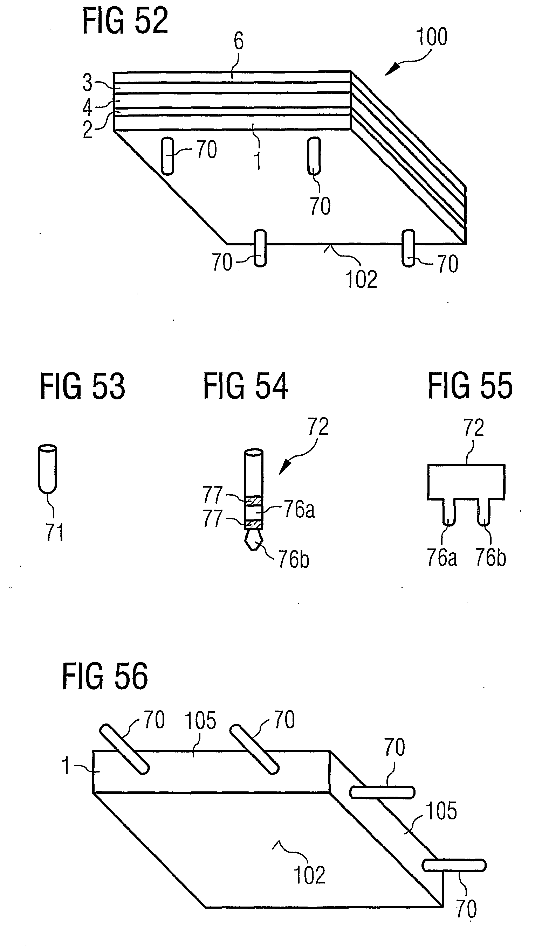

Die Figur 52 zeigt eine schematische Perspektivdarstellung eines Ausführungsbeispiels eines hier beschriebenen Leuchtmittels 100.

Substrat 1, Elektroden 2, 3, organischer Schichtstapel 4 und Verkapselung 6 des Leuchtmittels 100 sind entsprechend einem sonstigen hier beschrieben Leuchtmittel ausgebildet.

Beim Ausführungsbeispiel der Figur 52 sind an der zweiten Hauptfläche 102 des Substrats 1 des Leuchtmittels 100 elektrische Anschlussstellen 70 ausgebildet. Im in Verbindung mit der Figur 52 beschriebenen Ausführungsbeispiel sind die Anschlussstellen 70 als aus dem Substrat herausragende Anschlussstellen ausgeführt. Die Anschlussstellen 70 sind beispielsweise mittels der weiter oben beschriebenen elektrischen Zuleitungen mit der ersten Elektrode 2 sowie der zweiten Elektrode 3 des Substrats verbunden und dienen zum elektrischen Kontaktieren des Leuchtmittels 100 von außerhalb des Leuchtmittels 100.

Darüber hinaus dienen die Anschlussstellen 70 des in Verbindung mit der Figur 52 beschriebenen Leuchtmittels 100 zur mechanischen Befestigung des Leuchtmittels 100 an einem anderen Leuchtmittel 100 oder auf einem Träger.

Die Figur 53 zeigt eine erste Möglichkeit zur Ausbildung der Anschlussstellen 70 im in Verbindung mit der Figur 52 beschriebenen Ausführungsbeispiel des Leuchtmittels 100. Die Anschlussstellen 70 des Leuchtmittels 100 sind in diesem Fall als Anschlussstifte 71 ausgeführt. Die Anschlussstifte sind beispielsweise zylinderartig ausgebildet. Die Anschlussstifte werden zur Kontaktierung und Befestigung des Leuchtmittels 100 in korrespondierende Anschlusslöcher gedrückt. Bevorzugt findet dabei neben der elektrischen Kontaktierung auch eine mechanische Befestigung des Leuchtmittels 100 durch eine Presspassung statt.

In Verbindung mit der Figur 54 ist in einer schematischen Perspektivskizze eine weitere Möglichkeit der Ausgestaltung der Anschlussstellen 70 des Leuchtmittels 100 der Figur 52 gezeigt. In diesem Fall sind die Anschlussstellen 70 als Anschlussstecker 72 ausgeführt. Der Anschlussstecker der Figur 54 ist nach Art eines Klinkensteckers ausgeführt. Der Anschlussstecker 72 weist einen ersten elektrisch leitenden Bereich 76a auf, der beispielsweise mit der ersten Elektrode 2 des Leuchtmittels 100 elektrisch leitend verbunden ist. Ferner weist der Anschlussstecker 72 einen zweiten elektrisch leitenden Bereich 76b auf, der mit der zweiten Elektrode 3 des Leuchtmittels 100 elektrisch leitend verbunden ist. Elektrisch isolierende Bereiche 77 trennen die beiden elektrisch leitenden Bereiche 76a, 76b voneinander.

In Verbindung mit der Figur 55 ist in einer schematischen Draufsicht eine weitere Ausgestaltungsmöglichkeit für die Anschlussstellen 70 des Leuchtmittels 100, wie es in der Figur F52 dargestellt ist, gezeigt. In diesem Fall ist die Anschlussstelle 70 als Anschlussstecker 72 ausgebildet, wobei die elektrisch leitenden Bereiche 76a, 76b lateral nebeneinander angeordnet sind. Die leitenden Bereiche 76a, 76b sind dabei zylinderartig ausgebildet.

Anhand der schematischen Perspektivskizze der Figur 56 ist ein Ausführungsbeispiel eines hier beschriebenen Leuchtmittels 100 näher erläutert.

Im Gegensatz zum Ausführungsbeispiel der Figur 52 sind in diesem Ausführungsbeispiel die Anschlussstellen 70 an den Seitenflächen 105 des Substrats 1 des Leuchtmittels 100 angeordnet. Die Anschlussstellen 70 können dabei wie in Verbindung mit den Figuren 53, 54 und 55 erläutert ausgebildet sein. Das heißt die Anschlussstellen sind als Anschlussstifte oder Anschlussstecker ausgeführt.

Die in der Figur 56 gezeigte Anordnung der Anschlussstellen 70 an den Seitenflächen 105 des Leuchtmittels ermöglicht in besonders einfacher Weise das Verbinden und elektrische Kontaktieren von mehreren gleichartig ausgebildeten Leuchtmitteln 100 zu einer Beleuchtungseinrichtung mit einer ausgedehnten Leuchtfläche. Die Leuchtfläche der Beleuchtungseinrichtung setzt sich dabei aus den Licht emittierenden Vorderseiten der Leuchtmittel der Beleuchtungseinrichtung zusammen.

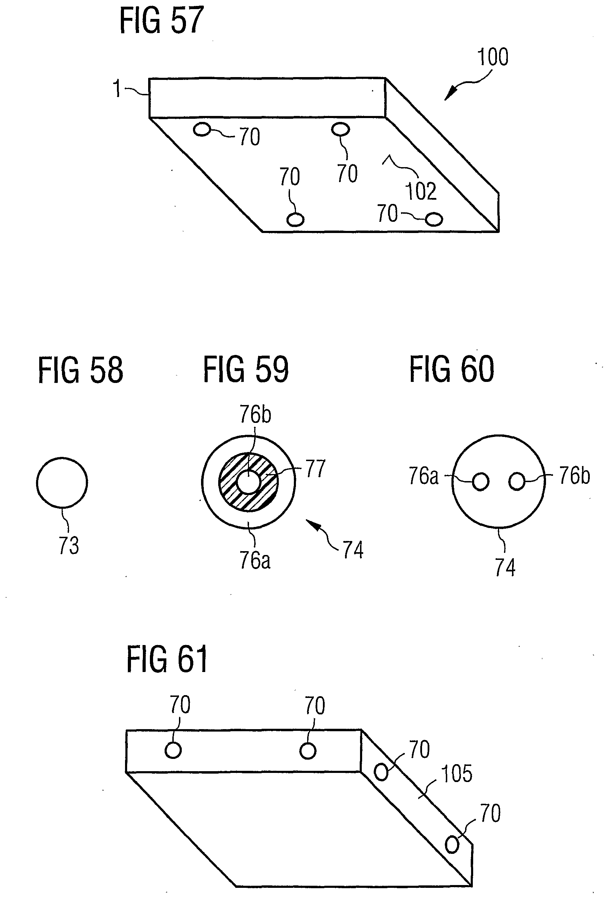

In Verbindung mit der schematischen Perspektivskizze der Figur 57 ist ein weiteres Ausführungsbeispiel eines Leuchtmittels 100 beschrieben. In diesem Ausführungsbeispiel sind die Anschlussstellen 70 an der zweiten Hauptfläche 102 des Substrates 1 des Leuchtmittels 100 ausgebildet. Die Anschlussstellen 70 sind dabei durch Ausnehmungen oder Durchbrüche im Substrat 1 gebildet.

Die Figur 58 zeigt in einer schematischen Draufsicht eine erste Möglichkeit zur Ausgestaltung der Anschlussstellen 70 des Leuchtmittels 100 der Figur 57. In diesem Fall ist die Anschlussstelle 70 als elektrisch leitende Ausnehmung 73 beziehungsweise Kontaktloch ausgeführt. Durch Eindrücken eines Anschlussstiftes wie er beispielsweise in der Figur 53 gezeigt ist, kann das Leuchtmittel 100 über die elektrisch leitende Ausnehmung elektrisch kontaktiert und mechanisch befestigt werden.

Die schematische Draufsicht der Figur 59 zeigt ein weiteres Ausführungsbeispiel für die Anschlussstellen 70 des in Verbindung mit der Figur 57 beschriebenen Leuchtmittels 100. In diesem Fall sind die Anschlussstellen 70 als Anschlussbuchsen 74 ausgeführt. Jede Anschlussbuchse 74 weist zwei elektrisch leitende Bereiche 76a, 76b auf, die mit je einer Elektrode 2, 3 des Leuchtmittels 100 verbunden sind. Beispielsweise kann eine solche Anschlussbuchse 74 mittels eines Anschlusssteckers 72 wie er in Figur 54 gezeigt ist, elektrisch kontaktiert werden.

Die Figur 60 zeigt in einer schematischen Draufsicht eine weitere Ausführungsform der Anschlussstellen 70 des Leuchtmittels 100 der Figur 57. In diesem Fall sind die elektrisch leitenden Bereiche 76a, 76b als elektrisch leitende - beispielsweise metallische - Beschichtungen einer Anschlussbuchse ausgeführt, die im Substrat 1 des Leuchtmittels 100 angeordnet sind. Die elektrisch leitenden Bereiche 76a und 76b sind dabei lateral nebeneinander angeordnet. Beispielsweise kann eine solche Anschlussbuchse 74 mittels eines Anschlusssteckers 72 wie er in Figur 55 gezeigt ist, elektrisch kontaktiert werden.

Die schematische Perspektivskizze der Figur 61 zeigt ein weiteres Ausführungsbeispiel eines hier beschriebenen Leuchtmittels 100. Im Unterschied zum in Verbindung mit der Figur 57 beschriebenen Leuchtmittel sind die Anschlussstellen als Ausnehmungen in den Seitenflächen 105 des Substrates 1 des Leuchtmittels 100 ausgeführt. Die konkrete Ausgestaltung der Anschlussstellen 70 kann dabei gemäß den in Verbindung mit den Figuren 58, 59 und 60 beschriebenen Anschlussstellen 70 erfolgen.

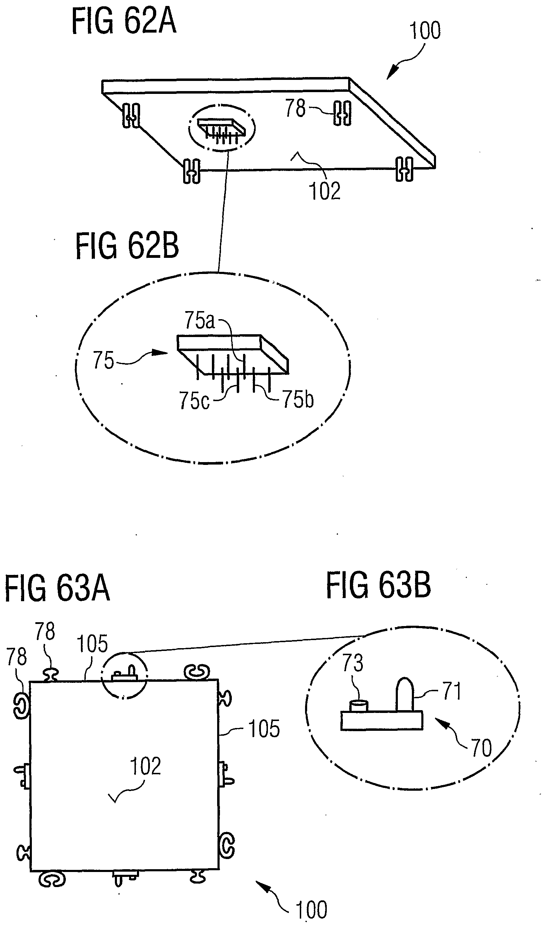

Die Figur 62A zeigt in einer schematischen Perspektivskizze ein weiteres Ausführungsbeispiel eines hier beschriebenen Leuchtmittels 100. In diesem Ausführungsbeispiel sind die elektrische Kontaktierung und die mechanische Befestigung des Leuchtmittels durch voneinander getrennte Elemente realisiert. Die mechanische Befestigung des Leuchtmittels erfolgt über mechanische Verbinder 78. Im Ausführungsbeispiel der Figur 62A sind die mechanischen Verbinder an der zweiten Hauptfläche 102 des Substrates 1 des Leuchtmittels 100 angeordnet. Die mechanischen Verbinder 78 sind als Clipse ausgeführt, die zur Befestigung des Leuchtmittels 100 in korrespondierende Ausnehmungen eingreifen.

Die Figur 62B zeigt in einer schematischen Perspektivdarstellung einen Pin-Anschluss 75 in einer Ausschnittsvergrößerung.

Zur elektrischen Kontaktierung des Leuchtmittels weist das Leuchtmittel 100 einen Pin-Anschluss 75 auf, der ebenfalls an der zweiten Hauptfläche 102 des Substrates 1 angeordnet ist. Der Pin-Anschluss 75 umfasst eine Mehrzahl von Pins 75a. Zumindest einer der Pins 75a kontaktiert die erste Elektrode 2, zumindest ein zweiter Pin 75b kontaktiert die zweite Elektrode 3. Weitere Pins 75c können beispielsweise zur Kontaktierung einer in das Leuchtmittel 100 integrierten Steuervorrichtung 11 vorgesehen sein.

In Verbindung mit der Figur 63A ist in einer schematischen Draufsicht ein weiteres Ausführungsbeispiel eines hier beschriebenen Leuchtmittels 100 erläutert. Auch in diesem Ausführungsbeispiel sind die mechanischen Verbinder 78 zu den elektrischen Anschlussstellen 70 des Leuchtmittels 100 separat angeordnet. Sowohl die mechanischen Verbinder 78 als auch die elektrischen Anschlussstellen 70 sind an den Seitenflächen 105 des Substrates 1 des Leuchtmittels 100 angeordnet. Die Ausschnittsvergrößerung der Figur 63B zeigt eine Anschlussstelle 70. Die Anschlussstelle weist beispielsweise eine elektrisch leitende Ausnehmung 73 - zum Beispiel ein Kontaktloch - sowie einen Anschlussstift 71 auf, wie sie in Verbindung mit den Figuren 58 beziehungsweise 53 näher erläutert sind.

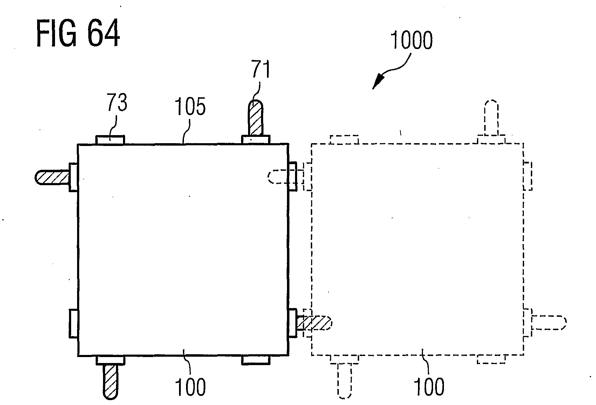

Die Figur 64 zeigt eine schematische Draufsicht auf ein Beispiel einer hier beschriebenen Beleuchtungseinrichtung 1000. Die Beleuchtungseinrichtung 1000 umfasst wenigstens zwei Leuchtmittel 100. Die Leuchtmittel 100 weisen an den Seitenflächen 105 des Substrates 1 angeordnete Anschlussstellen auf, die abwechselnd als elektrisch leitende Ausnehmungen 73 und Kontaktstifte 71 ausgebildet sind. Die Kontaktstifte 71 eines ersten Leuchtmittels greifen in korrespondierende elektrisch leitende Ausnehmungen 73 eines zweiten Leuchtmittels. Durch die Verbindung von Kontaktstiften 71 und elektrisch leitenden Ausnehmungen 73 wird sowohl eine elektrische als auch eine mechanische Verbindung zwischen den Leuchtmitteln 100 der Beleuchtungseinrichtung 1000 hergestellt.

Die mechanische Verbindung zwischen je zwei Leuchtmitteln 100 wird beispielsweise durch eine Presspassung vermittelt. Dazu ist der Durchmesser eines jeden Kontaktstiftes 71 gleich oder größer gleich dem Durchmesser einer jeden elektrisch leitenden Ausnehmung 73 gewählt. Durch das Einpressen des Kontaktstiftes 71 in die korrespondierende elektrisch leitende Ausnehmung 73 wird eine mechanische Verbindung vermittelt, die sich nur durch Aufbringen großer mechanischer Kraft wieder lösen lässt.

Alternativ können die Anschlussstellen als Kontaktstecker - wie sie in Verbindung mit den Figuren 54 und 55 beschrieben sind - beziehungsweise als korrespondierende Anschlussbuchsen - wie sie in Verbindung mit den Figuren 59 und 60 - beschrieben sind, ausgebildet sein. Dies ermöglicht eine elektrische und mechanische Verbindung der Leuchtmittel 100. Dabei ist die mechanische Verbindung der Leuchtmittel 100 durch Aufbringen einer relativ geringen mechanischen Kraft lösbar. Dies erlaubt ein besonders einfaches Austauschen eines defekten Leuchtmittels 100 aus der Beleuchtungseinrichtung 1000.

In Verbindung mit den Figuren 66 und 65 ist anhand schematischer Perspektivskizzen ein weiteres Beispiel der Beleuchtungseinrichtung 1000 beschrieben. Die Leuchtmittel 100 sind in diesem Beispiel auf einen Träger, der als Trägergitter 81 ausgebildet ist, aufgebracht. Das Trägergitter 81 weist Anschlussstellen 82 auf, die beispielsweise als Kontaktlöcher ausgebildet sind, wie sie in Verbindung mit der Figur 58 näher beschrieben sind. Alternativ können die Kontaktstellen 82 als Anschlussbuchsen ausgeführt sein, wie sie in Verbindung mit den Figuren 59 und 60 näher erläutert sind.

Kontaktstifte 71 beziehungsweise Kontaktstecker 72, wie sie in Verbindung mit den Figuren 53, 54 und 55 beschrieben sind, bilden die Anschlussstellen 70 der Leuchtmittel 100. Die Anschlussstellen 70 greifen in korrespondierende Anschlussstellen 82 des Trägergitters 81. Auf dem Trägergitter 81 ist vorzugsweise eine Vielzahl von Leuchtmitteln 100 elektrisch kontaktiert und mechanisch befestigt. Die Beleuchtungseinrichtung 1000 wird durch eine Stromversorgung 10 mit dem für den Betrieb der Leuchtmittel 100 notwendigen Betriebsstrom versorgt.

In Verbindung mit den Figuren 69 und 65 ist ein weiteres Beispiel einer hier beschriebenen Beleuchtungseinrichtung 1000 erläutert. In diesem Beispiel weist die Beleuchtungseinrichtung 1000 eine Trägerplatte 80 auf, die eine Vielzahl von Anschlussstellen 82 umfasst. Korrespondierende Anschlussstellen 70 des Leuchtmittels 100 greifen in die Anschlussstellen 82 der Trägerplatte 80. Für den Fall, dass die Anschlussstellen 70 des Leuchtmittels als Anschlussstifte 71 oder Anschlussstecker 72 ausgeführt sind, sind die Anschlussstellen 82 der Trägerplatte als elektrisch leitende Ausnehmungen 73 oder Anschlussbuchsen 74 ausgeführt. Für den Fall, dass die Anschlussstellen 70 der Leuchtmittel 100 als elektrisch leitende Ausnehmungen 73 oder Anschlussbuchsen 74 ausgeführt sind, sind die Anschlussstellen 82 der Trägerplatte 80 als Anschlussstifte 71 beziehungsweise Anschlussstecker 72 ausgeführt.

Die Beleuchtungseinrichtung 1000, wie sie in Verbindung mit den Figuren 67 und 65 beschrieben ist, ist von einer Stromversorgung 10 bestromt.

In Verbindung mit der Figur 68 ist in einer schematischen Perspektivdarstellung ein weiteres Beispiel einer hier beschriebenen Beleuchtungseinrichtung 1000 erläutert. Die Beleuchtungseinrichtung 1000 weist einen Träger auf, der in Form eines Seil- beziehungsweise Stangensystems ausgebildet ist. Das Seil- beziehungsweise Stangensystem umfasst wenigstens zwei im Wesentlichen zueinander parallel verlaufende Seile beziehungsweise Stangen 83 aus einem elektrisch leitenden Material. Über die Seile beziehungsweise Stangen 83 werden die Leuchtmittel 100 der Beleuchtungseinrichtung 1000 bestromt.

Zur mechanischen Befestigung und elektrischen Kontaktierung an den Seilen beziehungsweise Stangen 83 weist das Leuchtmittel 100 zwei Anschlussstellen auf, die als Anschlussschienen 84 ausgeführt sind, die an einander gegenüberliegenden Seitenflächen 105 des Substrates 1 des Leuchtmittels 100 angeordnet sind.

Die Anschlussschienen 84 sind nach Art von aufgeschnittenen Zylindern ausgeführt. Die Anschlussschienen 84 erstrecken sich über die gesamte Länge der Seitenfläche 105 des Substrates 1, an dem sie befestigt sind.

Die Anschlussschienen 84 greifen in die Seile beziehungsweise Stangen 83 des Trägers der Beleuchtungseinrichtung 1000 vorzugsweise derart locker ein, dass die Leuchtmittel 100 der Beleuchtungseinrichtung 1000 durch Anwenden einer relativ geringen mechanischen Kraft entlang der Seile beziehungsweise der Stangen 83 verschoben werden können. Auf diese Weise ist eine besonders einfache Positionierung der Leuchtmittel 100 entlang der Seile beziehungsweise Stangen 83 möglich. Die Leuchtmittel 100 können sogar im Betrieb der Beleuchtungseinrichtung 1000 entlang der Seile beziehungsweise Stangen 83 verschoben werden. Insgesamt erlaubt dies eine besonders flexibel einsetzbare Beleuchtungseinrichtung 1000.

In Verbindung mit der Figur 69 ist anhand einer schematischen Schaltskizze ein Beispiel zur Verschaltung von Leuchtmitteln 100 einer hier beschriebenen Beleuchtungseinrichtung 1000 erläutert. In diesem Beispiel sind die Leuchtmittel 100 parallel zueinander geschaltet. Die Leuchtmittel 100 werden beispielsweise von einer Spannungsquelle 10 mit Betriebsspannung versorgt. Dabei ist es möglich, dass die Leuchtmittel 100 jeweils eine integrierte Steuervorrichtung 11 umfassen.

In Verbindung mit der Figur 70 ist anhand einer schematischen Schaltskizze ein weiteres Beispiel einer hier beschriebenen Beleuchtungseinrichtung 1000 erläutert. In diesem Fall sind die Leuchtmittel 100 der Beleuchtungseinrichtung 1000 in Reihe zueinander verschaltet. Die Leuchtmittel 100 werden dabei von einer Stromquelle 10 mit dem nötigen Betriebsstrom versorgt. Dabei ist es möglich, dass die Stromquelle 10 zur Selbsterkennung der Anzahl der Leuchtmittel 100 der Beleuchtungseinrichtung 1000 geeignet ist. Die Leuchtmittel 100 können darüber hinaus eine integrierte Steuervorrichtung 11 umfassen, wie sie weiter oben beschrieben ist.

Die Erkennung der Leuchtmittel 100 kann beispielsweise durch eine Messung der Stromstärke oder der Spannung erfolgen. Dabei kann im Betrieb auch der eventuelle Ausfall von einem oder mehreren Leuchtmittel 100 detektiert werden.

In Verbindung mit der Figur 71 ist ein weiteres Beispiel einer hier beschriebenen Beleuchtungseinrichtung 1000 erläutert. Die Leuchtmittel 100 sind dabei mit einer Steuervorrichtung 11, wie sie weiter oben beschrieben ist, ausgestattet. Eine weitere Steuervorrichtung 11a der Beleuchtungseinrichtung 1000 versorgt die Leuchtmittel 100 mit dem nötigen Betriebsstrom sowie Steuersignalen für die Steuervorrichtungen 11 der Leuchtmittel 100.

In Verbindung mit der Figur 72 ist anhand einer schematischen Perspektivdarstellung ein weiteres Beispiel einer hier beschriebenen Beleuchtungseinrichtung 1000 erläutert. Die Beleuchtungseinrichtung 1000 weist eine Vielzahl von Leuchtmitteln 100 auf, die entweder mittels der oben beschriebenen Anschluss- und Verbindungstechniken direkt miteinander verbunden sind oder die in der oben beschriebenen Weise auf einen Träger aufgebracht sind und mit diesen elektrisch verbunden sind.

Den Leuchtmitteln 100 ist an ihrer Licht emittierenden Vorderseite ein optisches Element 60 nachgeordnet, das beispielsweise durch eine Diffuserplatte gebildet ist. Das optische Element kann beispielsweise durch eine lichtdurchlässige Platte - zum Beispiel eine Glasplatte - gebildet sein, in welche Licht streuende Teilchen eingebracht sind. Alternativ ist es möglich, dass die Oberfläche der strahlungsdurchlässigen Platte aufgeraut ist, so dass aufgrund von Lichtbrechung beim Durchtritt durch die Platte eine diffuse Streuung des durchtretenden Lichts stattfindet. Durch die Diffuserplatte wird das Licht der Leuchtmittel 100 derart gestreut, dass die einzelnen Leuchtmittel vom Betrachter nicht mehr getrennt wahrnehmbar sind. Auf diese Weise ist eine großflächige Beleuchtungseinrichtung 1000 mit einer besonders großen, homogenen Leuchtfläche realisiert. Die Leuchtfläche der Beleuchtungseinrichtung setzt sich dabei aus den Licht emittierenden Vorderseiten der Leuchtmittel der Beleuchtungseinrichtung zusammen.

In Verbindung mit der Figur 73 ist ein weiteres Beispiel einer Beleuchtungseinrichtung 1000 anhand einer schematischen Perspektivskizze dargestellt. Die Beleuchtungseinrichtung 1000 kann beispielsweise als Deckenleuchte Verwendung finden. Die Beleuchtungseinrichtung 1000 umfasst mehrere Leuchtmittel 100, die entweder wie oben beschrieben durch Anschlussstellen an den Seitenflächen 105 der Substrate 1 der Leuchtmittel 100 miteinander elektrisch und mechanisch verbunden sind oder die mittels Stangen beziehungsweise Seile 83 befestigt und elektrisch kontaktiert sind.

In Verbindung mit der schematischen Perspektivdarstellung der Figur 74 ist ein weiteres Beispiel einer Beleuchtungseinrichtung 1000 beschrieben. Die Beleuchtungseinrichtung 1000 umfasst einen Sockel, in dem die Stromversorgung 10 sowie eine Ansteuervorrichtung 11 integriert sind. Die Leuchtmittel 100 der Beleuchtungseinrichtung 1000 sind mittels Stangen 83 mechanisch befestigt und elektrisch kontaktiert. Als Leuchtmittel 100 können wiederum die in Verbindung mit den obigen Beispielen beschriebenen Leuchtmittel Verwendung finden.

Die in Verbindung mit der Figur 74 beschriebene Beleuchtungseinrichtung 1000 eignet sich besonders gut als Steh- oder Tischlampe.

In Verbindung mit der Figur 75 ist eine Anzeigevorrichtung 1010 anhand einer schematischen Perspektivdarstellung näher erläutert. Die Anzeigevorrichtung 1010 umfasst eine Beleuchtungseinrichtung 1000 als Hinterleuchtung für ein bildgebendes Element 90. Bei dem bildgebenden Element 90 handelt es sich beispielsweise um ein LCD-Panel. Das LCD-Panel wird von der Beleuchtungseinrichtung 1000 direkt hinterleuchtet. Das heißt das bildgebende Element 90 ist der Beleuchtungseinrichtung 1000 derart nachgeordnet, dass ein Großteil des von der Beleuchtungseinrichtung 1000 im Betrieb erzeugten Lichts auf das bildgebende Element 90 trifft und dieses hinterleuchtet.

Die Beleuchtungseinrichtung 1000, die hier als Hinterleuchtungsvorrichtung Verwendung findet, ist beispielsweise gemäß einem der sonstigen hier beschriebenen Beispiele ausgeführt. Die Beleuchtungseinrichtung umfasst dabei zumindest zwei Leuchtmittel 100, wie sie hier beschrieben sind.

Zur Homogenisierung des zur Hinterleuchtung vorgesehenen Lichts ist es weiter möglich, dass zwischen dem bildgebenden Element 90 und der Licht emittierenden Vorderseite der Leuchtmittel 100 der Beleuchtungseinrichtung 1000 ein optisches Element 60 angeordnet ist, das dann vorzugsweise als Diffuserplatte ausgebildet ist. Das optische Element kann beispielsweise durch eine lichtdurchlässige Platte - zum Beispiel eine Glasplatte - gebildet sein, in welche Licht streuende Teilchen eingebracht sind. Alternativ ist es möglich, dass die Oberfläche der strahlungsdurchlässigen Platte aufgeraut ist, so dass aufgrund von Lichtbrechung beim Durchtritt durch die Platte eine diffuse Streuung des durchtretenden Lichts stattfindet. Durch die Diffuserplatte wird das Licht der Leuchtmittel 100 der Beleuchtungseinrichtung derart gestreut, dass die einzelnen Leuchtmittel nicht mehr getrennt auf das bildgebende Element 90 abgebildet werden. Auf diese Weise ist eine großflächige Beleuchtungseinrichtung 1000 mit einer besonders großen, homogenen Leuchtfläche zu Hinterleuchtung des bildgebenden Elements 90 realisiert.

In Verbindung mit der Figur 76 ist ein Beispiel eines grobkörnigen Displays 95 anhand einer schematischen Draufsicht näher erläutert. Das grobkörnige Display ist als Beleuchtungseinrichtung mit einer Trägerplatte 80 ausgeführt, auf die eine Mehrzahl von Leuchtmitteln 100 aufgebracht ist. Die Leuchtmittel 100 sind beispielsweise nach Art einer Sieben-Segment-Anzeige angeordnet. Durch Bestromung bestimmter Leuchtmittel 100 ist auf diese Weise ein grobkörniges Display 95 realisiert, das zur Darstellung von Ziffern geeignet ist.

Die Figur 77 zeigt ein Badezimmer mit Leuchtmitteln 100, die als Kacheln ausgebildet sind. Die Leuchtmittel 100 sind beispielsweise gemäß einem der weiter oben beschriebenen Ausführungsbeispiele ausgeführt. Sie sind mit der zweiten Hauptfläche 102 des Substrats 1 beispielsweise auf herkömmliche Sanitärfliesen aufgeklebt. Eine Stromversorgung dieser Leuchtmittel kann beispielsweise mittels Induktion erfolgen. In diesem Fall kann auf elektrische Leiterbahnen zum Anschließen der Leuchtmittel 100 verzichtet werden. Diese Leuchtmittel eignen sich daher besonders gut für den Einsatz im Sanitärbereich, da die Gefahr eines Kurzschlusses aufgrund von Feuchtigkeit reduziert ist.

Ein Leuchtmittel, das mittels Induktion bestromt wird, ist zum Beispiel in der Druckschrift DE 102006025115 offenbart.

Figur 78 zeigt eine schematische perspektivische Darstellung einer Beleuchtungseinrichtung 1000 mit einem Leuchtmittel 100 und einer zweiten Lichtquelle 370 gemäß einem Beispiel. Als zweite Lichtquelle 370 ist vorliegend eine Glühlampe verwendet, die in eine Halterung eines Trägers 371 eingebracht ist. Anstelle einer Glühlampe als zweite Lichtquelle 370 kann beispielsweise auch eine Halogenlampe verwendet sein. Die Glühlampe ist derart ausgebildet, dass sie im Betrieb weißes Licht mit einem Farbort im warmweißen Bereich der CIE-Norm-Farbtafel aussendet. Das Leuchtmittel ist hingegen derart ausgebildet, dass es im Betrieb Licht aus dem kaltweißen Bereich der CIE-Norm-Farbtafel aussendet. Das Leuchtmittel 100 ist vorliegend flexibel sowie durchlässig für sichtbares Licht ausgebildet. Das Leuchtmittel 100 ist als zylinderförmiger Lampenschirm um die Glühlampe derart angeordnet, dass ein Großteil des von der zweiten Lichtquelle emittierten Lichtes durch das Leuchtmittel hindurch tritt. Auf diese Art und Weise wird im Betrieb der Beleuchtungseinrichtung mischfarbiges Licht ausgesandt, das Licht des Leuchtmittels 100 und Licht der zweiten Lichtquelle 370 aufweist.

Weiterhin sind das Leuchtmittel 100 und die zweite Lichtquelle 370 dimmbar ausgeführt, so dass der Anteil des Lichtes der Glühlampe und der Anteil des Lichtes des Leuchtmittels 100 an dem mischfarbigen Licht variiert werden kann. Je nach Anteil des Lichtes der Glühlampe und des Lichtes des Leuchtmittels kann der Farbort mittels eines Reglers 372 in der Halterung der Beleuchtungseinrichtung von kaltweiß zu warmweiß reguliert werden. Bei der Beleuchtungseinrichtung gemäß der Figur 78 handelt es sich daher um eine farbveränderliche Beleuchtungseinrichtung.

Die Figur 79 zeigt eine schematische perspektivische Darstellung eines weiteren Beispiels einer Beleuchtungseinrichtung 1000 mit einem Leuchtmittel 100 und einer zweiten Lichtquelle 370. Die Beleuchtungseinrichtung ist dazu vorgesehen, an der Wand befestigt zu werden. Bei der zweiten Lichtquelle 370 handelt es sich um eine Lavalampe. Die Lavalampe umfasst Wachs, das in eine Trägerflüssigkeit eingebracht ist. Im Betrieb der Lavalampe werden Wachs und Trägerflüssigkeit von einer Seite, in der Regel von unten, erwärmt, so dass die Trägerflüssigkeit in der Lampe aufgrund von Konvektion zirkuliert. Weiterhin bildet das Wachs aufgrund der Erwärmung dekorative Formen innerhalb der Trägerflüssigkeit aus. Die Trägerflüssigkeit weist in der Regel eine andere Farbe als das Wachs auf, so dass die Lavalampe mischfarbiges Licht aussendet, das Anteile der Farbe des Wachses und Anteile der Farbe der Trägerflüssigkeit umfasst.

Die Lavalampe ist vorliegend im Wesentlichen zylinderförmig ausgebildet und an der Wand befestigt. Das Leuchtmittel 100 ist flexibel ausgebildet und als halber Zylindermantel um die Lavalampe derart angeordnet, dass das von der Lavalampe ausgesandte Licht, das nicht zur Wand strahlt, im Wesentlichen durch das Leuchtmittel hindurch tritt. Das Leuchtmittel 100 sendet weiterhin bevorzugt Licht einer Farbe aus, die nicht von dem Licht der Lavalampe umfasst ist. Das Leuchtmittel kann weiterhin beispielsweise dimmbar ausgeführt sein, so dass der Farbton des Lichtes, das von der Beleuchtungseinrichtung ausgesandt wird, durch Dimmen des Leuchtmittels in der Farbe verändert werden kann. Auf diese Art und Weise erhält man eine farbveränderliche Beleuchtungseinrichtung, die besonders eindrucksvolle Farbeffekte hervorrufen kann. Weiterhin ist es möglich, dass auch die Lavalampe dimmbar ist.

Die Figur 80A zeigt eine schematische perspektivische Darstellung einer Beleuchtungseinrichtung gemäß der Erfindung. Figur 80B zeigt eine Schnittdarstellung der Beleuchtungseinrichtung der Figur 80A.

Bei der Beleuchtungseinrichtung gemäß den Figuren 80A und 80B handelt es sich ebenfalls um eine farbveränderliche Beleuchtungseinrichtung 1000. Diese umfasst mehrere Leuchtdioden (LEDs) 380, die auf einen Träger 381 montiert sind, als weitere, zweite Lichtquelle 370. Die LEDs 380 senden Licht einer zweiten Farbe aus. Über den LEDs ist eine milchige Glasscheibe als optisches Element 60 angeordnet, durch die das Licht der LEDs im Betrieb der Beleuchtungseinrichtung derart hindurch tritt, dass die milchige Glasscheibe von ihrer Vorderseite farbiges Streulicht der zweiten Farbe emittiert. Bevorzugt streut die milchige Glasscheibe das Licht der LEDs derart, dass ein Beobachter, der vor der Glasscheibe positioniert ist, eine einheitliche leuchtende Fläche wahrnimmt.

Die milchige Glasscheibe dient weiterhin als Substrat 1 für ein Leuchtmittel 100, das Licht einer weiteren von der zweiten Farbe verschiedenen ersten Farbe aussendet und durchlässig für sichtbares Licht ausgebildet ist. Die milchige Glasscheibe weist einen aktiven Bereich auf, auf den eine erste Elektrode aufgebracht ist, die durchlässig für sichtbares Licht ist.

Auf die erste Elektrode 2 ist der organische Schichtstapel 4 aufgebracht, der ebenfalls durchlässig für sichtbares Licht ausgebildet ist. Der organische Schichtstapel 4 sendet Licht einer ersten Farbe aus, die verschieden ist von der zweiten Farbe. Auf dem organischen Schichtstapel 4 ist eine zweite Elektrode 3 aufgebracht, die ebenfalls durchlässig für sichtbares Licht ist. Erste und zweite Elektroden 2, 3, die durchlässig sind für sichtbares Licht, sind beispielsweise anhand der Figur 2A beschrieben. Auf die zweite Elektrode 3 ist eine Glasscheibe als Verkapselung 6 aufgebracht, beispielsweise durch Kleben. Die Glasscheibe, die als Verkapselung 6 dient, ist im Gegensatz zu der Glasscheibe, die als Substrat 1 dient, klar ausgebildet.

Eine Beleuchtungseinrichtung gemäß den Figuren 80A und 80B kann beispielsweise als Bodenbeleuchtung in Bars oder von Tanzflächen eingesetzt werden. Weiterhin können solche als farbveränderliche Lichtkacheln ausgebildete farbveränderliche Beleuchtungseinrichtungen auch zu medizinischen Zwecken in der Lichttherapie eingesetzt werden.

Figur 81 zeigt ein weiteres Beispiel einer Beleuchtungseinrichtung 1000, bei der neben einem Leuchtmittel 100 zumindest eine weitere Lichtquelle verwendet wird. Vorliegend ist das Leuchtmittel 100 starr und planar ausgebildet. Mittig innerhalb der Vorderseite des Leuchtmittels sind als zweite Lichtquellen 370 zwei Kaltkathodenlampen angeordnet. Ein solches Element kann beispielsweise als Deckenelement verwendet werden.

Figur 82 zeigt ein weiteres Beispiel einer Beleuchtungseinrichtung 1000 mit einem Leuchtmittel und einer zweiten Lichtquelle. Das Leuchtmittel 100 ist vorliegend wie das Leuchtmittel gemäß der Figur 81 starr ausgebildet. Mittig in der Vorderseite des Leuchtmittels ist ein LED-Modul 390 angeordnet, das ein Trägerelement umfasst, auf dem vier Leuchtdioden 380 angeordnet sind. Vorteilhaft sind bei der Beleuchtungseinrichtung 1000 Punktlichtquellen - nämlich die LED des LED-Moduls 390 - mit einer flächigen Lichtquelle - dem Leuchtmittel 100 kombiniert. Der Nutzer der Beleuchtungseinrichtung 1000 kann auf diese Weise zwischen verschiedenen Betriebszuständen wählen und diese miteinander kombinieren.

Die Figur 83 zeigt ein weiteres Beispiel einer Beleuchtungseinrichtung 1000 mit einem Leuchtmittel 100 und einer zweiten Leuchtquelle. Das Leuchtmittel 100 ist vorliegend durchlässig für sichtbares Licht ausgebildet und sendet Licht einer ersten Farbe aus. Als zweite Lichtquelle 370 ist eine organische Leuchtdiode verwendet, die Licht einer zweiten Farbe aussendet. Die organische Leuchtdiode weist eine strahlungsemittierende Vorderseite auf, auf der das Leuchtmittel angeordnet ist. Im Betrieb der Beleuchtungseinrichtung durchdringt das Licht der organischen Leuchtdiode das Leuchtmittel 100, so dass die Beleuchtungseinrichtung 1000 mischfarbiges Licht aussendet, das Licht des Leuchtmittels und Licht der zweiten Lichtquelle umfasst. Das Leuchtmittel 100 sowie die organische Leuchtdiode werden vorliegend von einer gemeinsamen Steuervorrichtung 11 kontrolliert.

In den Figuren 84A und 84B ist ein Beispiel für ein Ablageelement AM100 gezeigt und in der Figur 84C ein Beispiel für ein Ablagemöbel AM1000 mit dem Ablageelement AM100. Die Figuren 84A und 84B zeigen dabei zwei schematische Schnittdarstellungen des Ablageelements AM100. Die Darstellung in der Figur 84A ist dabei eine Schnittdarstellung des Ablageelements AM100 entlang der Schnittebene A2 in der Figur 84B, gesehen von der die Schicht AM5 aufweisenden Seite, währen die Darstellung in der Figur 84B eine Schnittdarstellung des Ablageelements AM100 entlang der Schnittebene A1 der Figur 84A ist. Die Figur 84C zeigt eine schematische Schnittdarstellung des Ablagemöbels AM1000, wobei die in der Darstellung gezeigte Schnittebene derjenigen Schnittebene der Figur 84B entspricht. Zur besseren Übersicht ist die Anordnung des Ablageelements AM100 im Ablagemöbel AM1000 durch den gestrichelten Bereich in Figur 84C gekennzeichnet. Die folgende Beschreibung bezieht sich gleichermaßen auf alle Figuren 84A bis 84C.

Das Ablageelement AM100 des Ablagemöbels AM1000 kann gemäß dem gezeigten Beispiel ein Substrat AM1 aufweisen, auf dem ein als organische Leuchtdiode (OLED) AM11 ausgebildetes strahlungsemittierendes Bauelement aufgebracht ist. Bei dem strahlungsemittierenden Bauelement kann es sich insbesondere auch um ein Leuchtmittel nach zumindest einem der hier beschriebenen Ausführungsbeispiele handeln.

Auf der der OLED AM11 gegenüberliegenden Seite weist das Substrat eine Ablagefläche AM10 auf. Dazu ist es besonders vorteilhaft, wenn das Substrat AM1 eine ausreichende Dicke und Festigkeit aufweist, so dass das Ablageelement AM100 eine ausreichende Stabilität und Festigkeit bei der Anordnung von Gegenständen auf der Ablagefläche AM10 aufweist. Dazu kann es zusätzlich vorteilhaft sein, wenn das Substrat AM1 weiterhin Stützstrukturen umfasst, durch die eine Erhöhung der Stabilität und Festigkeit erreicht werden kann.

Die OLED AM11 weist eine erste Elektrode AM3 auf dem Substrat AM1 auf. Auf der ersten Elektrode AM3 kann eine Schichtenfolge AM2 mit wenigstens einer organischen Schicht ausgebildet sein, wobei die Schichtenfolge AM2 einen aktiven Bereich aufweist, der geeignet ist, im Betrieb elektromagnetische Strahlung mittels Elektrolumineszenz auszusenden. Über der Schichtenfolge AM2 ist eine zweite Elektrode AM4 aufgebracht. Beispielsweise kann dabei die erste Elektrode AM3 als Anode und die zweite Elektrode AM4 als Kathode ausgebildet sein. Über der zweiten Elektrode kann eine weitere Schicht AM5 aufgebracht sein, die beispielsweise als Verkapselung der OLED AM11 dienen kann. Insbesondere können das Substrat AM1 und die Schicht AM5 einen Schutz der OLED AM11 vor schädigenden Einflüssen von außen wie etwa Feuchtigkeit oder Sauerstoff oder mechanischen Beeinträchtigungen gewährleisten. Alternativ kann bei diesem wie auch bei den folgenden Beispielen das strahlungsemittierende Bauelement als anorganische elektrolumineszierende Folie ausgebildet sein.

Das Substrat AM1 und die erste Elektrode AM3 können bevorzugt transparent ausgebildet sein, so dass die vom aktiven Bereich der Schichtenfolge AM2 erzeugte elektromagnetische Strahlung über die Ablagefläche AM10 abgestrahlt werden kann. Dazu kann das Substrat AM1 bevorzugt Glas aufweisen oder aus Glas sein. Alternativ oder zusätzlich kann das Substrat AM10 einen transparenten Kunststoff aufweisen oder aus transparentem Kunststoff sein oder eine Schichtenfolge oder ein Laminat aus Glas- und/oder transparenten Kunststoffschichten aufweisen oder sein. Durch die Transparenz des Substrats AM1 und der ersten Elektrode AM3 kann es möglich sein, auf der Ablagefläche AM10 abgelegte Gegenstände von unten, das bedeutet von der Ablagefläche AM10 her, zu beleuchten.

Alternativ oder zusätzlich können auch die zweite Elektrode AM4 und die Schicht AM5 transparent ausgeführt sein, so dass die der OLED AM11 abgewandte Seite der Schicht AM5 als Austrittsfläche für die elektromagnetische Strahlung ausgebildet sein kann. Dadurch kann es beispielsweise möglich sein, Gegenstände, die unter dem Ablageelement AM100 angeordnet sind, von oben her zu beleuchten, beispielsweise Gegenstände die sich auf einem unter diesem Ablageelement AM100 angeordneten weiteren Ablageelement befinden. Die erste Elektrode AM3 und die zweite Elektrode AM4 können dabei wie in dem Beispiel gezeigt flächig ausgebildet sein, so dass eine großflächige Abstrahlung der elektromagnetischen Strahlung ermöglicht werden kann. Die Schicht AM5 kann dazu bevorzugt Glas und/oder transparenten Kunststoff aufweisen oder aus Glas oder transparentem Kunststoff sein und kann weiterhin auch als Laminat oder Schichtenfolge mit Glasund/oder transparenten Kunststoffschichten ausgebildet sein. Weiterhin weist das Ablageelement AM100 elektrische Kontakte AM31, AM41 auf, die jeweils mittels elektrischer Leitungen AM32, AM42 jeweils mit der ersten und zweiten Elektrode AM3, AM4 elektrisch leitend verbunden sein können. Weiterhin können die Bereiche AM9 als Halteelemente in Form von Auflageflächen ausgebildet sein, die wie hier gezeigt die elektrischen Kontakte AM31, AM41 umfassen.

Das Ablagemöbel AM1000 weist weiterhin Haltevorrichtungen AM7 auf, die als Unterlegflächen ausgebildete Halteteile AM6 aufweisen können. Die Halteteile AM6 können zusammen mit den beispielsweise als Auflageflächen ausgebildeten Halteelementen AM9 des Ablageelements AM100 eine Montierbarkeit des Ablageelements AM100 an den Haltevorrichtungen AM7 ermöglichen. Die Haltevorrichtungen AM7 können dabei beispielsweise als Schrank- oder Regalwände, Stützpfosten oder Streben oder als Teile davon ausgebildet sein, die geeignete Halteteile AM6 aufweisen. Insbesondere können die Halteteile AM6 elektrische Zuleitungskontakte AM8 umfassen, die elektrisch leitend mit den elektrischen Kontakten AM31, AM41 des Ablageelements AM100 verbunden sind. Die elektrisch leitende Verbindung zwischen den elektrischen Kontakten AM31, AM41 und den elektrischen Zuleitungskontakten AM8 kann beispielsweise durch den mechanischen Kontakt der als jeweils ebene Flächen ausgebildeten elektrischen Kontakte AM31, AM41 und elektrische Zuleitungskontakte AM8 ermöglicht werden. Alternativ oder zusätzlich können die elektrischen Kontakte AM31, AM41 und/oder die elektrischen Zuleitungskontakte AM8 beispielsweise als Federelemente oder Steckverbindungen ausgebildet sein um eine verbesserte elektrisch leitende Verbindung zu ermöglichen. Das Ablageelement AM100 und die Haltevorrichtungen AM7 können zusätzlich noch weitere Halteelemente beziehungsweise Halteteile wie etwa beispielsweise Schraubverbindungen oder Klemmen aufweisen (nicht gezeigt), um eine erhöhte Stabilität des Ablagemöbels AM1000 zu gewährleisten.

Mittels der in die Halteteile AM6 integrierten elektrischen Zuleitungskontakte AM8 können die ersten elektrischen Kontakte AM31, AM41 an eine Strom- und/oder Spannungsversorgung angeschlossen werden. Weitere elektronische oder elektrotechnische Elemente zur Inbetriebnahme und Steuerung der OLED AM11 können beispielsweise in den Haltevorrichtungen 7 integriert werden.

Durch die Integration der OLED AM11 in das Ablageelement AM100 durch die Anordnung der OLED AM11 zwischen dem Substrat AM11, das gleichzeitig die Ablagefläche AM10 aufweist, und der Schicht AM5 lässt sich somit ein Ablagemöbel AM1000 mit einem Ablageelement AM100 realisieren, dass bei einer kompakten Bauweise eine großflächige Abstrahlfläche über die Ablagefläche AM10 und/oder über die der OLED gegenüberliegende Seite der Schicht AM5 ermöglicht.

Alternativ oder zusätzlich kann die OLED AM11 weitere Schichten wie etwa ein geeignetes Trägersubstrat umfassen. Dadurch kann es beispielsweise möglich sein, dass die OLED AM11, mit der ersten und zweiten Elektrode AM3, AM4 und der Schichtenfolge AM2 aufgebracht auf dem Trägersubstrat ist und zusammen mit dem Trägersubstrat auf dem Substrat AM1 angeordnet werden kann.

Alternativ kann auch die Schicht AM5 ein Trägersubstrat umfassen, auf das die OLED aufgebracht ist.

Das in der Figur 85 gezeigte Beispiel für ein Ablageelement AM200 stellt eine Modifikation des Beispiels gemäß der vorangehenden Figuren dar und zeigt ein organisches, lichtemittierendes Bauelement im Ablageelement AM200 mit einer flächig ausgebildeten ersten Elektrode AM3 mit zwei elektrischen Kontakten AM311, AM312, die über elektrische Leitungen AM321, AM322 elektrisch leitend mit der ersten Elektrode AM3 verbunden sind. Weiterhin ist die zweite Elektrode als parallele Streifen AM401, AM402 strukturiert, die alternierend über der aktiven Schichtenfolge AM2 angeordnet sind, wobei die parallelen Streifen AM401 über die elektrische Leitung AM421 mit dem elektrischen Kontakt AM411 elektrisch leitend verbunden sind und die parallelen Steifen AM402 über die elektrische Leitung AM422 mit dem elektrischen Kontakt AM412 verbunden sind. Damit kann die zweite Elektrode unabhängig voneinander kontaktierbare Teilbereiche AM401 und AM402 aufweisen. Insbesondere kann es dadurch ermöglicht werden, dass die jeweils zwischen den Teilbereichen AM401, AM402 der zweiten Elektrode und der ersten Elektrode AM3 angeordneten Bereiche des aktiven Bereichs der Schichtenfolge AM2 der OLED AM11 unabhängig voneinander elektromagnetische Strahlung aussenden können. Dabei kann beispielsweise auch der aktive Bereich der OLED AM11 strukturiert sein, so dass der Teilbereich der OLED AM11, der zwischen dem Teilbereich AM401 der zweiten Elektrode und der ersten Elektrode AM3 angeordnet ist, eine elektromagnetische Strahlung mit einem ersten Spektrum aussenden kann und der Teilbereich der OLED, der zwischen dem Teilbereich AM402 der zweiten Elektrode AM4 und der ersten Elektrode AM3 angeordnet ist, eine elektromagnetische Strahlung mit einem zweiten Spektrum aussenden kann, wobei das erste und das zweite Spektrum verschieden sein können. Durch das Anlegen eines Stroms und/oder einer Spannung zwischen zumindest einem der elektrischen Kontakte AM311, AM312 und jeweils einem der elektrischen Kontakte AM411 und AM412 oder beiden können somit drei verschiedene Betriebszustände mit verschiedenen Leuchteindrücken bei einem Betrachter ermöglicht werden. Beispielsweise kann das erste Spektrum eine oder mehrere Wellenlängen im blauen Spektralbereich aufweisen und das zweite Spektrum eine oder mehrere Wellenlängen im gelben oder orangefarbigen Spektralbereich, so dass bei einem Betrachter durch die drei Betriebszustände beispielsweise ein blauer, ein gelber oder orangefarbiger und bei Überlagerung des blauen mit dem gelben oder orangefarbigen Leuchteindruck auch ein weißfarbiger Leuchteindruck ermöglicht werden kann.

Alternativ kann auch die erste Elektrode strukturiert sein während die zweite Elektrode flächig ausgebildet sein kann, oder beide Elektroden sind als großflächige Elektrodenflächen ausgeformt. Insbesondere kann eine Elektrode jedwede gewünschte und geeignete Strukturierung aufweisen, beispielsweise auch in Form von Piktogrammen, um neben dem Leuchteindruck auch einen bildhaften Eindruck bei einem Betrachter zu ermöglichen.

Besonders bevorzugt weist das Ablageelement AM200 Halteelemente auf (nicht gezeigt), die die elektrischen Kontakte AM311, AM312, AM411, AM412 umfassen. Solche Halteelemente können beispielsweise Auflageflächen, Öffnungen, Löcher sowie Teile von Schraub-, Steck-, oder Klemmverbindungen sein. Eine geeignete Haltevorrichtung kann dann dementsprechende Halteteile aufweisen, die insbesondere auch vorteilhafterweise elektrische Zuleitungskontakte aufweisen können.

Das in der Figur 86 gezeigte Beispiel für ein Ablageelement AM300 zeigt als weitere Modifikation zu den vorangehenden Beispielen für ein Ablageelement neben der zweiten Elektrode, die in Teilbereiche AM401, AM402 mit parallelen Streifen strukturiert ist, auch die erste Elektrode, die in Teilbereiche AM301, AM302 mit parallelen Streifen strukturiert ist. Die Teilbereiche AM301, AM302 können dabei über elektrische Leitungen AM321, AM322 jeweils elektrisch leitend mit elektrischen Kontakten AM311, AM312 verbunden sein. Die erste Elektrode kann dabei parallele Streifen AM301, AM302 aufweisen, die beispielsweise senkrecht zu den parallelen Streifen AM401, AM402 der zweiten Elektrode sind. Damit kann die OLED beispielsweise bildpunktartige Teilbereiche aufweisen, die durch parallel geschaltete Kreuzungspunkte der Elektroden-Teilbereiche AM301, AM302 und AM401, AM402 gegeben sind. Insbesondere kann bei diesem Beispiel die Schichtenfolge AM2 oder zumindest der aktive Bereich der Schichtenfolge AM2 der OLED so strukturiert sein, dass sich durch Anlegen eines Stroms und/oder einer Spannung zwischen einem oder beiden Teilbereichen AM301, AM302 der ersten Elektrode und einem oder beiden Teilbereichen AM401, AM402 der zweiten Elektrode durch verschiedene Abstrahlspektren und deren Mischspektren verschiedene Betriebszustände mit verschiedenen Leuchteindrücken bei einem Betrachter realisieren lassen. Beispielsweise kann durch das Anlegen einer Spannung und/oder eines Stromes jeweils zwischen den elektrischen Kontakten AM311 und AM411, AM312 und AM411, AM311 und AM412 sowie AM312 und AM412 jeweils ein schachbrettartiger Leuchteindruck bei einem Betrachter ermöglicht werden, wohingegen das Anlegen einer Spannung und/oder eines Stromes zwischen den elektrischen Kontakten AM311 und AM312 und einem der elektrischen Kontakte AM411 und AM412 sowie zwischen einem der elektrischen Kontakte AM311 oder AM312 und den elektrischen Kontakten AM411 und AM412 jeweils ein Leuchteindruck zeilenartig angeordneter bildpunktartiger Teilbereiche bei einem Betrachter erweckt werden kann. Durch Anlegen einer Spannung und/oder eines Stromes zwischen allen Kontakten der ersten und zweiten Elektrode kann ein flächiger Leuchteindruck bei einem Betrachter ermöglicht werden.

Darüber hinaus kann dem organischen strahlungsemittierenden Bauelement im Strahlengang der emittierten elektromagnetischen Strahlung beispielsweise auch eine Diffusorplatte nachgeordnet sein, so dass ein homogenerer und flächigerer Leuchteindruck der verschiedenen oben beschriebenen Betriebszustände bei einem Betrachter ermöglicht werden kann.

Insbesondere die Form, die Größe und der Abstand zwischen den strukturierten Teilbereichen jeweils der ersten und zweiten Elektrode kann entsprechend dem gewünschten Leuchteindruck gewählt werden und ist in den vorangegangenen Beispielen rein beispielhaft gezeigt.

Das Beispiel für ein Ablageelement AM400 gemäß der Figur 87 zeigt beispielsweise eine Aufsicht des Ablageelements mit einem organischen strahlungsemittierenden Bauelement mit ersten AM301, AM302 und zweiten Elektroden AM401, AM402 und einer Schichtenfolge AM2 mit einem aktiven Bereich, die nur in Randbereichen des Substrat AM1 angeordnet sind. Dadurch kann beispielsweise eine Beleuchtung von Gegenständen, die auf der Ablagefläche AM10 und/oder unter dem Ablageelement AM400 angeordnet sind, von der Seite her erfolgen. Insbesondere kann eine Abstrahlfläche dazu zusätzlich optische Strukturen aufweisen, durch die die elektromagnetische Strahlung bevorzugt in den Raumbereich zwischen den Teilbereichen AM301, AM401 und AM302, AM402 der ersten und zweiten Elektrode abgestrahlt werden kann.

Die in den vorangehenden Figuren, insbesondere die in den Figuren 85 bis 87, gezeigten Beispiele für eine Strukturierung der ersten und/oder der zweiten Elektrode sind rein exemplarisch und nicht limitierend zu verstehen. Insbesondere können die erste und/oder die zweite Elektrode mehr als zwei Teilbereiche AM301, AM302 beziehungsweise AM401, AM402 aufweisen und dementsprechend auch mehr als zwei elektrische Kontakte AM311, AM312 beziehungsweise AM411, AM412. Insbesondere kann auch die Form und Anordnung der elektrischen Kontakte und/oder der Halteelemente von den gezeigten Formen und Anordnungen abweichen.

In der Figur 88 ist ein Beispiel für ein Ablagemöbel AM2000 mit Ablageelementen AM101, AM102 gezeigt. Die Ablageelemente AM101, AM102 sind dabei der Übersicht halber nur durch die gestrichelten Bereiche angedeutet und können beispielsweise gemäß einem der vorangehenden Beispiele ausgebildet sein.

Das Ablagemöbel AM2000 weist vier Haltevorrichtungen AM7 auf, die als senkrechte Pfosten oder Streben ausgebildet sind. Darüber hinaus können in weiteren Beispielen die Haltevorrichtungen AM7 auch Teile von Möbelwänden sein. Die Haltevorrichtungen AM7 können Halteteile AM6 aufweisen, die geeignet sind, die Ablageelemente AM101, AM102 an die Haltevorrichtungen AM7 zu montieren. Diesbezüglich können die Ablageelemente AM101, AM102 dazu geeignete Halteelemente aufweisen (nicht in Figur 88 gezeigt). Weiterhin kann es vorteilhaft sein, wenn die Halteteile AM6 elektrische Zuleitungskontakte umfassen (nicht in Figur 88 gezeigt), die eine elektrische Kontaktierung der organischen strahlungsemittierenden Bauelemente der Ablageelemente AM101, AM102 über deren elektrische Kontakte AM311, AM312, AM411, AM412 (nicht in Figur 88 gezeigt) ermöglichen.

Die in den Figuren 89A bis 89E dargestellten Beispiele zeigen in einer Aufsicht Beispiele für die Anzahl und Anordnung von elektrischen Kontakten und/oder Halteelementen auf Ablageelementen AM101 und von elektrischen Zuleitungskontakten und/oder Halteteilen in Haltevorrichtungen AM7 für Ablagemöbel. Die Pfeile kennzeichnen dabei die Art der Anordnung der Ablageelemente AM101 in den Haltevorrichtungen AM7, die der Übersichtlichkeit halber räumlich getrennt voneinander dargestellt sind. Beispielsweise können die Pfeile darstellen, das das Ablageelement in die betreffende Haltevorrichtung hinein geschoben wird, wobei dann gegebenenfalls noch eine feste Montage erfolgen kann. Die Bezugszeichen AM51 bis AM55 können dabei sowohl elektrische Kontakte, Halteelemente als auch Halteelemente, die elektrische Kontakte umfassen, kennzeichnen. Ebenso können die Bezugszeichen AM711 bis AM715 sowohl elektrische Zuleitungen, Halteteile als auch Halteteile, die elektrische Zuleitungen umfassen, kennzeichnen. Darüber hinaus sind Größen, Abstände, Positionen und Anzahl der elektrischen Kontakte beziehungsweise Halteelemente AM51 bis AM55 sowie der elektrischen Zuleitungskontakte beziehungsweise Halteteile AM711 bis AM715 rein exemplarisch gezeigt.

Eine Haltevorrichtungen AM7 kann beispielsweise eine oder mehrere Möbelwände, ein Rahmen, vertikale oder horizontale Streben, wandmontierbare Streben, wandmontierbare Halterahmen oder Teile davon sein, die geeignet sein können, ein Ablageelement AM101 so zu halten, dass die Ablagefläche des Ablageelements AM101 im Wesentlichen parallel zu einem Boden ist, auf der die Haltevorrichtung AM7 aufgestellt sein kann, oder im Wesentlichen senkrecht zu einer Wand, an der die Haltevorrichtung angebracht oder montiert sein kann. Beispielsweise können Halteelemente AM51, AM52 beziehungsweise Halteteile AM711, AM712 wie in Figur 89A gezeigt als Schienen oder Teile eines Schienensystems ausbildet sein. Darüber hinaus kann beispielsweise wie in Figur 89B gezeigt ein weiteres Halteelement AM53 als Auflagefläche und ein weiteres Halteteil AM713 als Unterlegfläche ausgebildet sein. Umfassen die Halteelemente AM51, AM52, AM53 elektrische Kontakte und die Halteteile AM711, AM712, AM713 elektrische Zuleitungskontakte, kann das gezeigte Beispiel beispielsweise für ein Ablageelement AM400 gemäß der Figur 87 geeignet sein. Die weiteren Beispiele gemäß der Figuren 89C bis 89E zeigen weitere Möglichkeiten mit wenigstens vier Halteelementen/elektrischen Kontakten beziehungsweise wenigstens vier Halteteilen/elektrischen Zuleitungskontakten.

Insbesondere können einige Halteteile beziehungsweise Halteelemente elektrische Kontakte beziehungsweise elektrische Zuleitungskontakte aufweisen und andere nicht.

## Patentansprüche

1. Beleuchtungseinrichtung (1000) mit
- einer ersten Lichtquelle, die Licht einer ersten Farbe aussendet, und
- einer zweiten Lichtquelle (370), die Licht einer, von der ersten Farbe verschiedenen, zweiten Farbe aussendet,
wobei
- zumindest eine der beiden Lichtquellen dimmbar ist,
- die erste Lichtquelle durch ein Leuchtmittel (100) gebildet ist, umfassend
- ein Substrat (1) mit einer ersten Hauptfläche (101), auf die eine erste Elektrode (2) aufgebracht ist,
- eine zweite Elektrode (3), und
- einen organischen Schichtstapel (4) innerhalb eines aktiven Bereiches (5) des Substrates (1) zwischen der ersten und der zweiten Elektrode (3), wobei der organische Schichtstapel (4) mindestens eine organische Schicht (401) umfasst, die geeignet ist, Licht zu erzeugen, und
- das Leuchtmittel (100) und die zweite Lichtquelle (370) so zueinander angeordnet sind, dass Licht der zweiten Lichtquelle durch das Leuchtmittel (100) hindurch tritt, dadurch gekennezeichnet, dass
- die zweite Lichtquelle (370) mehrere Leuchtdioden (380), die auf einen Träger (381) montiert sind, umfasst,
- die Leuchtdioden (380) Licht der zweiten Farbe aussenden,
- über den Leuchtdioden (380) eine milchige Glasscheibe als optisches Element (60) angeordnet ist, durch die das Licht der Leuchtdioden (380) im Betrieb der Beleuchtungseinrichtung derart hindurch tritt, dass die milchige Glasscheibe von ihrer den Leuchtdioden (380) abgewandten Vorderseite farbiges Streulicht der zweiten Farbe emittiert, und
- die milchige Glasscheibe das Substrat (1) des Leuchtmittels (100) ist, welches durchlässig für sichtbares Licht ausgebildet ist.

2. Beleuchtungseinrichtung (1000) nach dem vorherigen Anspruch,
bei dem die erste Farbe im blauen Spektralbereich und die zweite Farbe im gelben Spektralbereich liegt.

3. Beleuchtungseinrichtung (1000) nach Anspruch 1,
bei dem die erste Farbe im gelben Spektralbereich und die zweite Farbe im blauen Spektralbereich liegt.

4. Beleuchtungseinrichtung (1000) nach Anspruch 1,
bei dem die erste Farbe im warmweißen Bereich der CIE-Normfarbtafel und die zweite Farbe im kaltweißen Bereich der CIE-Normfarbtafel liegt.

5. Beleuchtungseinrichtung (1000) nach Anspruch 1,
bei dem
die erste Farbe im kaltweißen Bereich der CIE-Normfarbtafel und die zweite Farbe im warmweißen Bereich der CIE-Normfarbtafel liegt.

6. Beleuchtungseinrichtung (1000) nach zumindest einem der obigen Ansprüche,
bei dem das Leuchtmittel (100) dimmbar ist.

7. Beleuchtungseinrichtung (1000) nach zumindest einem der obigen Ansprüche,
bei dem die zweite Lichtquelle (370) dimmbar ist.

8. Beleuchtungseinrichtung (1000) nach zumindest einem der obigen Ansprüche,
bei der das Leuchtmittel (100) flexibel und durchlässig für sichtbares Licht ausgebildet ist.

9. Beleuchtungseinrichtung (1000) nach zumindest einem der obigen Ansprüche,
bei der das Leuchtmittel (100) als Lampenschirm ausgebildet ist.

10. Beleuchtungseinrichtung (1000) nach zumindest einem der obigen Ansprüche,
die im Betrieb mischfarbiges Licht aussendet, das Licht des Leuchtmittels (100) und Licht der zweiten Lichtquelle (370) aufweist.

## Claims

1. Illumination device (1000) with
- a first light source emitting light of a first colour, and
- a second light source (370) emitting light of a second colour different from the first colour,
wherein
- at least one of the two light sources is dimmable,
- the first light source is formed by a luminous means (100) comprising
- a substrate (1) having a first main surface (101) to which a first electrode (2) is applied,
- a second electrode (3), and
- an organic layer stack (4) within an active region (5) of the substrate (1) between the first and the second electrodes (3), wherein the organic layer stack (4) comprises at least one organic layer (401) which is suitable for generating light, and
- the luminous means (100) and the second light source (370) are arranged with respect to one another in such a way that light from the second light source passes through the luminous means (100), **characterized in that**
- the second light source (370) comprises a plurality of light emitting diodes (380) mounted on a carrier (381),
- the light emitting diodes (380) emit light of the second colour,
- above the light-emitting diodes (380) a milky glazing is arranged as an optical element (60) through which the light of the light-emitting diodes (380) passes during operation of the illumination device in such a way that the milky glazing emits coloured scattered light of the second colour from its front side facing away from the light-emitting diodes (380), and
- the milky glazing is the substrate (1) of the luminous means (100) which is transparent to visible light.

2. Illumination device (1000) according to the previous claim,
in which the first colour is in the blue spectral range and the second colour is in the yellow spectral range.

3. Illumination device (1000) according to claim 1,
in which the first colour is in the yellow spectral range and the second colour is in the blue spectral range.

4. Illumination device (1000) according to claim 1,
in which the first colour is in the warm white region of the CIE standard chromaticity diagram and the second colour is in the cold white region of the CIE standard chromaticity diagram.

5. Illumination device (1000) according to claim 1,
in which the first colour is in the cold white region of the CIE standard chromaticity diagram and the second colour is in the warm white region of the CIE standard chromaticity diagram.

6. Illumination device (1000) according to at least one of the previous claims,
in which the luminous means (100) is dimmable.

7. Illumination device (1000) according to at least one of the previous claims,
In which the second light source (370) is dimmable.

8. Illumination device (1000) according to at least one of the previous claims,
in which the luminous means (100) is flexible and transmissive to visible light.

9. Illumination device (1000) according to at least one of the previous claims,
in which the luminous means (100) is embodied as a lampshade.

10. Illumination device (1000) according to at least one of the previous claims,
which emits mixed-coloured light during operation, comprising light from the luminous means (100) and light from the second light source (370).

## Revendications

1. Dispositif d'éclairage (1000) avec
- une première source de lumière émettant une lumière d'une première couleur, et
- une deuxième source de lumière (370) émettant une lumière d'une deuxième couleur différente de la première,
dans lequel
- au moins une des deux sources de lumière est réglable,
- la première source de lumière est constituée par un moyen lumineux (100) comprenant
- un substrat (1) ayant une première surface principale (101) sur laquelle est appliquée une première électrode (2),
- une deuxième électrode (3), et
- une empilement de couches organiques (4) dans une zone active (5) du substrat (1) entre la première et la deuxième électrode (3), dans laquelle l'empilement de couches organiques (4) comprenant au moins une couche organique (401), qui est convient pour générer de la lumière, et
- le moyen lumineux (100) et la deuxième source de lumière (370) sont disposés l'un par rapport à l'autre de telle sorte que la lumière de la deuxième source de lumière passe à travers le moyen lumineux (100), **caractérisé en ce que**
- la seconde source de lumière (370) comprend une pluralité de diodes électroluminescentes (380) qui sont montées sur un support (381),
- les diodes électroluminescentes (380) émettent une lumière de la deuxième couleur,
- une vitre en verre laiteux est disposée comme qu'élément optique (60) au-dessus des diodes électroluminescentes (380), à travers lequel la lumière des diodes électroluminescentes (380) passe pendant le fonctionnement du dispositif d'éclairage de telle sorte que la vitre en verre laiteux émet une lumière colorée diffusée de la deuxième couleur à partir de sa face avant opposée aux diodes électroluminescentes (380), et
- le verre laiteux est le substrat (1) du moyen lumineux (100), qui est transparent à la lumière visible.

2. Dispositif d'éclairage (1000) selon la revendication précédente,
dans lequel la première couleur est dans la gamme spectrale bleue et la seconde est dans la gamme spectrale jaune.

3. Dispositif d'éclairage (1000) selon la revendication 1, dans lequel la première couleur est dans la gamme spectrale jaune et la deuxième couleur est dans la gamme spectrale bleue.

4. Dispositif d'éclairage (1000) selon la revendication 1, dans lequel la première couleur est dans la zone blanc chaud du nuancier standard de la CIE et la deuxième couleur est dans la zone blanc froid du nuancier standard de la CIE.

5. Dispositif d'éclairage (1000) selon la revendication 1, dans lequel
la première couleur est dans la zone blanche froide du nuancier standard de la CIE et la deuxième couleur est dans la zone blanche chaude du nuancier standard de la CIE.

6. Dispositif d'éclairage (1000) selon au moins l'une des revendications précédentes,
dans lequel le moyen lumineux (100) est réglable.

7. Dispositif d'éclairage (1000) selon au moins l'une des revendications précédentes,
dans lequel la deuxième source de lumière (370) est réglable.

8. Dispositif d'éclairage (1000) selon au moins l'une des revendications précédentes,
dans lequel le moyen lumineux (100) est flexible et transparent à la lumière visible.

9. Dispositif d'éclairage (1000) selon au moins l'une des revendications précédentes,
dans lequel le moyen lumineux (100) est conçu comme un abat-jour.

10. Dispositif d'éclairage (1000) selon au moins l'une des revendications précédentes,
qui émet une lumière de couleur mixte pendant le fonctionnement, comprenant la lumière de le moyen lumineux (100) et la lumière de la seconde source de lumière (370).
